# EUROPEAN PATENT APPLICATION

(11) **EP 4 362 646 A1**
(43) Date of publication of application: **01.05.2024**
(21) Application number: 23206059.0
(22) Date of filing: 26.10.2023
(51) Int. Cl.: H10K 85/30, H10K 85/60, H10K 101/00

(54) **ORGANIC ELECTROLUMINESCENT MATERIALS AND DEVICES**

(30) Priority: 27.10.2022 US 202263419782 P; 02.11.2022 US 202263421804 P; 13.12.2022 US 202263387166 P; 21.12.2022 US 202263434161 P; 07.02.2023 US 202363483647 P; 14.02.2023 US 202363484757 P; 14.02.2023 US 202363484786 P; 27.02.2023 US 202363487055 P; 14.03.2023 US 202363490065 P; 13.04.2023 US 202363459091 P; 17.05.2023 US 202318319182; 20.10.2023 US 202318491065
(71) Applicant: Universal Display Corporation, Ewing, NJ 08618 (US)
(72) Inventor: FLEETHAM, Tyler, Ewing, 08618 (US); HAMZE, Rasha, Ewing, 08618 (US)
(74) Representative: Dragotti & Associati S.R.L.

(57) **Abstract**

Provided is an OLED that includes an anode; a cathode; and an emissive region disposed between the anode and the cathode. The emissive region includes a first compound S1; a second compound A1; and a third compound H1. The first compound S1 is capable of phosphorescent emission at room temperature and is a sensitizer that transfers energy to the second compound A1; the second compound A1 is an acceptor that is an emitter; and the third compound H1 is a first host, and at least one of the first compound S1 and the second compound A1 is doped in the third compound H1. Consumer products including the OLED are also provided, as are formulations containing the first, second, and third compounds.

## Description

### CROSS-REFERENCE TO RELATED APPLICATIONS

This application is a continuation-in-part of United States patent Application No. 18/319,182, filed on May 17, 2023, and also claims priority under 35 U.S.C. § 119(e) to United States Provisional Applications No. 63/387,166, filed on December 13, 2022, No. 63/419,782, filed on October 27, 2022, No. 63/421,804, filed on November 2, 2022, No. 63/483,647, filed on February 7, 2023, No. 63/487,055, filed on February 27, 2023, No. 63/459,091, filed on April 13, 2023, No. 63/434,161, filed on December 21, 2022, No. 63/484,757, filed on February 14, 2023, No. 63/484,786, filed on February 14, 2023, No. 63/490,065, filed on March 14, 2023, the entire contents of which are incorporated herein by reference.

### FIELD

The present invention relates to devices and techniques for fabricating organic emissive devices, such as organic light emitting diodes, and devices and techniques including the same.

### BACKGROUND

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, organic scintillators, and organic photodetectors. For OLEDs, the organic materials may have performance advantages over conventional materials. For example, the wavelength at which an organic emissive layer emits light may generally be readily tuned with appropriate dopants.

OLEDs make use of thin organic films that emit light when voltage is applied across the device. OLEDs are becoming an increasingly interesting technology for use in applications such as displays, illumination, and backlighting. Several OLED materials and configurations are described in U.S. Pat. Nos. 5,844,363, 6,303,238, and 5,707,745, which are incorporated herein by reference in their entirety.

One application for emissive molecules is a full color display. Industry standards for such a display call for pixels adapted to emit particular colors, referred to as "saturated" colors. In particular, these standards call for saturated red, green, and blue pixels. Alternatively the OLED can be designed to emit white light. In conventional liquid crystal displays emission from a white backlight is filtered using absorption filters to produce red, green and blue emission. The same technique can also be used with OLEDs. The white OLED can be either a single EML device or a stack structure. Color may be measured using CIE coordinates, which are well known to the art.

### SUMMARY

In one aspect, the present disclosure provides an organic light emitting device (OLED) comprising:
an anode;
a cathode; and
an emissive region disposed between the anode and the cathode;
wherein the emissive region comprises:
   a first compound S1;
   a second compound A1; and
   a third compound H1;
wherein the first compound S1 is capable of phosphorescent emission at room temperature and is a sensitizer that transfers energy to the second compound A1;
wherein the second compound A1 is an acceptor that is an emitter; and
wherein the third compound H1 is a first host, and at least one of the first compound S1 and the second compound A1 is doped in the third compound H1;
with at least one of the following conditions being true:
(1) the third compound H1 comprises a boron atom; or
(2) the first compound S1 is a metal complex comprising metal M, and a first ligand L_{A} that comprises at least one moiety F; wherein the at least one moiety F is a fused ring system comprising two or more 5 -membered and/or 6- membered carbocyclic or heterocyclic rings and is joined to the metal M through an anionic bond; wherein M is selected from the group consisting of Ir, Rh, Re, Ru, Os, Pt, Pd, Zn, Ag, Au, and Cu; and with the proviso that if M is Pt or Pd, then the at least one moiety F is not a nonfused carbazole.

In another aspect, the present disclosure also provides consumer products containing an OLED as disclosed herein. The present disclosure further provides a formulation as described herein.

### BRIEF DESCRIPTION OF THE DRAWINGS

FIG. 1 shows an organic light emitting device.
FIG. 2 shows an inverted organic light emitting device that does not have a separate electron transport layer.
FIG. 3 shows a graph of modeled P-polarized photoluminescence as a function of angle for emitters with different vertical dipole ratio (VDR) values.
FIG. 4 shows PL spectra of several Phosphor compounds.

### DETAILED DESCRIPTION

### A. Terminology

Unless otherwise specified, the below terms used herein are defined as follows:
As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processable" means capable of being dissolved, dispersed, or transported in and/or deposited from a liquid medium, either in solution or suspension form.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

The terms "halo," "halogen," and "halide" are used interchangeably and refer to fluorine, chlorine, bromine, and iodine.

The term "acyl" refers to a substituted carbonyl group (-C(O)-Rₛ).

The term "ester" refers to a substituted oxycarbonyl (-O-C(O)-Rₛ or -C(O)-O-Rₛ) group.

The term "ether" refers to an -ORₛ group.

The terms "sulfanyl" or "thio-ether" are used interchangeably and refer to a -SRₛ group.

The term "selenyl" refers to a -SeRₛ group.

The term "sulfinyl" refers to a -S(O)-Rₛ group.

The term "sulfonyl" refers to a -SO₂-Rₛ group.

The term "phosphino" refers to a group containing at least one phosphorus atom used to be bonded to the relevant molecule, common examples such as, but not limited to, a -P(Rₛ)₂ group or a -PO(Rₛ)₂ group, wherein each Rₛ can be same or different.

The term "silyl" refers to a group containing at least one silicon atom used to be bonded to the relevant molecule, common examples such as, but not limited to, a -Si(Rₛ)₃ group, wherein each Rₛ can be same or different.

The term "germyl" refers to a group containing at least one germanium atom used to be bonded to the relevant molecule, common examples such as, but not limited to, a -Ge(Rₛ)₃ group, wherein each Rₛ can be same or different.

The term "boryl" refers to a group containing at least one boron atom used to be bonded to the relevant molecule, common examples such as, but not limited to, a -B(Rₛ)₂ group or its Lewis adduct -B(Rₛ)₃ group, wherein Rₛ can be same or different.

In each of the above, Rₛ can be hydrogen or the general substituents as defined in this application. Preferred Rₛ is selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, and combination thereof. More preferably Rₛ is selected from the group consisting of alkyl, cycloalkyl, aryl, heteroaryl, and combination thereof.

The term "alkyl" refers to and includes both straight and branched chain alkyl groups. Preferred alkyl groups are those containing from one to fifteen carbon atoms, preferably one to nine carbon atoms, and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group can be further substituted.

The term "cycloalkyl" refers to and includes monocyclic, polycyclic, and spiro alkyl groups. Preferred cycloalkyl groups are those containing 3 to 12 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group can be further substituted.

The terms "heteroalkyl" or "heterocycloalkyl" refer to an alkyl or a cycloalkyl group, respectively, having at least one carbon atom replaced by a heteroatom. Optionally the at least one heteroatom is selected from O, S, N, P, B, Si, Ge and Se, preferably, O, S or N. Additionally, the heteroalkyl or heterocycloalkyl group can be further substituted.

The term "alkenyl" refers to and includes both straight and branched chain alkene groups. Alkenyl groups are essentially alkyl groups that include at least one carbon-carbon double bond in the alkyl chain. Cycloalkenyl groups are essentially cycloalkyl groups that include at least one carbon-carbon double bond in the cycloalkyl ring. The term "heteroalkenyl" as used herein refers to an alkenyl group having at least one carbon atom replaced by a heteroatom. Optionally the at least one heteroatom is selected from O, S, N, P, B, Si, Ge, and Se, preferably, O, S, or N. Preferred alkenyl, cycloalkenyl, or heteroalkenyl groups are those containing two to fifteen carbon atoms. Additionally, the alkenyl, cycloalkenyl, or heteroalkenyl group can be further substituted.

The term "alkynyl" refers to and includes both straight and branched chain alkyne groups. Alkynyl groups are essentially alkyl groups that include at least one carbon-carbon triple bond in the alkyl chain. Preferred alkynyl groups are those containing two to fifteen carbon atoms. Additionally, the alkynyl group can be further substituted.

The terms "aralkyl" or "arylalkyl" are used interchangeably and refer to an alkyl group that is substituted with an aryl group. Additionally, the aralkyl group can be further substituted.

The term "heterocyclic group" refers to and includes aromatic and non-aromatic cyclic groups containing at least one heteroatom. Optionally the at least one heteroatom is selected from O, S, Se, N, P, B, Si, Ge, and Se, preferably, O, S, N, or B. Hetero-aromatic cyclic groups may be used interchangeably with heteroaryl. Preferred hetero-non-aromatic cyclic groups are those containing 3 to 10 ring atoms, preferably those containing 3 to 7 ring atoms, which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group can be further substituted or fused.

The term "aryl" refers to and includes both single-ring and polycyclic aromatic hydrocarbyl groups. The polycyclic rings may have two or more rings in which two carbons are common to two adjoining rings (the rings are "fused"). Preferred aryl groups are those containing six to thirty carbon atoms, preferably six to twenty-four carbon atoms, six to eighteen carbon atoms, and more preferably six to twelve carbon atoms. Especially preferred is an aryl group having six carbons, ten carbons, twelve carbons, fourteen carbons, or eighteen carbons. Suitable aryl groups include phenyl, biphenyl, triphenyl, triphenylene, tetraphenylene, naphthalene, anthracene, phenalene, phenanthrene, pyrene, chrysene, perylene, and azulene, preferably phenyl, biphenyl, triphenyl, triphenylene, and naphthalene. Additionally, the aryl group can be further substituted or fused, such as, without limitation, fluorene.

The term "heteroaryl" refers to and includes both single-ring aromatic groups and polycyclic aromatic ring systems that include at least one heteroatom. The heteroatoms include, but are not limited to O, S, Se, N, P, B, Si, Ge, and Se. In many instances, O, S, N, or B are the preferred heteroatoms. Hetero-single ring aromatic systems are preferably single rings with 5 or 6 ring atoms, and the ring can have from one to six heteroatoms. The hetero-polycyclic ring systems can have two or more aromatic rings in which two atoms are common to two adjoining rings (the rings are "fused") wherein at least one of the rings is a heteroaryl. The hetero-polycyclic aromatic ring systems can have from one to six heteroatoms per ring of the polycyclic aromatic ring system. Preferred heteroaryl groups are those containing three to thirty carbon atoms, preferably three to twenty-four carbon atoms, three to eighteen carbon atoms, and more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably dibenzothiophene, dibenzofuran, dibenzoselenophene, carbazole, indolocarbazole, imidazole, pyridine, triazine, benzimidazole, 1,2-azaborine, 1,3-azaborine, 1,4-azaborine, borazine, and aza-analogs thereof. Additionally, the heteroaryl group can be further substituted or fused.

Of the aryl and heteroaryl groups listed above, the groups of triphenylene, naphthalene, anthracene, dibenzothiophene, dibenzofuran, dibenzoselenophene, carbazole, indolocarbazole, imidazole, pyridine, pyrazine, pyrimidine, triazine, and benzimidazole, and the respective aza-analogs of each thereof are of particular interest.

In many instances, the general substituents are selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof.

In some instances, the preferred general substituents are selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

In some instances, the more preferred general substituents are selected from the group consisting of deuterium, fluorine, alkyl, cycloalkyl, alkoxy, aryloxy, amino, silyl, aryl, heteroaryl, nitrile, sulfanyl, and combinations thereof.

In some instances, the more preferred general substituents are selected from the group consisting of deuterium, fluorine, alkyl, cycloalkyl, silyl, aryl, heteroaryl, nitrile, and combinations thereof.

In yet other instances, the most preferred general substituents are selected from the group consisting of deuterium, alkyl, cycloalkyl, aryl, heteroaryl, and combinations thereof.

The terms "substituted" and "substitution" refer to a substituent other than H that is bonded to the relevant position, e.g., a carbon or nitrogen. For example, when R¹ represents mono-substitution, then one R¹ must be other than H (i.e., a substitution). Similarly, when R¹ represents di-substitution, then two of R¹ must be other than H. Similarly, when R¹ represents zero or no substitution, R¹, for example, can be a hydrogen for available valencies of ring atoms, as in carbon atoms for benzene and the nitrogen atom in pyrrole, or simply represents nothing for ring atoms with fully filled valencies, e.g., the nitrogen atom in pyridine. The maximum number of substitutions possible in a ring structure will depend on the total number of available valencies in the ring atoms.

As used herein, "combinations thereof' indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include up to forty atoms that are not hydrogen or deuterium, or those that include up to thirty atoms that are not hydrogen or deuterium. In many instances, a preferred combination of substituent groups will include up to twenty atoms that are not hydrogen or deuterium.

The "aza" designation in the fragments described herein, i.e. aza-dibenzofuran, aza-dibenzothiophene, etc. means that one or more of the C-H groups in the respective aromatic ring can be replaced by a nitrogen atom, for example, and without any limitation, azatriphenylene encompasses both dibenzo[*f,h*]quinoxaline and dibenzo[*f,h*]quinoline. One of ordinary skill in the art can readily envision other nitrogen analogs of the aza-derivatives described above, and all such analogs are intended to be encompassed by the terms as set forth herein.

As used herein, "deuterium" refers to an isotope of hydrogen. Deuterated compounds can be readily prepared using methods known in the art. For example, U.S. Pat. No. 8,557,400, Patent Pub. No. WO 2006/095951, and U.S. Pat. Application Pub. No. US 2011/0037057, which are hereby incorporated by reference in their entireties, describe the making of deuterium-substituted organometallic complexes. Further reference is made to Ming Yan, et al., Tetrahedron 2015, 71, 1425-30 and Atzrodt et al., Angew. Chem. Int. Ed. (Reviews) 2007, 46, 7744-65, which are incorporated by reference in their entireties, describe the deuteration of the methylene hydrogens in benzyl amines and efficient pathways to replace aromatic ring hydrogens with deuterium, respectively.

As used herein, any specifically listed substituent, such as, without limitation, methyl, phenyl, pyridyl, etc. includes undeuterated, partially deuterated, and fully deuterated versions thereof. Similarly, classes of substituents such as, without limitation, alkyl, aryl, cycloalkyl, heteroaryl, etc. also include undeuterated, partially deuterated, and fully deuterated versions thereof. A chemical structure without further specified H or D should be considered to include undeuterated, partially deuterated, and fully deuterated versions thereof. Some common smallest partially or fully deuterated group, without limitation, includes CD₃, CD₂C(CH₃)₃, C(CD₃)₃, and C₆D₅.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or attached fragment are considered to be equivalent.

In some instances, a pair of substituents in the molecule can be optionally joined or fused into a ring. The preferred ring is a five to nine-membered carbocyclic or heterocyclic ring, includes both instances where the portion of the ring formed by the pair of substituents is saturated and where the portion of the ring formed by the pair of substituents is unsaturated. In yet other instances, a pair of adjacent substituents can be optionally joined or fused into a ring. As used herein, "adjacent" means that the two substituents involved can be on the same ring next to each other, or on two neighboring rings having the two closest available substitutable positions, such as 2, 2' positions in a biphenyl, or 1, 8 position in a naphthalene.

Layers, materials, regions, and devices may be described herein in reference to the color of light they emit. In general, as used herein, an emissive region that is described as producing a specific color of light may include one or more emissive layers disposed over each other in a stack.

As used herein, a "red" layer, material, region, or device refers to one that emits light in the range of about 580-700nm or having a highest peak in its emission spectrum in that region. Similarly, a "green" layer, material, region, or device refers to one that emits or has an emission spectrum with a peak wavelength in the range of about 500-600nm; a "blue" layer, material, or device refers to one that emits or has an emission spectrum with a peak wavelength in the range of about 400-500nm; and a "yellow" layer, material, region, or device refers to one that has an emission spectrum with a peak wavelength in the range of about 540-600nm. In some arrangements, separate regions, layers, materials, regions, or devices may provide separate "deep blue" and a "light blue" light. As used herein, in arrangements that provide separate "light blue" and "deep blue", the "deep blue" component refers to one having a peak emission wavelength that is at least about 4nm less than the peak emission wavelength of the "light blue" component. Typically, a "light blue" component has a peak emission wavelength in the range of about 465-500nm, and a "deep blue" component has a peak emission wavelength in the range of about 400-470nm, though these ranges may vary for some configurations. Similarly, a color altering layer refers to a layer that converts or modifies another color of light to light having a wavelength as specified for that color. For example, a "red" color filter refers to a filter that results in light having a wavelength in the range of about 580-700nm. In general, there are two classes of color altering layers: color filters that modify a spectrum by removing unwanted wavelengths of light, and color changing layers that convert photons of higher energy to lower energy. A component "of a color" refers to a component that, when activated or used, produces or otherwise emits light having a particular color as previously described. For example, a "first emissive region of a first color" and a "second emissive region of a second color different than the first color" describes two emissive regions that, when activated within a device, emit two different colors as previously described.

As used herein, emissive materials, layers, and regions may be distinguished from one another and from other structures based upon light initially generated by the material, layer or region, as opposed to light eventually emitted by the same or a different structure. The initial light generation typically is the result of an energy level change resulting in emission of a photon. For example, an organic emissive material may initially generate blue light, which may be converted by a color filter, quantum dot or other structure to red or green light, such that a complete emissive stack or sub-pixel emits the red or green light. In this case the initial emissive material or layer may be referred to as a "blue" component, even though the sub-pixel is a "red" or "green" component.

In some cases, it may be preferable to describe the color of a component such as an emissive region, sub-pixel, color altering layer, or the like, in terms of 1931 CIE coordinates. For example, a yellow emissive material may have multiple peak emission wavelengths, one in or near an edge of the "green" region, and one within or near an edge of the "red" region as previously described. Accordingly, as used herein, each color term also corresponds to a shape in the 1931 CIE coordinate color space. The shape in 1931 CIE color space is constructed by following the locus between two color points and any additional interior points. For example, interior shape parameters for red, green, blue, and yellow may be defined as shown below:

| **Color** | **CIE Shape Parameters** |
|---|---|
| Central Red | Locus: [0.6270,0.3725];[0.7347,0.2653]; |
| | Interior: [0.5086,0.2657] |
| Central Green | Locus: [0.0326,0.3530];[0.3731,0.6245]; |
| | Interior: [0.2268,0.3321 |
| Central Blue | Locus: [0.1746,0.0052];[0.0326,0.3530]; |
| | Interior: [0.2268,0.3321] |
| Central Yellow | Locus: [0.373 1,0.6245];[0.6270,0.3725]; |
| | Interior: [0.3700,0.4087];[0.2886,0.4572] |

More details on OLEDs, and the definitions described above, can be found in US Pat. No. 7,279,704, which is incorporated herein by reference in its entirety.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In general parlance in the art, a "sub-pixel" may refer to the emissive region, which may be a single-layer EML, a stacked device, or the like, in conjunction with any color altering layer that is used to modify the color emitted by the emissive region.

As used herein, the "emissive region" of a sub-pixel refers to any and all emissive layers, regions, and devices that are used initially to generate light for the sub-pixel. A sub-pixel also may include additional layers disposed in a stack with the emissive region that affect the color ultimately produced by the sub-pixel, such as color altering layers disclosed herein, though such color altering layers typically are not considered "emissive layers" as disclosed herein. An unfiltered sub-pixel is one that excludes a color modifying component such as a color altering layer, but may include one or more emissive regions, layers, or devices.

In some configurations, an "emissive region" may include emissive materials that emit light of multiple colors. For example, a yellow emissive region may include multiple materials that emit red and green light when each material is used in an OLED device alone. When used in a yellow device, the individual materials typically are not arranged such that they can be individually activated or addressed. That is, the "yellow" OLED stack containing the materials cannot be driven to produce red, green, or yellow light; rather, the stack can be driven as a whole to produce yellow light. Such an emissive region may be referred to as a yellow emissive region even though, at the level of individual emitters, the stack does not directly produce yellow light. As described in further detail below, the individual emissive materials used in an emissive region (if more than one), may be placed in the same emissive layer within the device, or in multiple emissive layers within an OLED device comprising an emissive region. As described in further detail below, embodiments disclosed herein may allow for OLED devices such as displays that include a limited number of colors of emissive regions, while including more colors of sub-pixels or other OLED devices than the number of colors of emissive regions. For example, a device as disclosed herein may include only blue and yellow emissive regions. Additional colors of sub-pixels may be achieved by the use of color altering layers, such as color altering layers disposed in a stack with yellow or blue emissive regions, or more generally through the use of color altering layers, electrodes or other structures that form a microcavity as disclosed herein, or any other suitable configuration. In some cases, the general color provided by a sub-pixel may be the same as the color provided by the emissive region in the stack that defines the sub-pixel, such as where a deep blue color altering layer is disposed in a stack with a light blue emissive region to produce a deep blue sub-pixel. Similarly, the color provided by a sub-pixel may be different than the color provided by an emissive region in the stack that defines the sub-pixel, such as where a green color altering layer is disposed in a stack with a yellow emissive region to product a green sub-pixel.

In some configurations, emissive regions and/or emissive layers may span multiple sub-pixels, such as where additional layers and circuitry are fabricated to allow portions of an emissive region or layer to be separately addressable.

An emissive region as disclosed herein may be distinguished from an emissive "layer" as typically referred to in the art and as used herein. In some cases, a single emissive region may include multiple layers, such as where a yellow emissive region is fabricated by sequentially red and green emissive layers to form the yellow emissive region. As previously described, when such layers occur in an emissive region as disclosed herein, the layers are not individually addressable within a single emissive stack; rather, the layers are activated or driven concurrently to produce the desired color of light for the emissive region. In other configurations, an emissive region may include a single emissive layer of a single color, or multiple emissive layers of the same color, in which case the color of such an emissive layer will be the same as, or in the same region of the spectrum as, the color of the emissive region in which the emissive layer is disposed.

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

The initial OLEDs used emissive molecules that emitted light from their singlet states ("fluorescence") as disclosed, for example, in U.S. Pat. No. 4,769,292, which is incorporated by reference in its entirety. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"), are incorporated by reference in their entireties. Phosphorescence is described in more detail in US Pat. No. 7,279,704 at cols. 5-6, which are incorporated by reference.

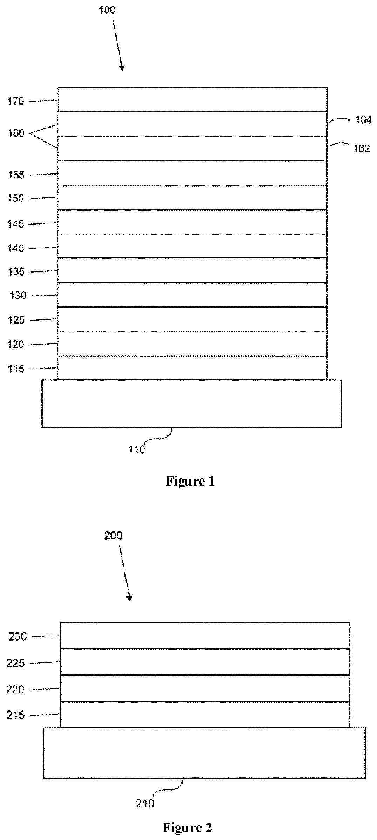

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with F₄-TCNQ at a molar ratio of 50:1, as disclosed in U.S. Patent Application Publication No. 2003/0230980, which is incorporated by reference in its entirety. Examples of emissive and host materials are disclosed in U.S. Pat. No. 6,303,238 to Thompson et al., which is incorporated by reference in its entirety. An example of an n-doped electron transport layer is BPhen doped with Li at a molar ratio of 1:1, as disclosed in U.S. Patent Application Publication No. 2003/0230980, which is incorporated by reference in its entirety. U.S. Pat. Nos. 5,703,436 and 5,707,745, which are incorporated by reference in their entireties, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980, which are incorporated by reference in their entireties. Examples of injection layers are provided in U.S. Patent Application Publication No. 2004/0174116, which is incorporated by reference in its entirety. Barrier layer 170 may be a single - or multilayer barrier and may cover or surround the other layers of the device. The barrier layer 170 may also surround the substrate 110, and/or it may be arranged between the substrate and the other layers of the device. The barrier also may be referred to as an encapsulant, encapsulation layer, protective layer, or permeation barrier, and typically provides protection against permeation by moisture, ambient air, and other similar materials through to the other layers of the device. Examples of barrier layer materials and structures are provided in U.S. Patent Nos. 6,537,688, 6,597,111, 6,664,137, 6,835,950, 6,888,305, 6,888,307, 6,897,474, 7,187,119, and 7,683,534, each of which is incorporated by reference in its entirety.

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the invention may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al., which is incorporated by reference in its entirety. By way of further example, OLEDs having a single organic layer may be used. OLEDs may be stacked, for example as described in U.S. Pat. No. 5,707,745 to Forrest et al, which is incorporated by reference in its entirety. The OLED structure may deviate from the simple layered structure illustrated in FIGS. 1 and 2. For example, the substrate may include an angled reflective surface to improve outcoupling, such as a mesa structure as described in U.S. Pat. No. 6,091,195 to Forrest et al., and/or a pit structure as described in U.S. Pat. No. 5,834,893 to Bulovic et al., which are incorporated by reference in their entireties.

In some embodiments disclosed herein, emissive layers or materials, such as emissive layer 135 and emissive layer 220 shown in FIGS. 1-2, respectively, may include quantum dots. An "emissive layer" or "emissive material" as disclosed herein may include an organic emissive material and/or an emissive material that contains quantum dots or equivalent structures, unless indicated to the contrary explicitly or by context according to the understanding of one of skill in the art. In general, an emissive layer includes emissive material within a host matrix. Such an emissive layer may include only a quantum dot material which converts light emitted by a separate emissive material or other emitter, or it may also include the separate emissive material or other emitter, or it may emit light itself directly from the application of an electric current. Similarly, a color altering layer, color filter, upconversion, or downconversion layer or structure may include a material containing quantum dots, though such layer may not be considered an "emissive layer" as disclosed herein. In general, an "emissive layer" or material is one that emits an initial light based on an injected electrical charge, where the initial light may be altered by another layer such as a color filter or other color altering layer that does not itself emit an initial light within the device, but may re-emit altered light of a different spectra content based upon absorption of the initial light emitted by the emissive layer and downconversion to a lower energy light emission. In some embodiments disclosed herein, the color altering layer, color filter, upconversion, and/or downconversion layer may be disposed outside of an OLED device, such as above or below an electrode of the OLED device.

Unless otherwise specified, any of the layers of the various embodiments may be deposited by any suitable method. For the organic layers, preferred methods include thermal evaporation, ink jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVJP), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. No s. 6,294,398 and 6,468,819, which are incorporated by reference in their entireties, and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processability than those having symmetric structures, because asymmetric materials may have a lower tendency to recrystallize. Dendrimer substituents may be used to enhance the ability of small molecules to undergo solution processing.

Devices fabricated in accordance with embodiments of the present invention may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829, which are herein incorporated by reference in their entireties. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

In some embodiments, at least one of the anode, the cathode, or a new layer disposed over the organic emissive layer functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. The enhancement layer is provided no more than a threshold distance away from the organic emissive layer, wherein the emitter material has a total non-radiative decay rate constant and a total radiative decay rate constant due to the presence of the enhancement layer and the threshold distance is where the total non-radiative decay rate constant is equal to the total radiative decay rate constant. In some embodiments, the OLED further comprises an outcoupling layer. In some embodiments, the outcoupling layer is disposed over the enhancement layer on the opposite side of the organic emissive layer. In some embodiments, the outcoupling layer is disposed on opposite side of the emissive layer from the enhancement layer but still outcouples energy from the surface plasmon mode of the enhancement layer. The outcoupling layer scatters the energy from the surface plasmon polaritons. In some embodiments this energy is scattered as photons to free space. In other embodiments, the energy is scattered from the surface plasmon mode into other modes of the device such as but not limited to the organic waveguide mode, the substrate mode, or another waveguiding mode. If energy is scattered to the non-free space mode of the OLED other outcoupling schemes could be incorporated to extract that energy to free space. In some embodiments, one or more intervening layer can be disposed between the enhancement layer and the outcoupling layer. The examples for interventing layer(s) can be dielectric materials, including organic, inorganic, perovskites, oxides, and may include stacks and/or mixtures of these materials.

The enhancement layer modifies the effective properties of the medium in which the emitter material resides resulting in any or all of the following: a decreased rate of emission, a modification of emission line - shape, a change in emission intensity with angle, a change in the stability of the emitter material, a change in the efficiency of the OLED, and reduced efficiency roll-off of the OLED device. Placement of the enhancement layer on the cathode side, anode side, or on both sides results in OLED devices which take advantage of any of the above-mentioned effects. In addition to the specific functional layers mentioned herein and illustrated in the various OLED examples shown in the figures, the OLEDs according to the present disclosure may include any of the other functional layers often found in OLEDs.

The enhancement layer can be comprised of plasmonic materials, optically active metamaterials, or hyperbolic metamaterials. As used herein, a plasmonic material is a material in which the real part of the dielectric constant crosses zero in the visible or ultraviolet region of the electromagnetic spectrum. In some embodiments, the plasmonic material includes at least one metal. In such embodiments the metal may include at least one of Ag, Al, Au, Ir, Pt, Ni, Cu, W, Ta, Fe, Cr, Mg, Ga, Rh, Ti, Ru, Pd, In, Bi, Ca alloys or mixtures of these materials, and stacks of these materials. In general, a metamaterial is a medium composed of different materials where the medium as a whole acts differently than the sum of its material parts. In particular, we define optically active metamaterials as materials which have both negative permittivity and negative permeability. Hyperbolic metamaterials, on the other hand, are anisotropic media in which the permittivity or permeability are of different sign for different spatial directions. Optically active metamaterials and hyperbolic metamaterials are strictly distinguished from many other photonic structures such as Distributed Bragg Reflectors ("DBRs") in that the medium should appear uniform in the direction of propagation on the length scale of the wavelength of light. Using terminology that one skilled in the art can understand: the dielectric constant of the metamaterials in the direction of propagation can be described with the effective medium approximation. Plasmonic materials and metamaterials provide methods for controlling the propagation of light that can enhance OLED performance in a number of ways.

In some embodiments, the enhancement layer is provided as a planar layer. In other embodiments, the enhancement layer has wavelength-sized features that are arranged periodically, quasi-periodically, or randomly, or sub-wavelength-sized features that are arranged periodically, quasi-periodically, or randomly. In some embodiments, the wavelength-sized features and the sub-wavelength-sized features have sharp edges.

In some embodiments, the outcoupling layer has wavelength-sized features that are arranged periodically, quasi-periodically, or randomly, or sub-wavelength-sized features that are arranged periodically, quasi-periodically, or randomly. In some embodiments, the outcoupling layer may be composed of a plurality of nanoparticles and in other embodiments the outcoupling layer is composed of a pluraility of nanoparticles disposed over a material. In these embodiments the outcoupling may be tunable by at least one of varying a size of the plurality of nanoparticles, varying a shape of the plurality of nanoparticles, changing a material of the plurality of nanoparticles, adjusting a thickness of the material, changing the refractive index of the material or an additional layer disposed on the plurality of nanoparticles, varying a thickness of the enhancement layer, and/or varying the material of the enhancement layer. The plurality of nanoparticles of the device may be formed from at least one of metal, dielectric material, semiconductor materials, an alloy of metal, a mixture of dielectric materials, a stack or layering of one or more materials, and/or a core of one type of material and that is coated with a shell of a different type of material. In some embodiments, the outcoupling layer is composed of at least metal nanoparticles wherein the metal is selected from the group consisting of Ag, Al, Au, Ir, Pt, Ni, Cu, W, Ta, Fe, Cr, Mg, Ga, Rh, Ti, Ru, Pd, In, Bi, Ca, alloys or mixtures of these materials, and stacks of these materials. The plurality of nanoparticles may have additional layer disposed over them. In some embodiments, the polarization of the emission can be tuned using the outcoupling layer. Varying the dimensionality and periodicity of the outcoupling layer can select a type of polarization that is preferentially outcoupled to air. In some embodiments the outcoupling layer also acts as an electrode of the device.

It is believed that the internal quantum efficiency (IQE) of fluorescent OLEDs can exceed the 25% spin statistics limit through delayed fluorescence. As used herein, there are two types of delayed fluorescence, i.e. P-type delayed fluorescence and E-type delayed fluorescence. P-type delayed fluorescence is generated from triplet-triplet annihilation (TTA).

On the other hand, E-type delayed fluorescence does not rely on the collision of two triplets, but rather on the thermal population between the triplet states and the singlet excited states. Compounds that are capable of generating E-type delayed fluorescence are required to have very small singlet-triplet gaps. Thermal energy can activate the transition from the triplet state back to the singlet state. This type of delayed fluorescence is also known as thermally activated delayed fluorescence (TADF). A distinctive feature of TADF is that the delayed component increases as temperature rises due to the increased thermal energy. If the reverse intersystem crossing rate is fast enough to minimize the non-radiative decay from the triplet state, the fraction of back populated singlet excited states can potentially reach 75%. The total singlet fraction can be 100%, far exceeding the spin statistics limit for electrically generated excitons.

E-type delayed fluorescence characteristics can be found in an exciplex system or in a single compound. Without being bound by theory, it is believed that E-type delayed fluorescence requires the luminescent material to have a small singlet-triplet energy gap (ΔES-T). Organic, non-metal containing, donor-acceptor luminescent materials may be able to achieve this. The emission in these materials is often characterized as a donor-acceptor charge-transfer (CT) type emission. The spatial separation of the HOMO and LUMO in these donor-acceptor type compounds often results in small ΔES-T. These states may involve CT states. Often, donor-acceptor luminescent materials are constructed by connecting an electron donor moiety such as amino- or carbazole-derivatives and an electron acceptor moiety such as N-containing six-membered aromatic ring.

Devices fabricated in accordance with embodiments of the invention can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the invention can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video walls comprising multiple displays tiled together, a theater or stadium screen, and a sign. Various control mechanisms may be used to control devices fabricated in accordance with the present invention, including passive matrix and active matrix. Many of the devices are intended for use in a temperature range comfortable to humans, such as 18 C to 30 C, and more preferably at room temperature (20-25 C), but could be used outside this temperature range, for example, from -40 C to 80 C.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

Boron triangulenes have been used as fluorescent acceptors in sensitized devices since their inception due to their narrow lineshapes and high emission efficiencies. The combinations of 5,9-dioxa-13b-boranaphtho[3,2,1-de]anthracene (OBO) type of hosts with phosphorescent sensitizers and fluorescent acceptors disclosed herein have not been disclosed. Such combinations may be of significant importance because the high mobility of the electron transporting host can aid in boosting recombination efficiency of excitons on the sensitizer to avoid the formation of triplets on the fluorescent acceptor.

In some aspects, an OLED comprising an anode; a cathode; and an emissive region disposed between the anode and the cathode are provided. The emissive region can include a first compound S1; a second compound A1; and a third compound H1. In some embodiments, the first compound S1 is capable of phosphorescent emission at room temperature and is a sensitizer that transfers energy to the second compound A1; the second compound A1 is an acceptor that is an emitter; and the third compound H1 is a first host comprising a boron atom, and at least one of the first compound S1 and the second compound A1 is doped in the third compound H1.In some embodiments, the present disclosure provides an organic light emitting device (OLED) comprising:
an anode;
a cathode; and
an emissive region disposed between the anode and the cathode;
wherein the emissive region comprises:
   a first compound S1;
   a second compound A1; and
   a third compound H1;
wherein the first compound S1 is capable of phosphorescent emission at room temperature and is a sensitizer that transfers energy to the second compound A1;
wherein the second compound A1 is an acceptor that is an emitter; and
wherein the third compound H1 is a first host comprising a boron atom, and at least one of the first compound S1 and the second compound A1 is doped in the third compound H1.

In some embodiments, the phosphorescent sensitizer is an emitter which emits light within the OLED. In some embodiments, the phosphorescent sensitizer does not emit light within the OLED. In some embodiments, the acceptor is the fluorescence material or the delayed fluorescence material which emits light within the OLED.

In some embodiments, the OLED may comprise an additional compound selected from the group consisting of a fluorescence material, a delayed fluorescence material, a phosphorescent material, and combination thereof.

In some embodiments, the first compound S1 is capable of functioning as a TADF emitter in an OLED at room temperature.

In some embodiments, the first compound S1 forms an exciplex with the third compound H1 in said OLED at room temperature.

In some embodiments, the second compound A1 is a delayed-fluorescent compound functioning as a TADF emitter in said OLED at room temperature.

In some embodiments, the second compound A1 is a fluorescent compound functioning as an emitter in said OLED at room temperature.

In some embodiments, at least two of the first, second, and the third compounds are present in one layer as a mixture.

In some embodiments, the first compound S1 is partially or fully deuterated. In some embodiments, the second compound A1 is partially or fully deuterated. In some embodiments, the third compound H1 is partially or fully deuterated.

In some embodiments, the third compound H1 has a structure selected from the group consisting of the structures of the following LIST A: 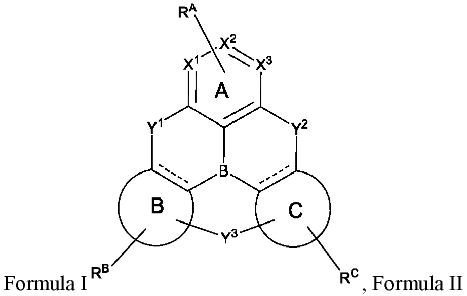 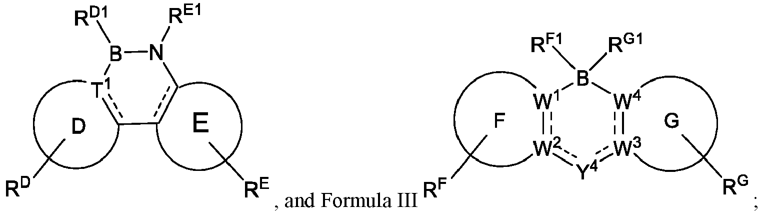 wherein:
rings B, C, D, E, F, and G are each independently a 5-membered or 6-membered carbocyclic or heterocyclic ring;
Y¹, Y², Y³, and Y⁴ are each independently absent or are selected from the group consisting of BR, BRR', NR, PR, P(O)R, O, S, Se, C=O, C=S, C=Se, C=NR, C=CRR', S=O, SO₂, CR, CRR', SiRR', GeRR', alkylene, cycloalkyl, aryl, cycloalkylene, arylene, heteroarylene, and combinations thereof;
each of X¹, X², and X³ is independently C or N;
T¹ is CorN;
each of W¹, W², W³, and W⁴ is independently C or N;
each - - - - - - - is independently a single bond or a double bond;
each of R^{A}, R^{B}, R^{C}, R^{D}, R^{E}, R^{F}, and R^{G} independently represents mono, or up to a maximum allowed substitutions, or no substitutions;
each R, R', R^{D1}, R^{E1}, R^{F1}, R^{G1}, R^{A}, R^{B}, R^{C}, R^{D}, R^{E}, R^{F}, and R^{G} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and
any two substituents can be joined or fused to form a ring.

In some embodiments, each R, R', R^{D1}, R^{E1}, R^{F1}, R^{G1}, R^{A}, R^{B}, R^{C}, R^{D}, R^{E}, R^{F}, and R^{G} is independently a hydrogen or a substituent selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

In some embodiments that comprises a third compound H1 having structure selected from the group consisting of the structures of LIST A, each of rings B, C, D, E, F, and G is independently selected from the group consisting of benzene, pyridine, pyrimidine, pyridazine, pyrazine, triazine, imidazole, pyrazole, pyrrole, oxazole, furan, thiophene, thiazole, and triazole.

In some embodiments, the third compound H1 has a structure of Formula I.

In some embodiments where the third compound H1 has a structure of Formula I, ring B is benzene.

In some embodiments where the third compound H1 has a structure of Formula I, ring C is benzene.

In some embodiments where the third compound H1 has a structure of Formula I, each of X¹ to X³ is C.

In some embodiments where the third compound H1 has a structure of Formula I, at least one of X¹ to X³ is N.

In some embodiments where the third compound H1 has a structure of Formula I, Y¹ and Y² are both O.

In some embodiments where the third compound H1 has a structure of Formula I, Y¹ and Y² are both NR', where R' is as defined above.

In some embodiments where the third compound H1 has a structure of Formula I, Y¹ is O and Y² is NR', where R' is as defined above.

In some embodiments, the third compound H1 has a structure of Formula II.

In some embodiments where the third compound H1 has a structure of Formula II, T¹ is N.

In some embodiments where the third compound H1 has a structure of Formula II, both ring D and ring E are 6-membered aromatic rings.

In some embodiments where the third compound H1 has a structure of Formula II, one of ring D and ring E is a 6-membered aromatic ring while the other is a 5-membered aromatic ring.

In some embodiments where the third compound H1 has a structure of Formula II, ring D is benzene or pyridine, and ring E is benzene or pyridine.

In some embodiments where the third compound H1 has a structure of Formula II, both ring D and ring E are benzene.

In some embodiments, the third compound H1 has a structure of Formula III.

In some embodiments where the third compound H1 has a structure of Formula III, each of W¹ to W⁴ is C.

In some embodiments where the third compound H1 has a structure of Formula III, at least one of W¹ to W⁴ is N.

In some embodiments where the third compound H1 has a structure of Formula III, exactly one of W¹ to W⁴ is N.

In some embodiments where the third compound H1 has a structure of Formula III, exactly two of W¹ to W⁴ are N.

In some embodiments where the third compound H1 has a structure of Formula III, both ring F and ring G are 6-membered aromatic rings.

In some embodiments where the third compound H1 has a structure of Formula III, one of ring F and ring G is a 6-memebred aromatic ring while the other is a 5-membered aromatic ring. In some embodiments, ring G is benzene or pyridine, and ring F is benzene or pyridine. In some embodiments, one of ring F and ring G is benzene, and the other is pyridine. In some embodiments, both ring F and ring G are benzene. In some embodiments, both ring F and ring G are pyridine.

In some embodiments comprising a third compound H1 of LIST A, at least one of R, R', R^{D1}, R^{E1}, R^{F1}, R^{G1}, R^{A}, R^{B}, R^{C}, R^{D}, R^{E}, R^{F}, and R^{G} is present and comprises a moiety selected from the group consisting of silyl, germyl, tetraphenylene, benzene, pyridine, pyrimidine, pyridazine, pyrazine, triazine, imidazole, pyrazole, pyrrole, oxazole, furan, thiophene, thiazole, triazole, dibenzothiophene, dibenzofuran, dibenzoseleonphene, carbazole, azadibenzothiophene, azadibenzofuran, 5λ²-benzo[*d*]benzo[4,5]imidazo[3,2-*a*]imidazole, azadibenzoseleonphene, and partially or fully deuterated variations thereof.

In some embodiments, the third compound H1 has a structure selected from the group consisting of the structures of the following LIST 1: 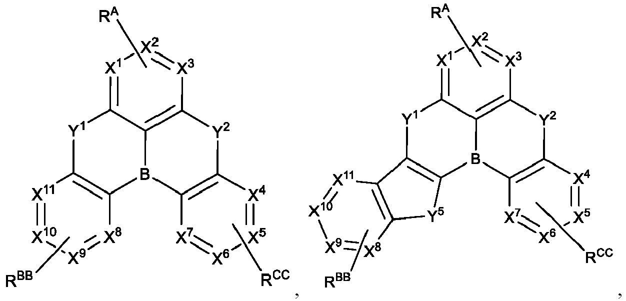 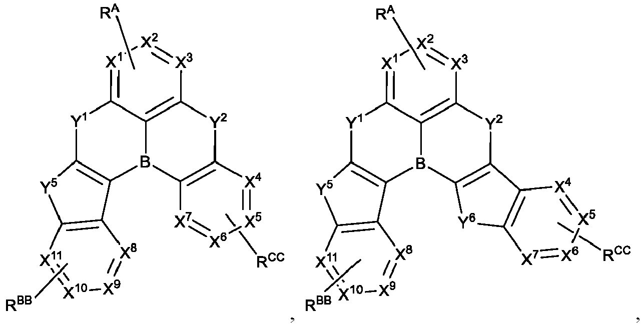 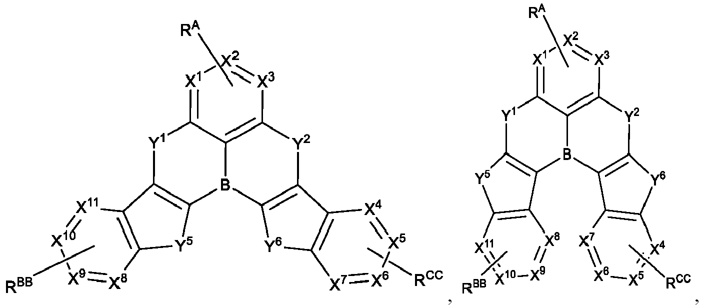 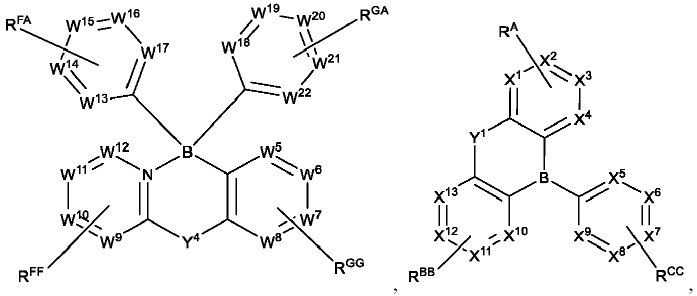 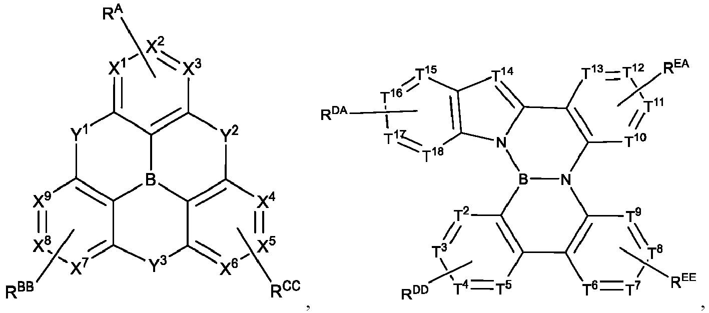 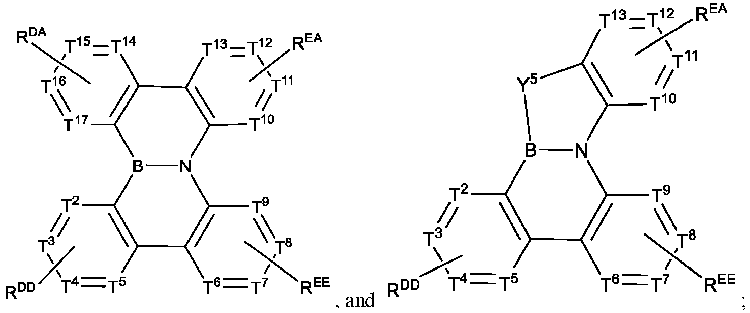 wherein:
each of X⁴ to X¹³ is independently C or N;
each of T² to T¹⁸ is independently C or N;
each of W⁵ to W²² is independently C or N;
Y⁵ and Y⁶ are each independently selected from the group consisting of BR, BRR', NR, PR, P(O)R, O, S, Se, C=O, C=S, C=Se, C=NR', C=CRR, S=O, SO₂, CRR', SiRR', and GeRR';
each of R^{BB}, R^{CC}, R^{DD}, R^{DA}, R^{EE}, R^{EA}, R^{FF}, R^{FA}, R^{GG}, and R^{GA} independently represents mono, or up to a maximum allowed substitutions, or no substitutions;
each R, R', R^{BB}, R^{CC}, R^{DD}, R^{DA}, R^{EE}, R^{EA}, R^{FF}, R^{FA}, R^{GG}, and R^{GA} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and
any two substitutions can be joined or fused to form a ring.

In some embodiments having a third compound H1 selected from the structures of LIST 1, each R^{BB}, R^{CC}, R^{DD}, R^{DA}, R^{EE}, R^{EA}, R^{FF}, R^{FA}, R^{GG}, and R^{GA} is independently a hydrogen or a substituent selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

In some embodiments having a third compound H1 selected from the structures of LIST 1, each R^{BB}, R^{CC}, R^{DD}, R^{DA}, R^{EE}, R^{EA}, R^{FF}, R^{FA}, R^{GG}, and R^{GA} is independently a hydrogen or a substituent selected from the group consisting of deuterium, phenyl, biphenyl, pyridine, pyrimidine, triazine, pyrazine, imidazole, pyrazole, pyrrole, oxazole, furan, thiophene, thiazole, dibenzothiophene, dibenzofuran, dibenzoseleonphene, carbazole, azadibenzothiophene, azadibenzofuran, azadibenzoseleonphene, azacarbazole, 5λ²-benzo[*d*]benzo[4,5]imidazo[3,2-*a*]imidazole, aza-5λ²-benzo[*d*]benzo [4,5]imidazo[3,2-*a*]imidazole, biscarbazole, silyl, boryl, partially or fully deuterated variations thereof, and combinations thereof.

In some embodiments having a third compound H1 selected from the structures of LIST 1, each R^{A}, R^{BB}, and R^{CC} is independently a hydrogen or a deuterium.

In some embodiments having a third compound H1 selected from the structures of LIST 1, each of X¹ to X¹³ is C.

In some embodiments having a third compound H1 selected from the structures of LIST 1, at least one of X¹ to X¹³ is N.

In some embodiments having a third compound H1 selected from the structures of LIST 1, no two substituents are joined or fused to form a ring.

In some embodiments having a third compound H1 selected from the structures of LIST 1, each of T² to T¹⁸ that is present is C.

In some embodiments having a third compound H1 selected from the structures of LIST 1, at least one of T² to T¹⁸ that is present is N.

In some embodiments having a third compound H1 selected from the structures of LIST 1, exactly one of T² to T¹⁸ that is present is N.

In some embodiments having a third compound H1 selected from the structures of LIST 1, one of T² to T⁵ that is present is N.

In some embodiments having a third compound H1 selected from the structures of LIST 1, one of T⁶ to T⁹ that is present is N.

In some embodiments having a third compound H1 selected from the structures of LIST 1, one of T¹⁰ to T¹³ that is present is N.

In some embodiments having a third compound H1 selected from the structures of LIST 1, T¹⁴ is present and is N.

In some embodiments having a third compound H1 selected from the structures of LIST 1, one of T¹⁵ to T¹⁸ that is present and is N.

In some embodiments having a third compound H1 selected from the structures of LIST 1, each of W⁵ to W²² that is present is C.

In some embodiments having a third compound H1 selected from the structures of LIST 1, at least one of W⁵ to W²² that is present and is N.

In some embodiments having a third compound H1 selected from the structures of LIST 1, exactly one of W⁵ is W²² that is present is N.

In some embodiments having a third compound H1 selected from the structures of LIST 1, one of W⁵ to W⁸ that is present is N.

In some embodiments having a third compound H1 selected from the structures of LIST 1, one of W⁹ to W¹² that is present is N.

In some embodiments having a third compound H1 selected from the structures of LIST 1, one of W¹³ to W¹⁷ that is present is N.

In some embodiments having a third compound H1 selected from the structures of LIST 1, one of W¹⁸ is W²² that is present is N.

In some embodiments, the third compound H1 has a structure selected from the group consisting of the structures of the following LIST 2: 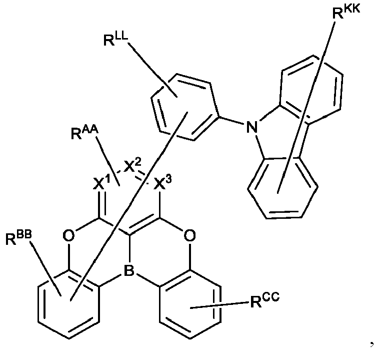 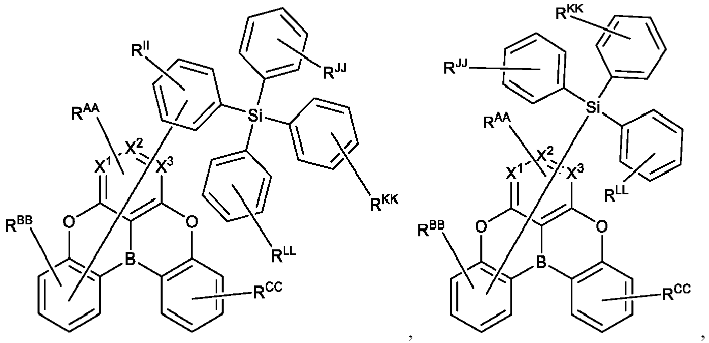 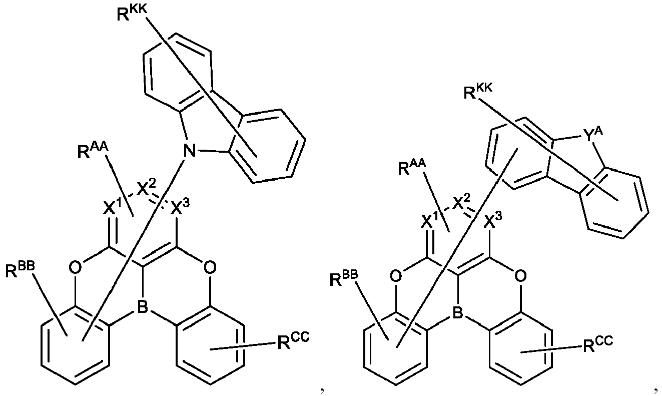 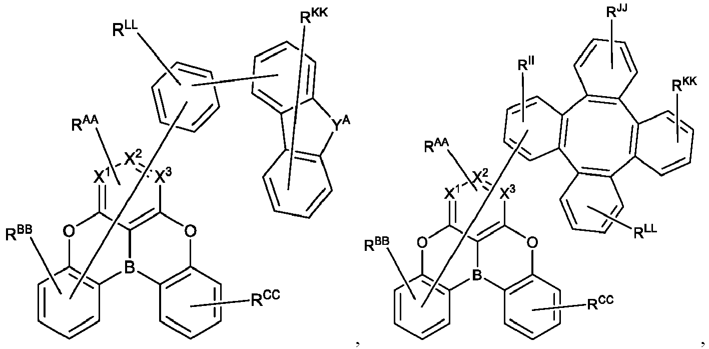 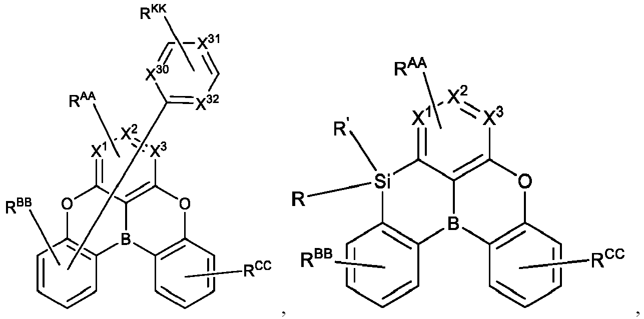 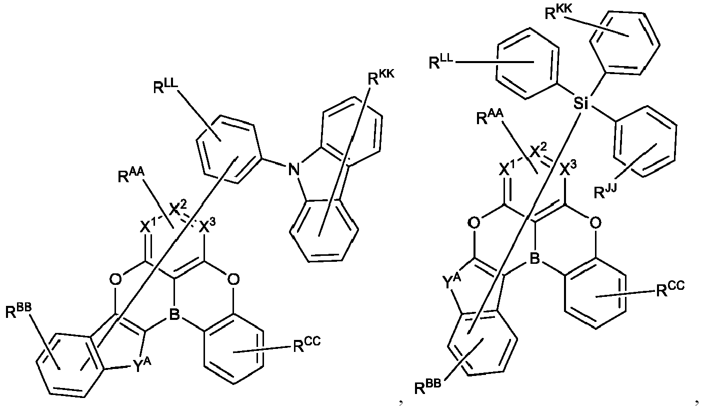 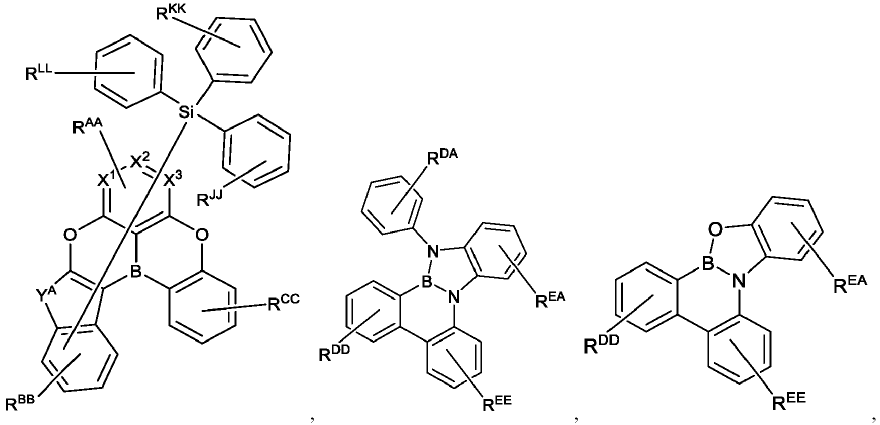 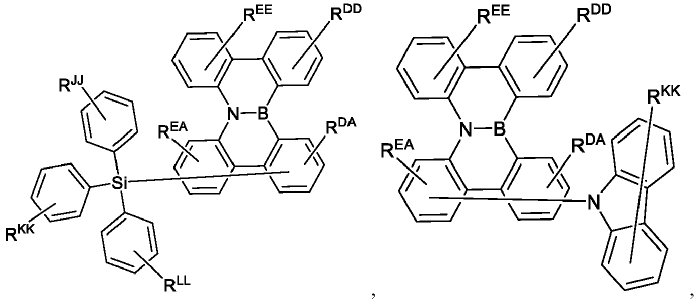 and 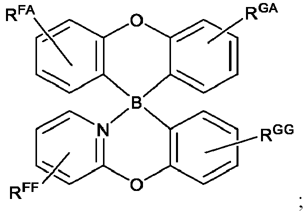 wherein:
each of X³⁰, X³¹, and X³² is independently C or N;
each Y^{A} is independently selected from the group consisting of BR, BRR', NR, PR, P(O)R, O, S, Se, C=O, C=S, C=Se, C=NR', C=CRR, S=O, SO₂, CRR', SiRR', and GeRR';
each of R^{AA}, R^{BB}, R^{CC}, R^{DD}, R^{DA}, R^{EE}, R^{EA}, R^{JJ}, R^{KK}, and R^{LL} independently represents mono, up to the maximum substitutions, or no substitutions;
each of R, R', R^{AA}, R^{BB}, R^{CC}, R^{DD}, R^{DA}, R^{EE}, R^{EA}, R^{II}, R^{JJ}, R^{KK}, and R^{LL} is independently a hydrogen or a substituent selected from the group consisting of deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, germyl, selenyl, and combinations thereof; and
any two adjacent substituents can be joined or fused to form a ring.

In some embodiments having a third compound H1 selected from the structures of LIST 2, each R^{AA}, R^{BB}, R^{CC}, R^{DD}, R^{DA}, R^{EE}, R^{EA}, R^{FF}, R^{FA}, R^{GG}, and R^{GA} is independently a hydrogen or a substituent selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

In some embodiments having a third compound H1 selected from the structures of LIST 2, each R^{AA}, R^{BB}, R^{CC}, R^{DD}, R^{DA}, R^{EE}, R^{EA}, R^{FF}, R^{FA}, R^{GG}, and R^{GA} is independently a hydrogen or a substituent selected from the group consisting of deuterium, phenyl, biphenyl, pyridine, pyrimidine, triazine, pyrazine, imidazole, pyrazole, pyrrole, oxazole, furan, thiophene, thiazole, dibenzothiophene, dibenzofuran, dibenzoseleonphene, carbazole, azadibenzothiophene, azadibenzofuran, azadibenzoseleonphene, azacarbazole, 5λ2-benzo[*d*]benzo[4,5]imidazo[3,2-*a*]imidazole, aza-5λ²-benzo[*d*]benzo[4,5]imidazo[3,2-*a*]imidazole, biscarbazole, silyl, boryl, partially or fully deuterated variations thereof, and combinations thereof.

In some embodiments having a third compound H1 selected from the structures of LIST 2, at least one of R^{AA}, R^{BB}, R^{CC}, R^{DD}, R^{DA}, R^{EE}, R^{EA}, R^{FF}, R^{FA}, R^{GG}, and R^{GA} is present and is not hydrogen.

In some embodiments having a third compound H1 selected from the structures of LIST 2, at least one of X¹-X³ is N. In some of the above embodiments, each of X¹-X³ is independently C. In some of the above embodiments, X¹ is N.

In some embodiments, the third compound H1 has a structure selected from the group consisting of the structures of the following LIST 3: 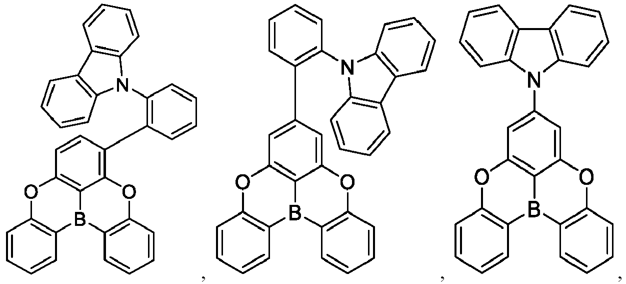 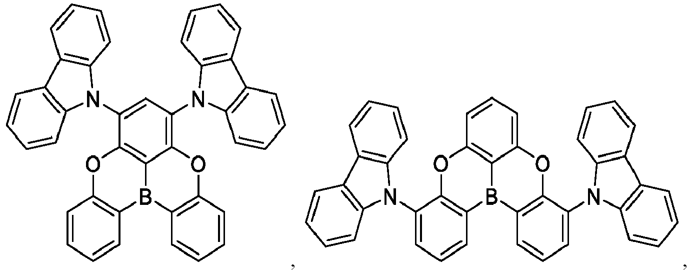 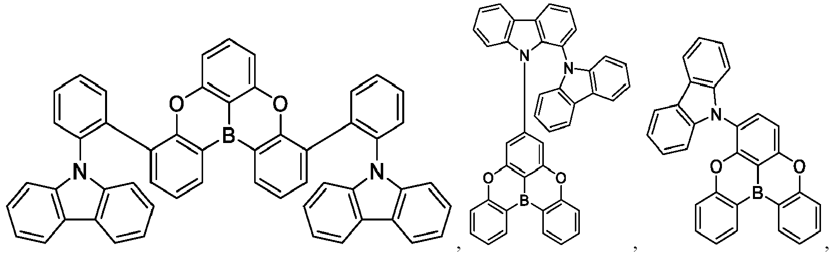 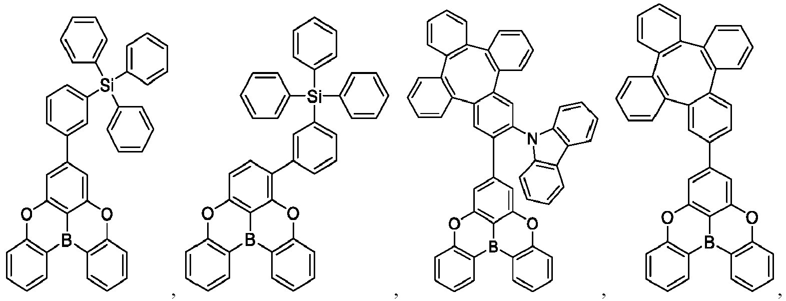 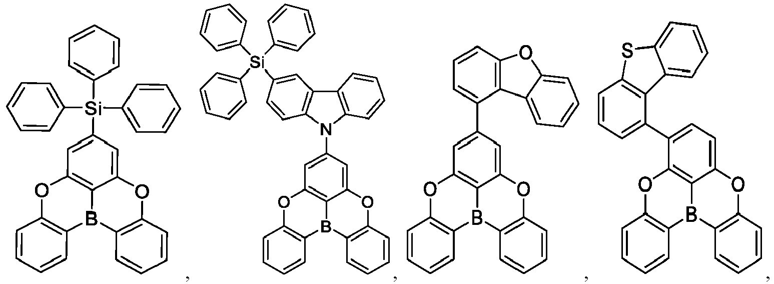 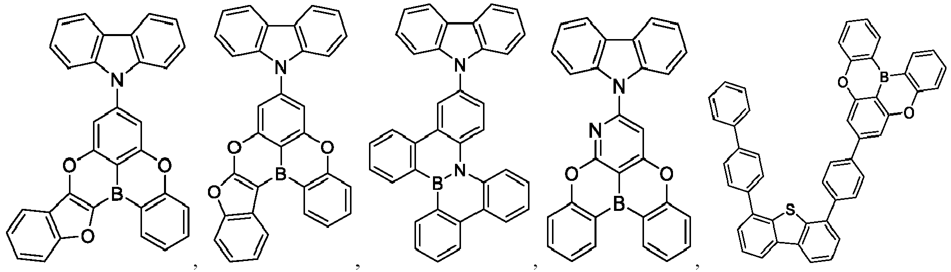 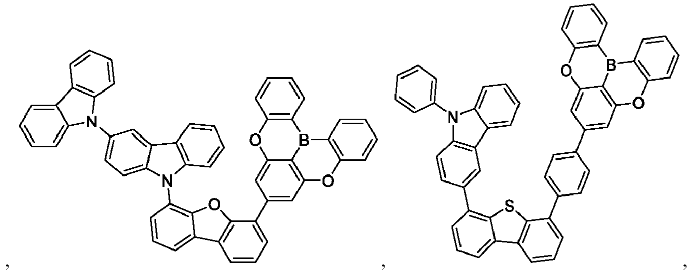 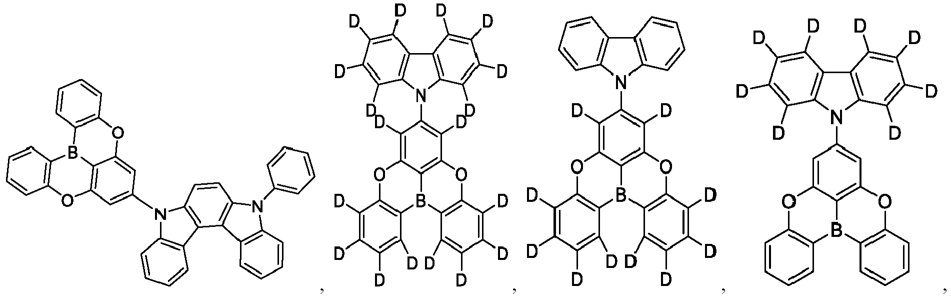 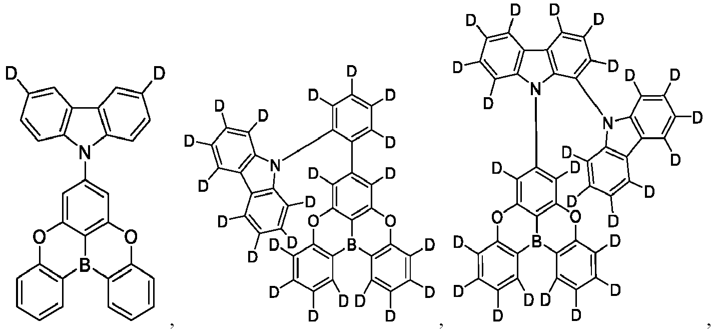 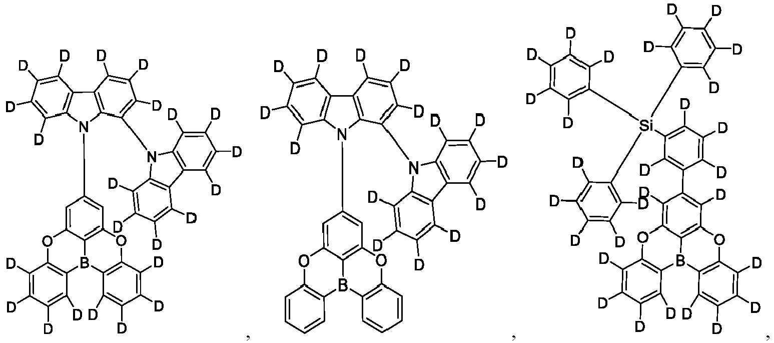 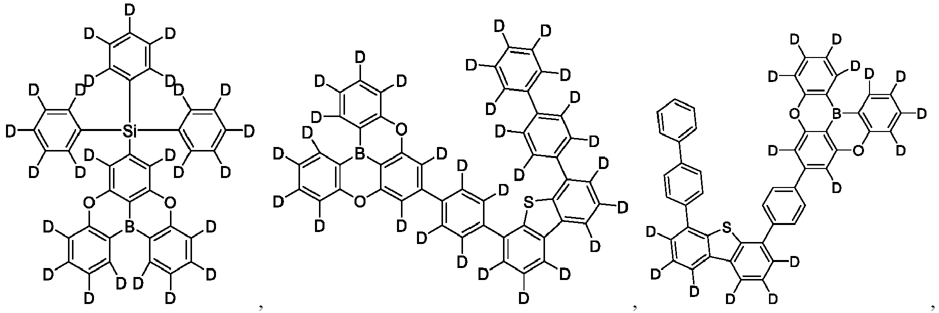 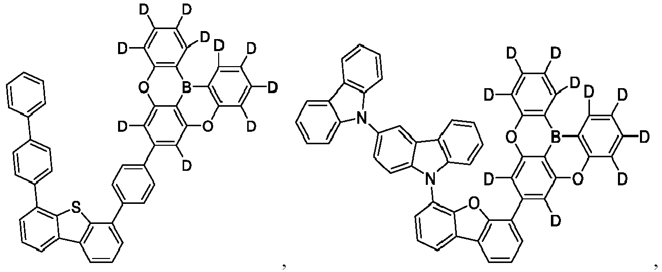 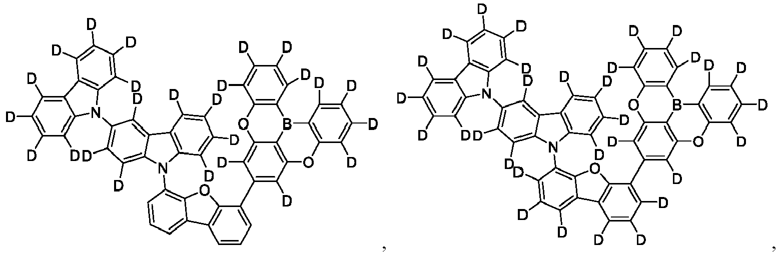 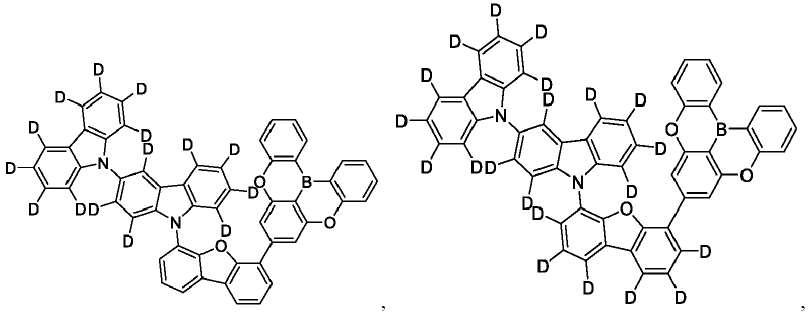 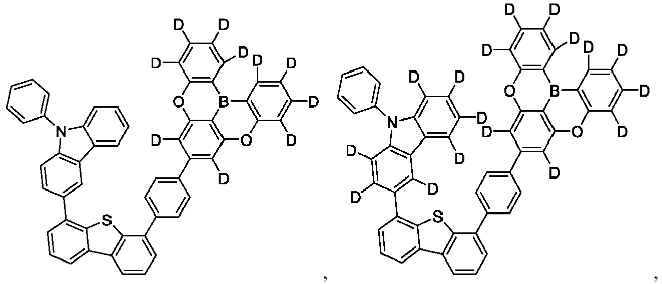 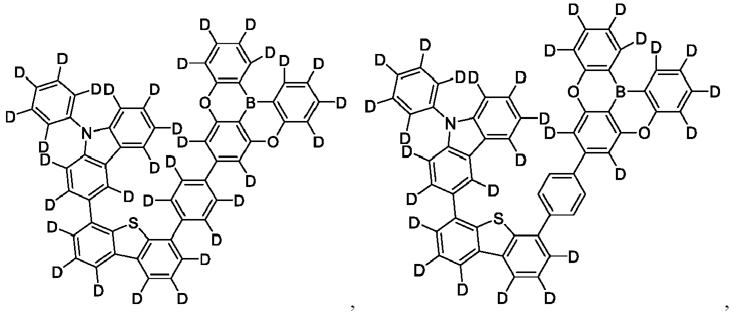 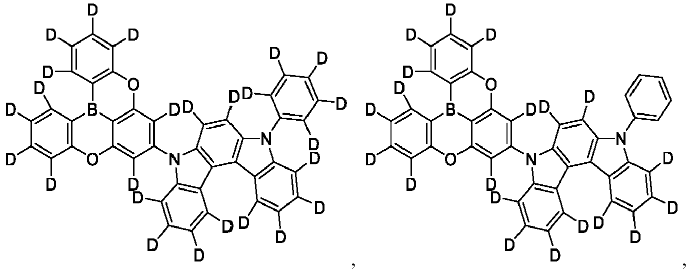 and

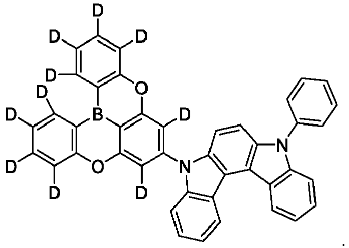

In some embodiments, the first compound S1 and the second compound A1 are in separate layers within the emissive region.

In some embodiments, the first, second, and third compounds are present as a mixture in the emissive region.

In some embodiments, the emissive region contains *N* layers where *N* > 2.

In some embodiments, the first compound S 1 is contained in each of the *N* layers, the second compound A1 is contained in less than or equal to *N*-1 layers.

In some embodiments, the second compound A1 is contained within less than or equal to *N*/2 layers.

In some embodiments, the first and second compounds are not in the same layer.

In some embodiments, the layers which contain the second compound A1 comprise a fourth compound which is not contained in layers with the first compound S1.

In some embodiments, two or more layers contain the second compound A1; wherein the concentrations of the second compound A1 in at least two of the two or more layers are different.

In some embodiments, the OLED emits a luminescent emission comprising an emission component from the S₁ energy of the second compound A1 when a voltage is applied across the OLED.

In some embodiments, at least 65% of the emission from the OLED is produced from the second compound A1 with a luminance of at least 10 cd/m². In some embodiments, at least 75% of the emission from the OLED is produced from the second compound A1 with a luminance of at least 10 cd/m². In some embodiments, at least 85% of the emission from the OLED is produced from the second compound A1 with a luminance of at least 10 cd/m². In some embodiments, at least 95% of the emission from the OLED is produced from the second compound A1 with a luminance of at least 10 cd/m².

In some embodiments, a T₁ energy (*i.e*., first triplet energy) of the third compound H1 is higher than the T₁ energies of the first and the second compounds.

In some embodiments, an S₁ energy (*i.e.,* first singlet energy) of the second compound A1 is lower than the S₁ energies of the first and the third compounds.

In some embodiments, an S₁-T₁ energy gap of the first compound S1 is less than 300 meV. In some embodiments, an S₁-T₁ energy gap of the first compound S 1 is less than 250 meV. In some embodiments, an S₁-T₁ energy gap of the first compound S 1 is less than 200 meV. In some embodiments, an S₁-T₁ energy gap of the first compound S1 is less than 150 meV. In some embodiments, an S₁-T₁ energy gap of the first compound S1 is less than 100 meV.

In some embodiments, an S₁-T₁ energy gap of the second compound A1 is less than 300 meV. In some embodiments, an S₁-T₁ energy gap of the second compound A1 is less than 250 meV. In some embodiments, an S₁-T₁ energy gap of the second compound A1 is less than 200 meV. In some embodiments, an S₁-T₁ energy gap of the second compound A1 is less than 150 meV. In some embodiments, an S₁-T₁ energy gap of the second compound A1 is less than 100 meV.

In some embodiments, the second compound A1 has a Stokes shift of 30 nm or less.

In some embodiments, the first compound S1 has a maximum emission wavelength λₘₐₓ₁ in a monochromic OLED having the third compound H1 as the host at room temperature; wherein the second compound A1 has a maximum emission wavelength λₘₐₓ₂ in the monochromic OLED by replacing the first compound S1 with the second compound A1; wherein Δλ = λₘₐₓ₁ - λₘₐₓ₂; and wherein Δλ is equal to or less than 15 nm. In some such embodiments, Δλ is equal to or less than 12 nm, or 10 nm, or 8 nm, or 6 nm, or 4 nm, or 2 nm, or 0 nm, or -2 nm, or -4 nm, or -6 nm, or -8 nm, or -10 nm.

In some embodiments, the first compound S1 is capable of functioning as a phosphorescent emitter in an OLED at room temperature. In some embodiments, the first compound S1 is capable of emitting light from a triplet excited state to a ground singlet state in an OLED at room temperature. In some such embodiments, the emitted light is blue light. In some such embodiments, the emitted light is red light. In some such embodiments, the emitted light is green light.

In some embodiments, the first compound S1 is a metal coordination complex having a metal-carbon bond. In some embodiments, the first compound S1 is a metal coordination complex having a metal-nitrogen bond. In some embodiments, the first compound S1 is a metal coordination complex having a metal-oxygen bond.

In some embodiments, the first compound S1 is a metal coordination complex and the metal is selected from the group consisting of Ir, Rh, Re, Ru, Os, Pt, Pd, Au, Zn, Ag, and Cu. In some such embodiments, the metal is Ir. In some such embodiments, the metal is Pt. In some embodiments, the first compound S1 has the formula of M(L¹)ₓ(L^{Z})_{y}(L³)_{z},
wherein L¹, L², and L³ can be the same or different;
wherein x is 1, 2, or 3;
wherein y is 0, 1, or 2;
wherein z is 0, 1, or 2;
wherein x+y+z is the oxidation state of the metal M;
wherein L¹ is selected from the group consisting of the structures of the following LIST 4: 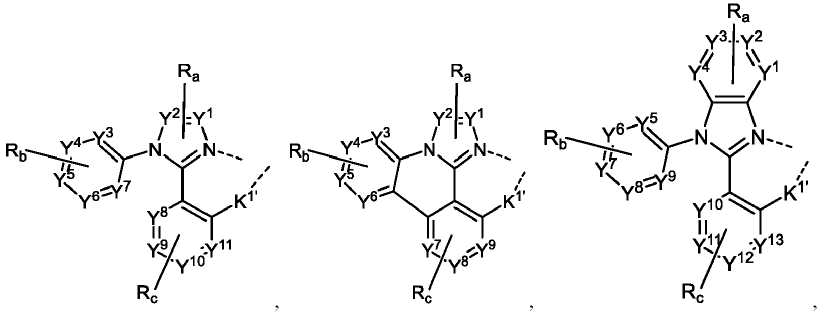 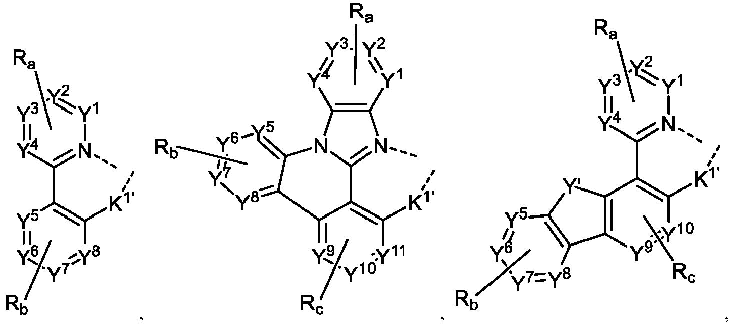 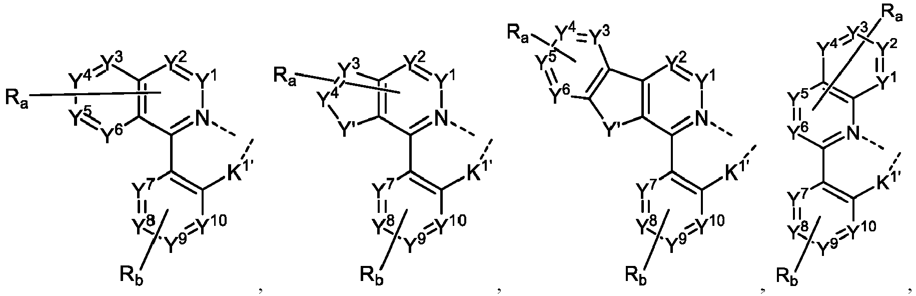 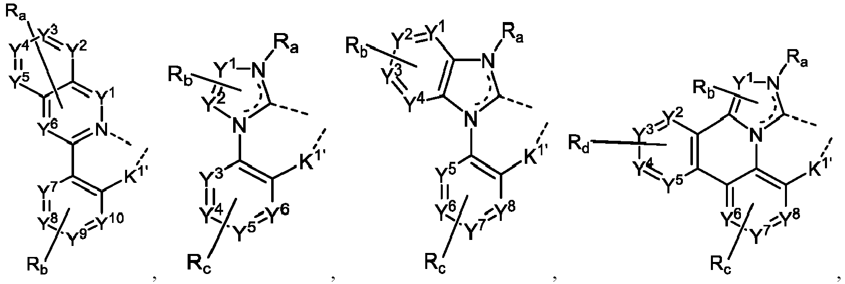 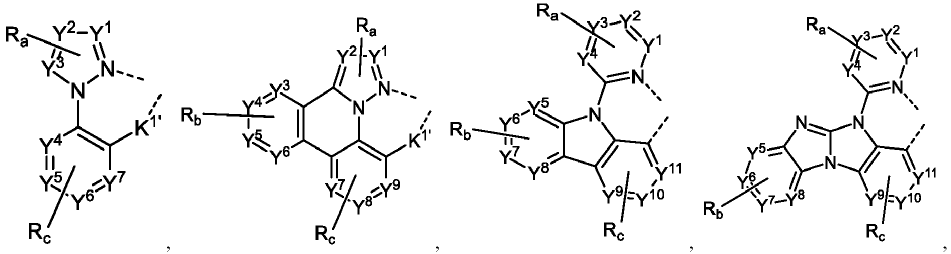 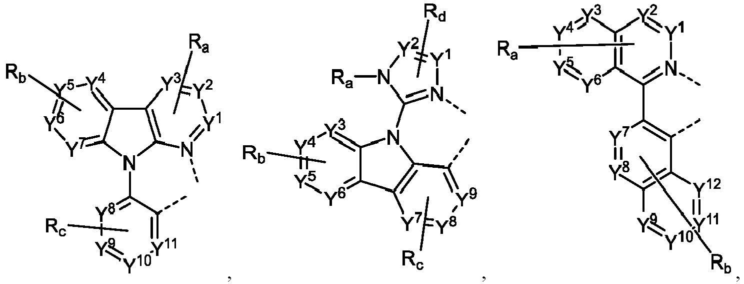 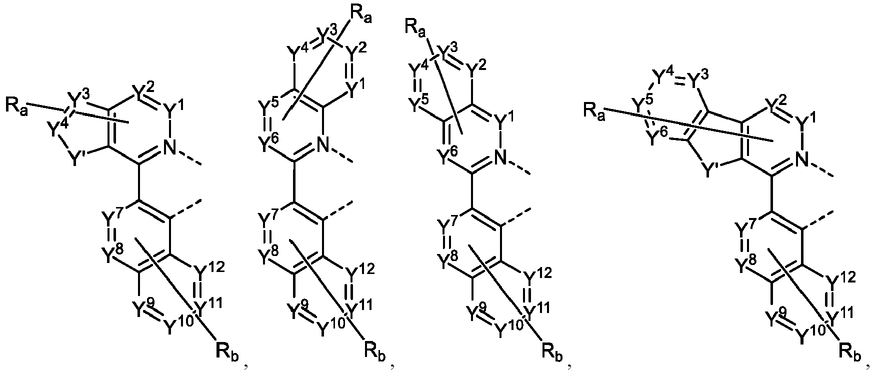 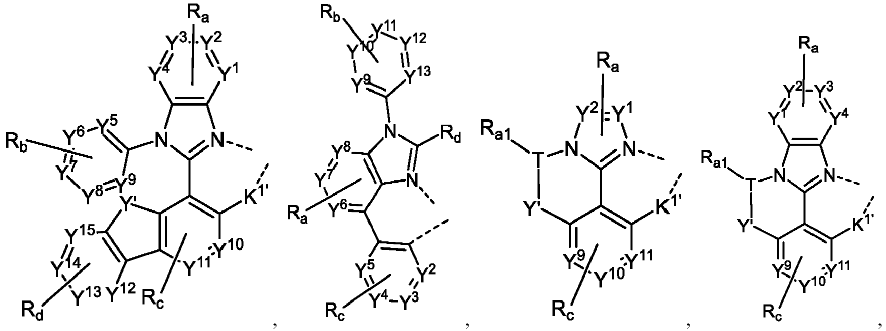 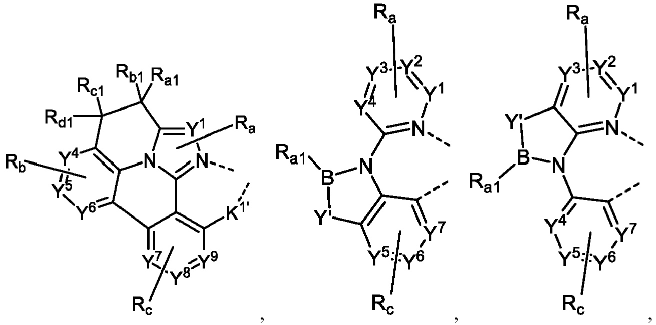 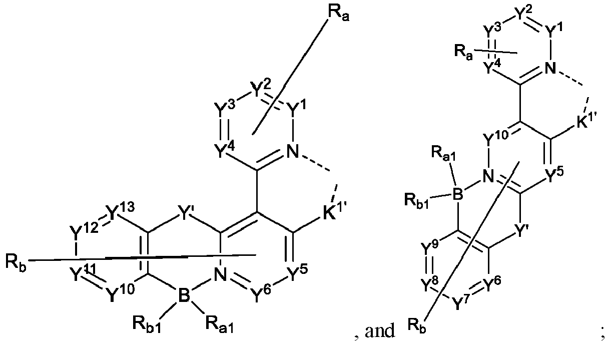
wherein L² and L³ are independently selected from the group consisting of 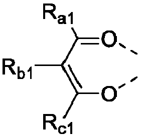 and the structures of LIST 4;
wherein:
T is selected from the group consisting of B, Al, Ga, and In;
K^{1'} is a direct bond or is selected from the group consisting of NRₑ, PRₑ, O, S, and Se;
each Y¹ to Y¹³ are independently selected from the group consisting of carbon and nitrogen;
Y' is selected from the group consisting of B Rₑ, N Rₑ, P Rₑ, O, S, Se, C=O, S=O, SO₂, CRₑR_{f}, SiRₑR_{f}, and GeRₑR_{f};
Rₑ and R_{f} can be fused or joined to form a ring;
each Rₐ, R_{b}, R_{c}, and R_{d} can independently represent from mono to the maximum possible number of substitutions, or no substitution;
each Rₐ₁, R_{b1}, R_{c1}, R_{d1}, Rₐ, R_{b}, Rₑ, R_{d}, Rₑ, and R_{f} is independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and
any two adjacent substituents of Rₐ₁, R_{b1}, R_{c1}, R_{d1}, Rₐ, R_{b}, R_{c}, and R_{d} can be fused or joined to form a ring or form a multidentate ligand.

In some embodiments, each Rₐ₁, R_{b1}, R_{c1}, R_{d1}, Rₐ, R_{b}, R_{c}, R_{d}, Rₑ, and R_{f} is independently a hydrogen or a substituent selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

In some embodiments, L² is selected from the group consisting of L_{B*k*}, wherein *k* is an integer from 1 to 621, and each of L_{B1} to L_{B621} is defined in the following LIST 6:

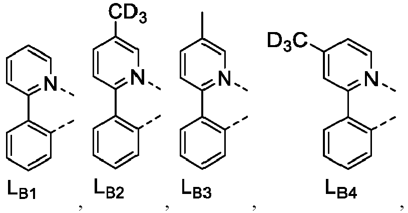

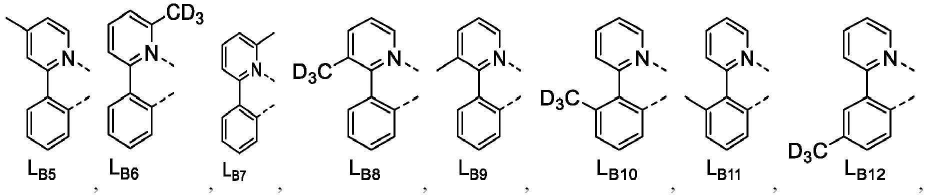

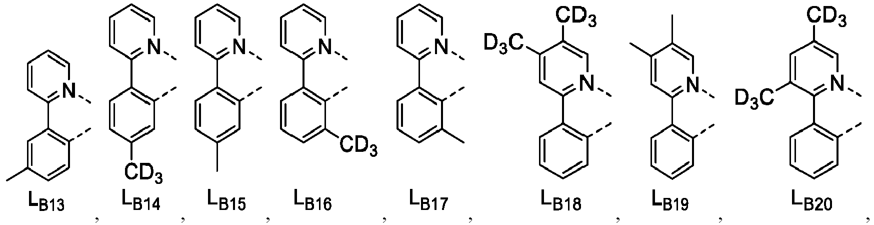

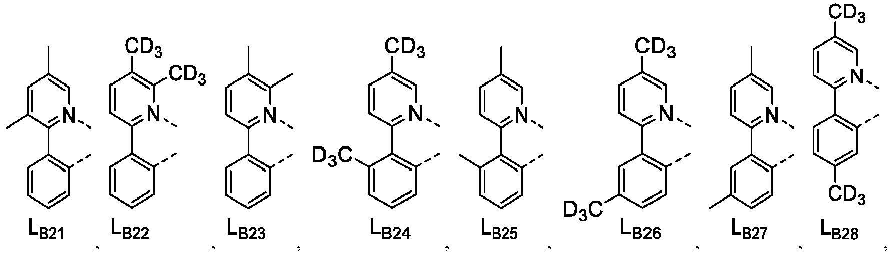

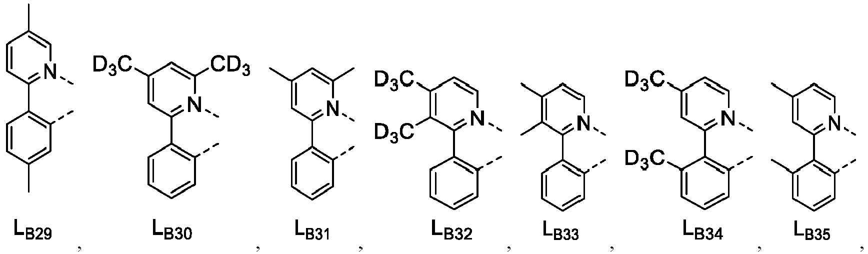

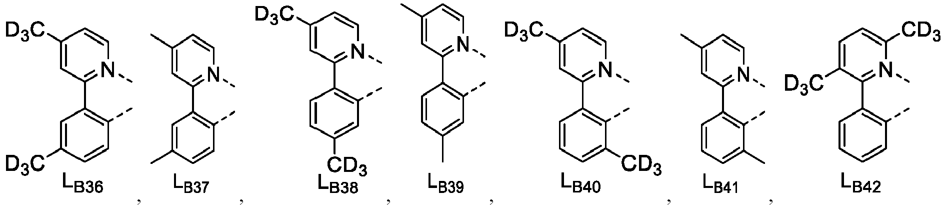

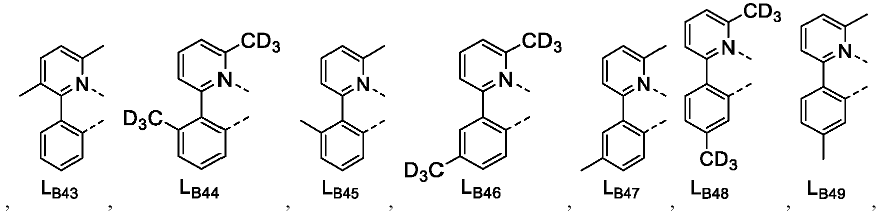

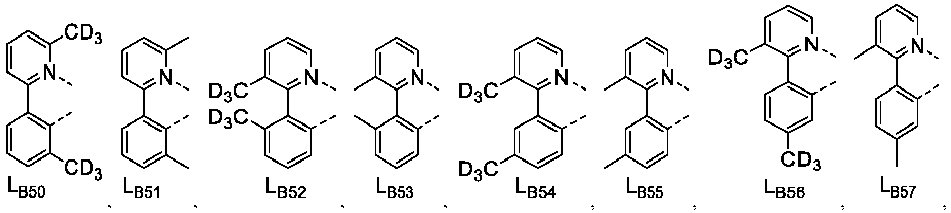

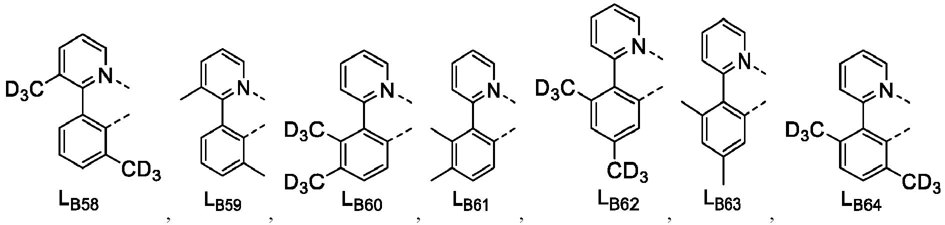

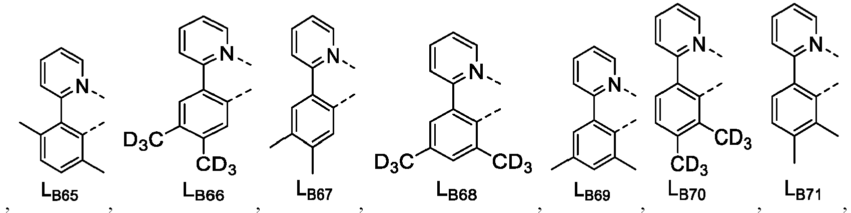

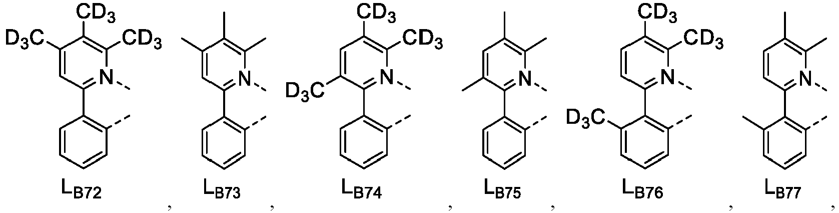

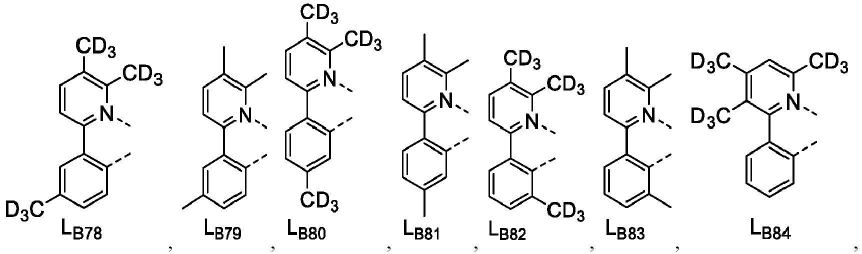

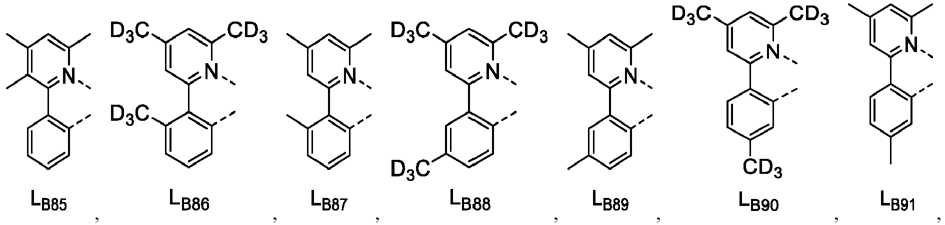

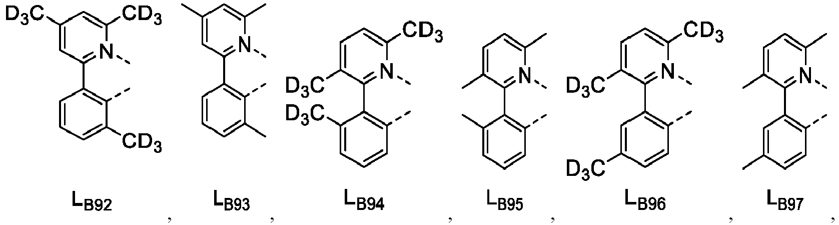

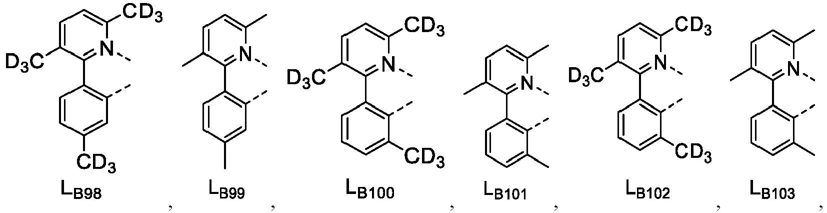

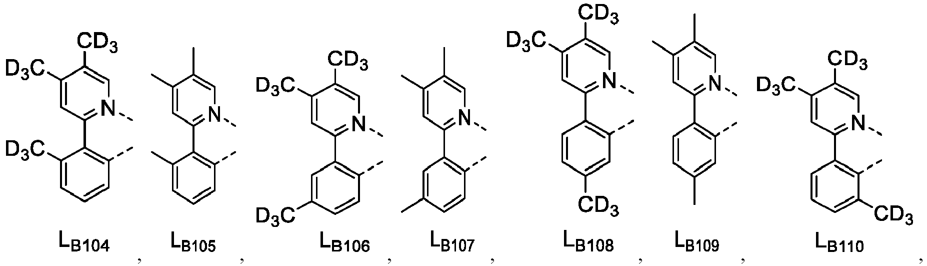

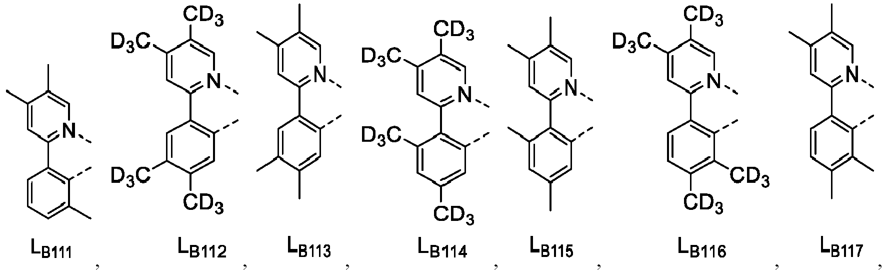

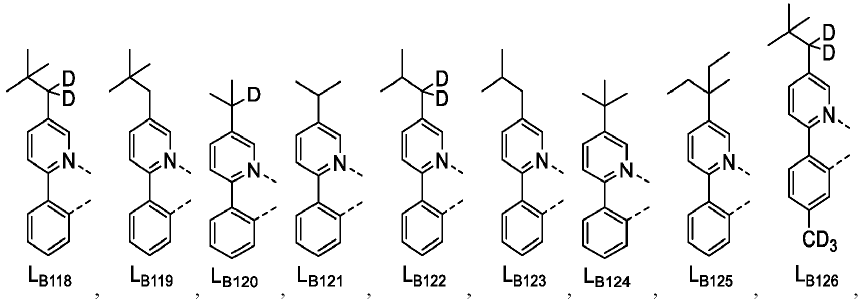

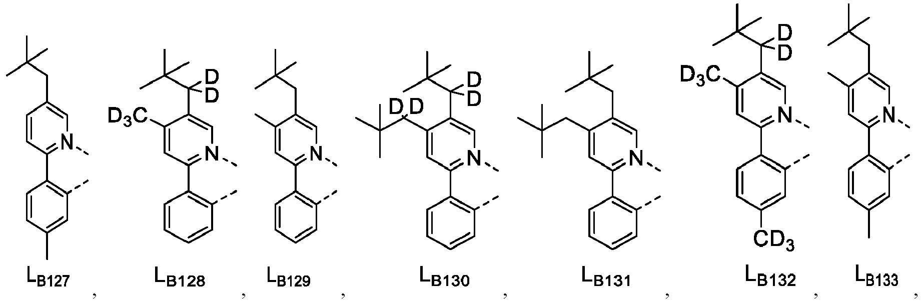

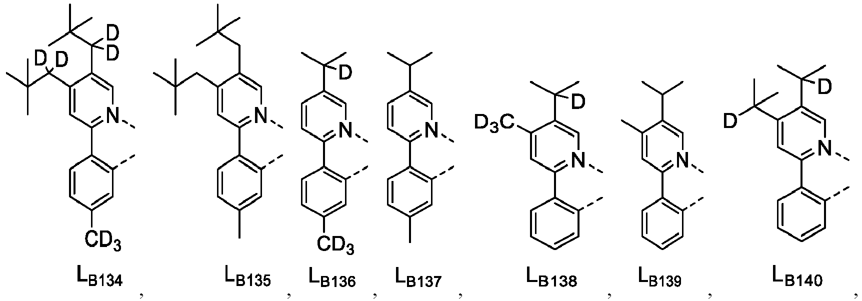

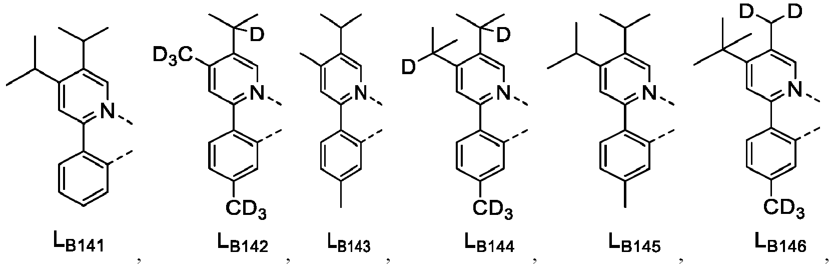

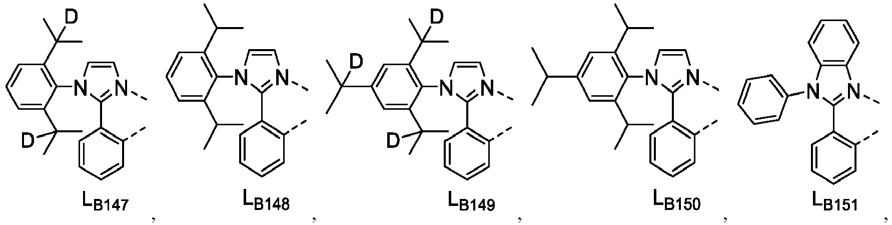

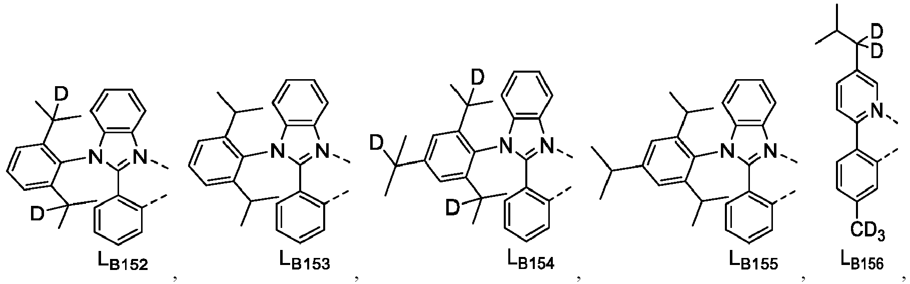

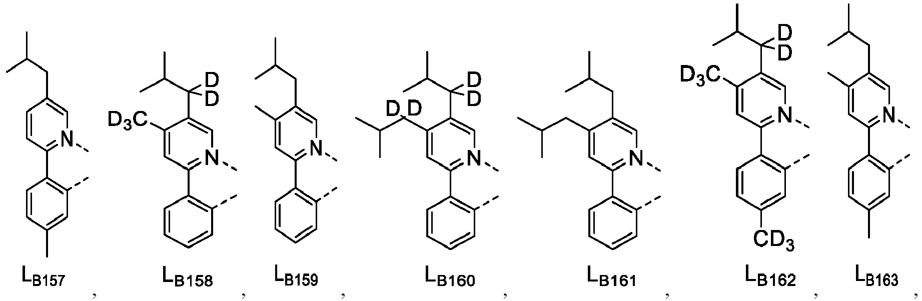

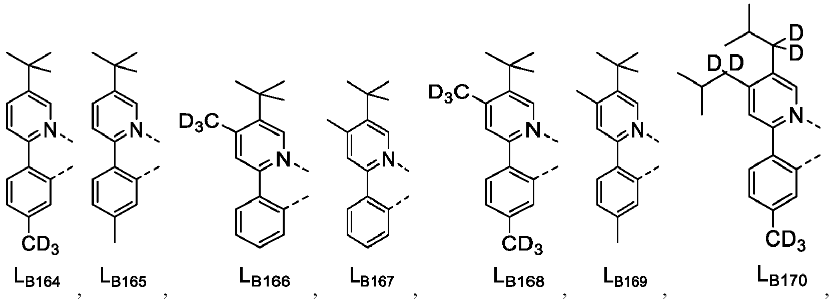

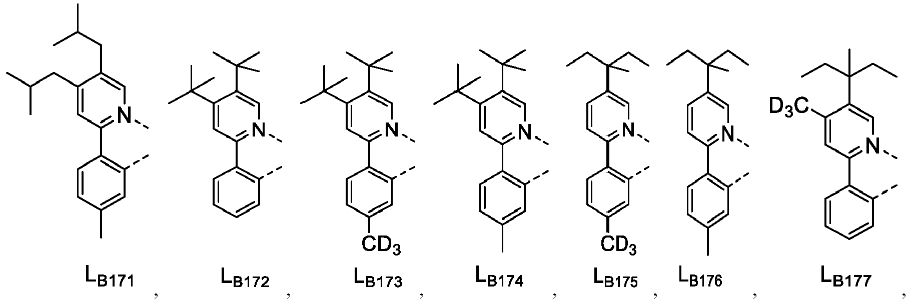

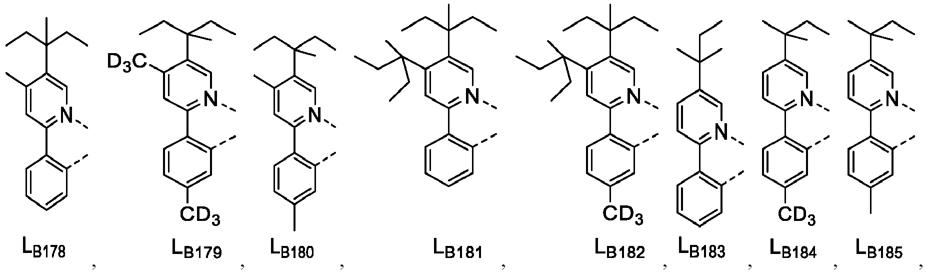

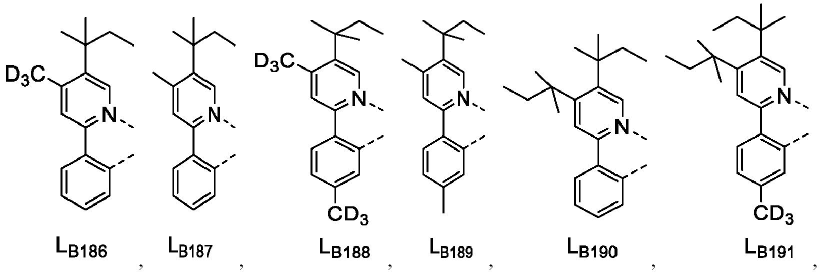

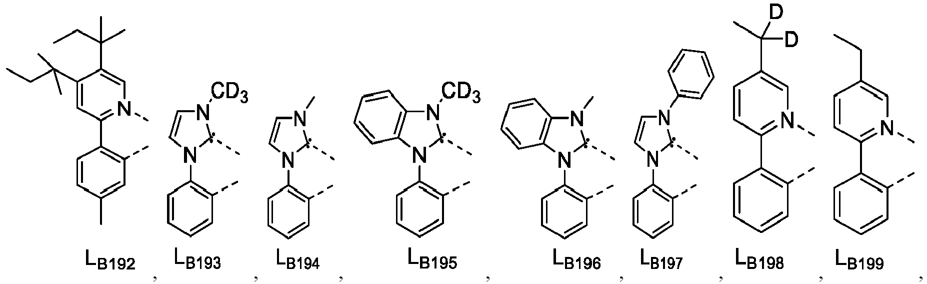

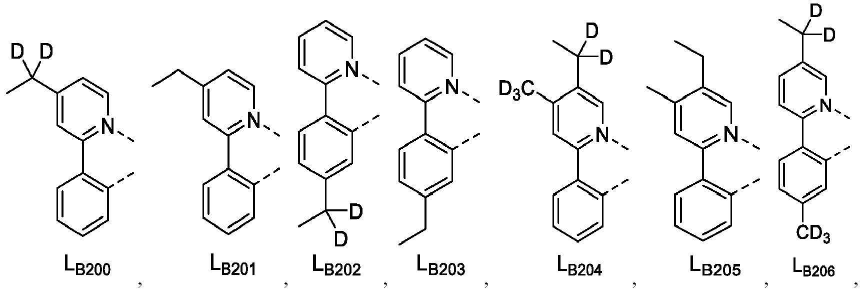

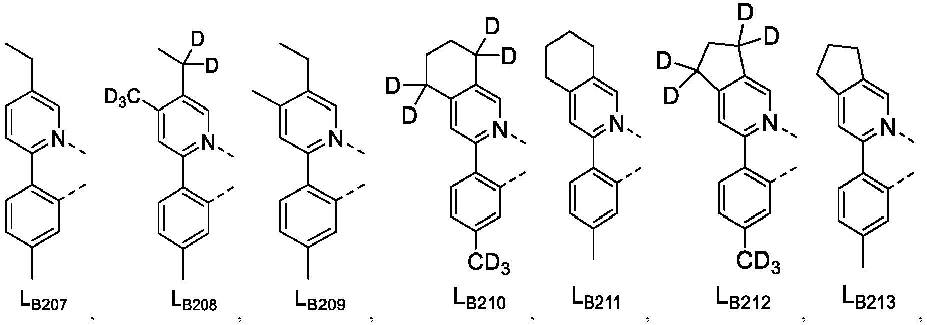

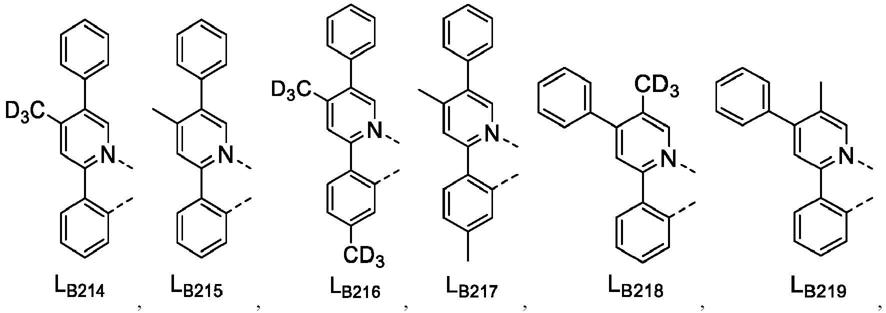

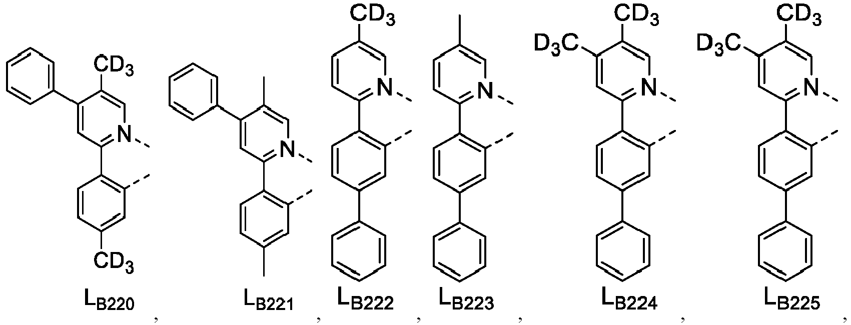

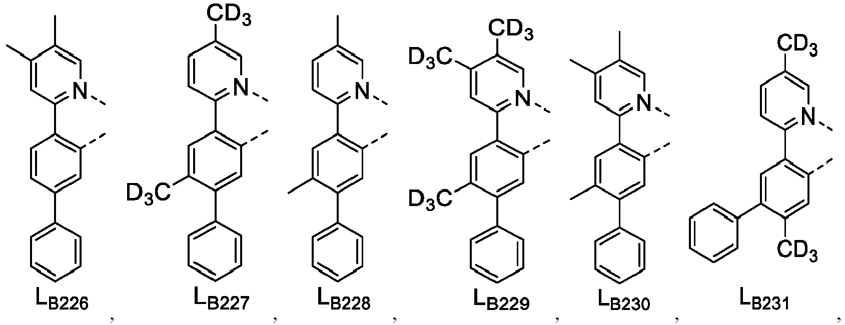

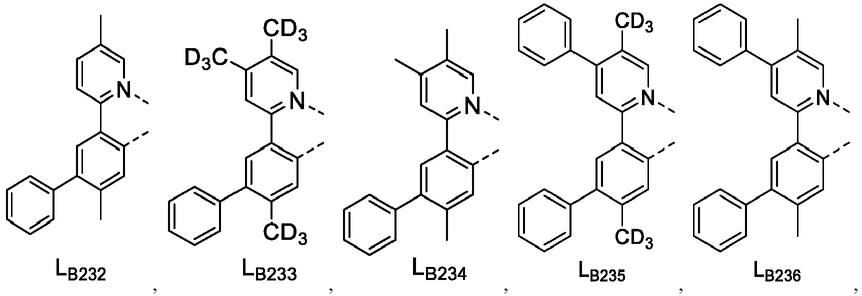

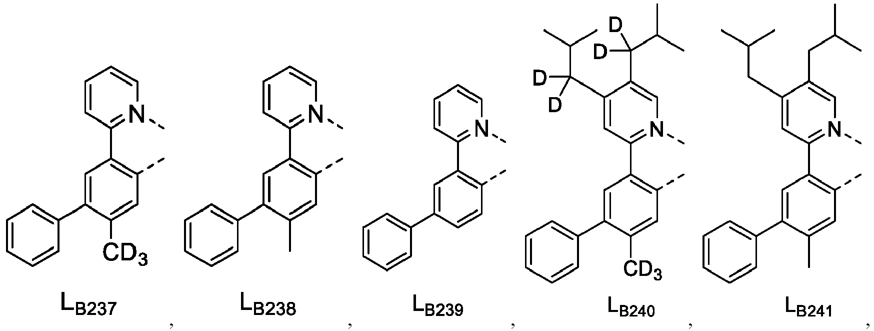

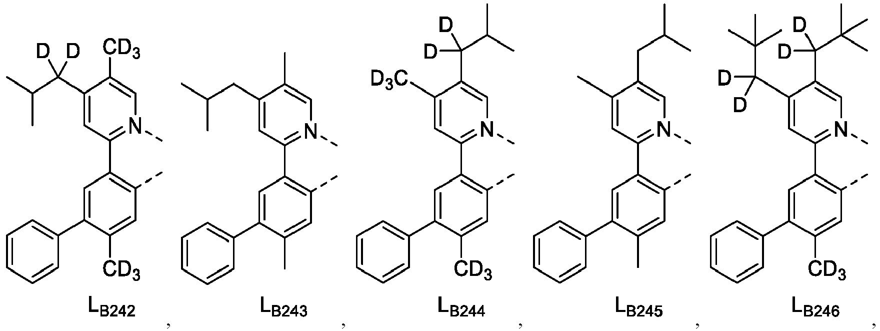

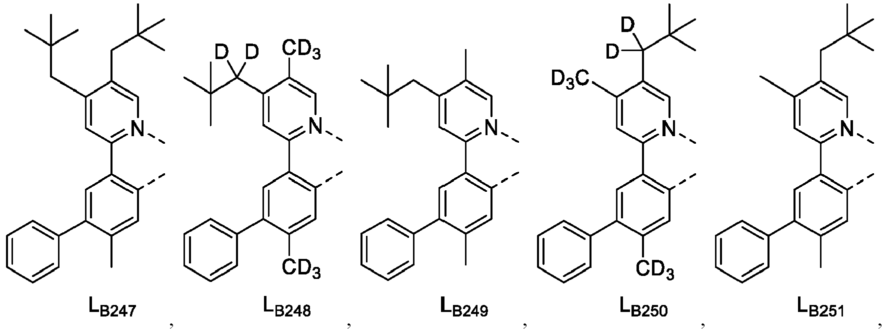

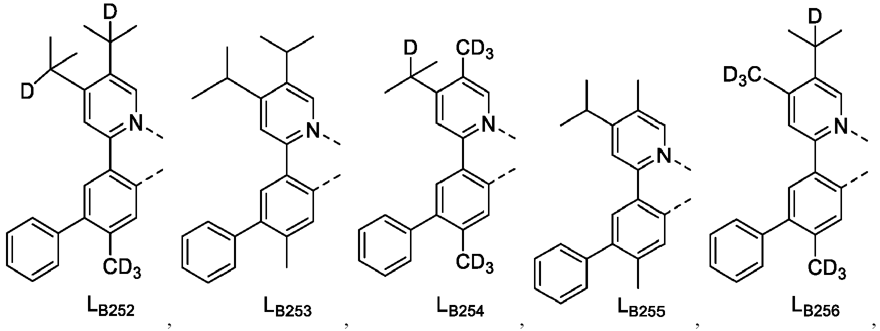

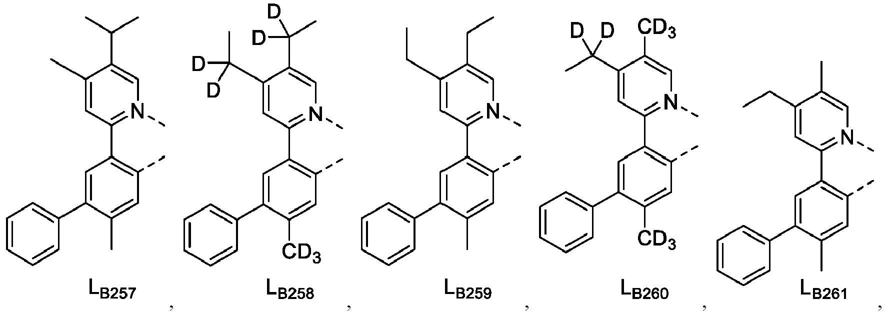

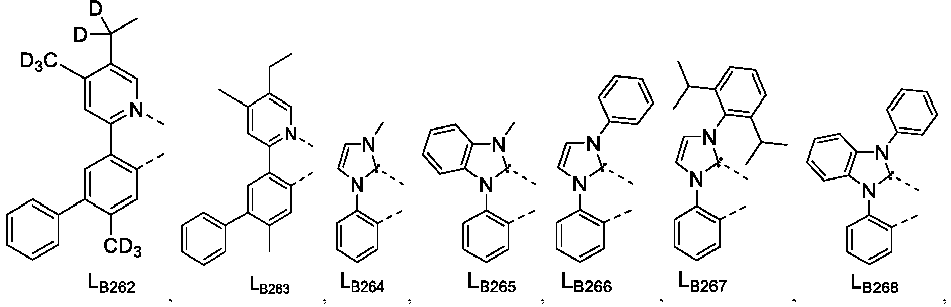

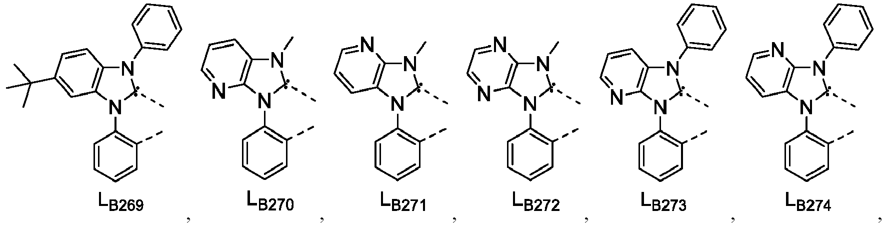

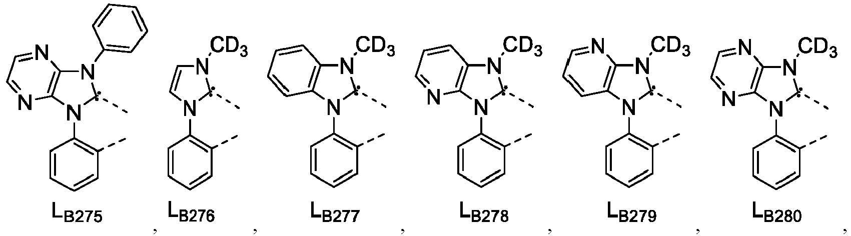

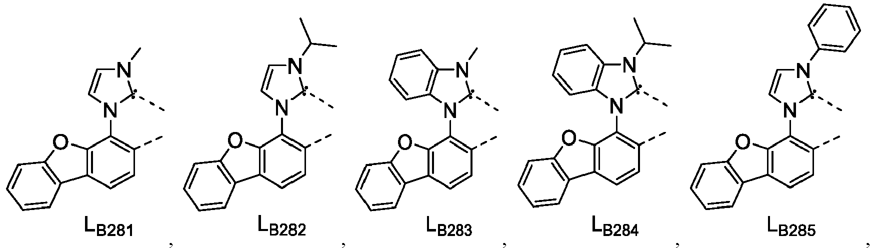

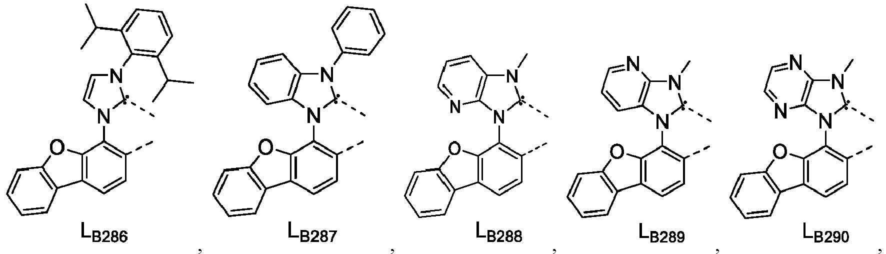

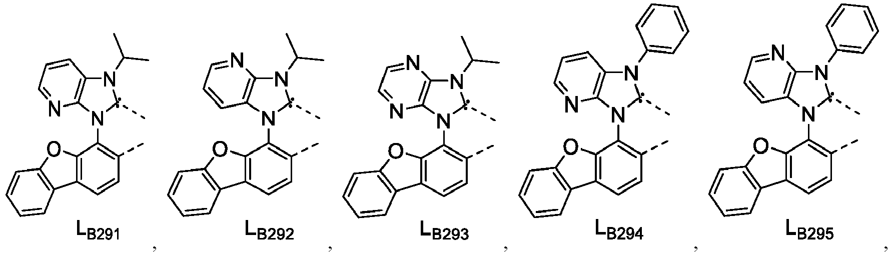

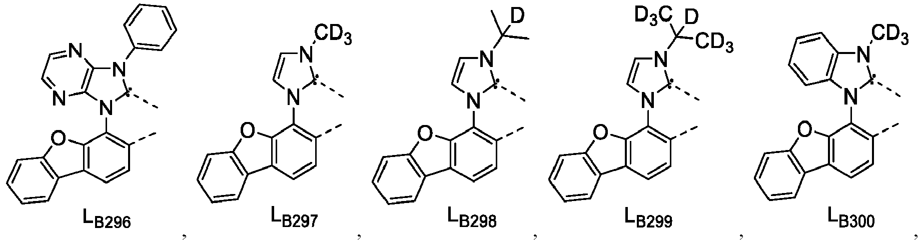

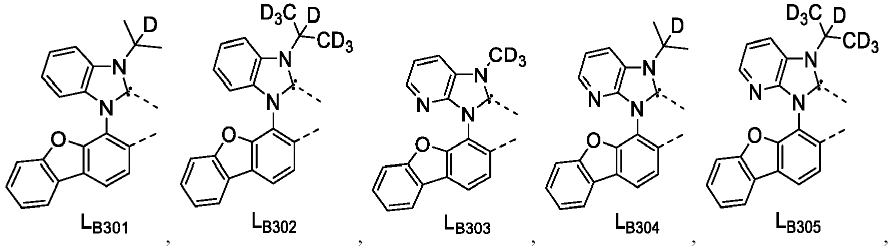

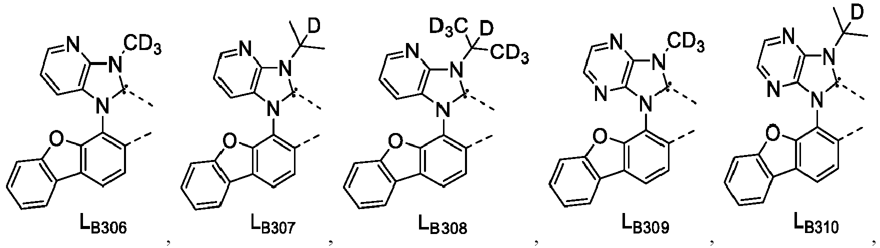

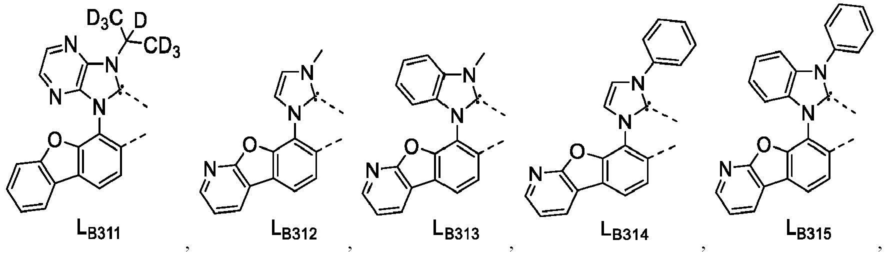

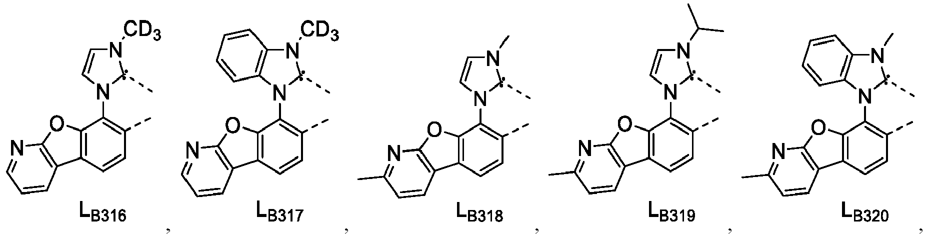

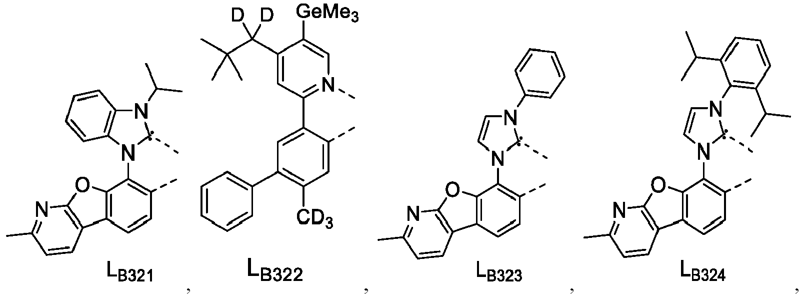

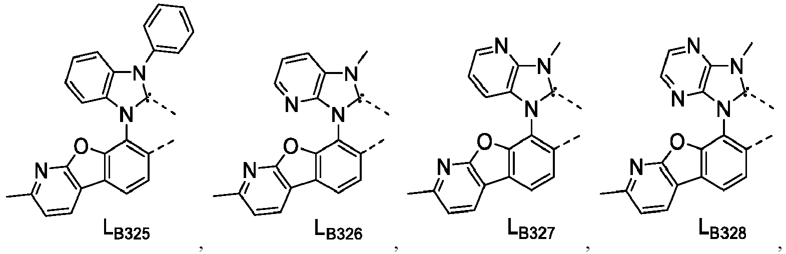

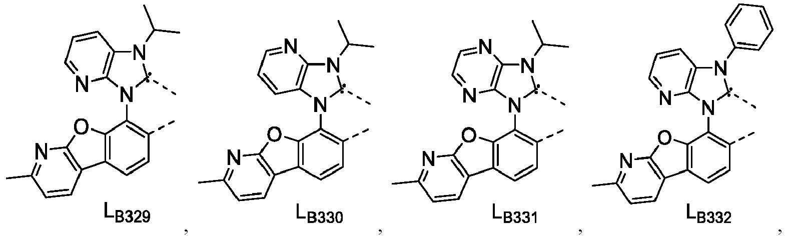

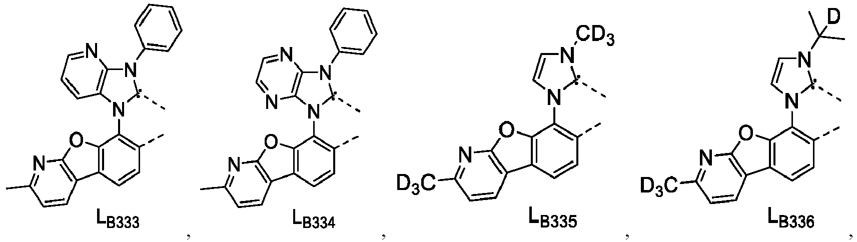

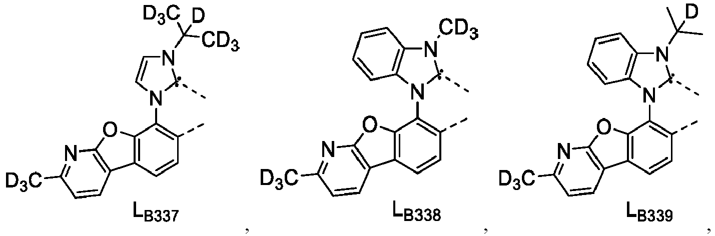

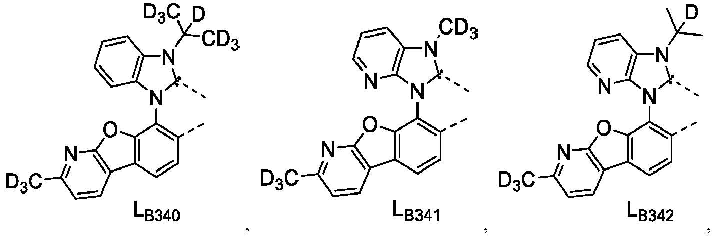

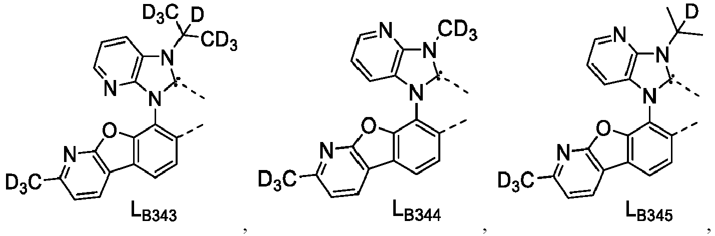

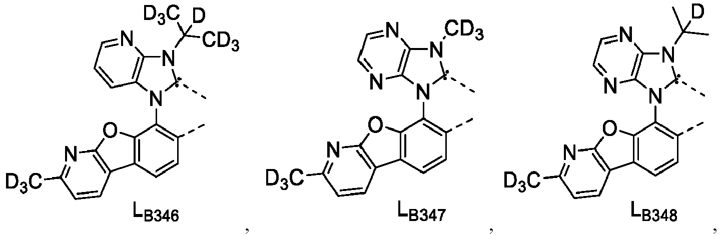

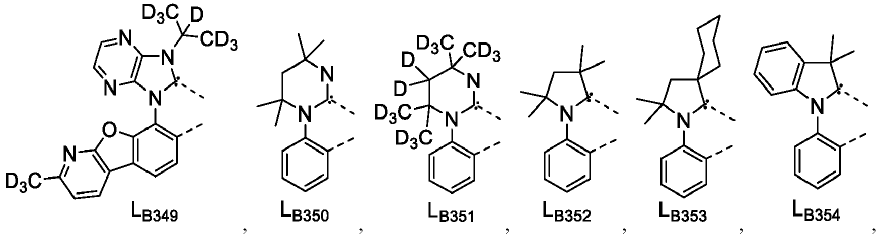

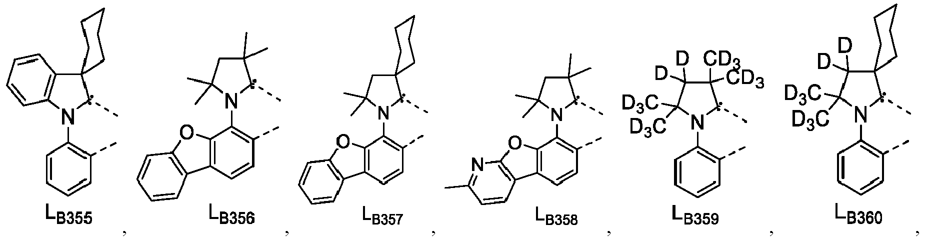

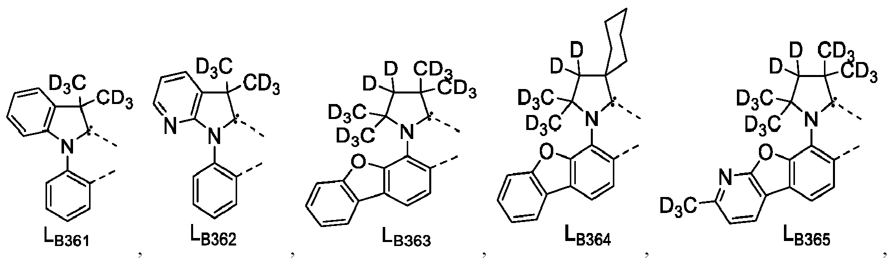

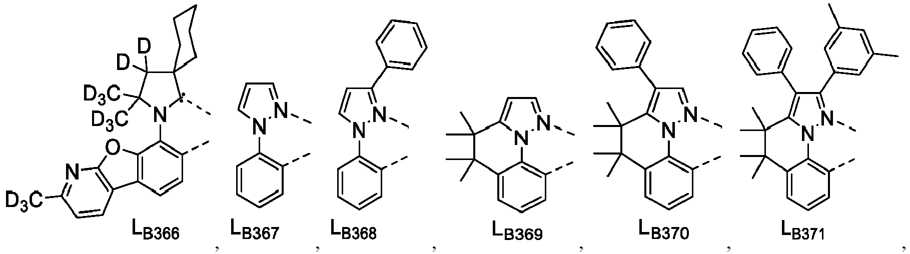

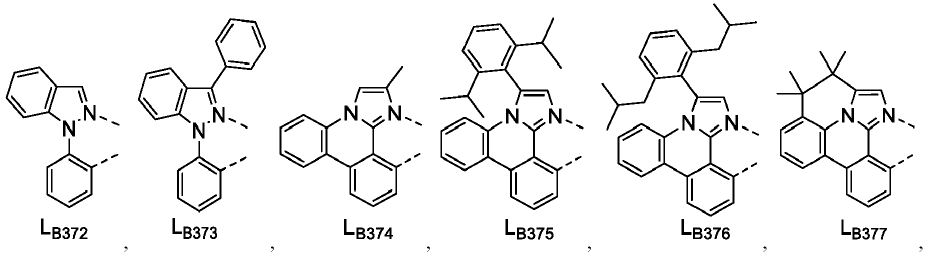

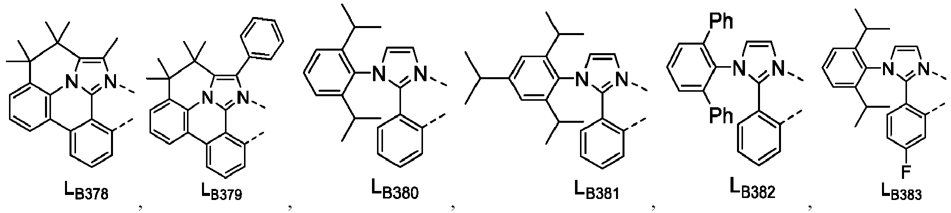

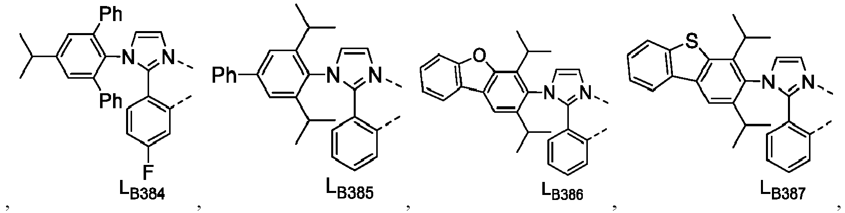

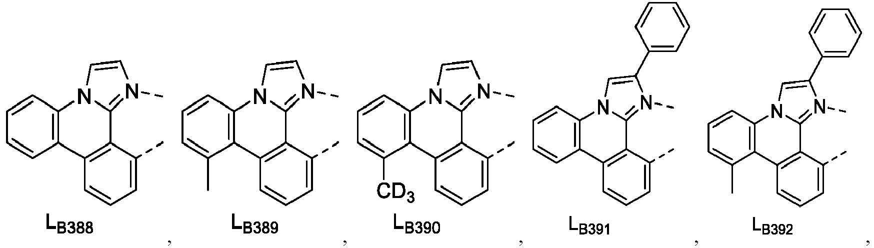

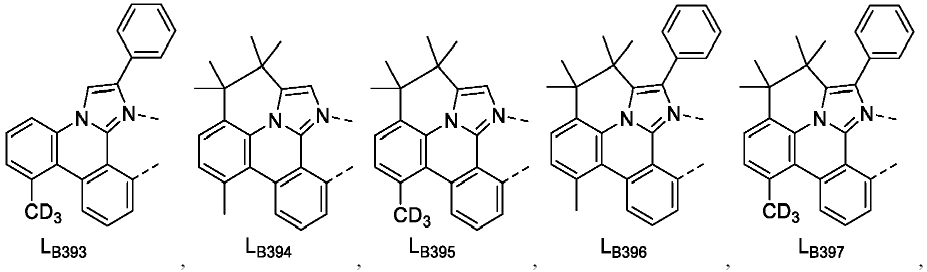

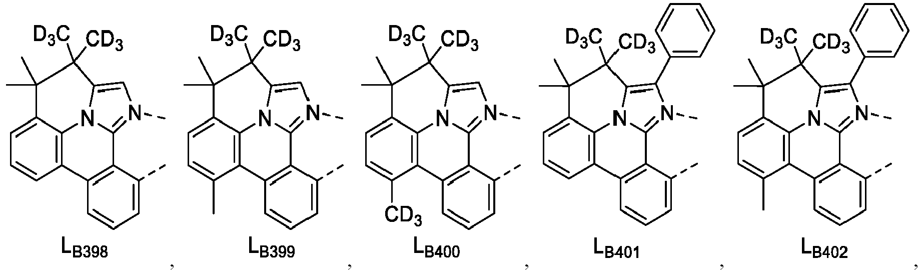

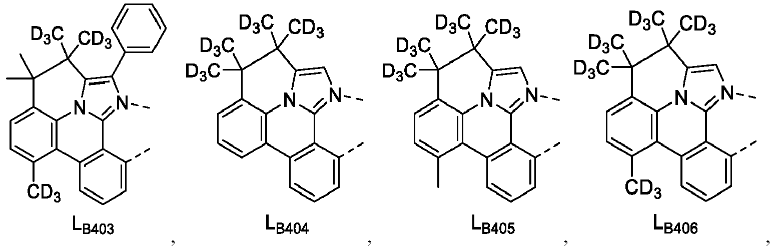

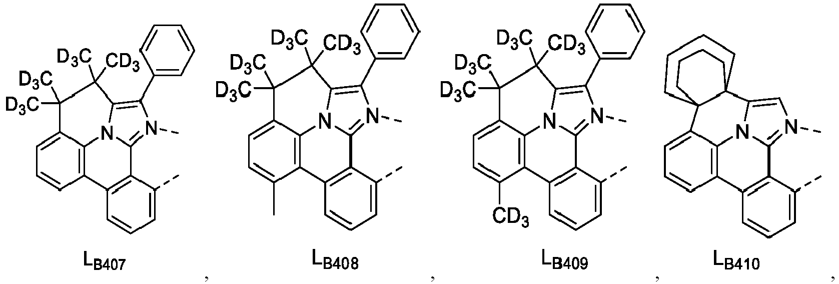

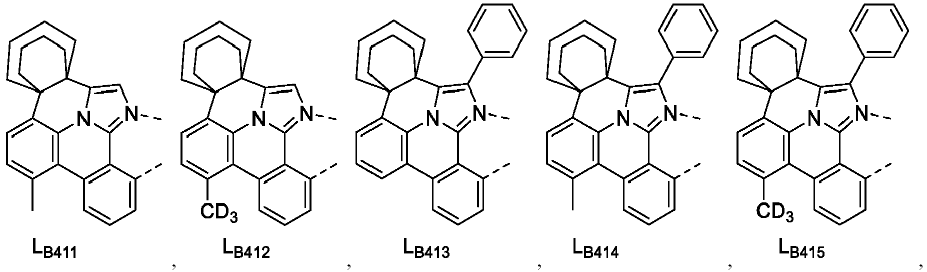

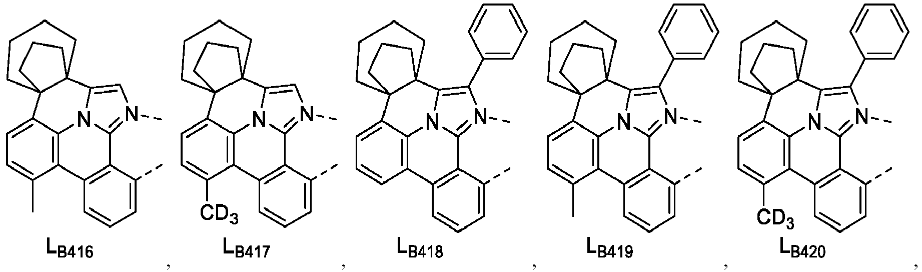

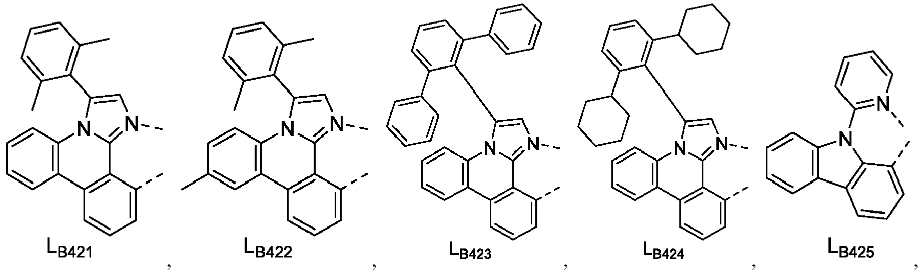

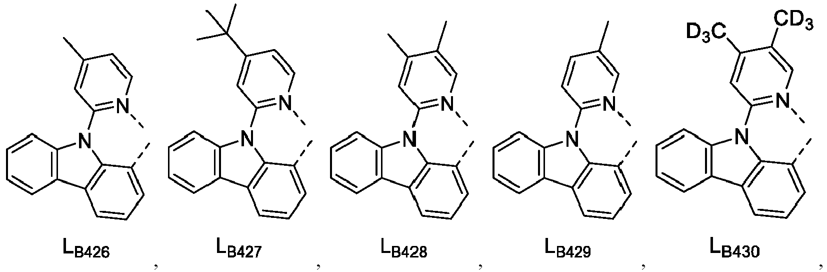

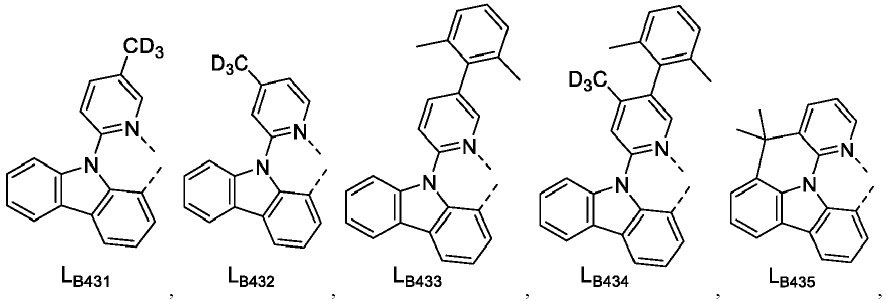

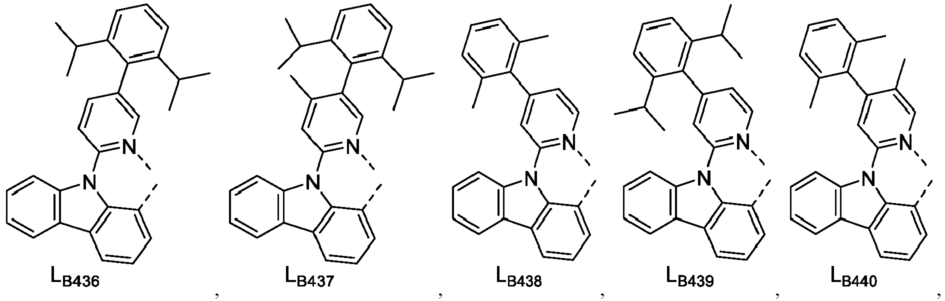

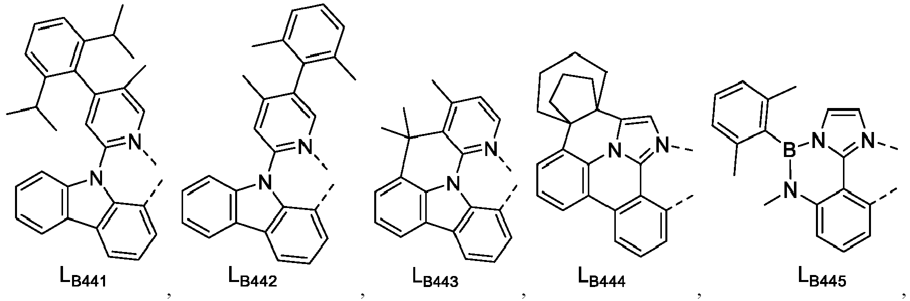

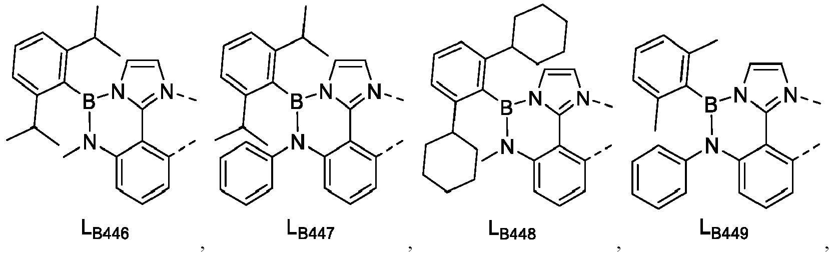

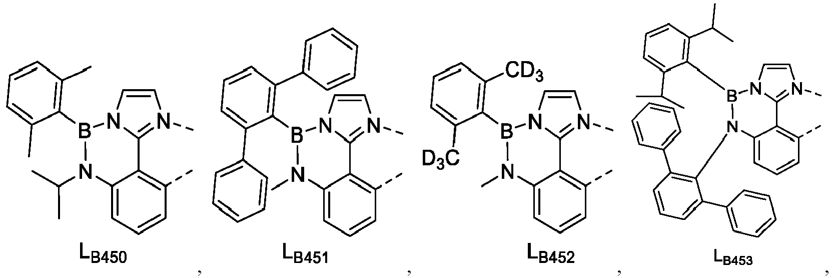

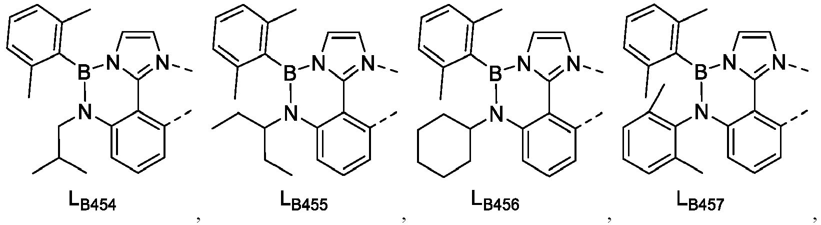

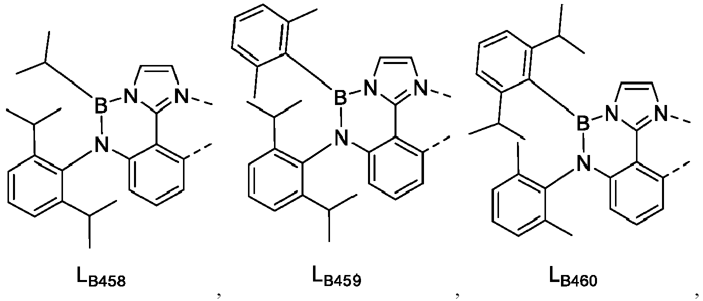

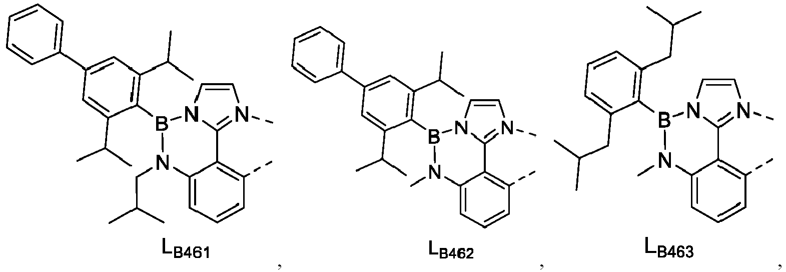

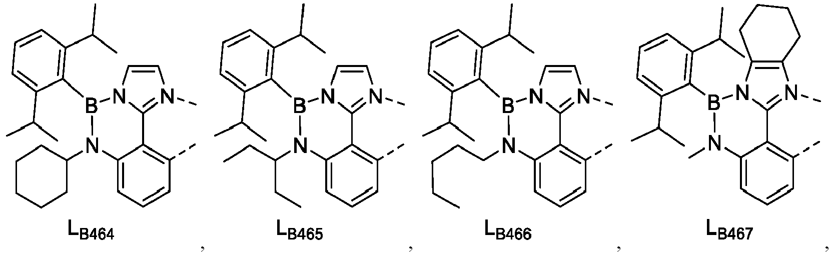

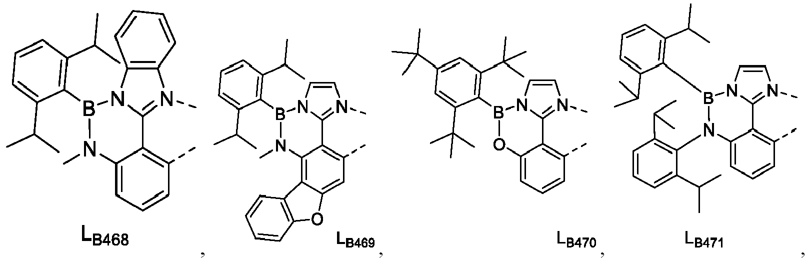

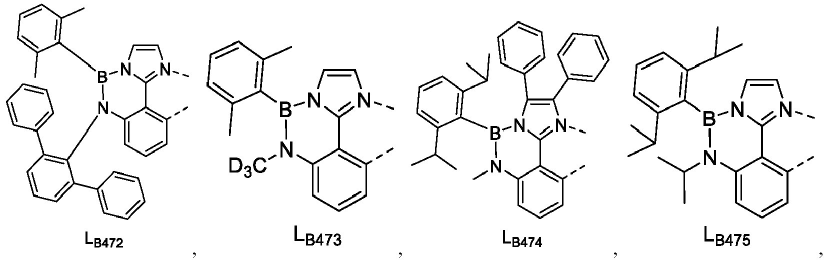

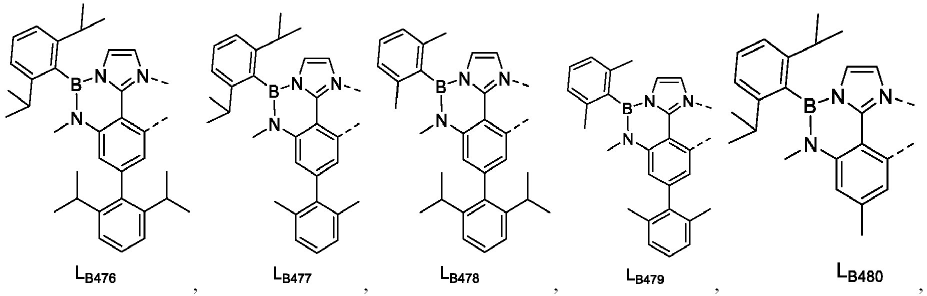

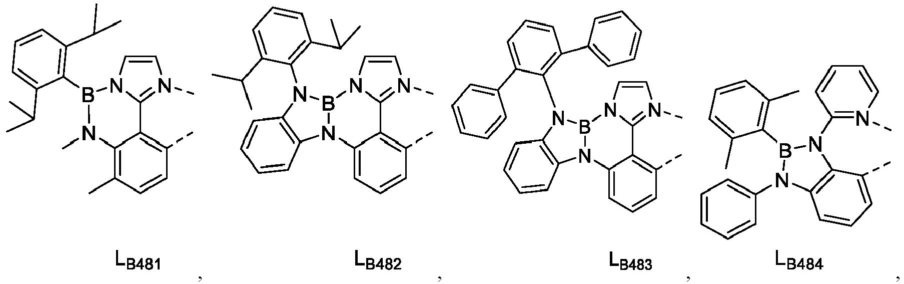

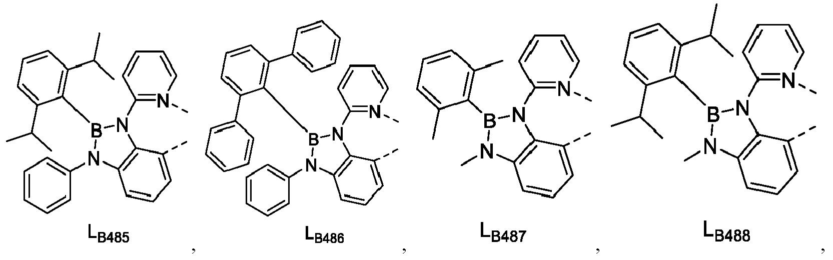

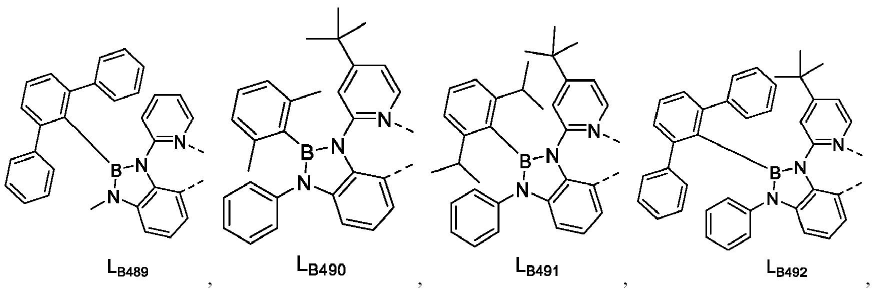

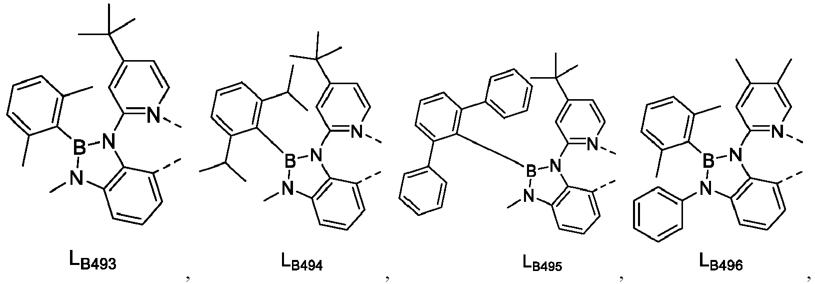

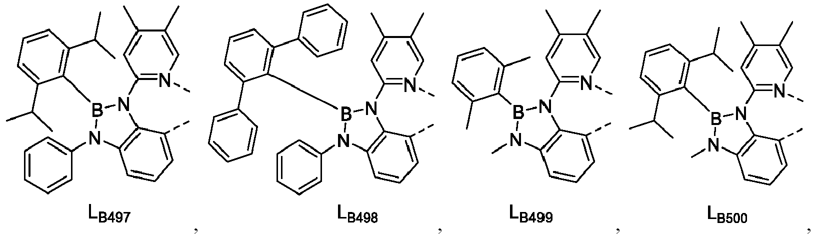

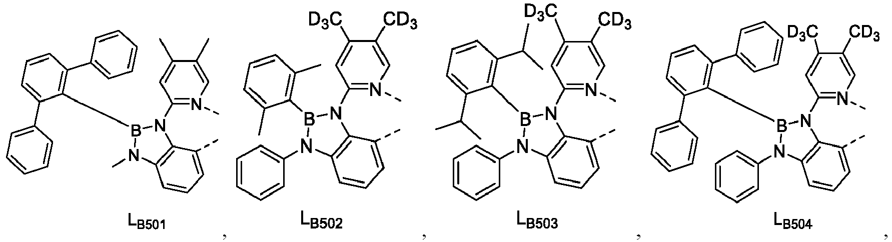

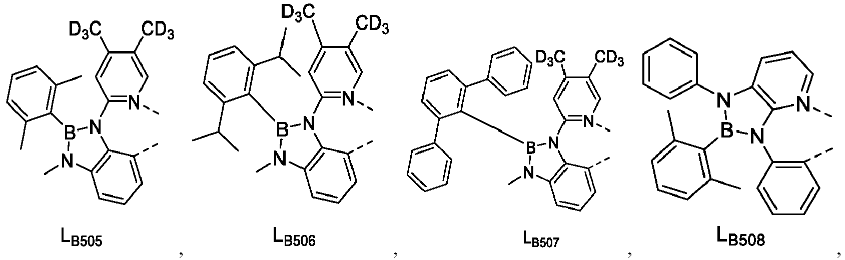

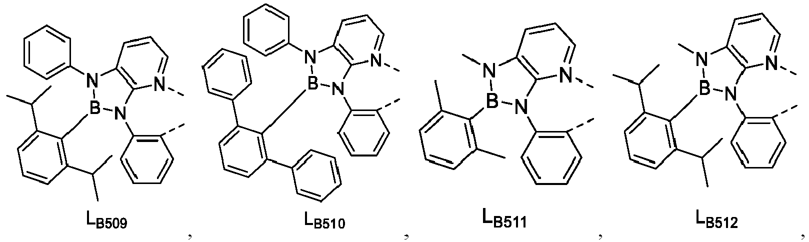

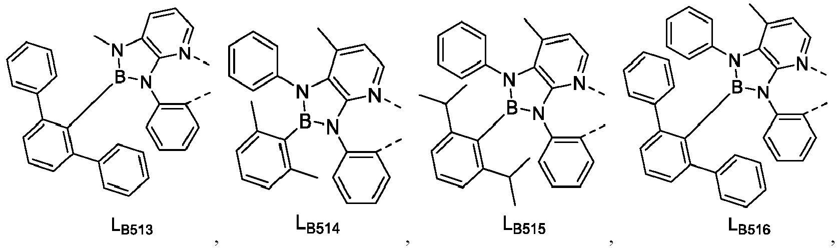

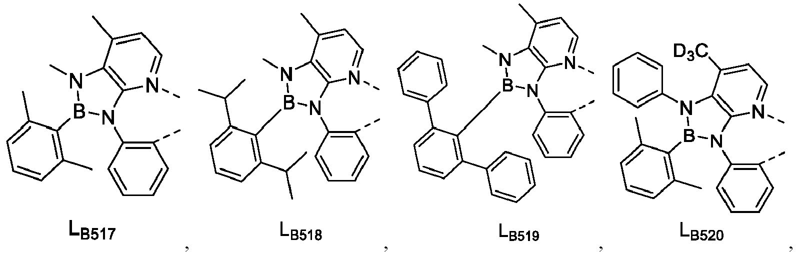

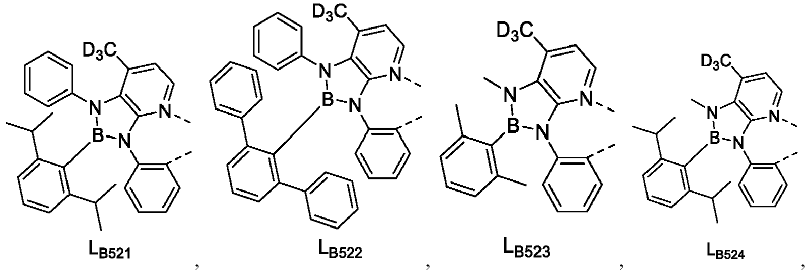

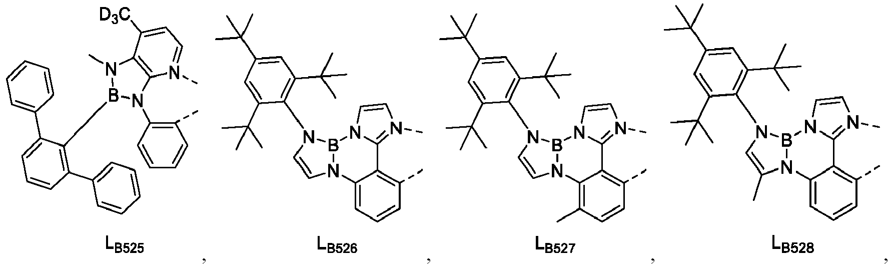

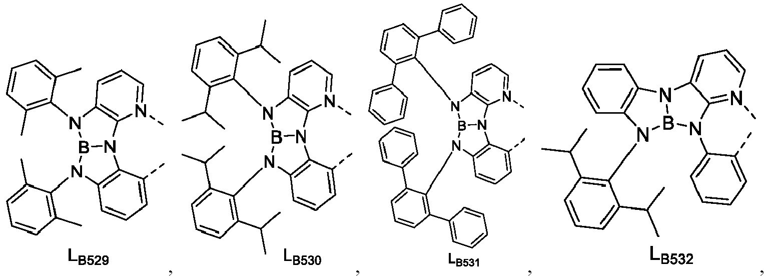

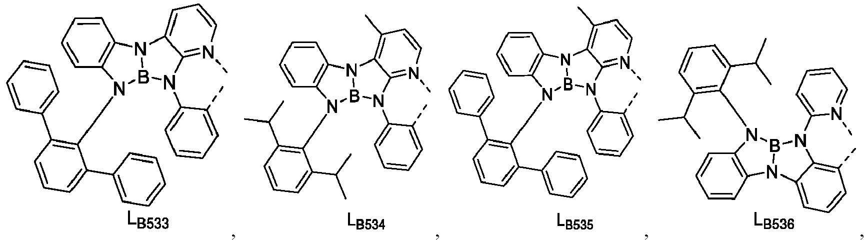

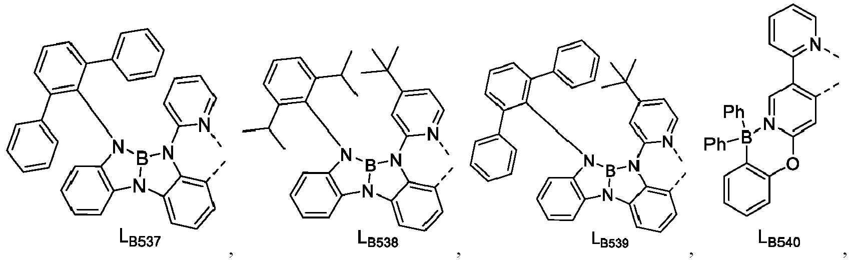

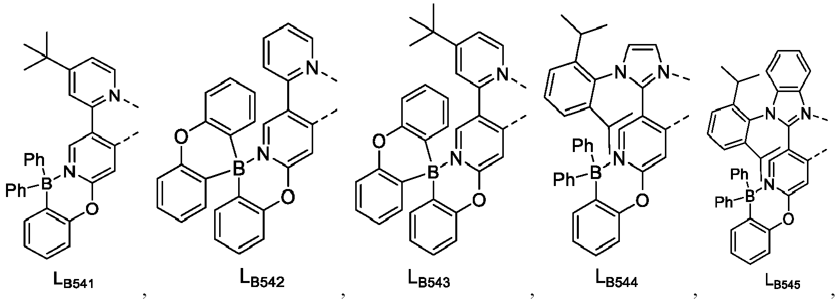

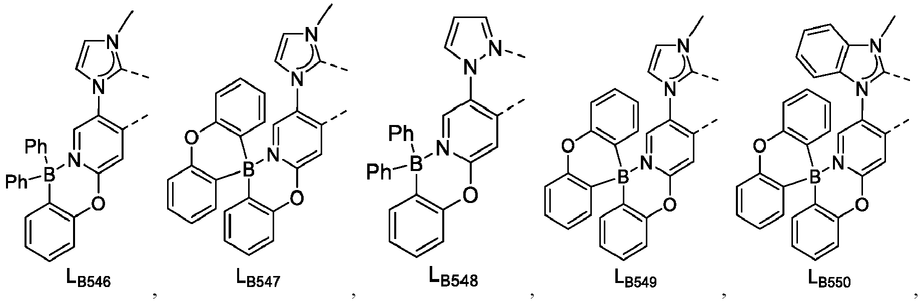

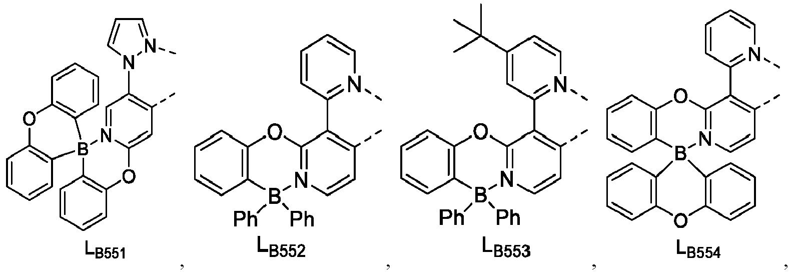

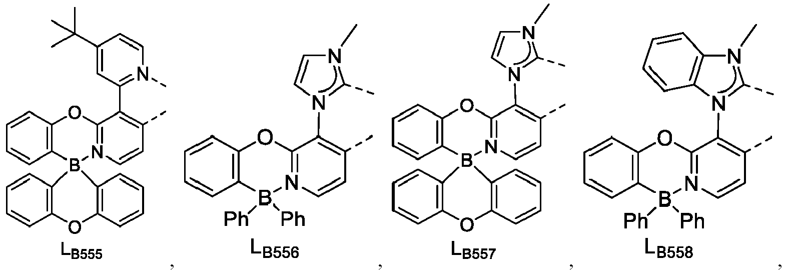

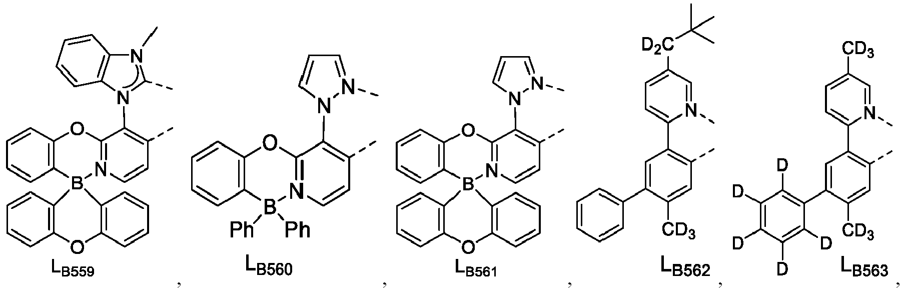

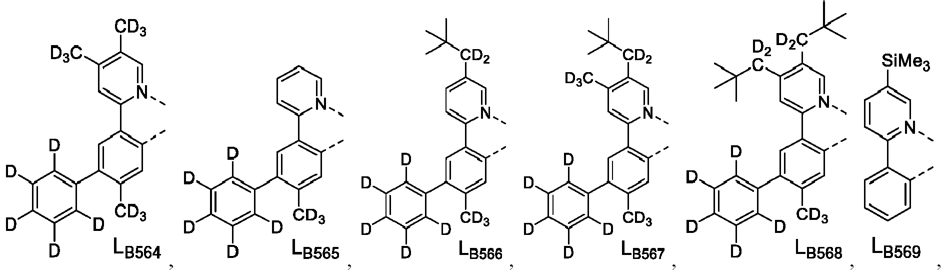

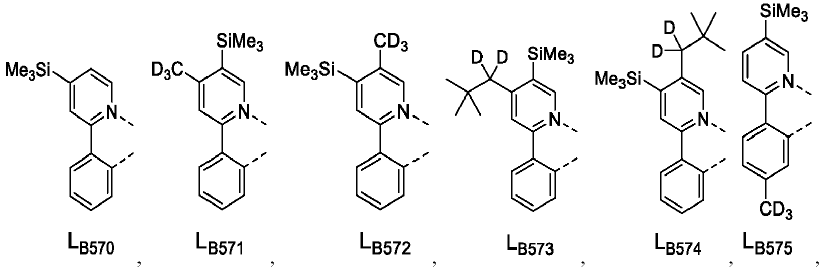

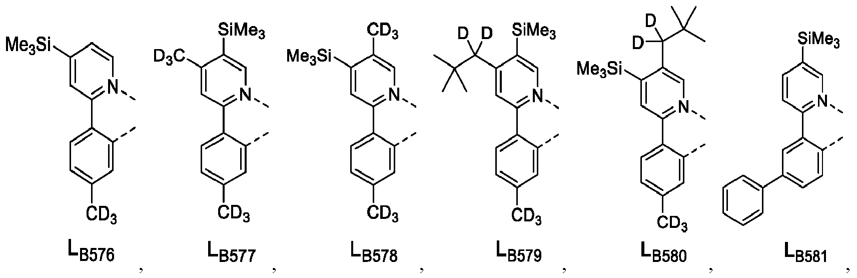

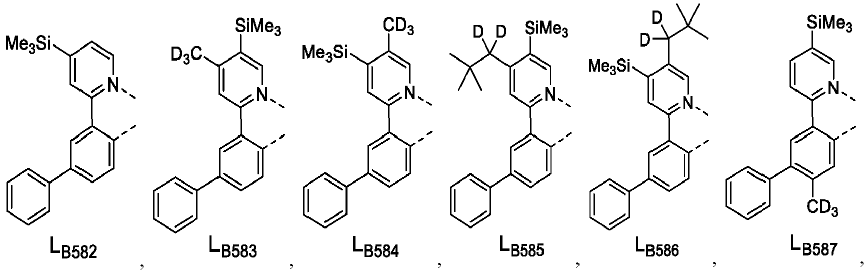

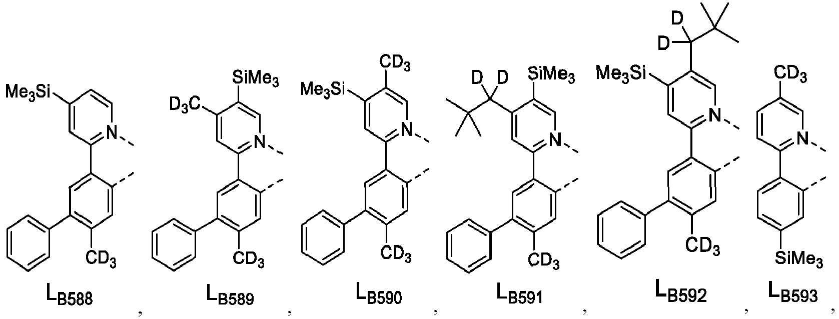

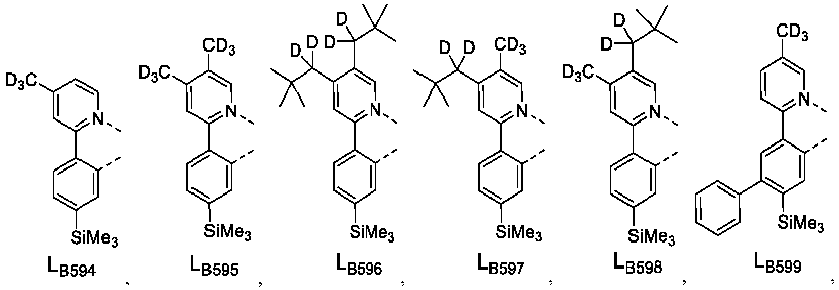

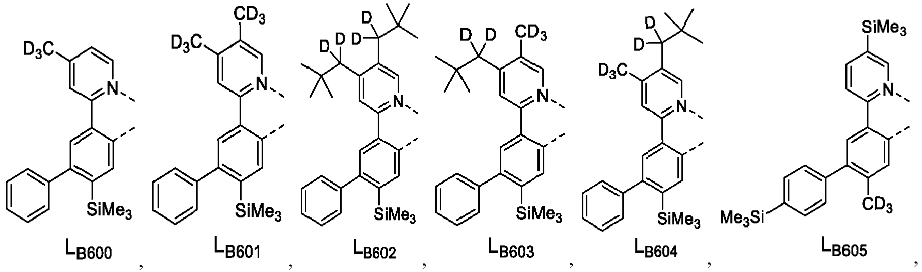

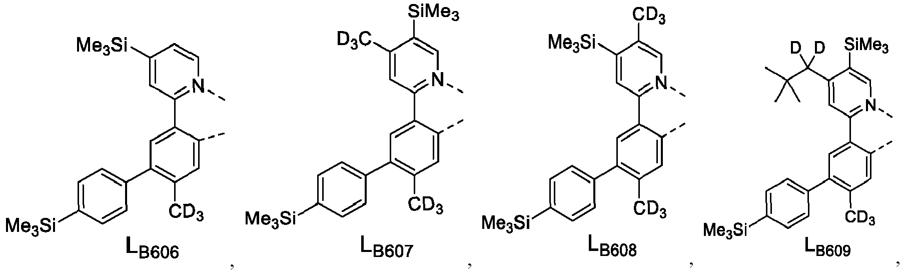

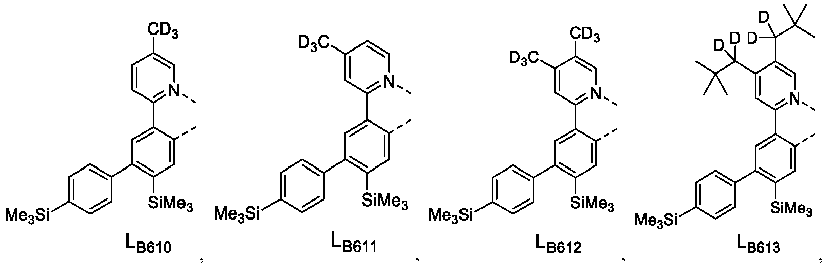

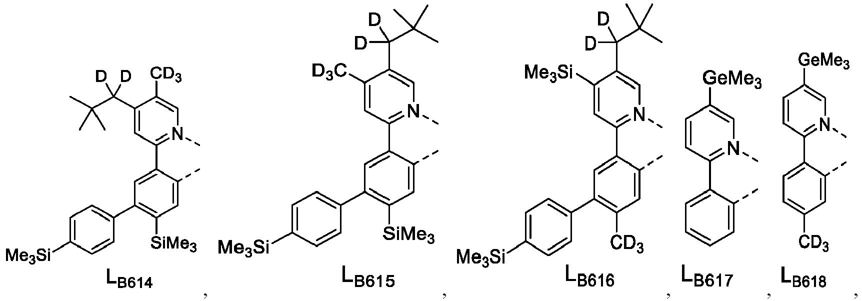

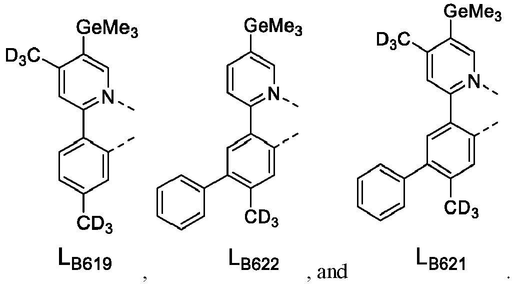

In some embodiments, the metal in formula M(L¹)ₓ(L²)_{y}(L³)_{z} is selected from the group consisting of Cu, Ag, or Au.

In some embodiments, the first compound S1 has a formula selected from the group consisting of Ir(L¹)₃, Ir(L¹)(L²)₂, Ir(L¹)₂(L²). Ir(L¹)₂(L³), Ir(L¹)(L²)(L³), and Pt(L¹)(L²);
wherein L¹, L², and L³ are different from each other in the Ir compounds;
wherein L¹ and L² can be the same or different in the Pt compounds; and
wherein L¹ and L² can be connected to form a tetradentate ligand in the Pt compounds.

In some embodiments, the first compound S 1 is selected from the group consisting of the structures of the following LIST 5: 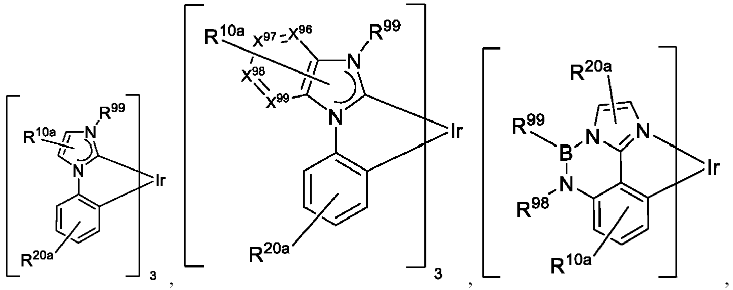 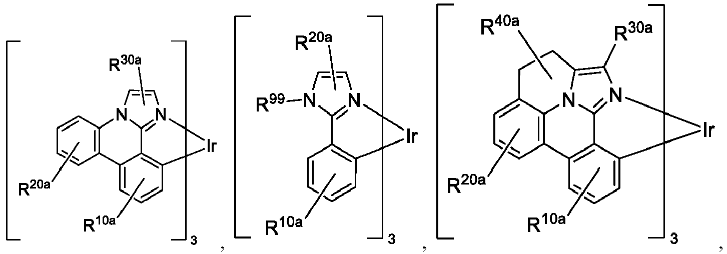 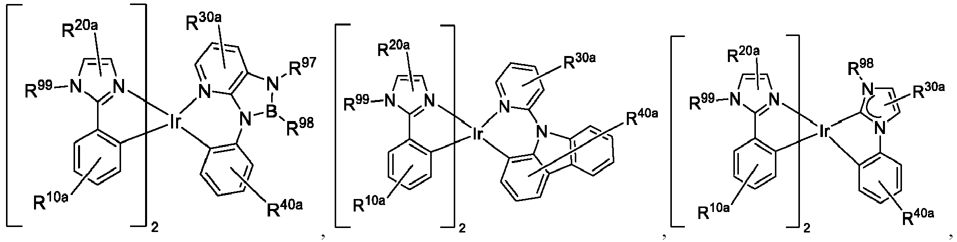 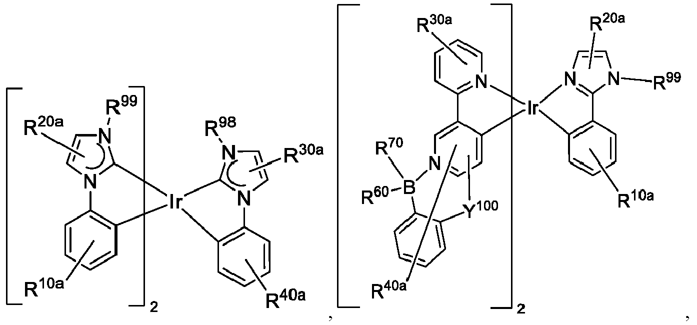 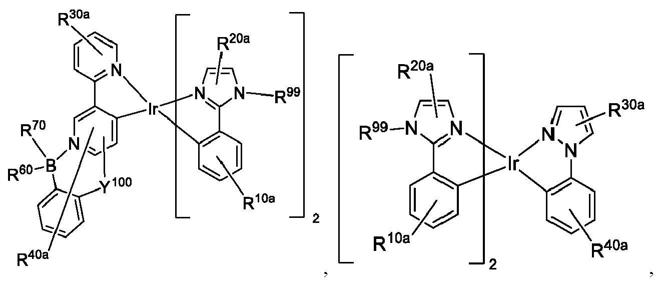 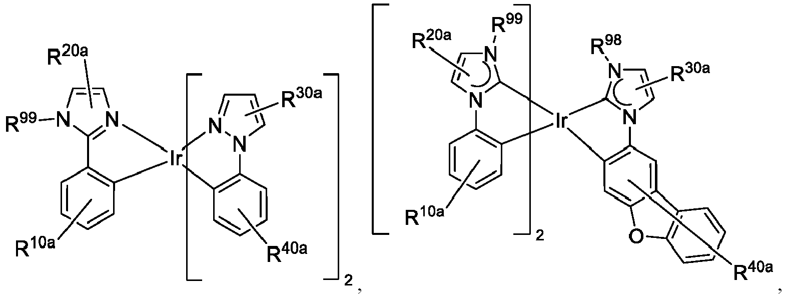 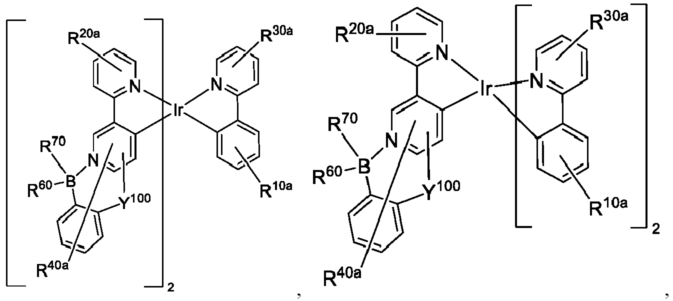 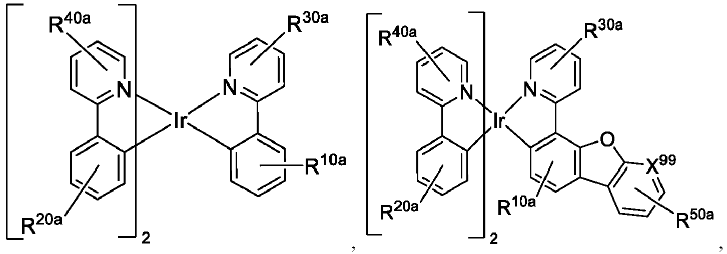 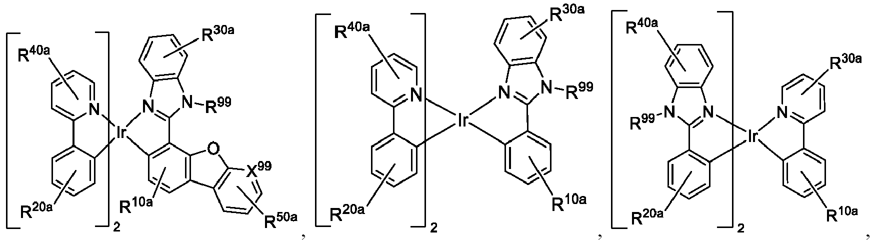 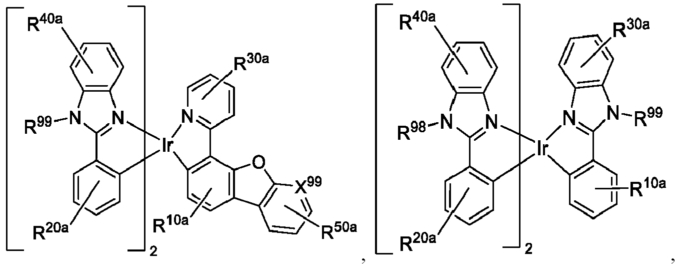 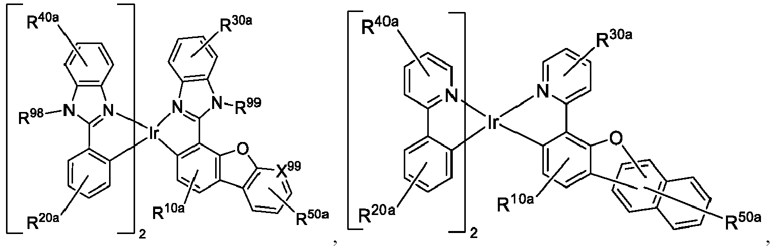 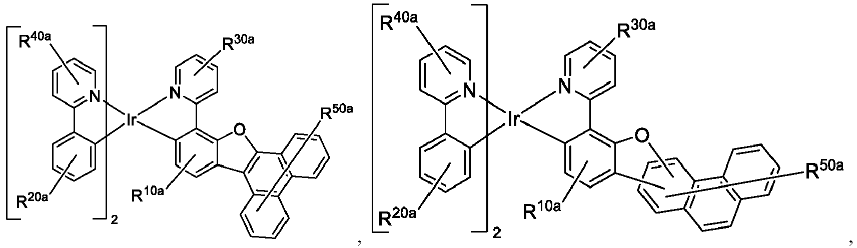 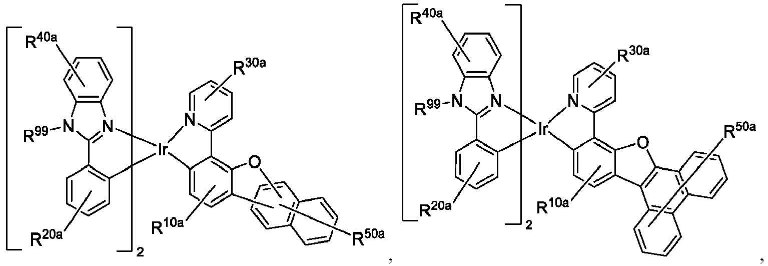 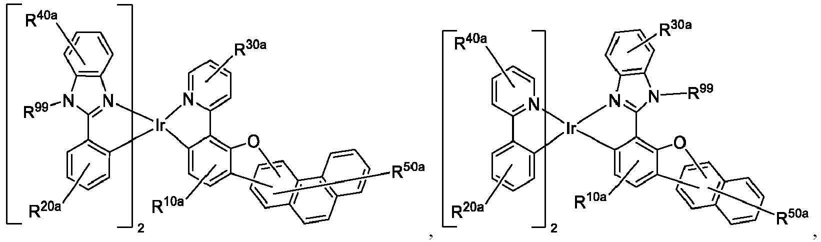 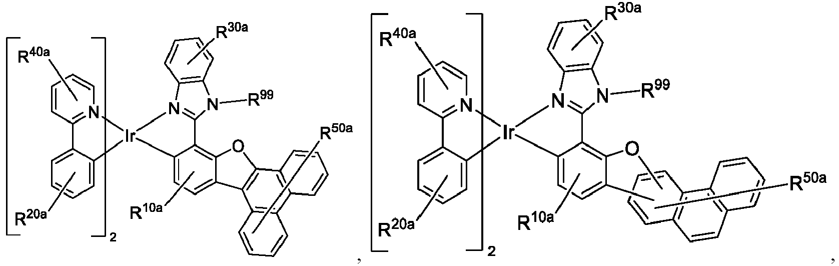 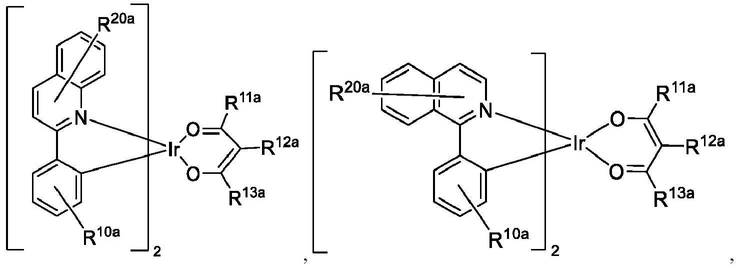 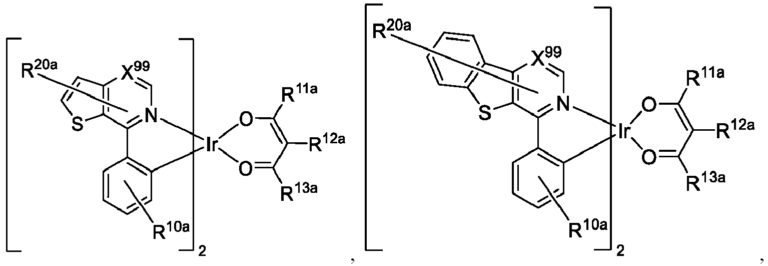 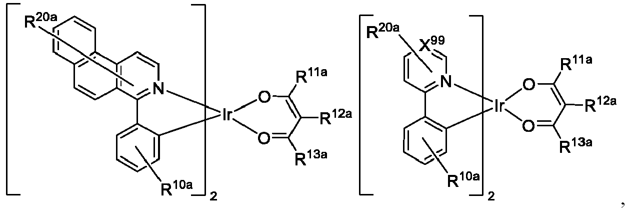 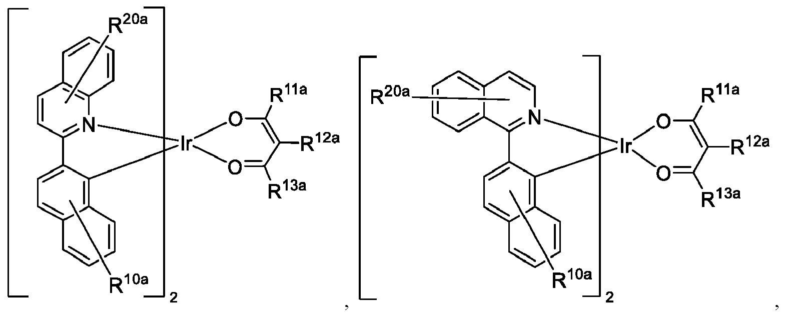 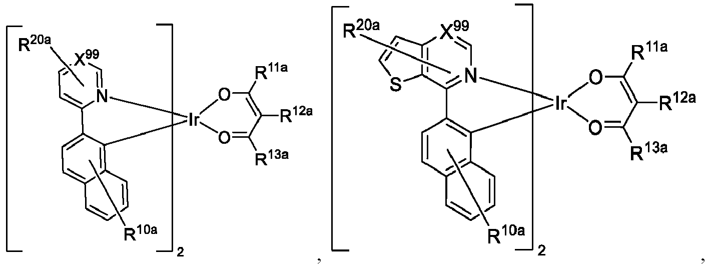 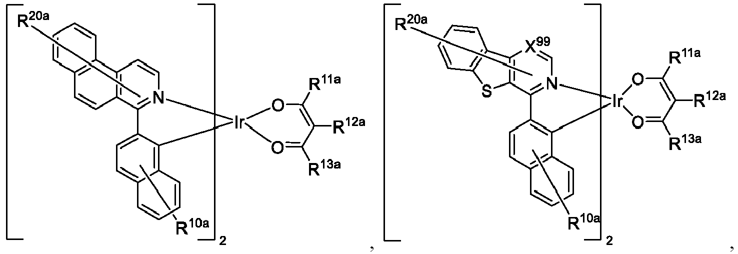 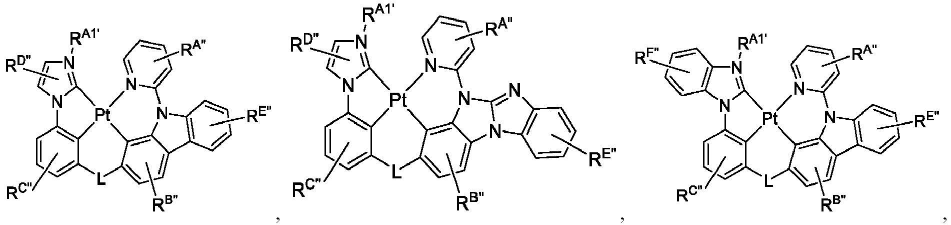 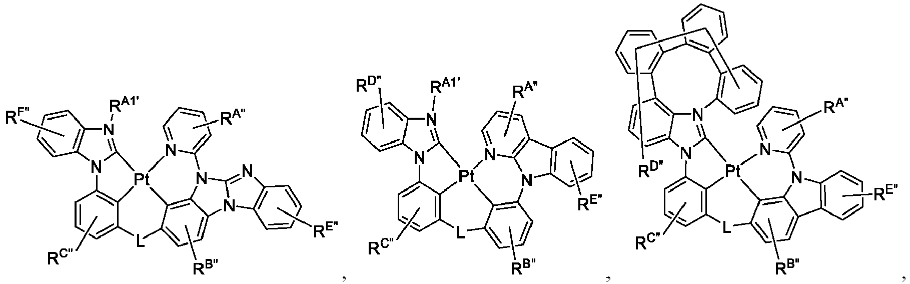 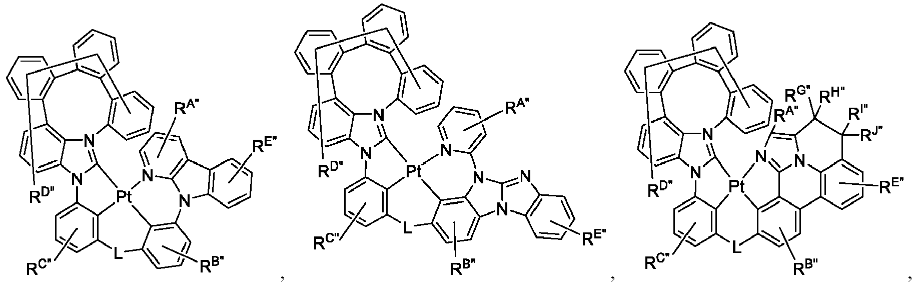 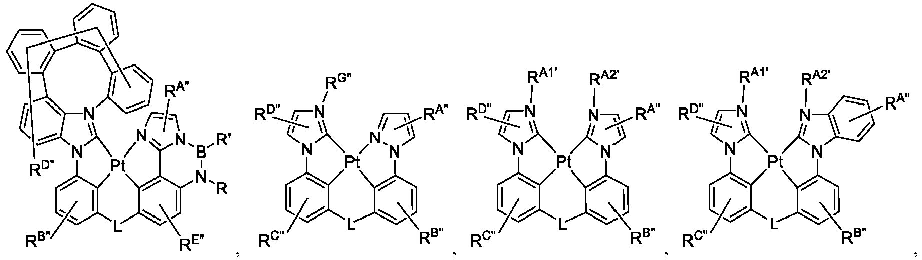 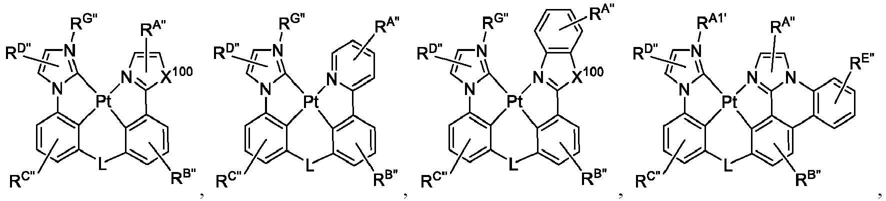 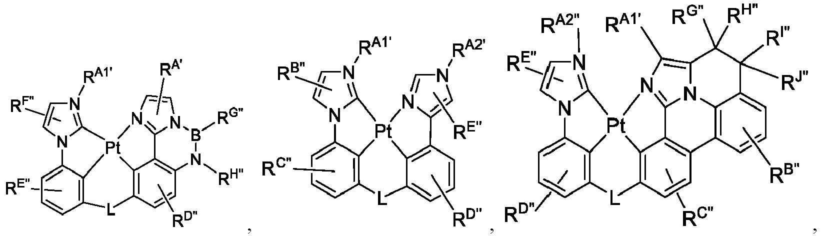 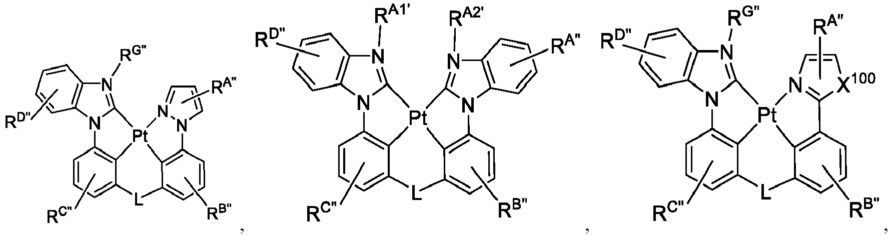 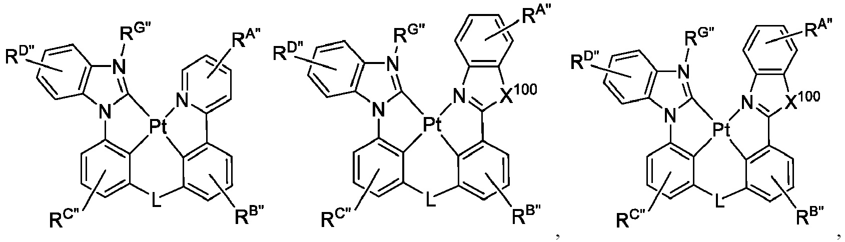 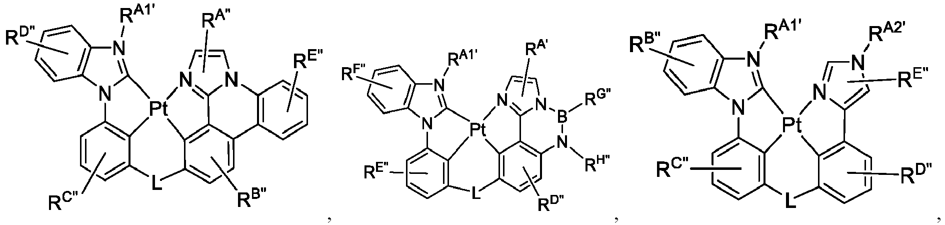 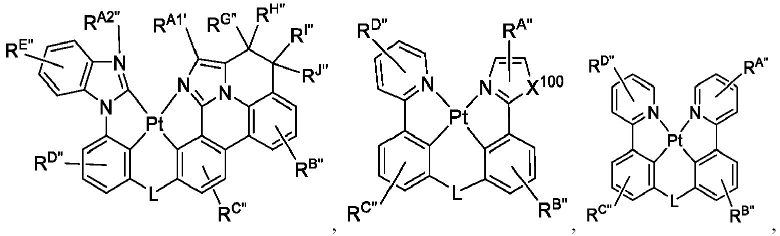 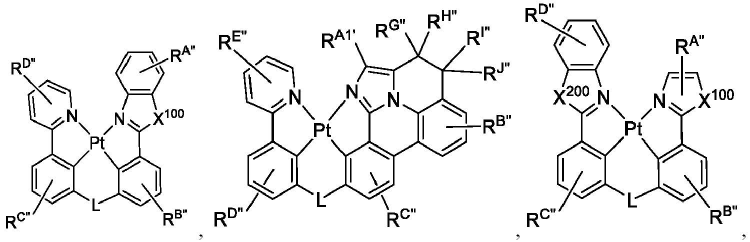 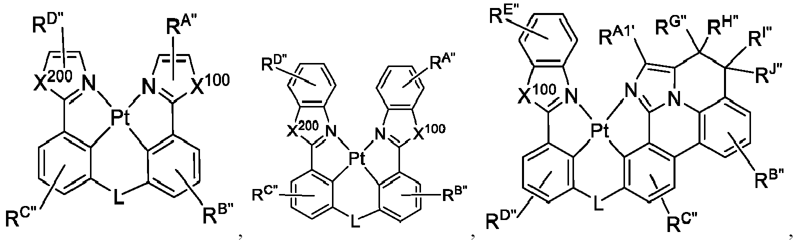 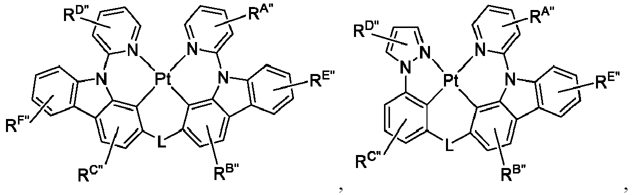 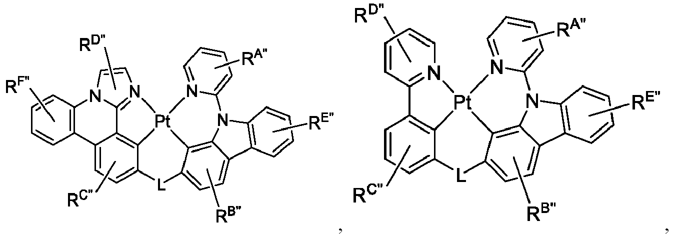 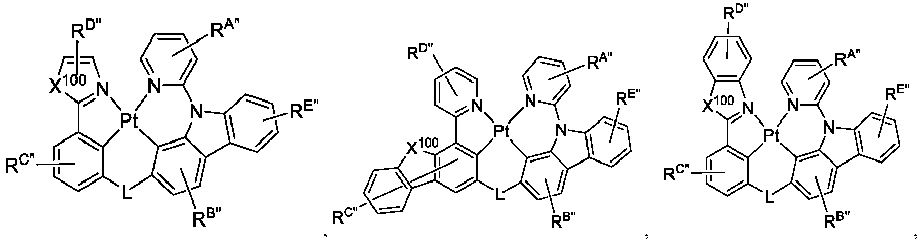 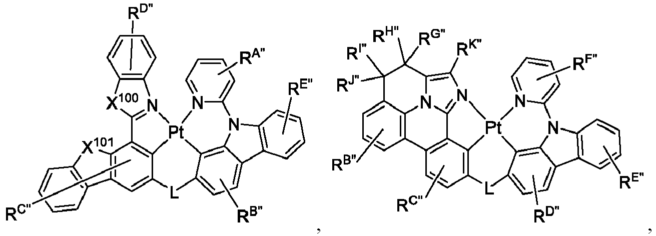 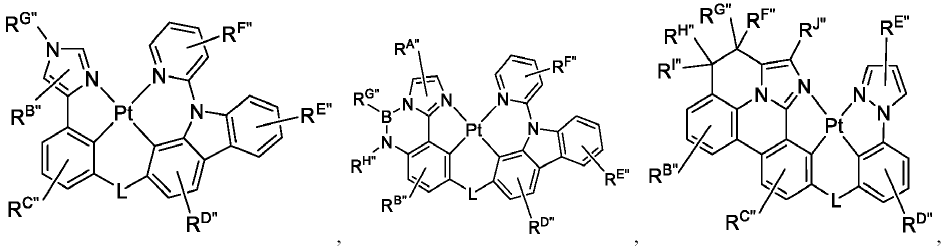 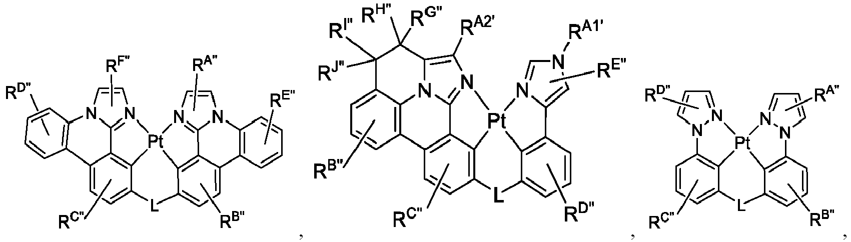 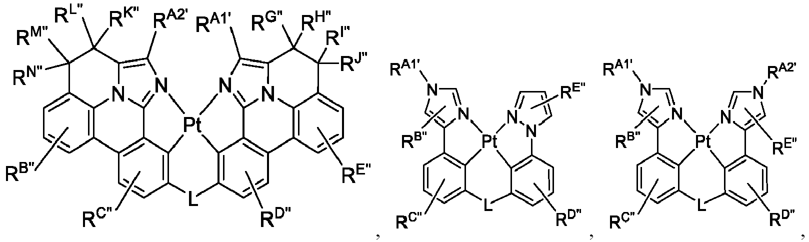 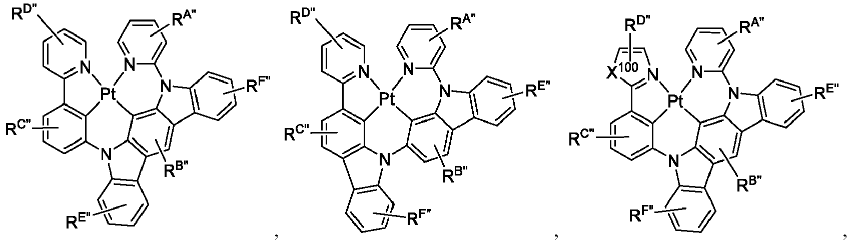 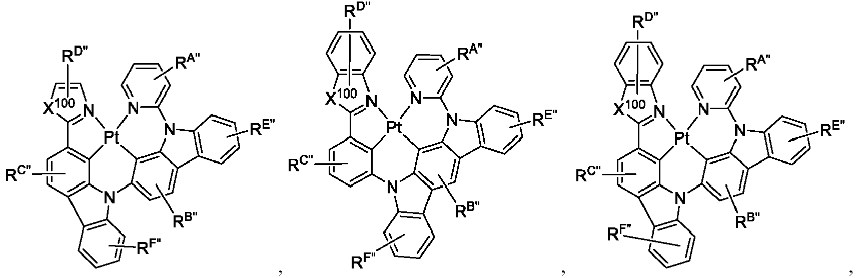 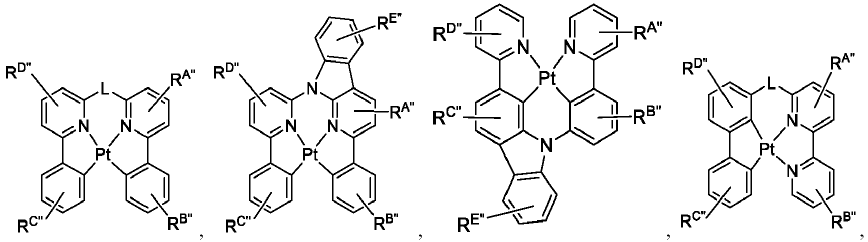 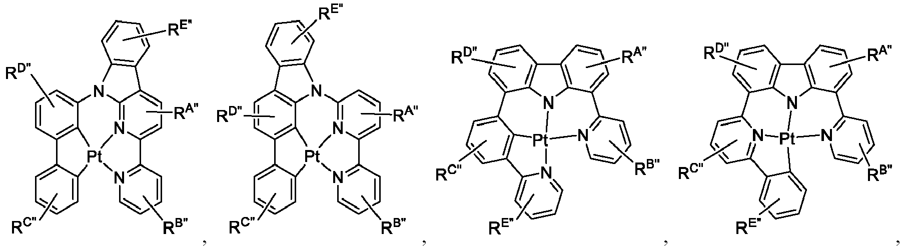 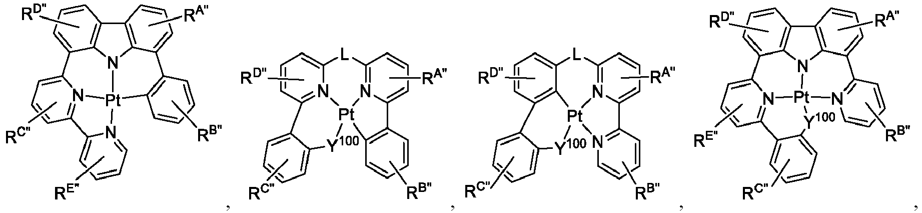 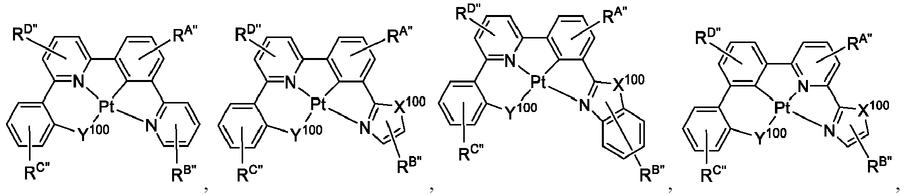 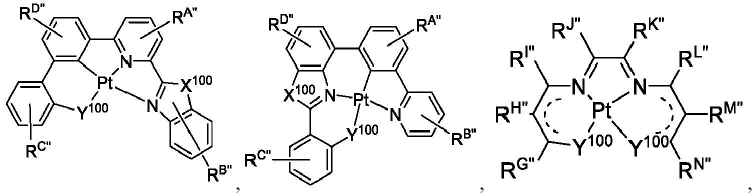 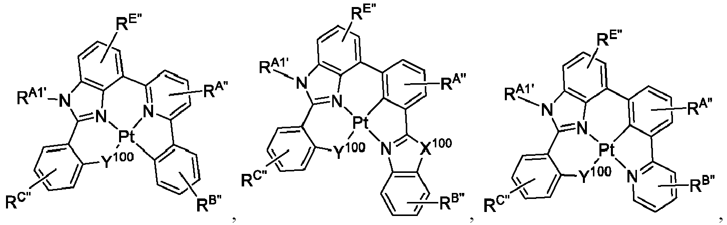 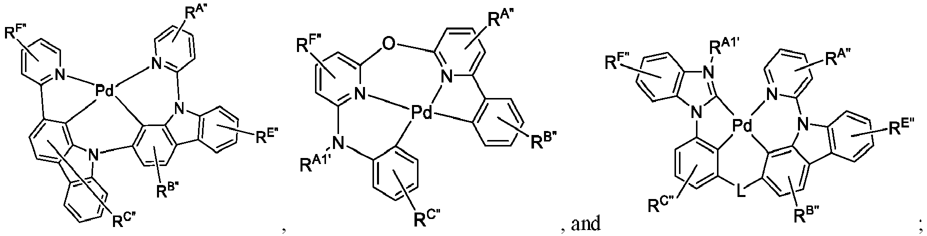 wherein:
each of X⁹⁶ to X⁹⁹ is independently C or N;
each of Y¹⁰⁰ and Y²⁰⁰ is independently selected from the group consisting of a NR", O, S, and Se;
L is independently selected from the group consisting of a direct bond, BR", BR"R‴, NR", PR", O, S, Se, C=O, C=S, C=Se, C=NR", C=CR"R‴, S=O, SO₂, CR", CR"R‴, SiR"R‴, GeR"R‴, alkyl, cycloalkyl, aryl, heteroaryl, and combinations thereof;
X¹⁰⁰, and X²⁰⁰ for each occurrence is selected from the group consisting of O, S, Se, NR", and CR"R"';
each R^{10a}, R^{20a}, R^{30a}, R^{40a}, and R^{50a}, R^{A"}, R^{B"}, R^{C"}, R^{D"}, R^{E"}, and R^{F"} independently represents mono-, up to the maximum substitutions, or no substitutions;
each R, R', R", R‴, R^{10a}, R^{11a}, R^{12a}, R^{13a}, R^{20a}, R^{30a}, R^{40a}, R^{50a}, R⁶⁰, R⁷⁰, R⁹⁷, R⁹⁸, R⁹⁹, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{E"}, R^{M"}, and R^{N"} is independently a hydrogen or a substituent selected from the group consisting of the general substituents as defined herein; wherein any two substituents can be fused or joined to form into a ring.

In some embodiments, each R, R', R", R‴, R^{10a}, R^{11a}, R^{12a}, R^{13a}, R^{20a}, R^{30a}, R^{40a}, R^{50a}, R⁶⁰, R⁷⁰, R⁹⁷, R⁹⁸, R⁹⁹, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is independently a hydrogen or a substituent selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

In some embodiments, at least one of R, R', R", R‴, R^{10a}, R^{11a}, R^{12a}, R^{13a}, R^{20a}, R^{30a}, R^{40a}, R^{50a}, R⁶⁰, R⁷⁰, R⁹⁷, R⁹⁸, R⁹⁹, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is or comprises an electron withdrawing group as defined herein.

It should be understood that the metal Pt of each of those compounds in LIST 5 can be replaced by Pd, and those derived Pd compounds are also intended to be specifically covered.

In some embodiments, the first compound S1 comprises an electron-withdrawing group. In some embodiments, the electron-withdrawing group has a Hammett constant larger than 0. In some embodiments, the electron-withdrawing group has a Hammett constant equal or larger than 0.1, 0.2, 0.3, 0.4, 0.5, 0.6, 0.7, 0.8, 0.9, 1.0, or 1.1.

In some embodiments, the first compound S1 comprises an electron-withdrawn group selected from the group consisting of the structures of the following EWG1 LIST: F, CF₃, CN, COCH₃, CHO, COCF₃, COOMe, COOCF₃, NO₂, SF₃, SiF₃, PF₄, SF₅, OCF₃, SCF₃, SeCF₃, SOCF₃, SeOCF₃, SO₂F, SO₂CF₃, SeO₂CF₃, OSeO₂CF₃, OCN, SCN, SeCN, NC, ⁺N(R^{k2})₃, (R^{k2})₂CCN, (R^{k2})₂CCF₃. CNC(CF₃)₂, BR^{k3}R^{k2}, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridoxine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated alkyl, partially and fully fluorinated aryl, partially and fully fluorinated heteroaryl, cyano -containing alkyl, cyano-containing aryl, cyano-containing heteroaryl, isocyanate, 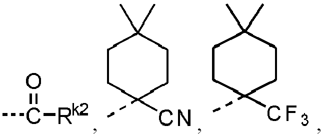 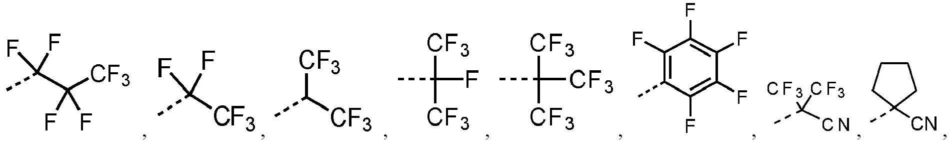 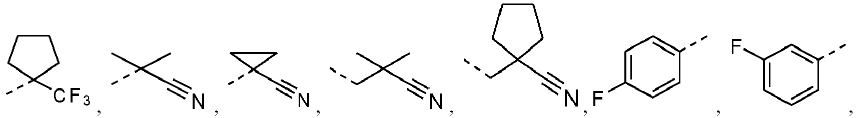 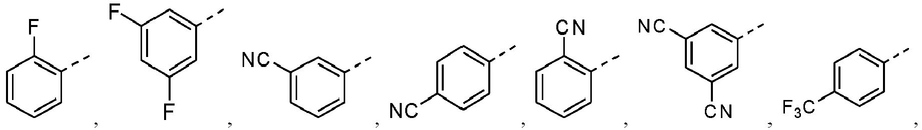 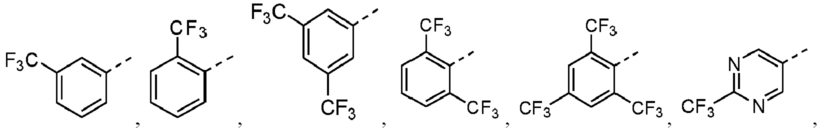 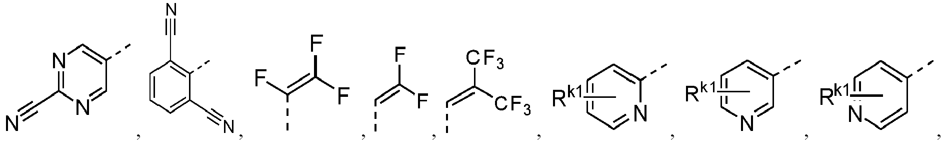 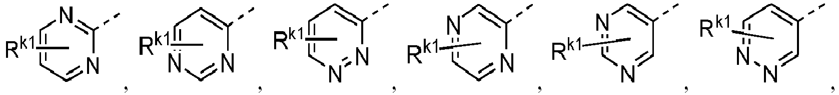 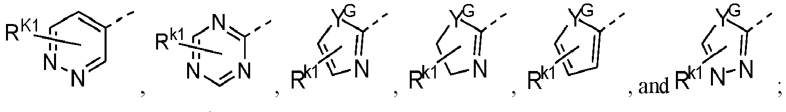
wherein each R^{k1} represents mono to the maximum allowable substitution, or no substitutions;
wherein Y^{G} is selected from the group consisting of BRₑ, NRₑ, PRₑ, O, S, Se, C=O, S=O, SO₂, CRₑR_{f}, SiRₑR_{f}, and GeRₑR_{f}; and
wherein each of R^{k1}, R^{k2}, R^{k3}, Rₑ, and R_{f} is independently a hydrogen or a substituent selected from the group consisting of the General Substituents defined herein.

In some embodiments, the first compound S 1 comprises an electron-withdrawing group selected from the group consisting of the structures of the following EWG2 List: 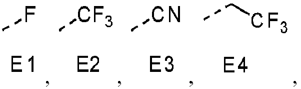 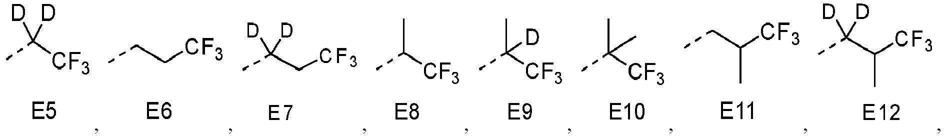 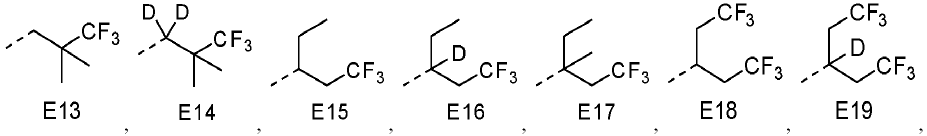 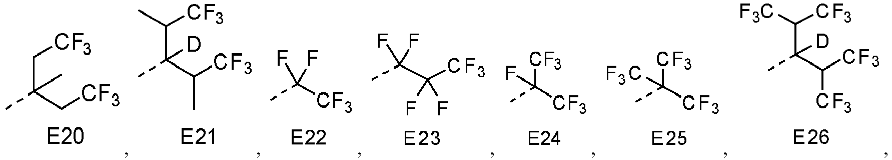 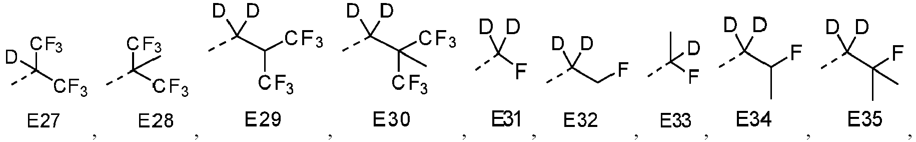 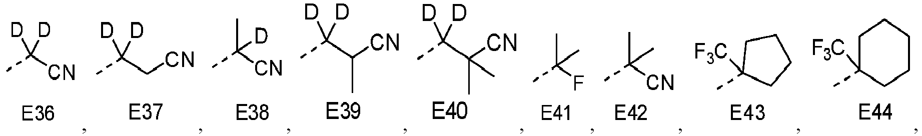 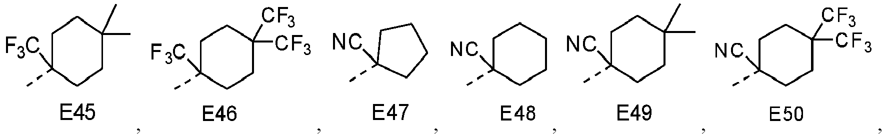 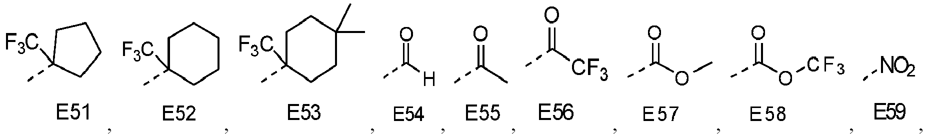 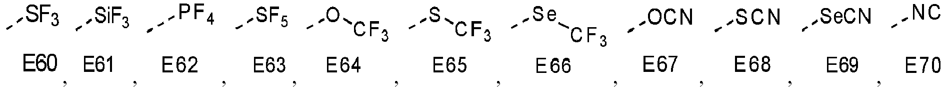 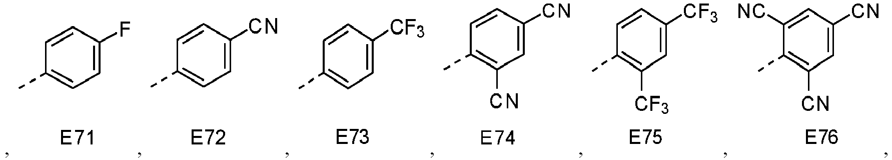 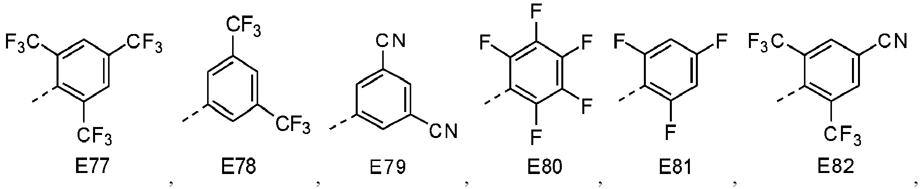 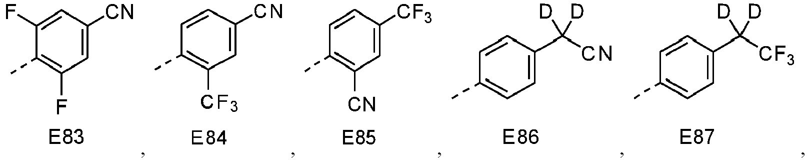 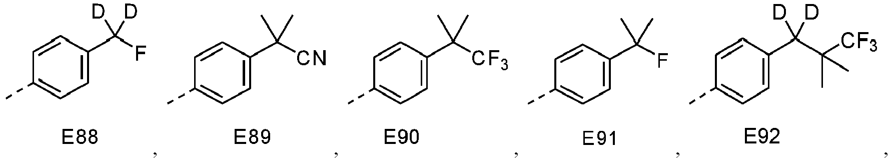 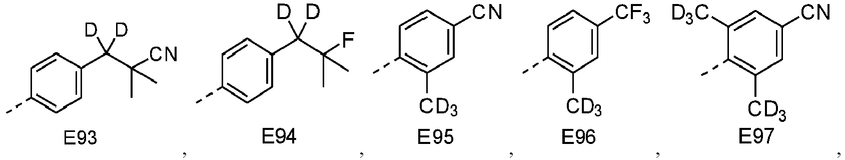 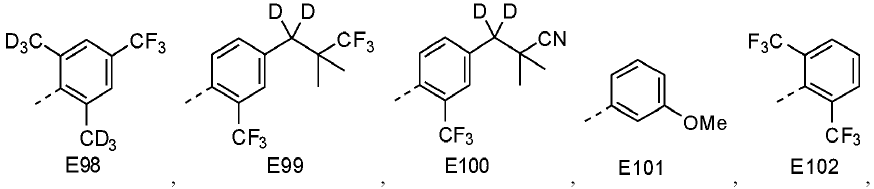 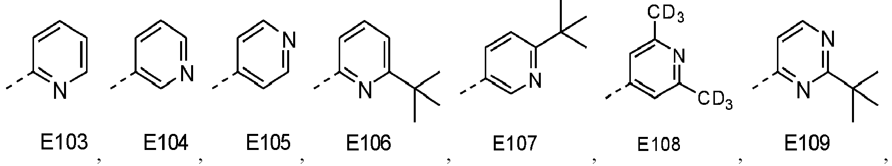 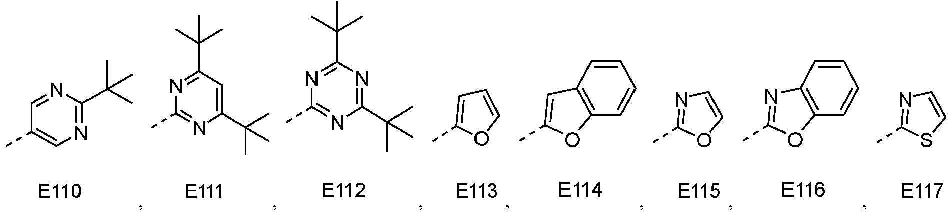 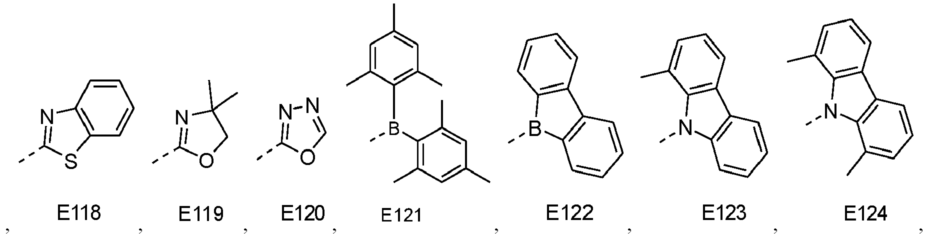 and

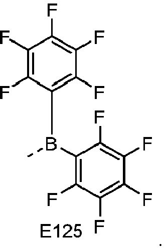

In some embodiments, the first compound S1 comprises an electron-withdrawing group selected from the group consisting of the structures of the following EWG3 LIST:

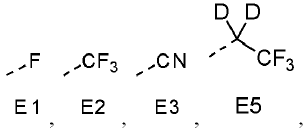

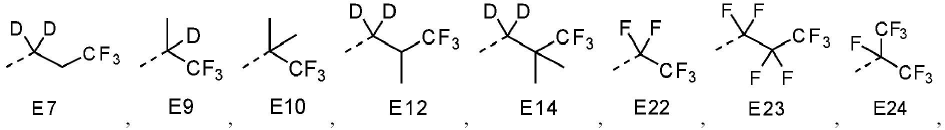

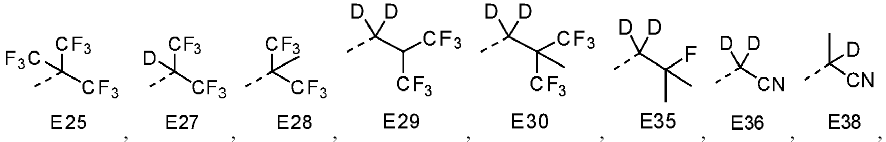

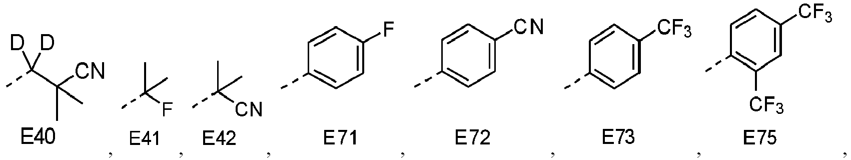

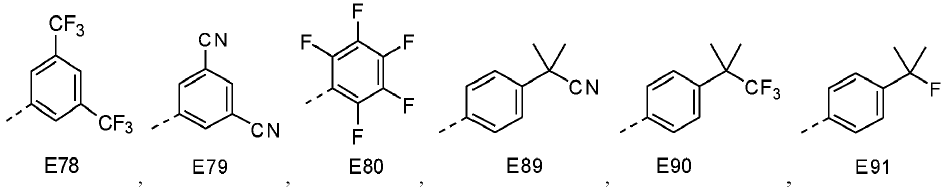

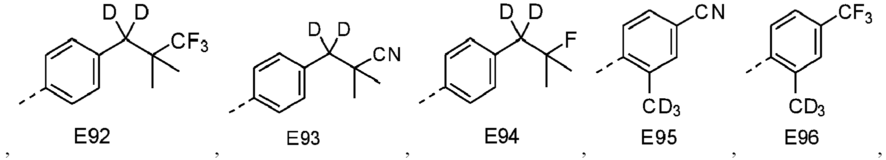

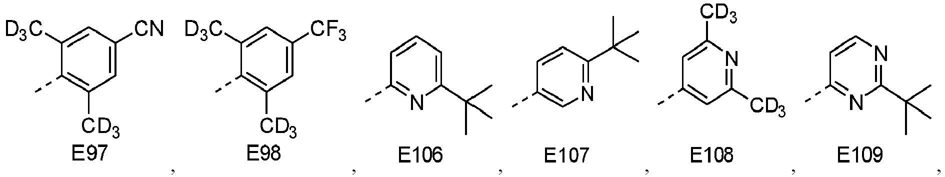

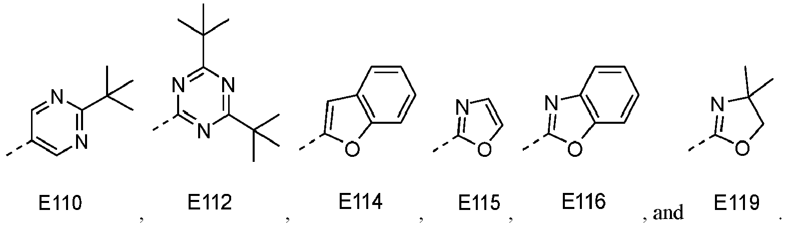

In some embodiments, the fiorst compound S1 comprises an electron-withdrawing group selected from the group consisting of the structures of the following EWG4 LIST:

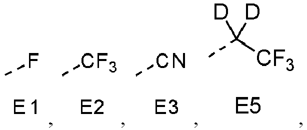

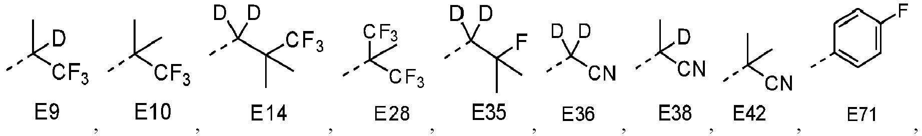

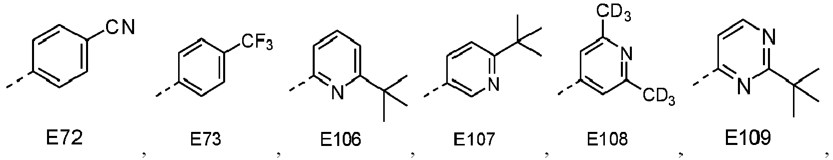

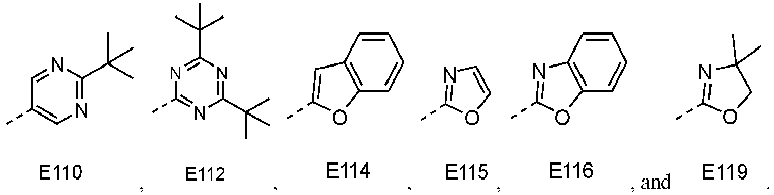

In some embodiments, the first compound S 1 comprises an electron-withdrawing group that is a π-electron deficient electron-withdrawing group. In some embodiments, the π-electron deficient electron-withdrawing group is selected from the group consisting of the structures of the following Pi-EWG LIST: CN, COCH₃, CHO, COCF₃, COOMe, COOCF₃, NO₂, SF₃, SiF₃, PF₄, SF₅, OCF₃, SCF₃, SeCF₃, SOCF₃, SeOCF₃, SO₂F, SO₂CF₃, SeO₂CF₃, OSeO₂CF₃, OCN, SCN, SeCN, NC, ⁺N(R^{k2})₃, BR^{k2}R^{k3}, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridazine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated aryl, partially and fully fluorinated heteroaryl, cyano-containing aryl, cyano-containing heteroaryl, isocyanate, 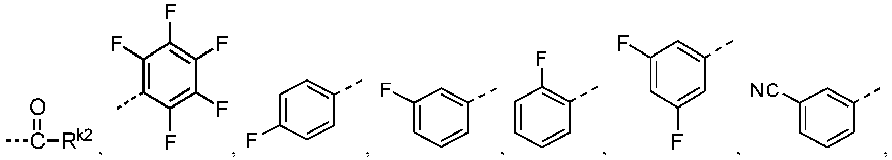 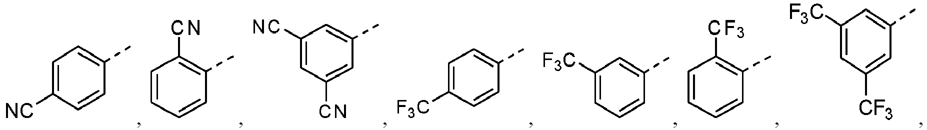 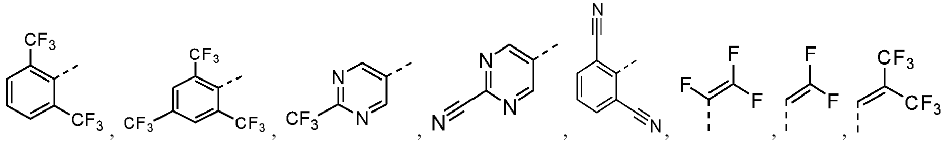 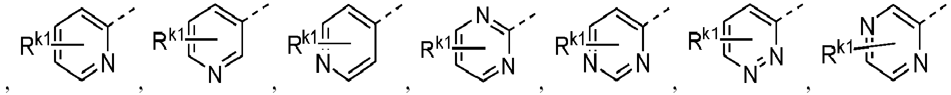 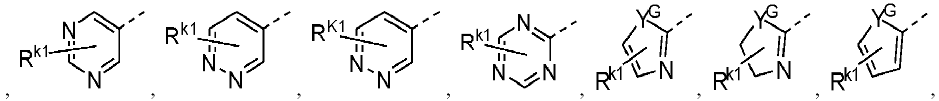 and 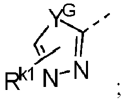 wherein the variables are the same as previously defined.

In some embodiments, the first compound S1 is selected from the group consisting of the structures of the following LIST 7: 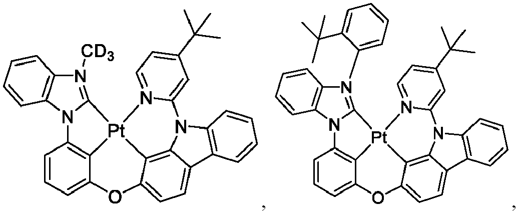 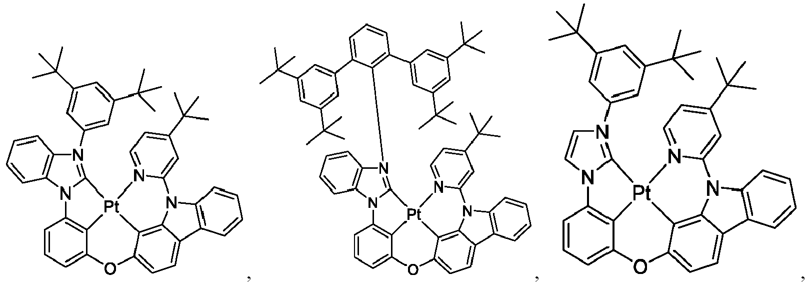 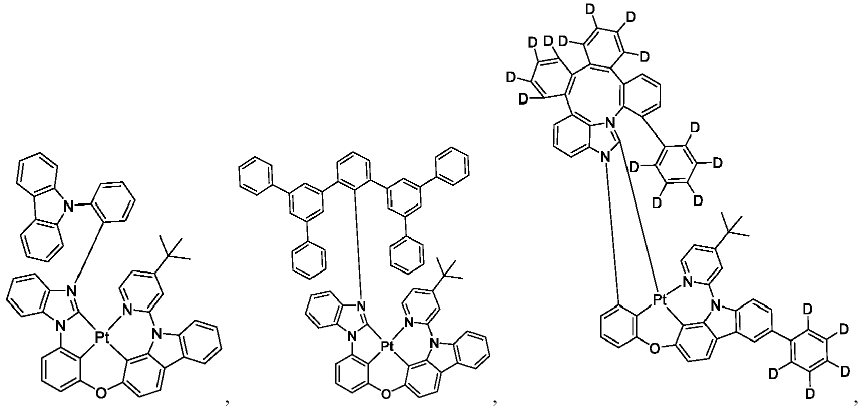 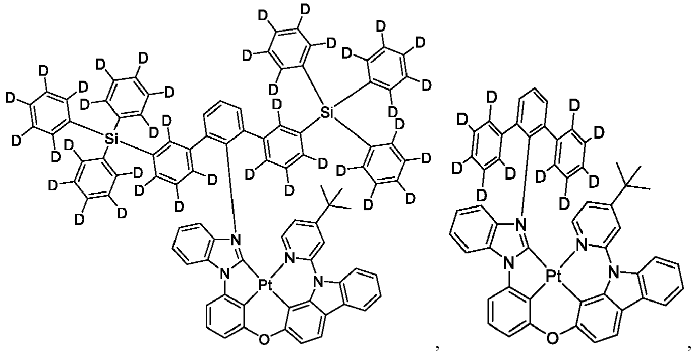 and

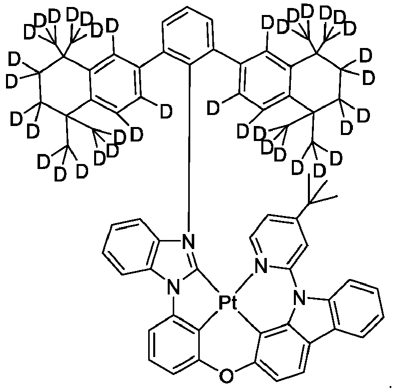

In some embodiments, the sensitizer is capable of functioning as a phosphorescent emitter, a TADF emitter, or a doublet emitter in an OLED at room temperature. In some embodiments, the acceptor is selected from the group consisting of a delayed-fluorescent compound functioning as a TADF emitter in the OLED at room temperature, a fluorescent compound functioning as a fluorescent emitter in the OLED at room temperature. In some embodiments, the fluorescent emitter can be a singlet or doublet emitters. In some of such embodiments, the singlet emitter can also include a TADF emitter, furthermore, a multi-resonant MR-TADF emitter. Description of the delayed fluorescence as used herein can be found in U.S. application publication US20200373510A1, at paragraphs 0083-0084, the entire contents of which are incorporated herein by reference.

In some embodiments of the OLED, the sensitizer and the acceptor are in separate layers within the emissive region.

In some embodiments, the sensitizer and the acceptor are present as a mixture in one or more layers in the emissive region. It should be understood that the mixture in a given layer can be a homogeneous mixture or the compounds in the mixture can be in graded concentrations through the thickness of the given layer. The concentration grading can be linear, non-linear, sinusoidal, etc. When there are more than one layer in the emissive region having a mixture of the sensitizer and the acceptor compounds, the type of mixture (i.e., homogeneous or graded concentration) and the concentration levels of the compounds in the mixture in each of the more than one layer can be the same or different. In addition to the sensitizer and the acceptor compounds, there can be one or more other functional compounds such as, but not limit to, hosts also mixed into the mixture.

In some embodiments, the acceptor can be in two or more layers with the same or different concentration. In some embodiments, when two or more layers contain the acceptor, the concentration of the acceptor in at least two of the two or more layers are different. In some embodiments, the concentration of the sensitizer in the layer containing the sensitizer is in the range of 1 to 50 %, 10 to 20 %, or 12-15 % by weight. In some embodiments, the concentration of the acceptor in the layer containing the acceptor is in the range of 0.1 to 10 %, 0.5 to 5 %, or 1 to 3 % by weight.

In some embodiments, the emissive region contains *N* layers where *N* > 2. In some embodiments, the sensitizer is present in each of the *N* layers, and the acceptor is contained in fewer than or equal to *N-*1 layers. In some embodiments, the sensitizer is present in each of the *N* layers, and the acceptor is contained in fewer than or equal to *N*/2 layers. In some embodiments, the acceptor is present in each of the *N* layers, and the sensitizer is contained in fewer than or equal to *N*-1 layers. In some embodiments, the acceptor is present in each of the *N* layers, and the sensitizer is contained in fewere than or equal to *N*/2 layers.

In some embodiments, the OLED emits a luminescent emission comprising an emission component from the S₁ energy (the first singlet energy) of the acceptor when a voltage is applied across the OLED. In some embodiments, at least 65%, 75%, 85%, or 95% of the emission from the OLED is produced from the acceptor with a luminance of at least 10 cd/m². In some embodiments, S₁ energy of the acceptor is lower than that of the sensitizer.

In some embodiments, a T₁ energy (the first triplet energy) of the host compound is greater than or equal to the T₁ energies of the sensitizer and the acceptor, and the T₁ energy of the sensitizer is greater than or equal to the S₁ energy (the first singlet energy) of the acceptor. In some embodiments, S₁-T₁ energy gap of the sensitizer, and/or the acceptor, and/or first host compound, and/or second host compound is less than 400, 300, 250, 200, 150, 100, or 50 meV. In some embodiments, the absolute energy difference between the HOMO of the sensitizer and the HOMO of the acceptor is less than 0.6, 0.5, 0.4, 0.3, or 0.2 eV. In some embodiments, the absolute energy difference between the LUMO of the sensitizer and the LUMO of the acceptor is less than 0.6, 0.5, 0.4, 0.3, or 0.2 eV.

In some embodiments where the sensitizer provides unicolored sensitization (i.e., minimal loss in energy upon energy transfer to the acceptor), the acceptor has a Stokes shift of 30, 25, 20, 15, or 10 nm or less. An example would be a broad blue phosphor sensitizing a narrow blue emitting acceptor.

In some embodiments where the sensitizer provides a down conversion process (e.g., a blue emitter being used to sensitize a green emitter, or a green emitter being used to sensitize a red emitter), the acceptor ha s a Stokes shift of 30, 40, 60, 80, or 100 nm or more.

In some embodiments, the difference between λmax of the emission spectrum of the sensitizer and λmax of the absorption spectrum of the acceptor is 50, 40, 30, or 20 nm or less. In some embodiments, the spectral overlap of the light absorbing area of the acceptor and the light emitting area of the sensitizer relative to the light emitting area of the sensitizer, is greater than 5%, 10%, 15%, 20%, 30%, 40%, 50%, or more.

One way to quantify the qualitative relationship between a sensitizer compound (a compound to be used as the sensitizer in the emissive region of the OLED of the present disclosure) and an acceptor compound (a compound to be used as the acceptor in the emissive region of the OLED of the present disclosure) is by determining a value Δλ = λₘₐₓ₁ - λₘₐₓ₂, where λₘₐₓ₁ and λₘₐₓ₂ are defined as follows. λₘₐₓ₁ is the emission maximum of the sensitizer compound at room temperature when the sensitizer compound is used as the sole emitter in a first monochromic OLED (an OLED that emits only one color) that has a first host. λₘₐₓ₂ is the emission maximum of the acceptor compound at room temperature when the acceptor compound is used as the sole emitter in a second monochromic OLED that has the same first host.

In some embodiments of the OLED of the present disclosure where the sensitizer provides unicolored sensitization (i.e., minimal loss in energy upon energy transfer to the acceptor), Δλ (determined as described above) is equal to or less than the number selected from the group consisting of 15, 12, 10, 8, 6, 4, 2, 0, -2, -4, - 6, -8, and -10 nm.

In some embodiments, a spectral overlap integral of the sensitizer and the acceptor is at least 10¹⁴ nm^{4*}L/cm*mol. In some embodiments, a spectral overlap integral of the sensitizer and the acceptor is at least 5 × 10¹⁴ nm^{4*}L/cm*mol. In some embodiments, a spectral overlap integral of the sensitizer and the acceptor is at least 10¹⁵ nm^{4*}L/cm*mol.

As used herein, "spectral overlap integral" is determined by multiplying the acceptor extinction spectrum by the sensitizer emission spectrum normalized with respect to the area under the curve. The higher the spectral overlap, the better the Förster Resonance Energy Transfer (FRET) efficiency. The rate of FRET is proportional to the spectral overlap integral. Therefore, a high spectral overlap can help improve the FRET efficiency and reduce the exciton lifetime in an OLED.

In some embodiments, the acceptor and the sensitizer are selected in order to increase the spectral overlap. Increasing the spectral overlap can be achieved in several ways, for example, increasing the oscillator strength of the acceptor, minimizing the distance between the sensitizer peak emission intensity and the acceptor absorption peak, and narrowing the line shape of the sensitizer emission or the acceptor absorption. In some embodiments, the oscillator strength of the acceptor is greater than or equal to 0.1.

In some embodiments where the emission of the acceptor is redshifted by the sensitization, the absolute value of Δλ is equal to or greater than the number selected from the group consisting of 20, 30, 40, 60, 80, 100 nm.

In some embodiments, the sensitizer and/or the acceptor can be a phosphorescent or fluorescent emitter. Phosphorescence generally refers to emission of a photon with a change in electron spin quantum number, i.e., the initial and final states of the emission have different electron spin quantum numbers, such as from T1 to S0 state. Ir and Pt complexes currently widely used in the OLED belong to phosphorescent emitters. In some embodiments, if an exciplex formation involves a triplet emitter, such exciplex can also emit phosphorescent light. On the other hand, fluorescent emitters generally refer to emission of a photon without a change in electron spin quantum number, such as from S1 to S0 state, or from D1 to D0 state. Fluorescent emitters can be delayed fluorescent or non-delayed fluorescent emitters. Depending on the spin state, fluorescent emitter can be a singlet emitter or a doublet emitter, or other multiplet emitter. It is believed that the internal quantum efficiency (IQE) of fluorescent OLEDs can exceed the 25% spin statistics limit through delayed fluorescence. There are two types of delayed fluorescence, i.e. P-type and E-type delayed fluorescence. P-type delayed fluorescence is generated from triplet-triplet annihilation (TTA). On the other hand, E-type delayed fluorescence does not rely on the collision of two triplets, but rather on the thermal population between the triplet states and the singlet excited states. Thermal energy can activate the transition from the triplet state back to the singlet state. This type of delayed fluorescence is also known as thermally activated delayed fluorescence (TADF). E-type delayed fluorescence characteristics can be found in an exciplex system or in a single compound. Without being bound by theory, it is believed that TADF requires a compound or an exciplex having a small singlet-triplet energy gap (ΔE_{S-T}) less than or equal to 400, 350, 300, 250, 200, 150, 100, or 50 meV. There are two major types of TADF emitters, one is called donor-acceptor type TADF, the other one is called multiple resonance (MR) TADF. Often, donor-acceptor single compounds are constructed by connecting an electron donor moiety such as amino- or carbazole-derivatives and an electron acceptor moiety such as N-containing six-membered aromatic rings or cyano-substituted aromatic rings. Donor-acceptor exciplex can be formed between a hole transporting compound and an electron transporting compound. The examples for MR-TADF include highly conjugated fused ring systems. In some embodiments, MR-TADF materials comprising boron, carbon, and nitrogen atoms. They may comprise other atoms as well, for example oxygen. In some embodiments, the reverse intersystem crossing time from T1 to S1 of the delayed fluorescent emission at 293K is less than or equal to 10 microseconds. In some embodiments, such time can be greater than 10 microseconds and less than 100 microseconds.

In some embodiments, the second compound A1 is a delayed-fluorescent compound functioning as a TADF emitter at room temperature.

In some embodiments, the TADF emitter comprises at least one donor group and at least one acceptor group.

In some embodiments, the TADF emitter is a metal complex. In some embodiments, the TADF emitter is a Cu, Zn, Zr, Ag, or Au complex.

In some embodiments, the TADF emitter is a non-metal complex.

In some embodiments, the TADF emitter is a boron-containing compound.

In some embodiments of the OLED, the TADF emitter comprises a boron atom. In some embodiments, the TADF emitter comprises at least one of the chemical moieties selected from the group consisting of the structures of the following LIST 8: 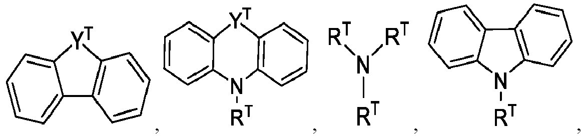 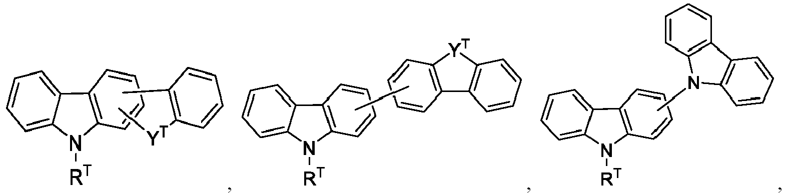 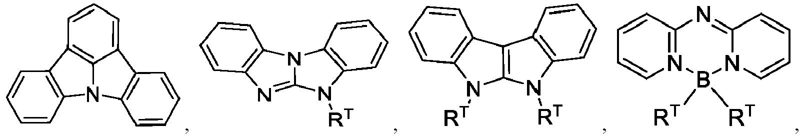 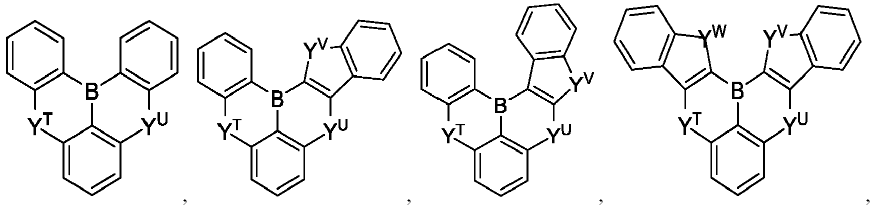 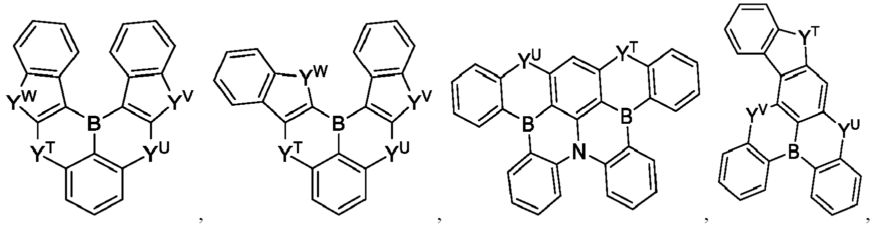 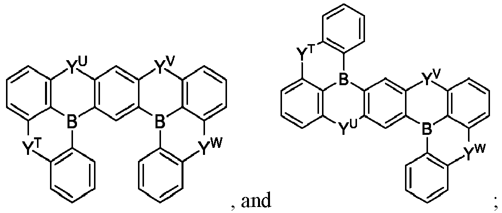
wherein T is selected from the group consisting of BR, NR, PR, O, S, Se, C=O, S=O, SO₂, CRR', SiRR', and GeRR';
wherein each R^{T} can be the same or different and each R^{T} is independently a donor, an acceptor group, an organic linker bonded to a donor group, an organic linker bonded to an acceptor group, or a terminal group selected from the group consisting of alkyl, cycloalkyl, heteroalkyl, heterocycloalkyl, arylalkyl, aryl, heteroaryl, and combinations thereof; and
each R and R' is independently a hydrogen or a substituent selected from the group consisting of the general substituents as defined herein.

In some of the above embodiments, any carbon ring atoms up to maximum of a total number of three, together with their substituents, in each phenyl ring of any of above structures can be replaced with N.

In some embodiments, the TADF emitter comprises at least one of the acceptor moieties selected from the group consisting of nitrile, isonitrile, borane, fluoride, pyridine, pyrimidine, pyrazine, triazine, aza-carbazole, aza-dibenzothiophene, aza-dibenzofuran, aza-dibenzoselenophene, aza-triphenylene, imidazole, pyrazole, oxazole, thiazole, isoxazole, isothiazole, triazole, thiadiazole, and oxadiazole. In some embodiments, the acceptor moieties and the donor moieties as described herein can be connected directly, through a conjugated linker, or a non-conjugated linker, such as a sp3 carbon or silicon atom.

In some embodiments of the OLED, the TADF emitter has the formula of M(L⁵)(L⁶), wherein M is Cu, Ag, or Au, L⁵ and L⁶ are different, and L⁵ and L⁶ are independently selected from the group consisting of: 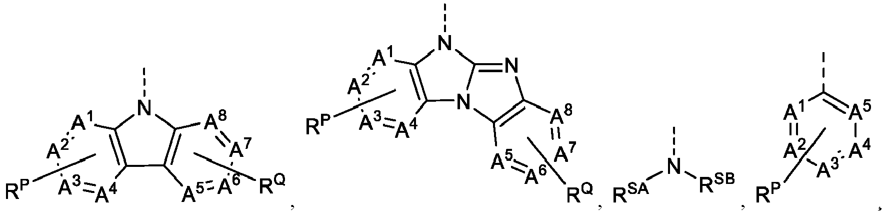 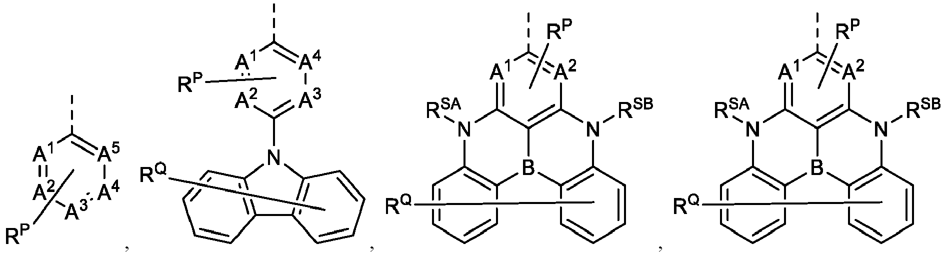 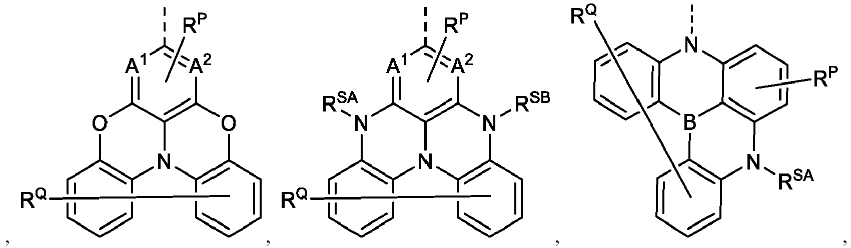 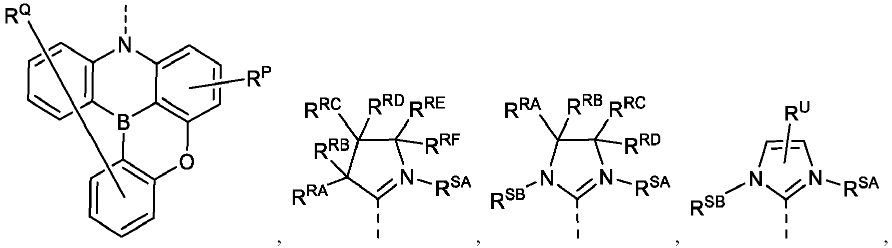 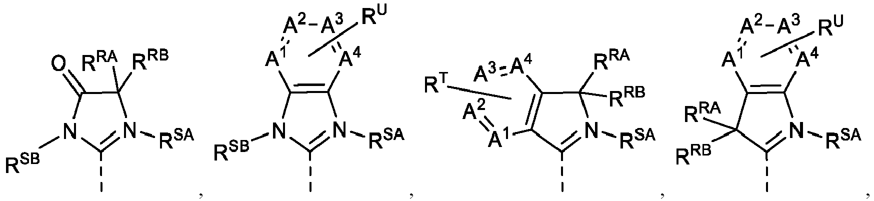 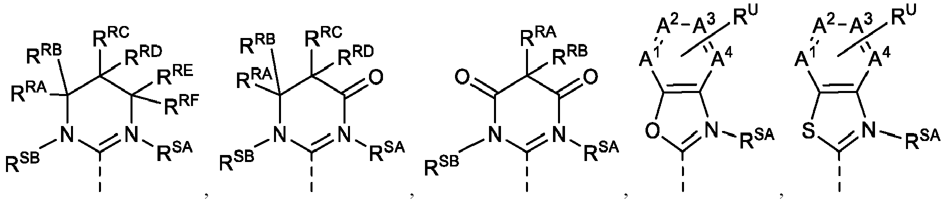 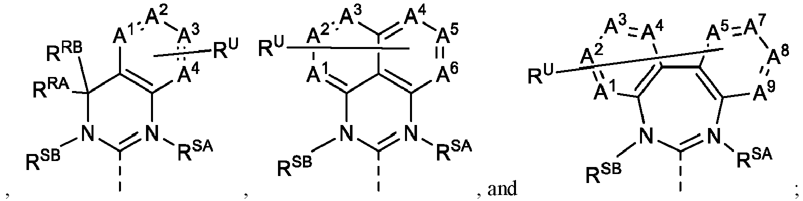
wherein A¹ - A⁹ are each independently selected from C or N;
wherein each R^{P}, R^{P}, R^{U}, R^{SA}, R^{SB}, R^{RA}, R^{RB}, R^{RC}, R^{RD}, R^{RE}, and R^{FF} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof.

In some embodiments of the OLED, the TADF emitter may be one of the following: 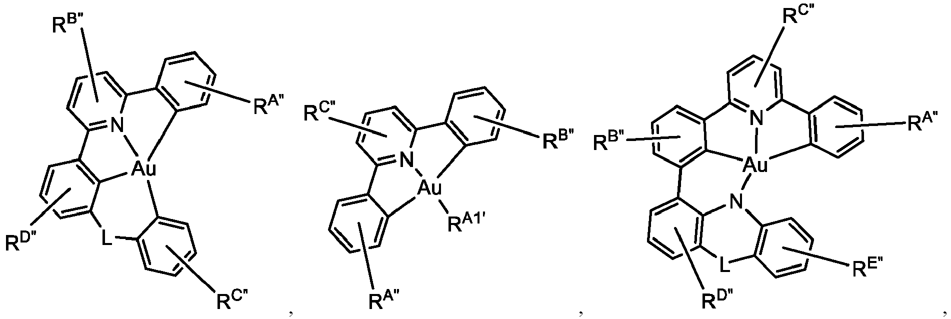 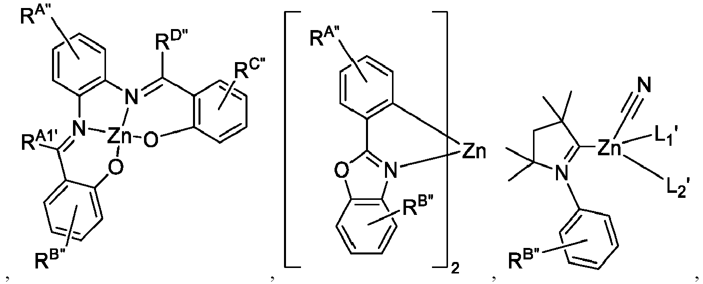 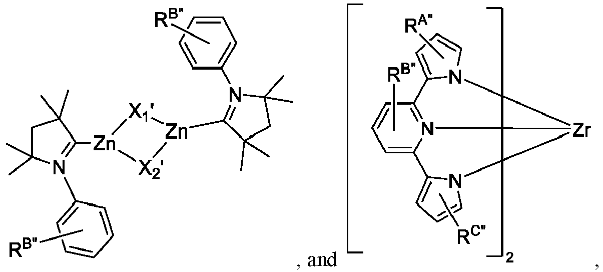
wherein each R^{A"}, R^{B"}, R^{C"}, R^{D"}, R^{E"}, and R^{F"} can independently represent from mono to the maximum possible number of substitutions, or no substitution;
each R", R‴, R^{A1}, R^{A"}, R^{B"}, R^{C"}, R^{D"}, R^{E"}, and R^{F"} is independently a hydrogen or a substituent selected from the group consisting of the general substituents as defined herein; wherein any two substituents can be fused or joined to form into a ring.
wherein L is independently selected from the group consisting of a direct bond, BR", BR"R‴, NR", PR", O, S, Se, C=O, C=S, C=Se, C=NR", C=CR"R‴, S=O, SO₂, CR", CR"R‴, SiR"R‴, GeR"R‴, alkyl, cycloalkyl, aryl, heteroaryl, and combinations thereof;
wherein each of L₁^{'} and L₂^{'} is a monodentate anionic ligand,
wherein each of X₁' and X₂' is a halide; and
wherein any two substituents can be fused or joined to form a ring.

In some embodiments of the OLED, the TADF emitter is selected from the group consisting of the structures in the following TADF LIST:

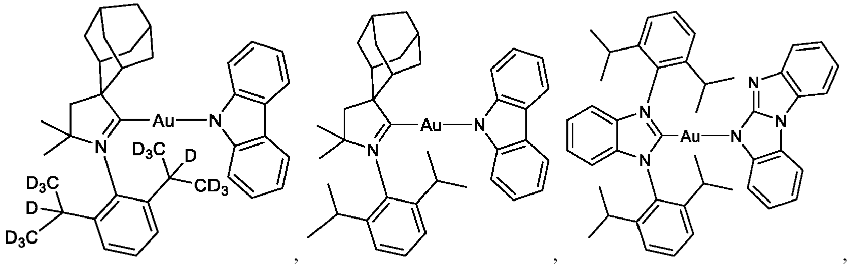

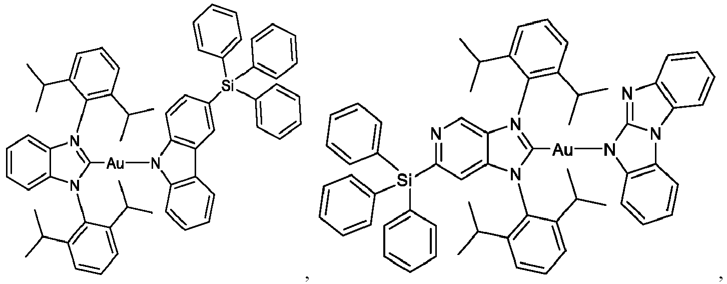

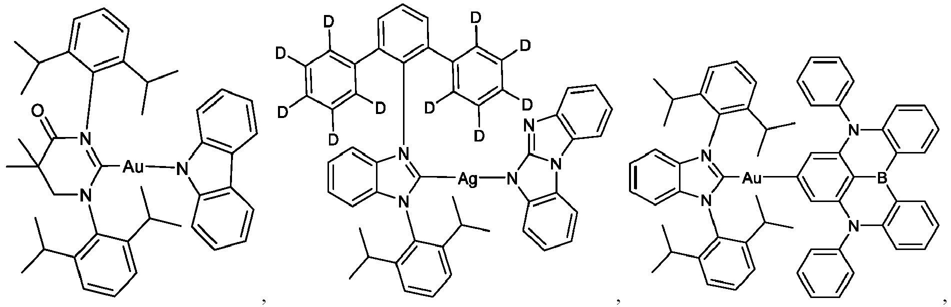

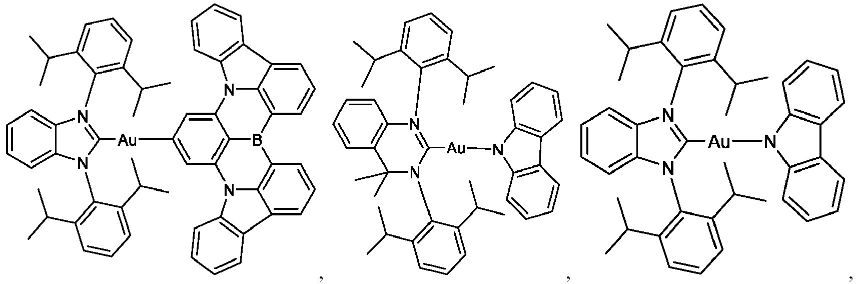

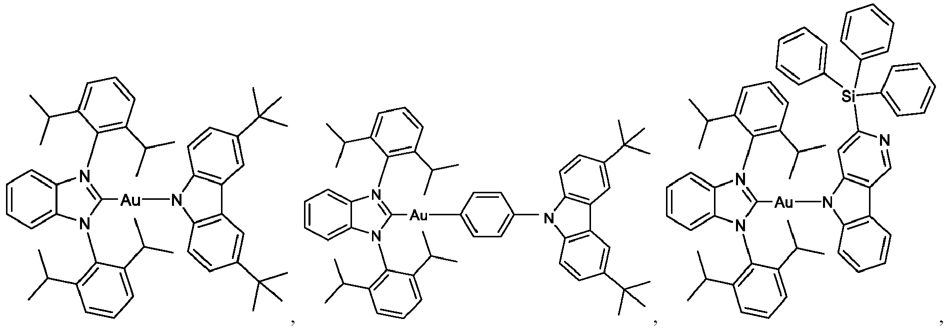

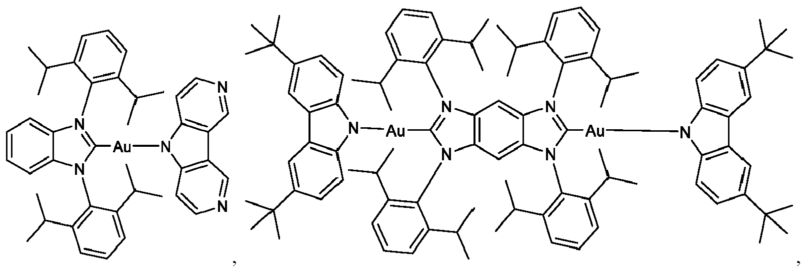

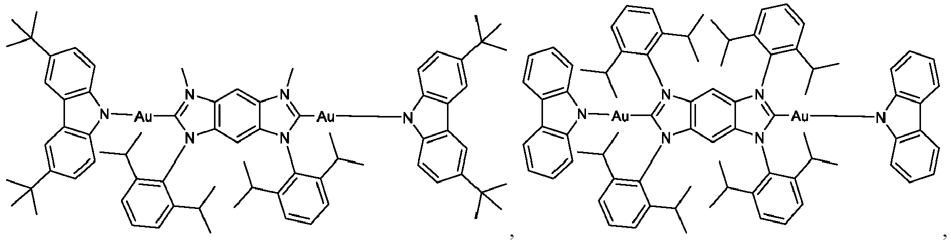

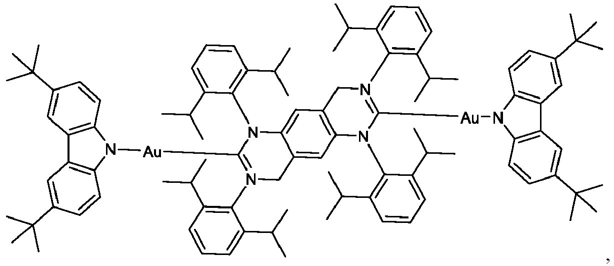

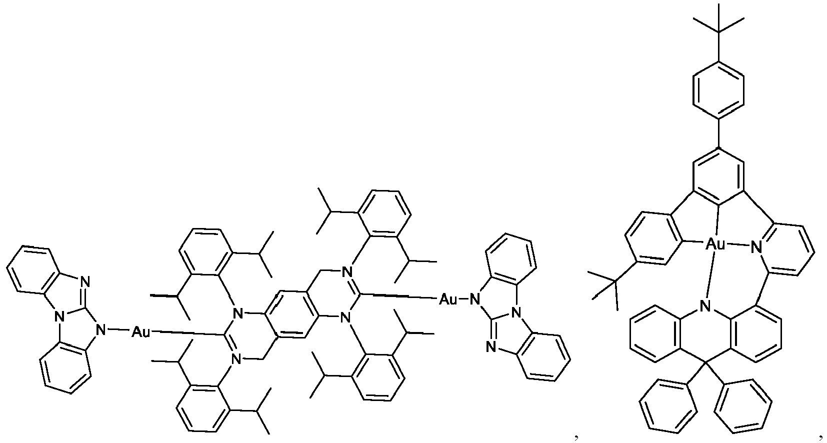

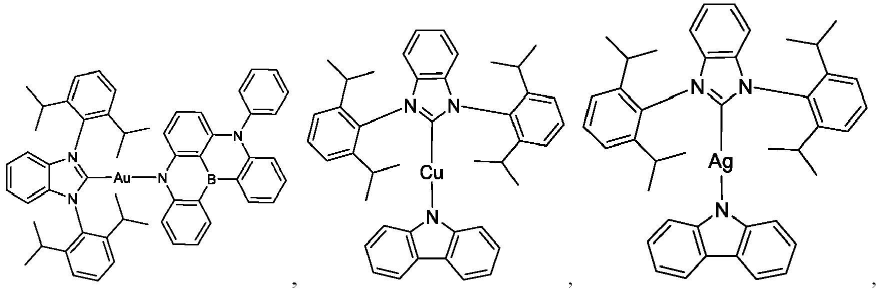

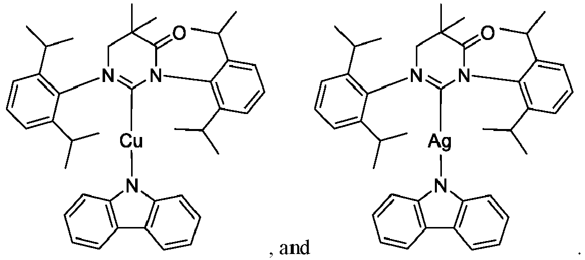

In some embodiments, the second compound A1 is selected from the group consisting of the structures of the following LIST 9: 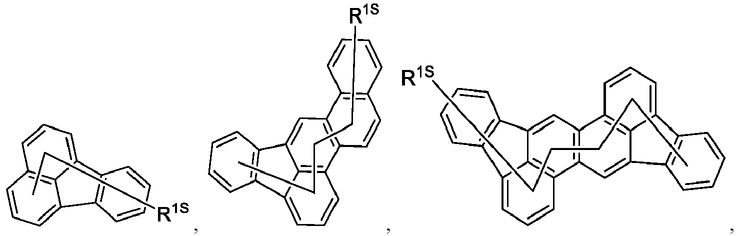 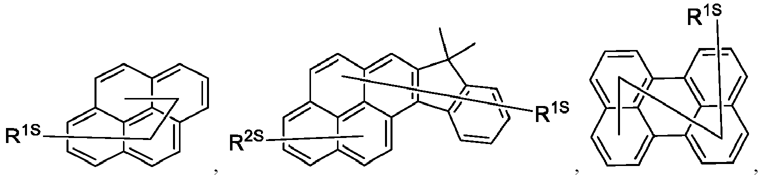 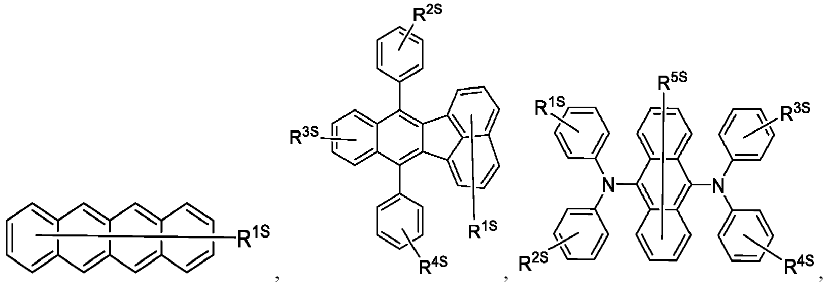 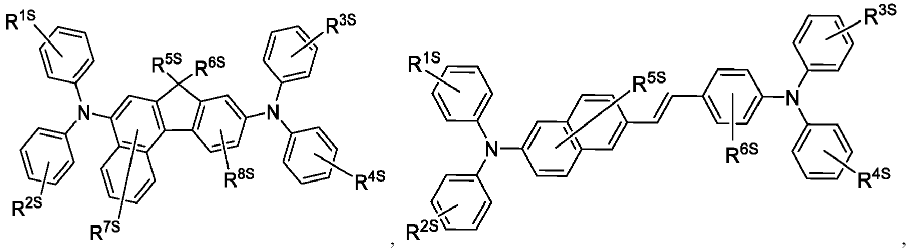 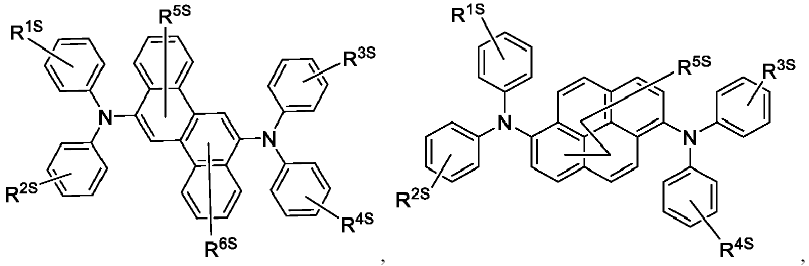 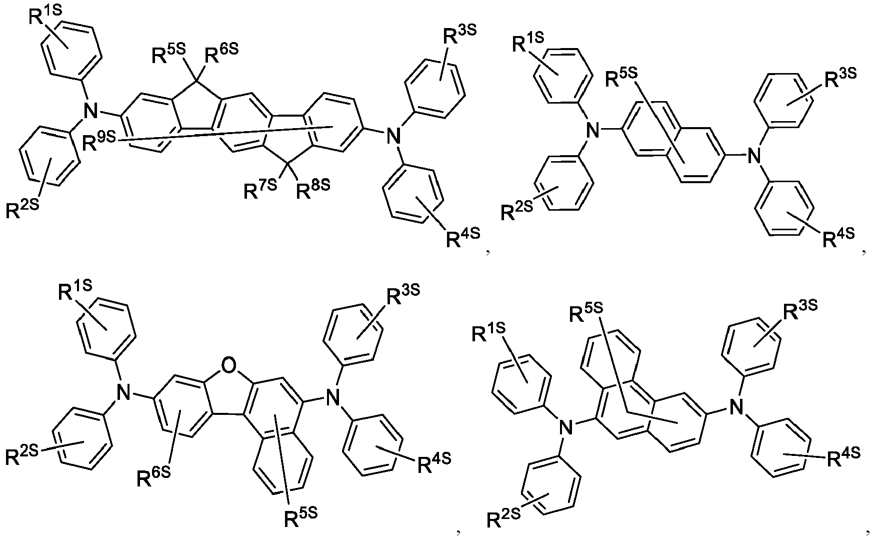 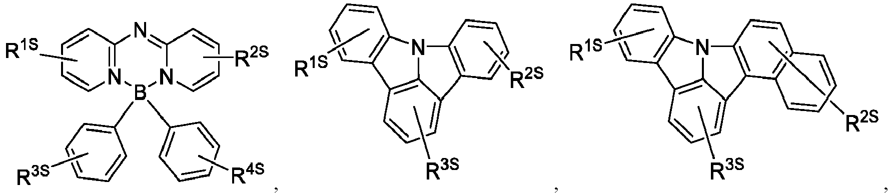 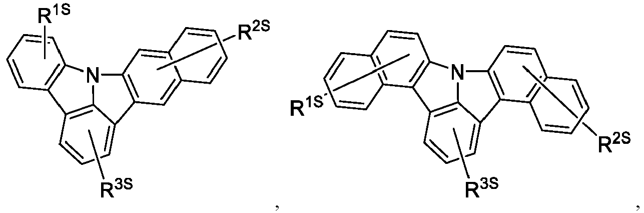 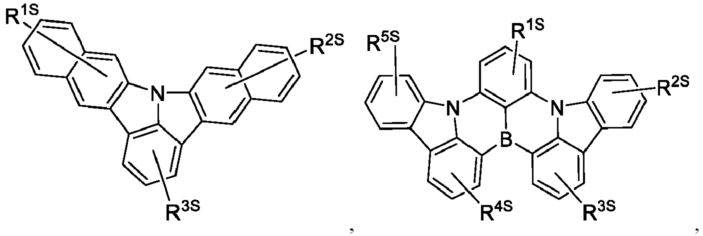 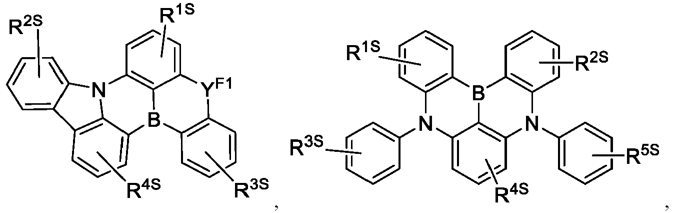 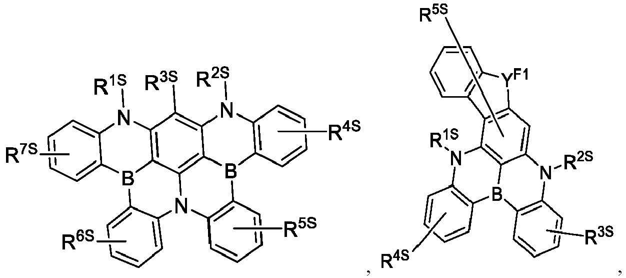 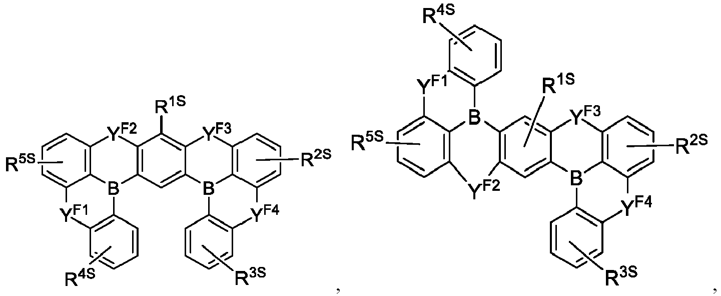 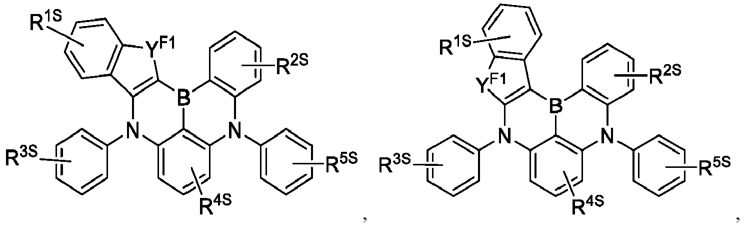 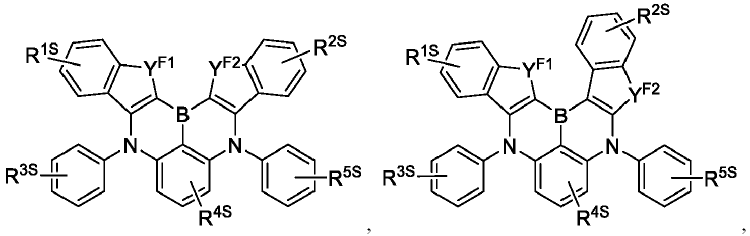 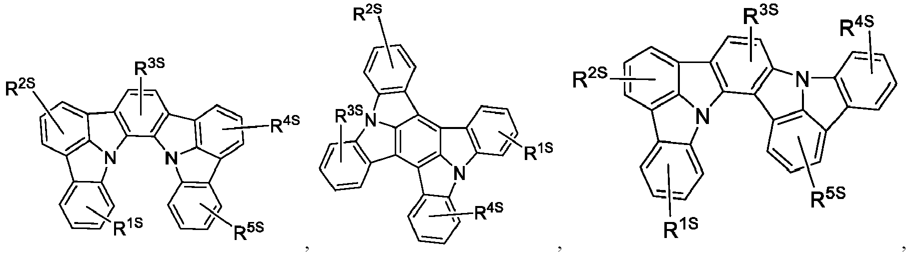 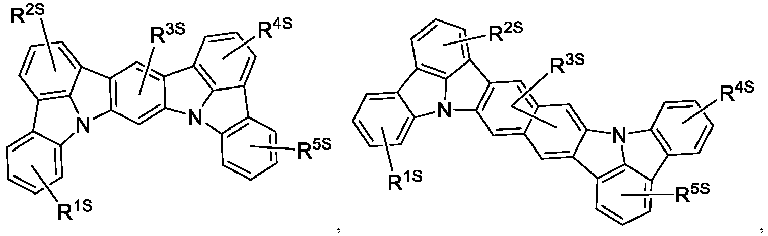 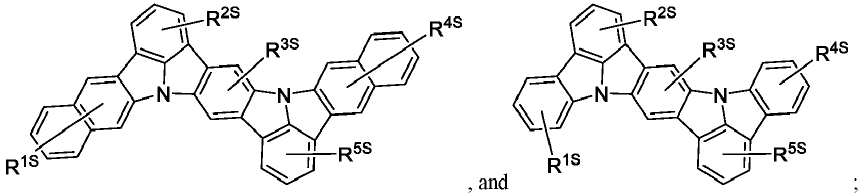 wherein:
Y^{F1} to Y^{F4} are each independently selected from O, S, and NR^{F1};
each of R¹ to R⁶ independently represents from mono to maximum possible number of substitutions, or no substitution; and
each R^{F1} and R¹ to R⁹ is independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof.

In some embodiments, the second compound A1 is selected from the group consisting of the structures of the following LIST 10:

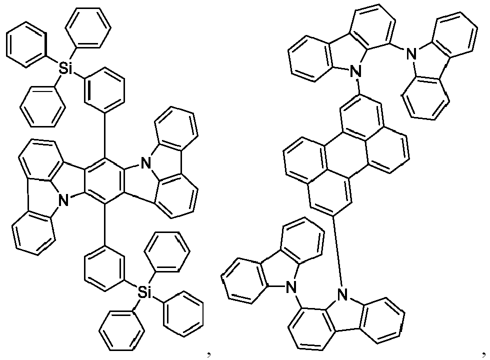

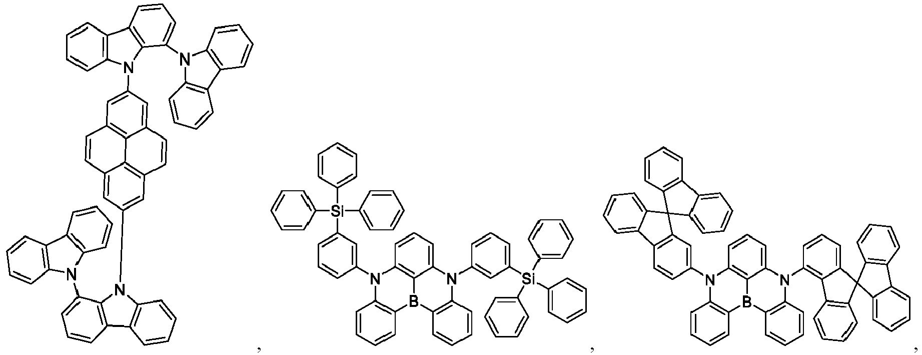

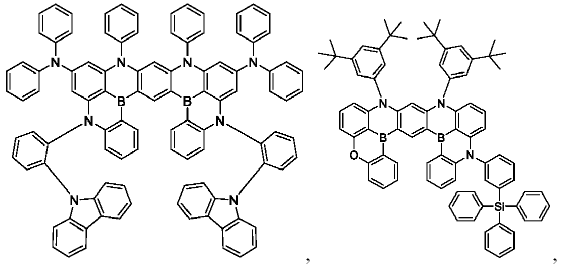

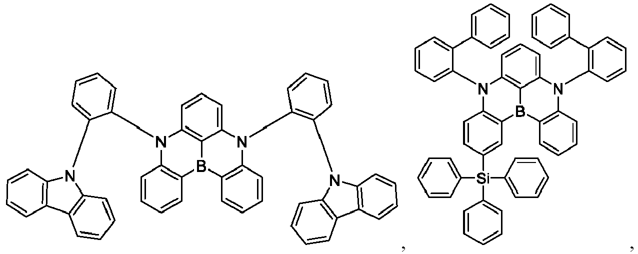

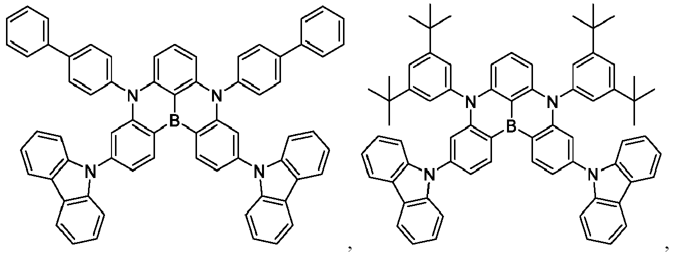

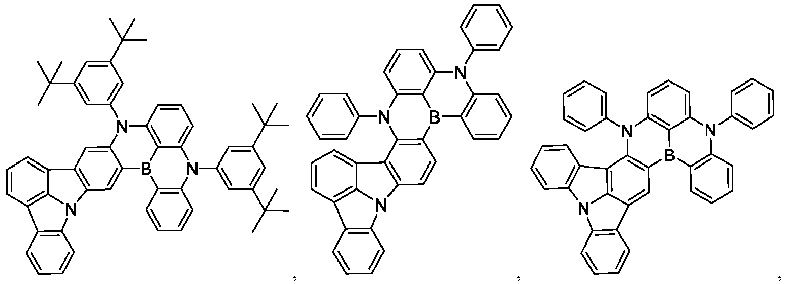

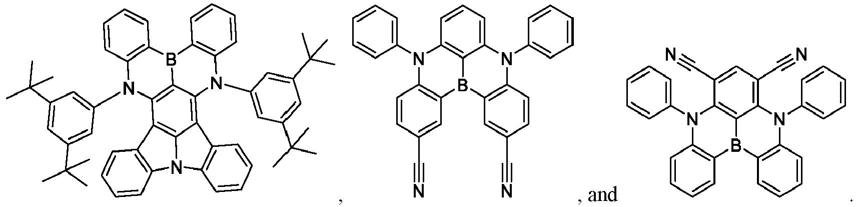

In some embodiments, the second compound A1 is a fluorescent compound functioning as an emitter in the OLED at room temperature. In some embodiments, the fluorescent compound comprises at least one of the chemical moieties selected from the group consisting of: 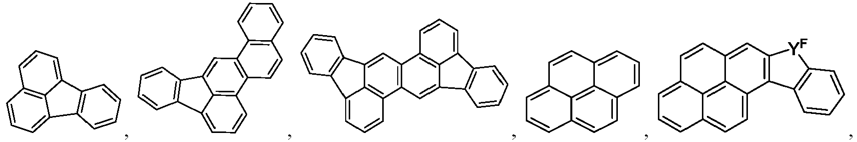 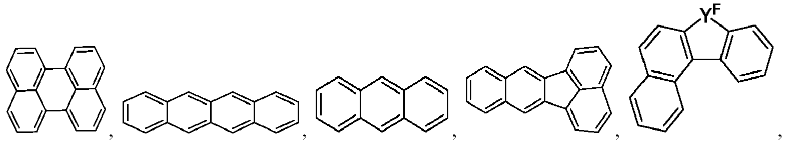 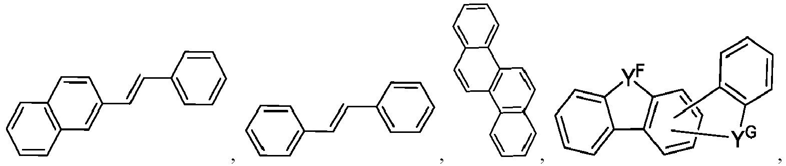 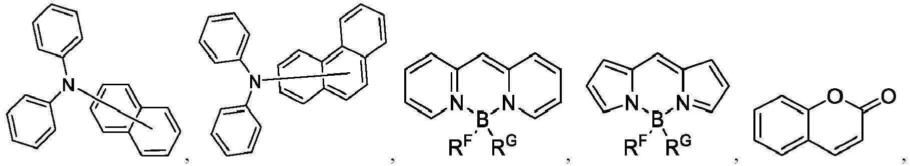 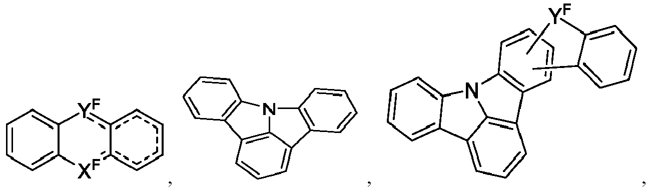 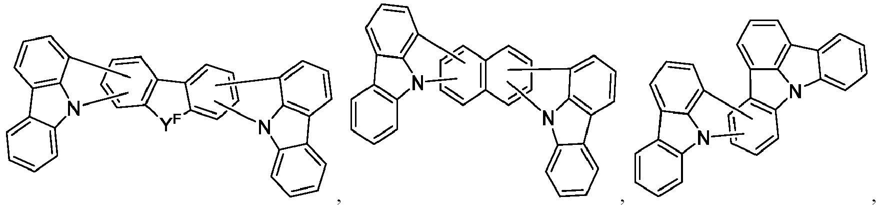 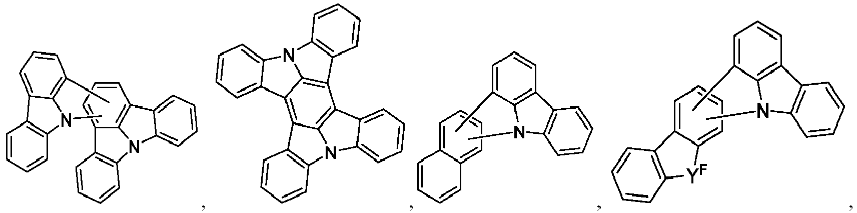 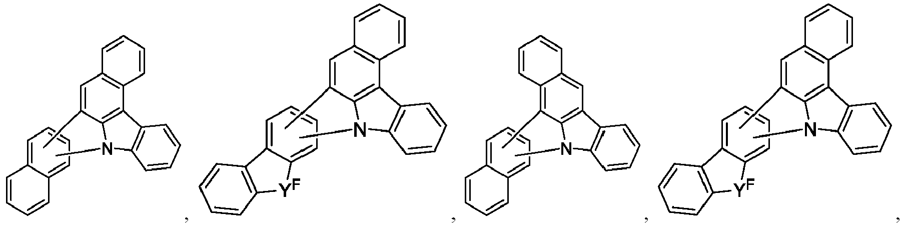 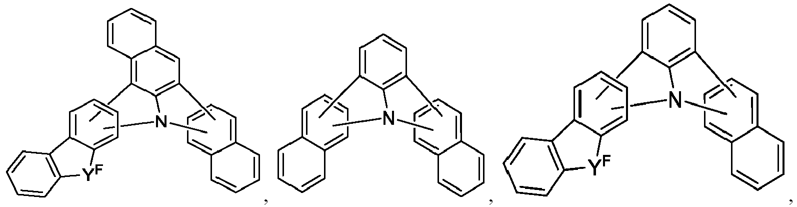 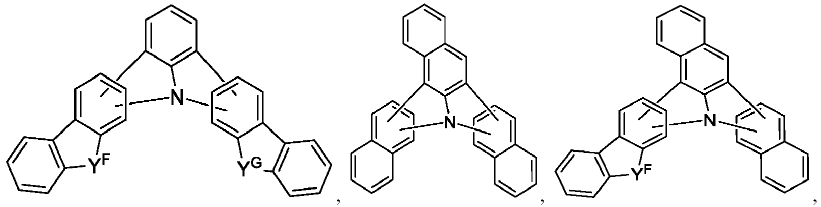 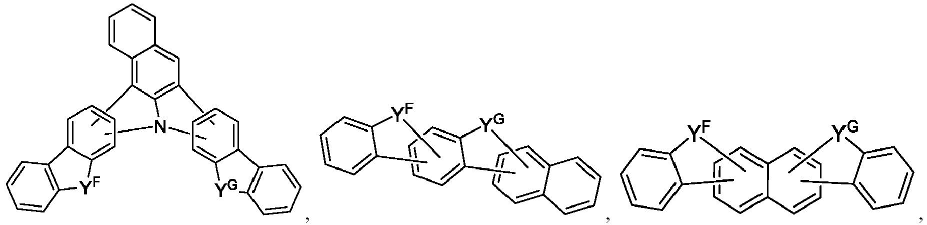 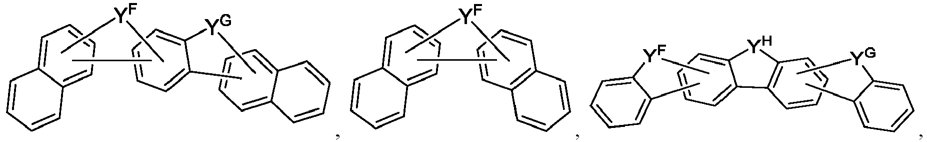 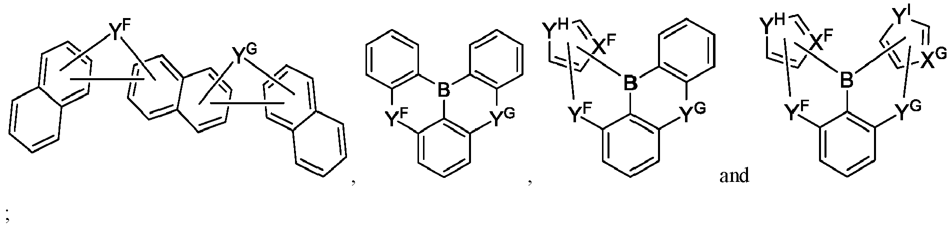
wherein Y^{F}, Y^{G}, Y^{H}, and Y^{I} are each independently selected from the group consisting of BR, NR, PR, O, S, Se, C=O, S=O, SO₂, BRR', CRR', SiRR', and GeRR';
wherein X^{F} and Y^{G} are each independently selected from the group consisting of C and N; and
wherein R^{F}, R^{G}, R, and R' are each independently a hydrogen or a substituent selected from the group consisting of the General Substituents as defined herein, and any two substituents can be joined or fused to form a ring.
In some of the above embodiments, any carbon ring atoms up to maximum of a total number of three, together with their substituents, in each phenyl ring of any of above structures can be replaced with N.

In some embodiments, the acceptor compound is selected from the group consisting of the structures of the following ACCEPTOR LIST: 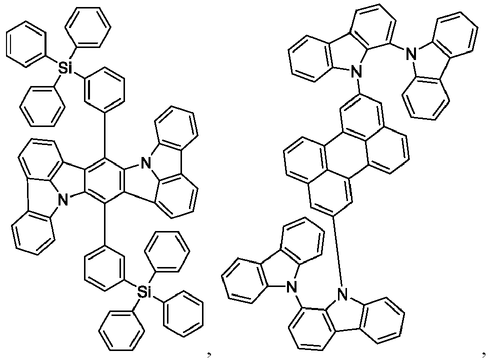 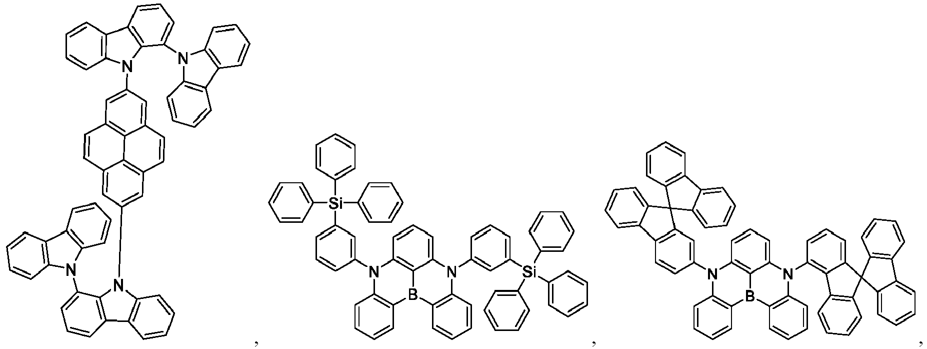 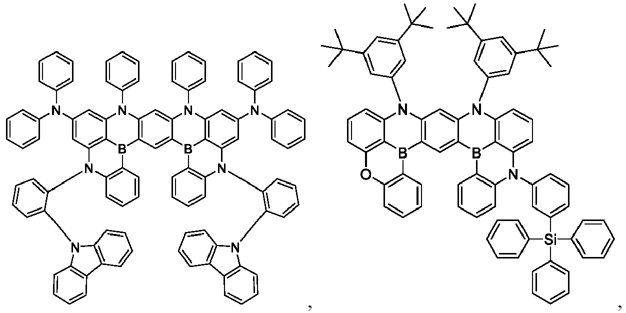 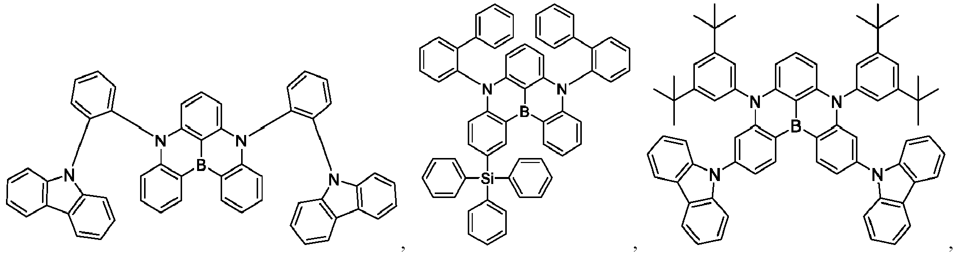 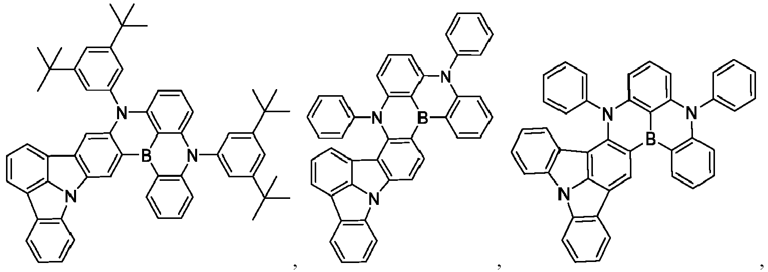 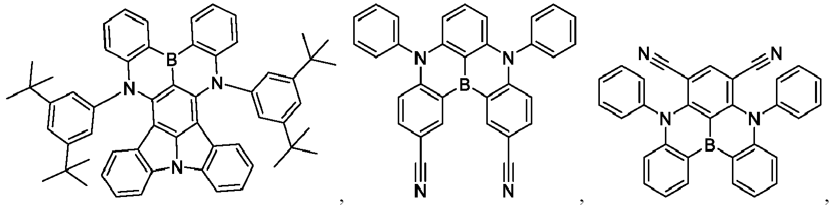 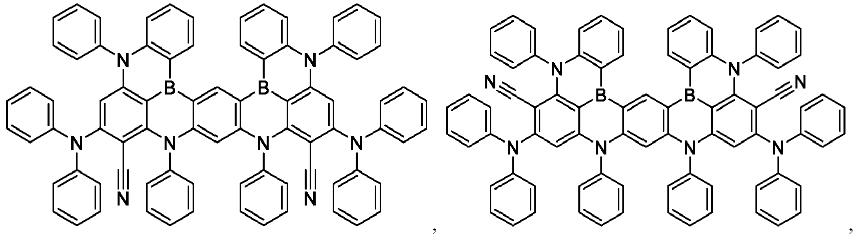 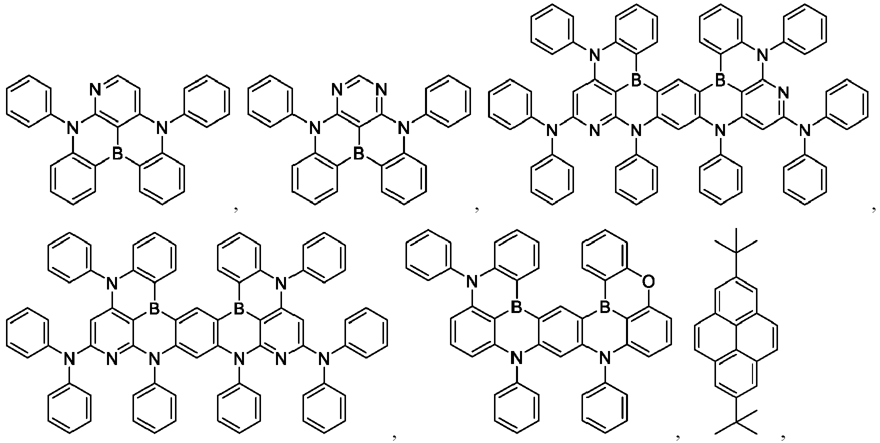 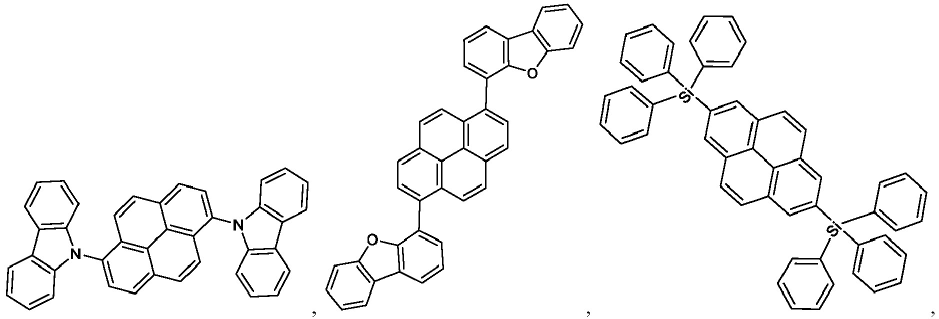 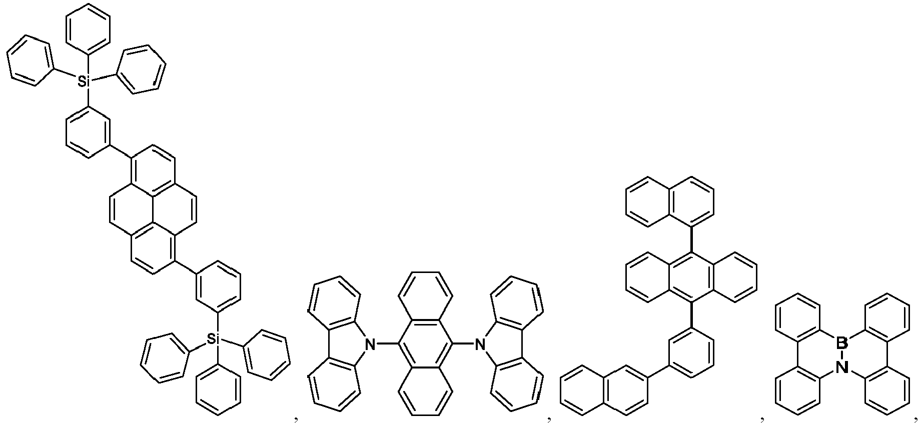 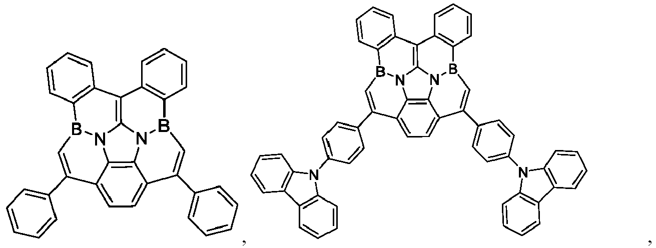 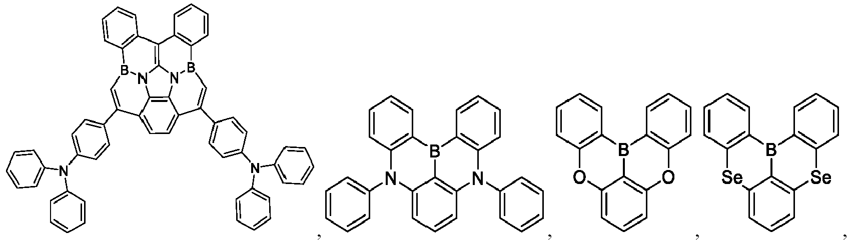 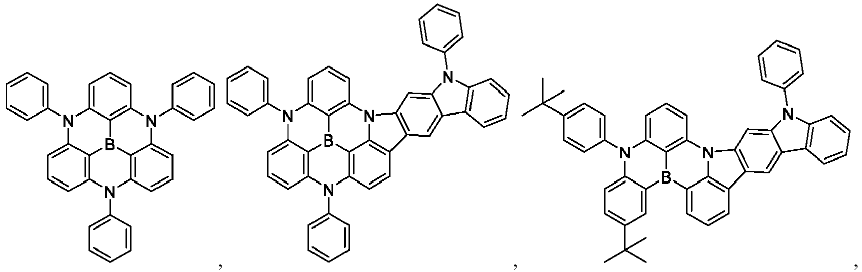 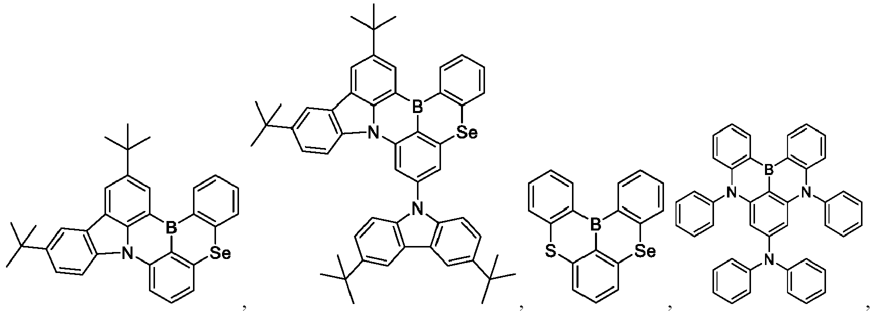 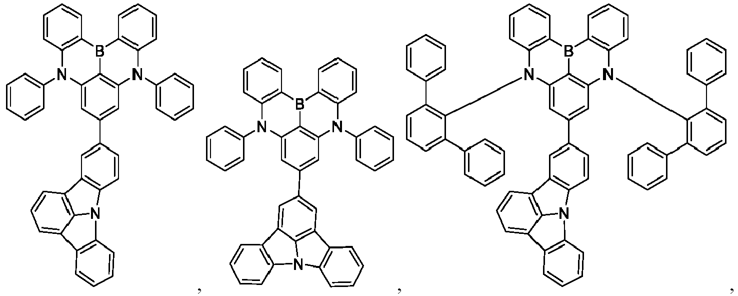 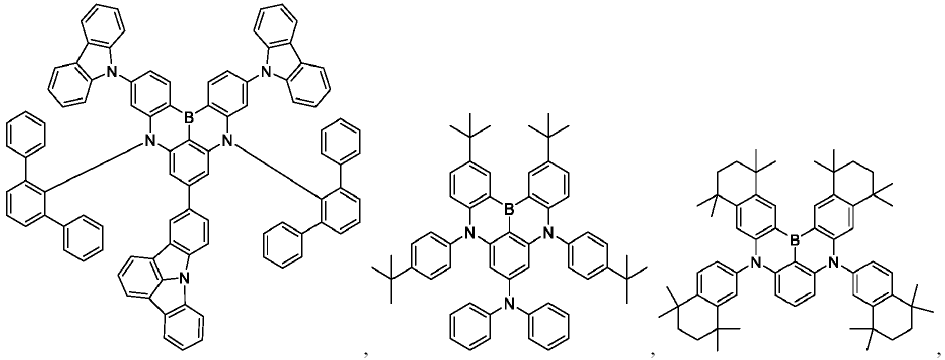 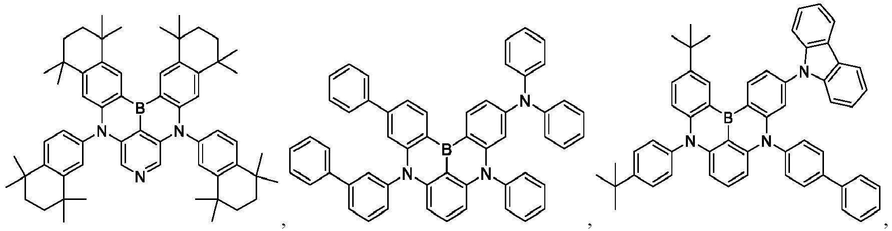 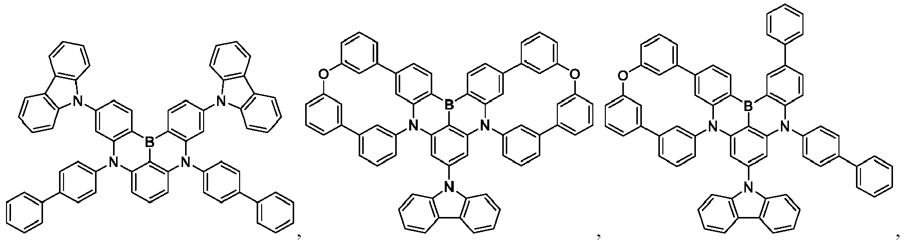 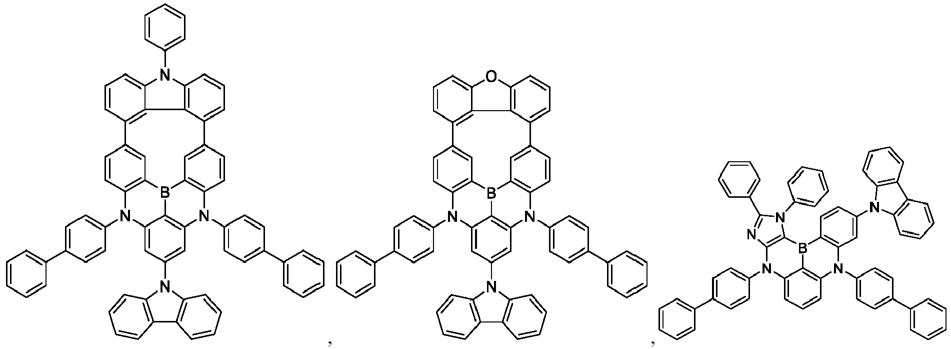 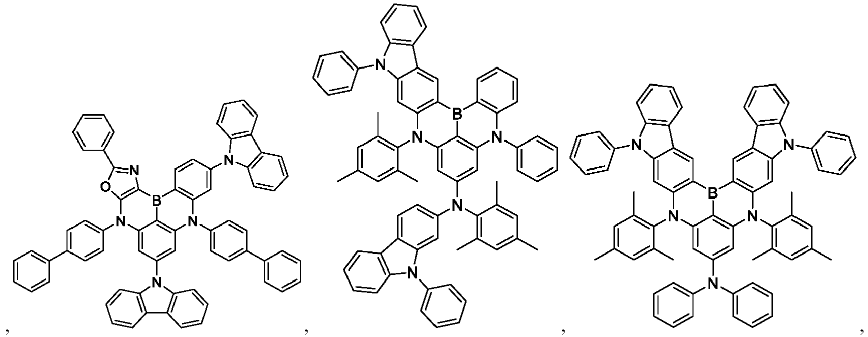 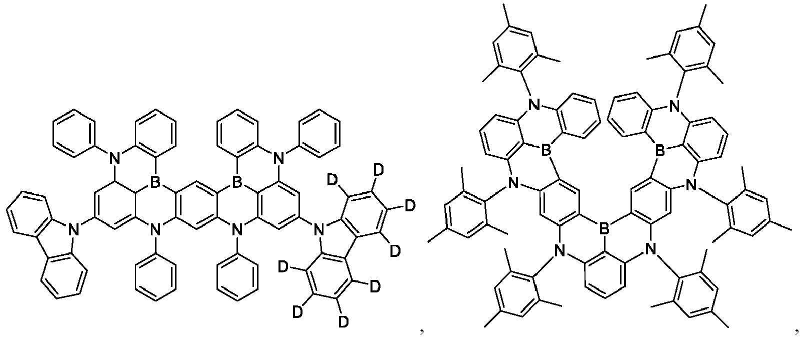 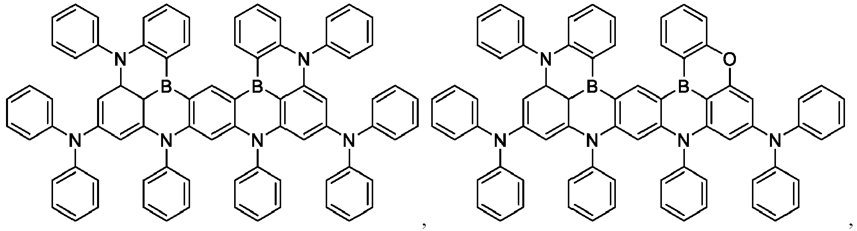 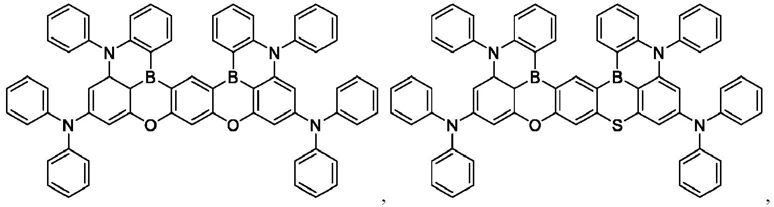 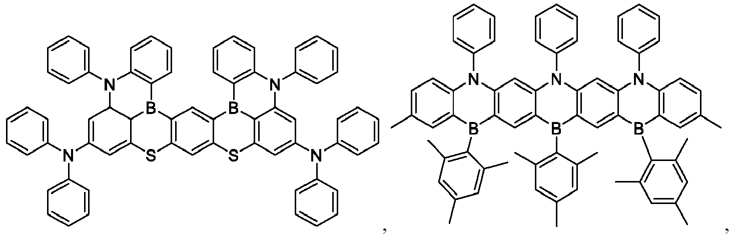 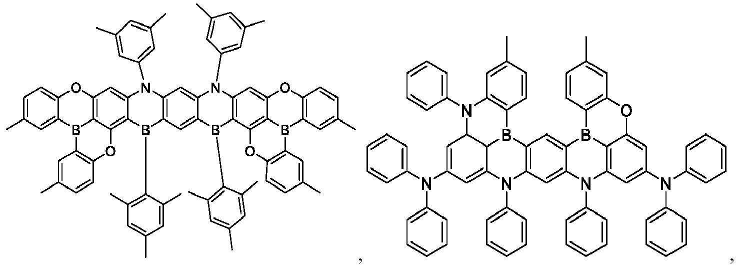 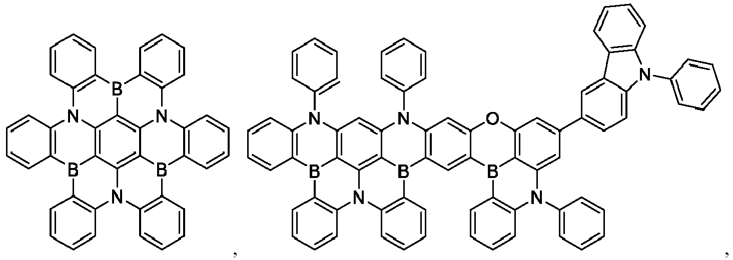 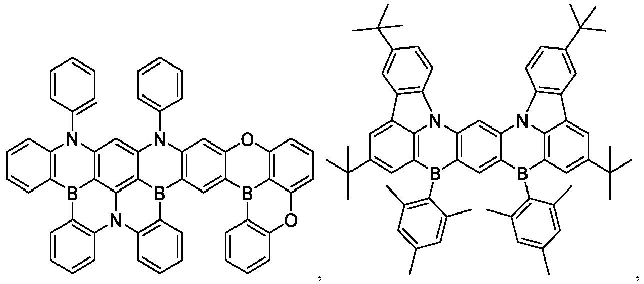 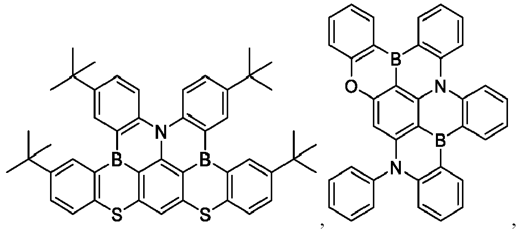 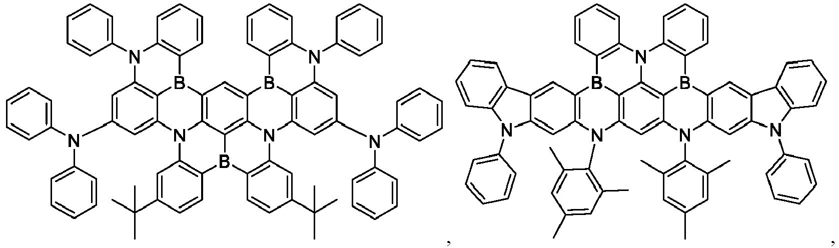 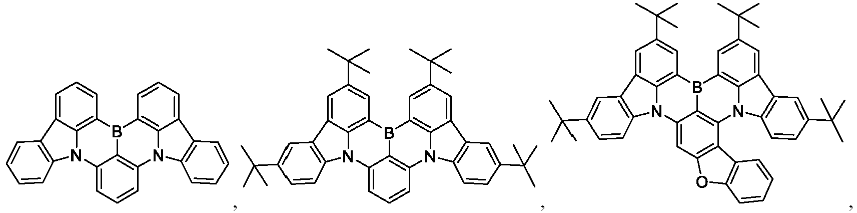 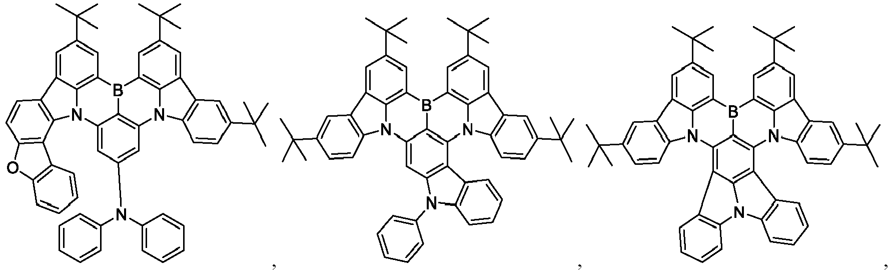 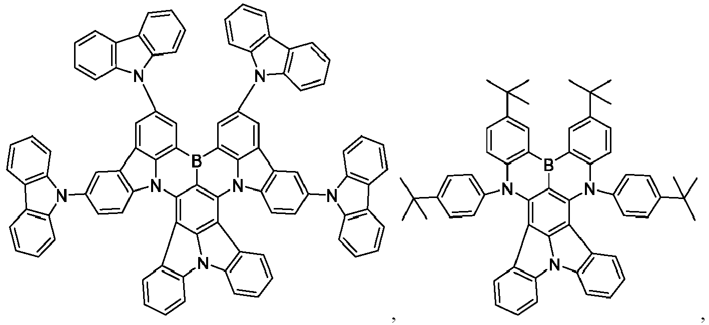 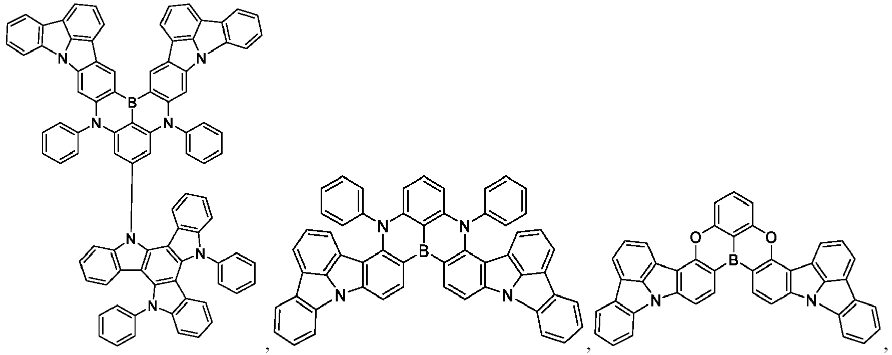 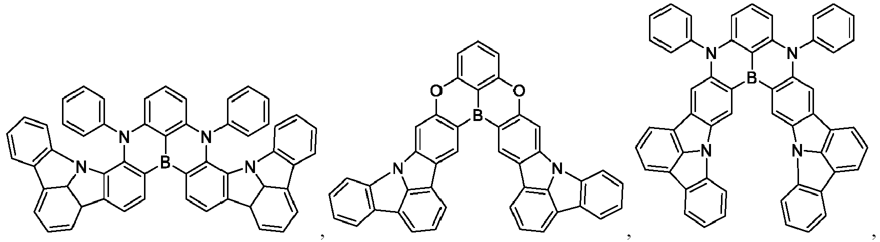 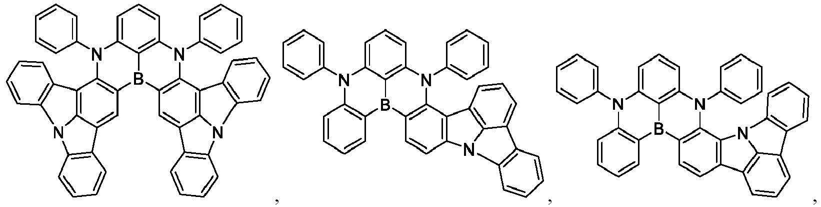 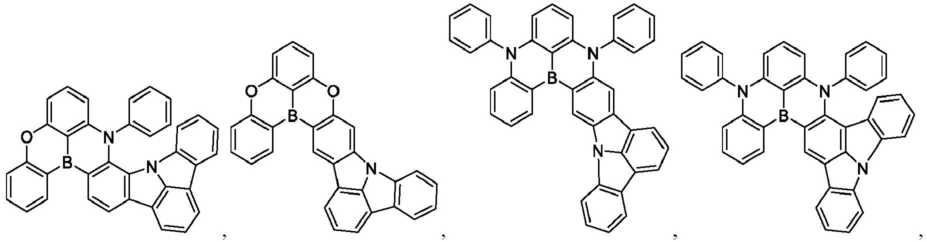 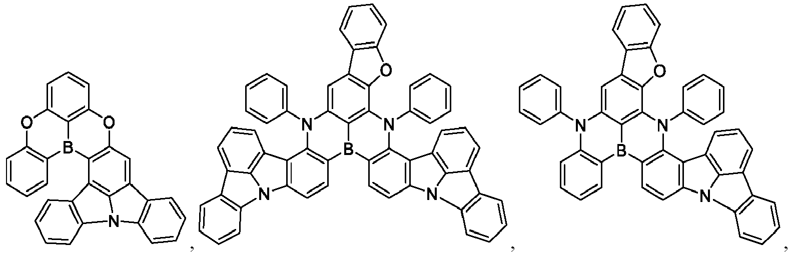 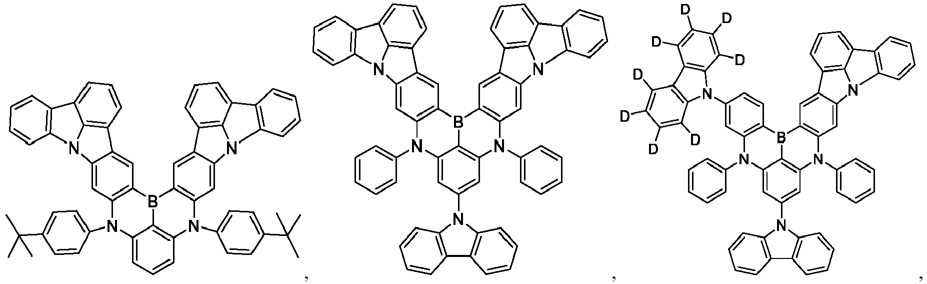 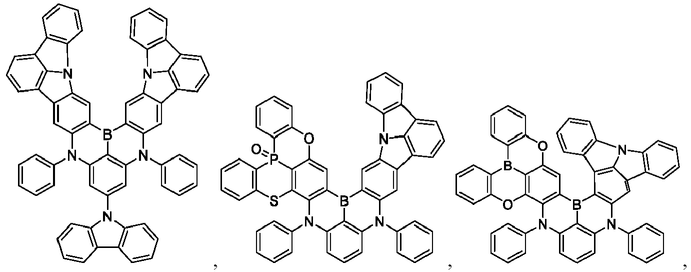 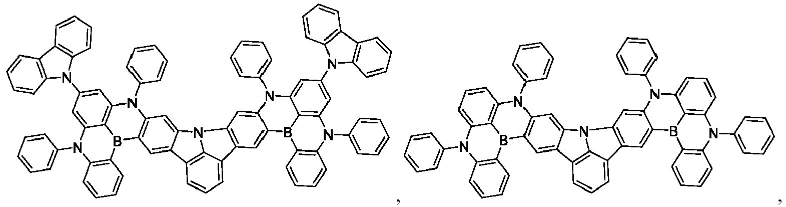 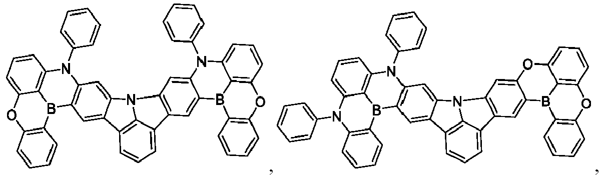 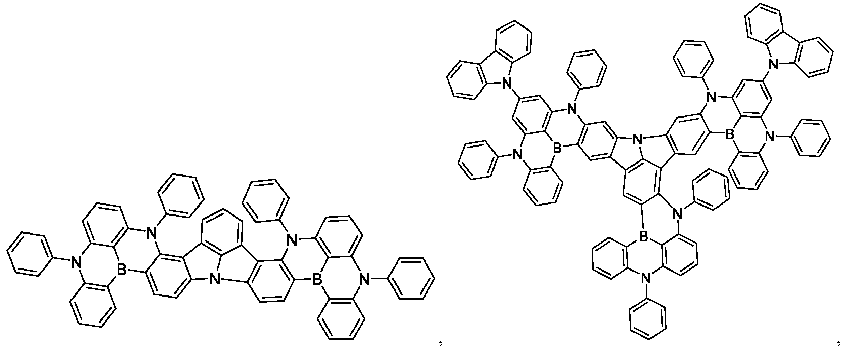 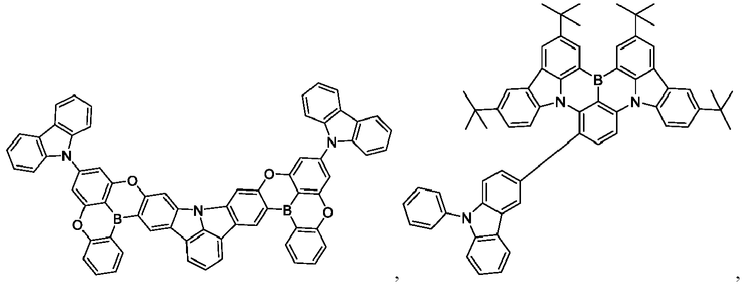 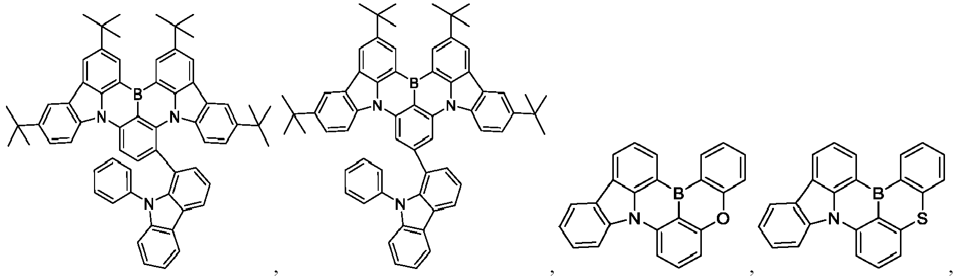 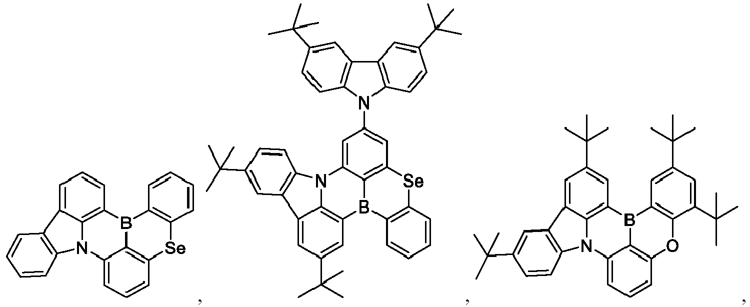 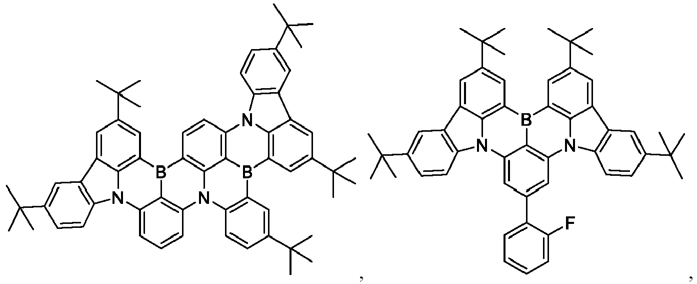 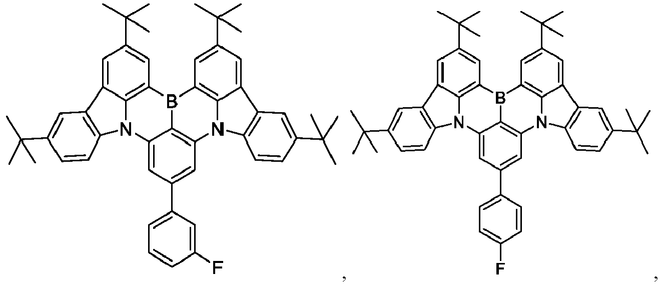 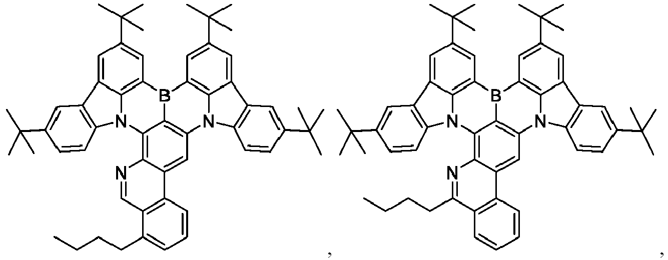 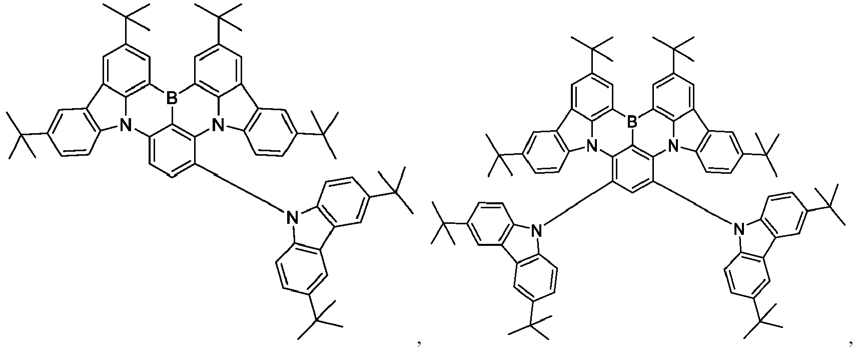 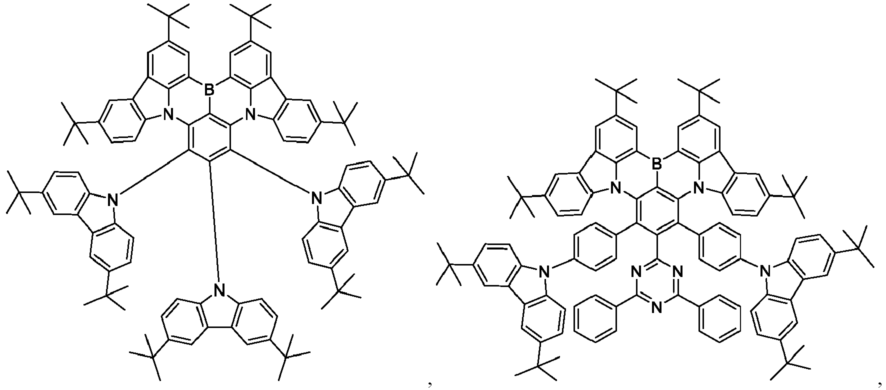 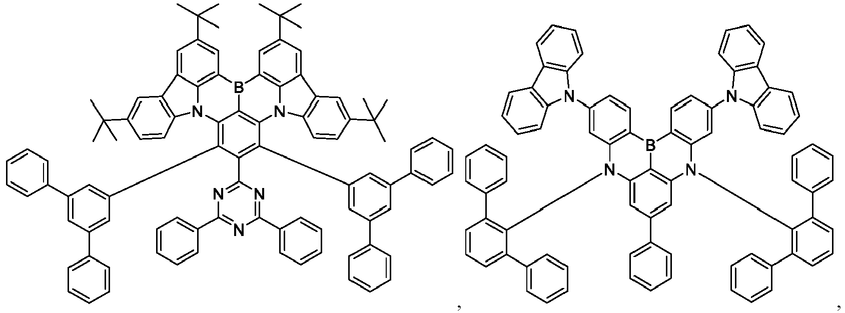 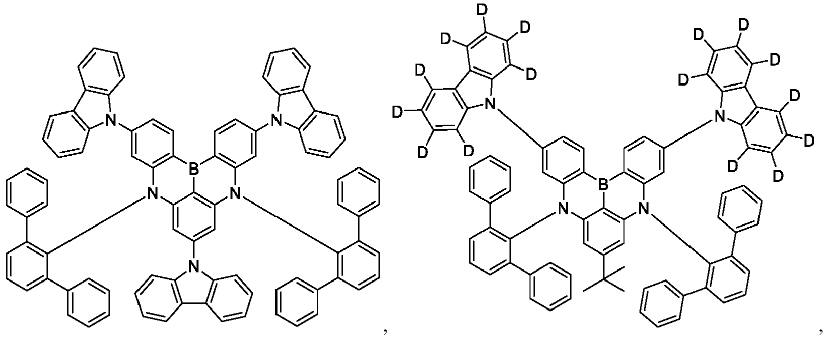 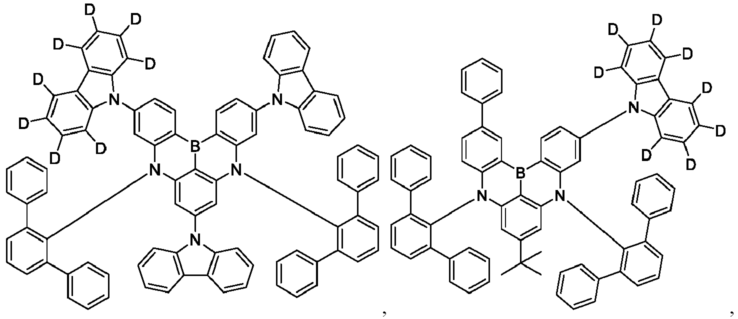 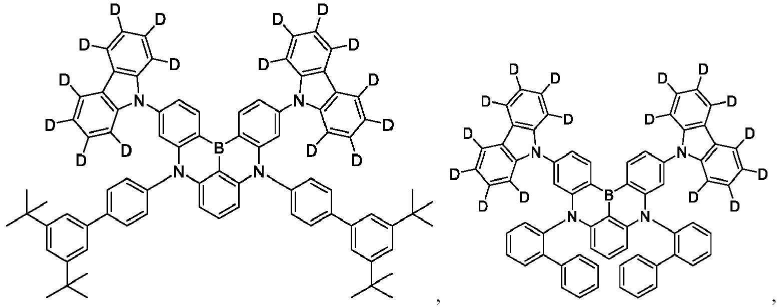 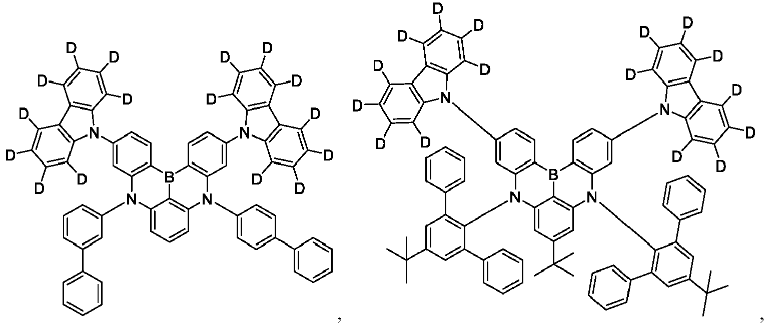 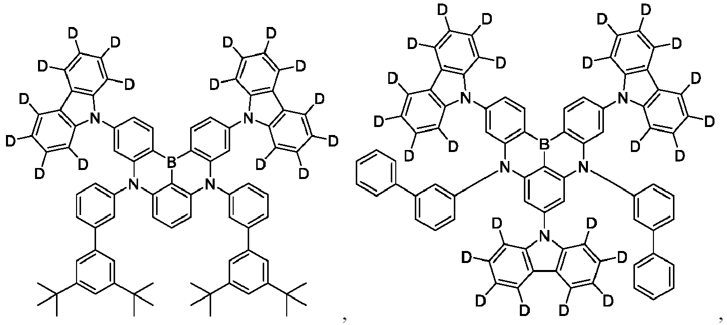 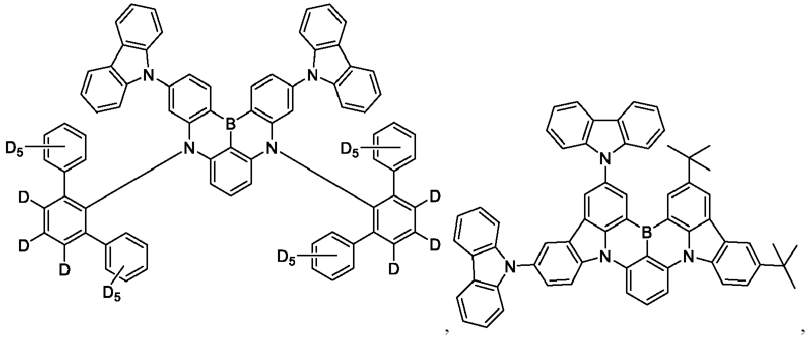 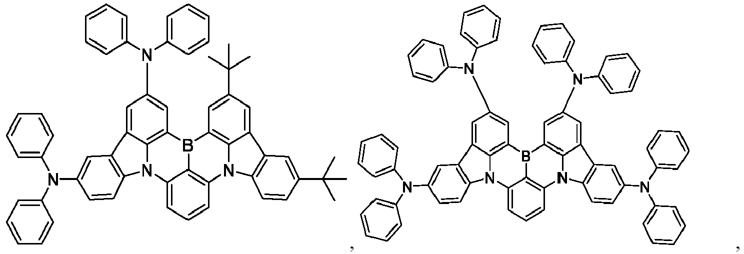 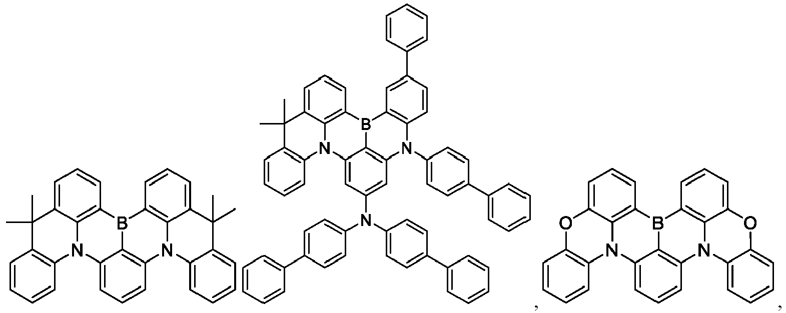 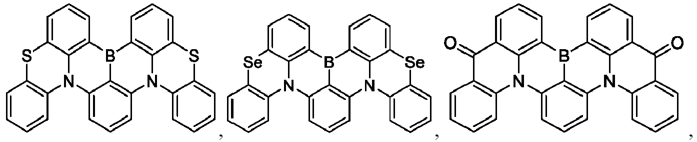 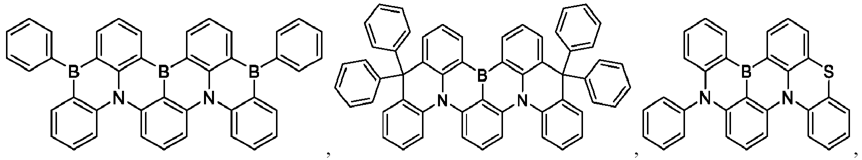 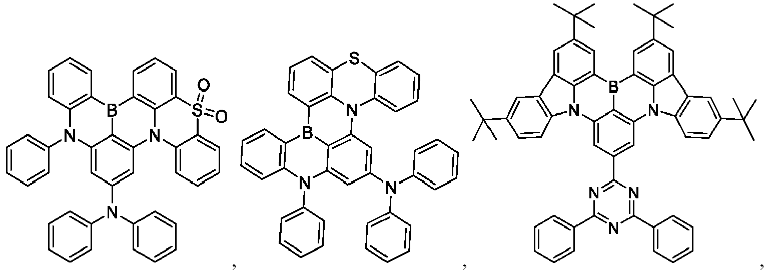 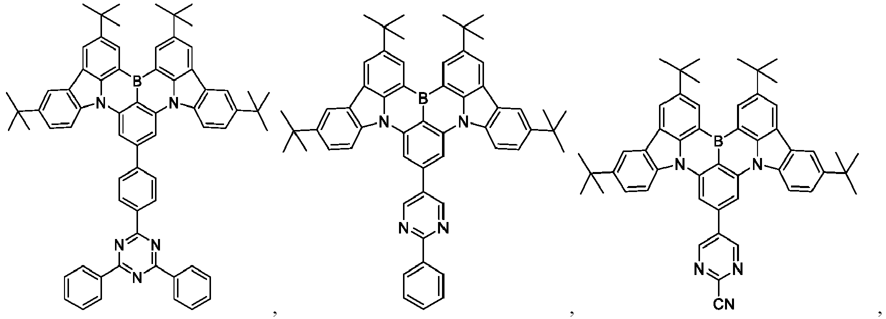 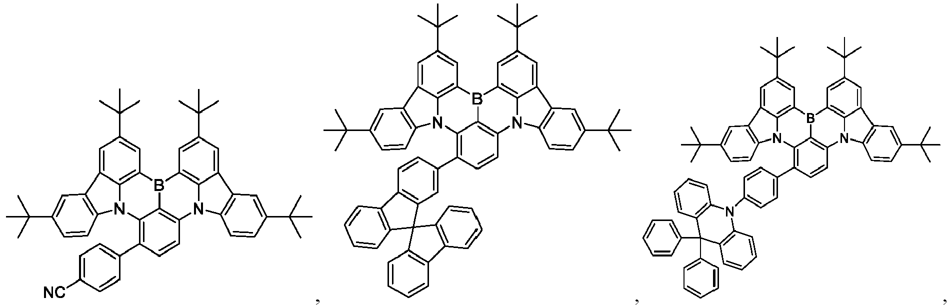 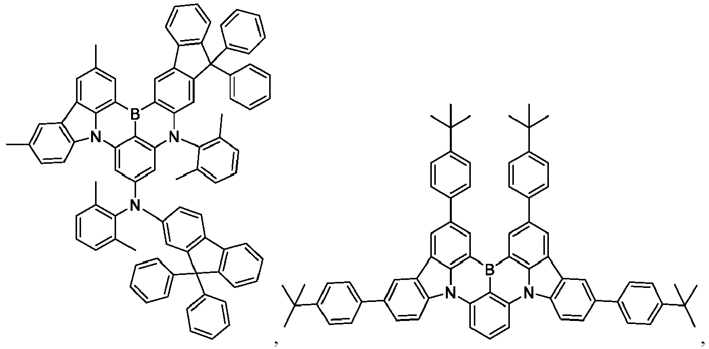 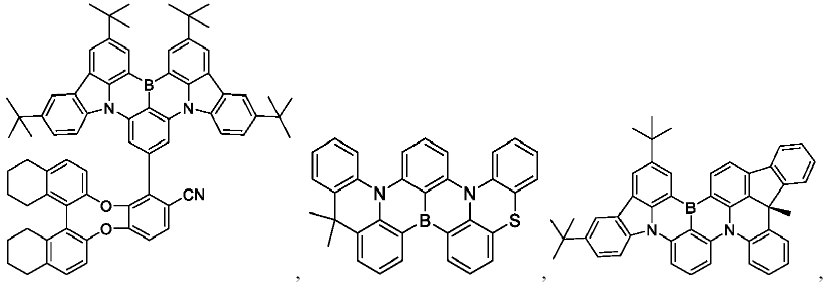 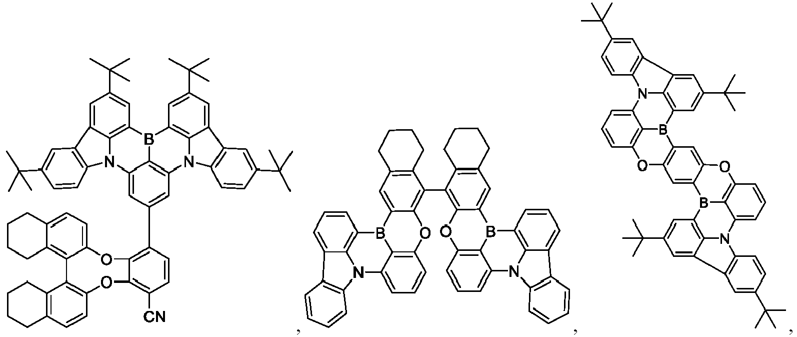 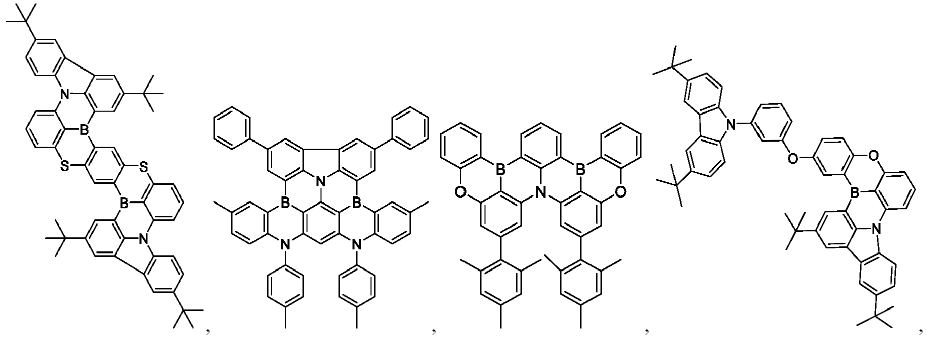 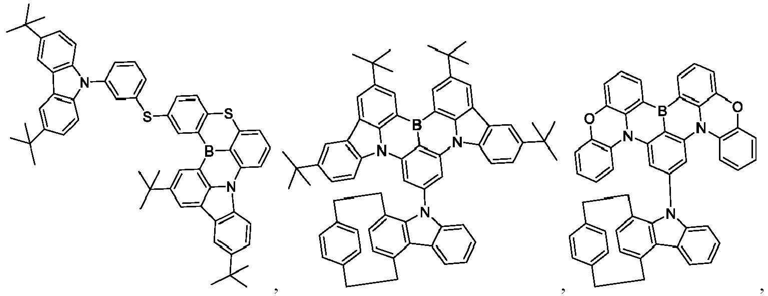 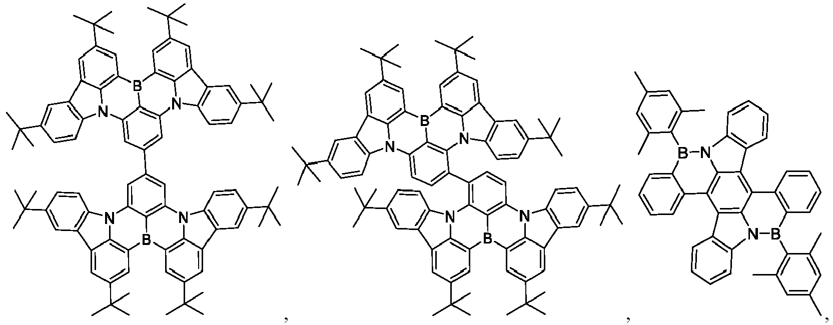 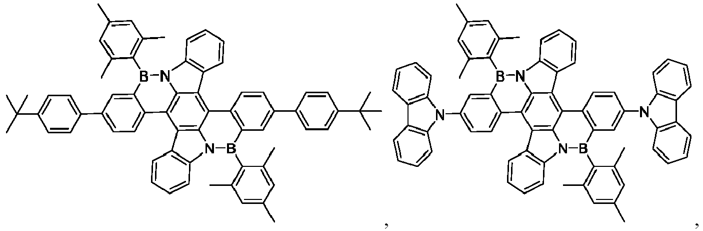 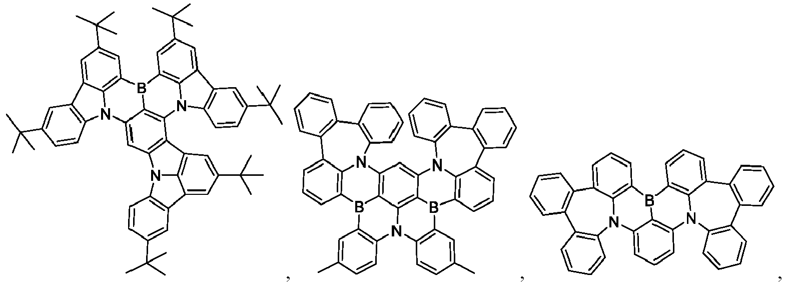 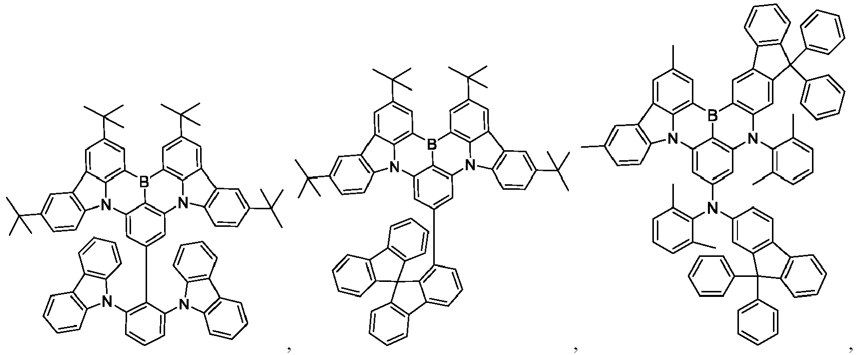 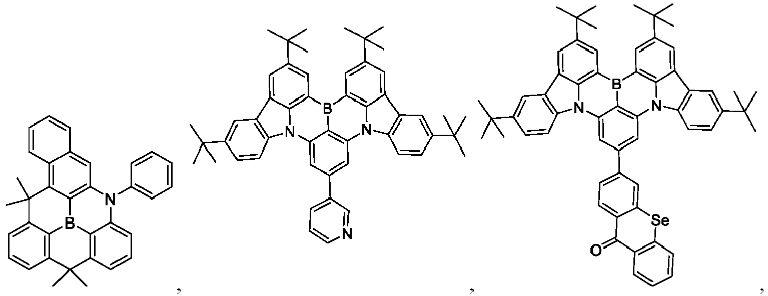 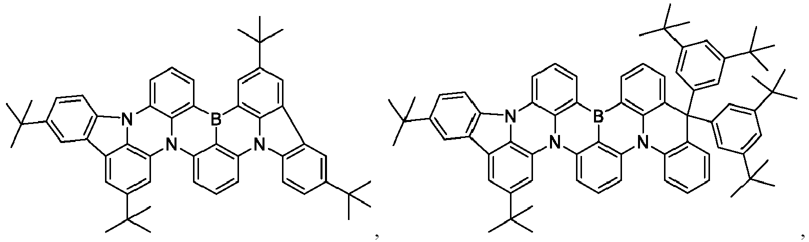 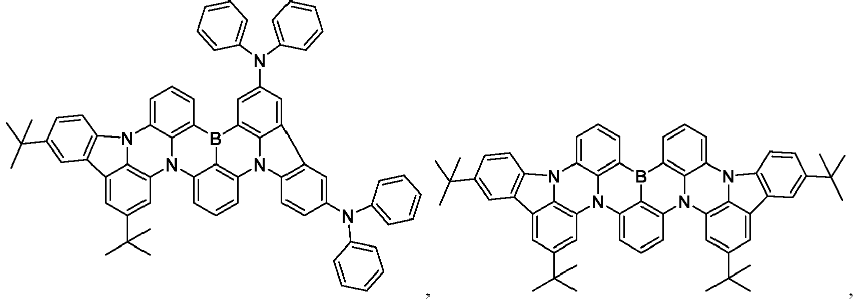 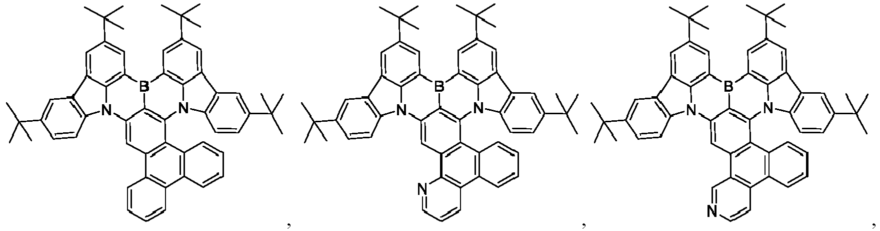 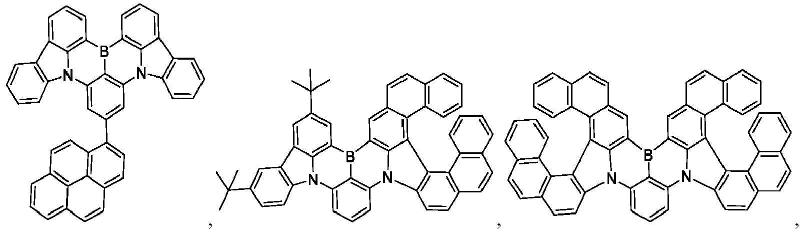 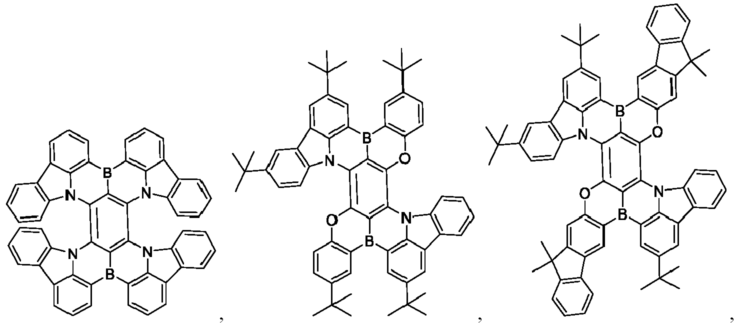 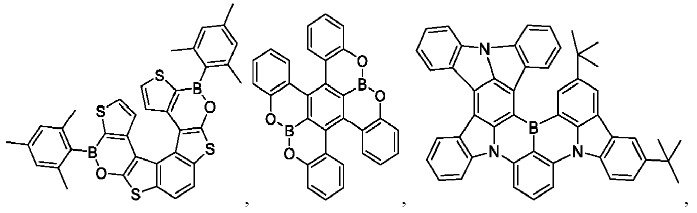 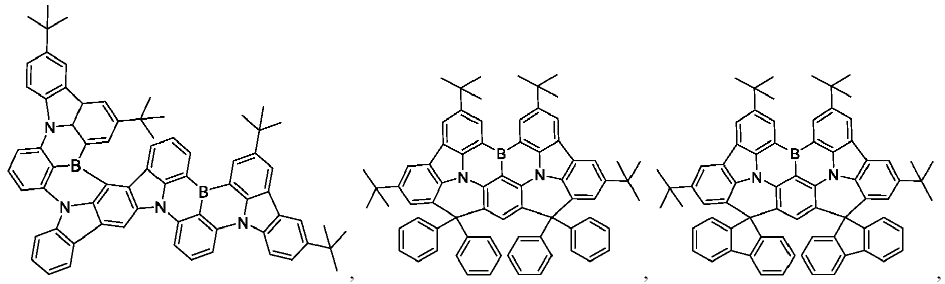 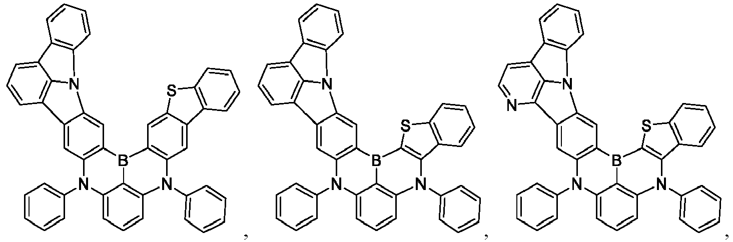 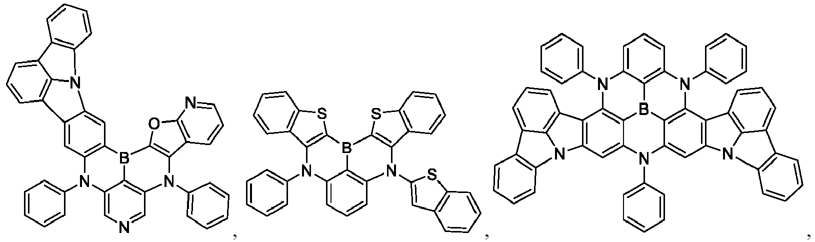 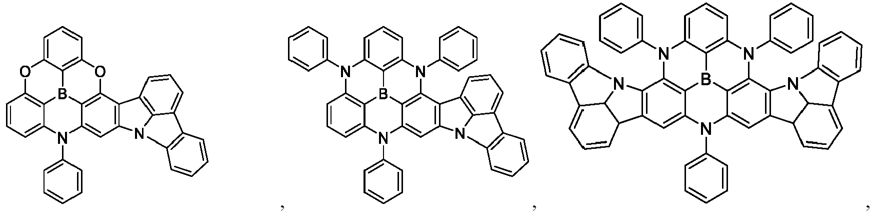 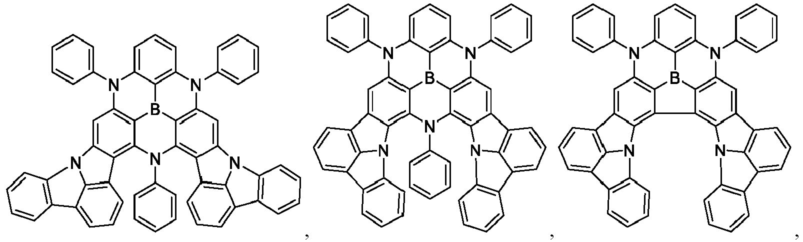 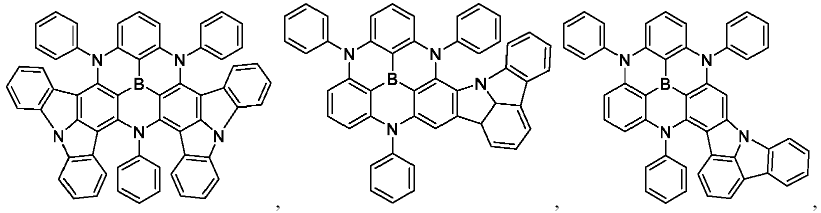 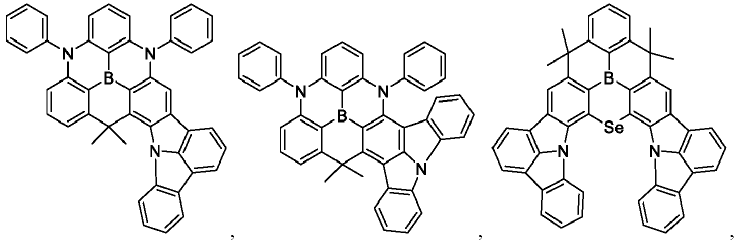 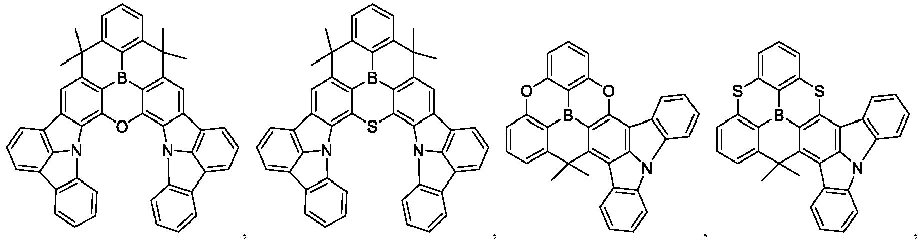 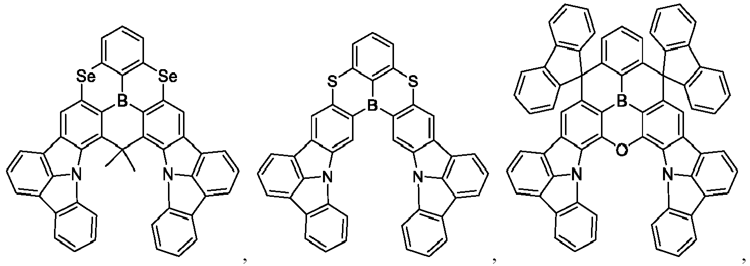 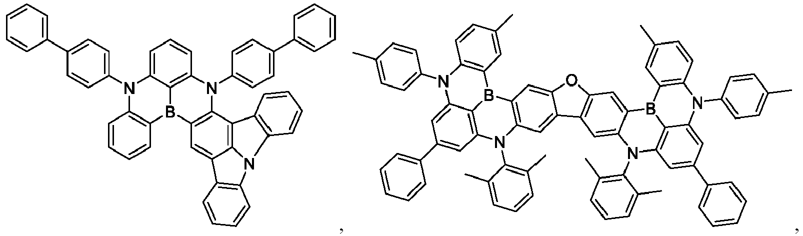 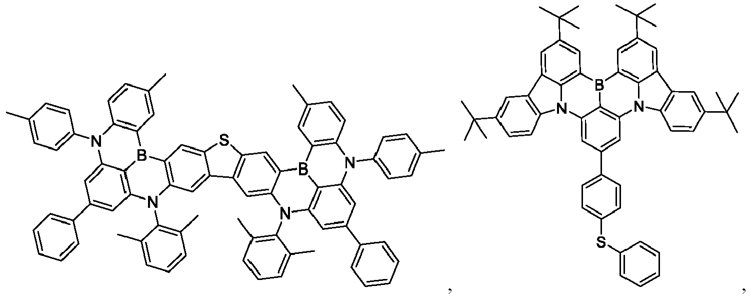 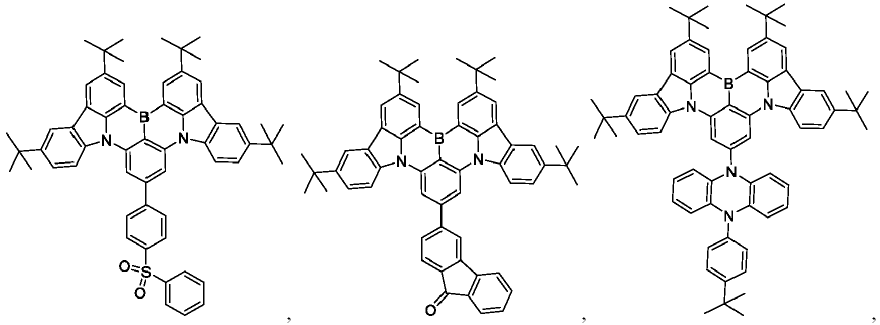 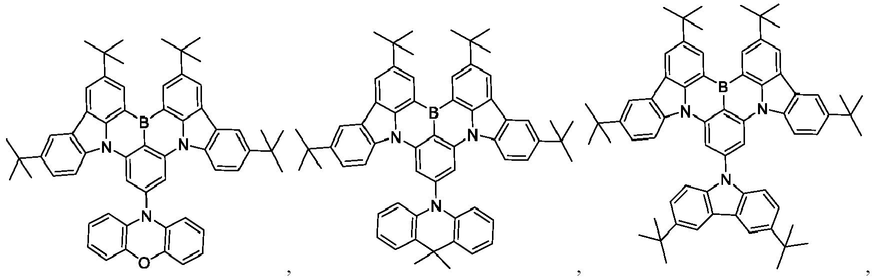 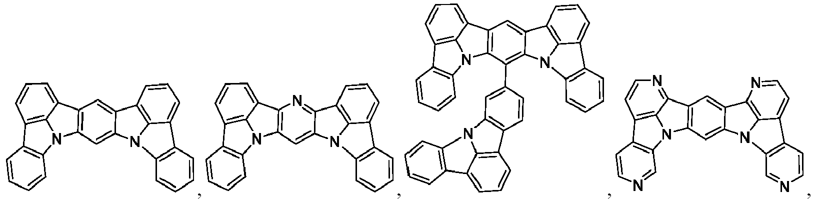 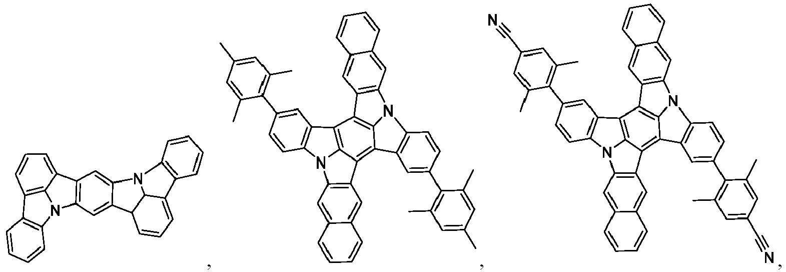 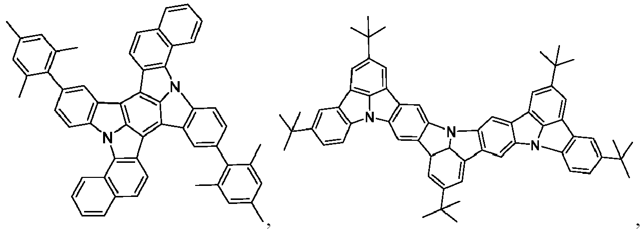 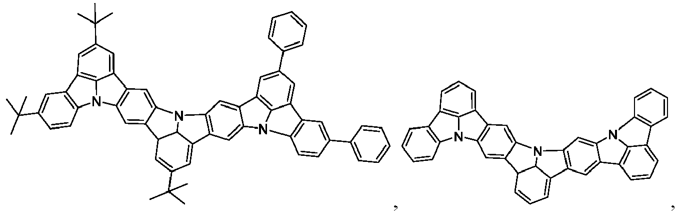 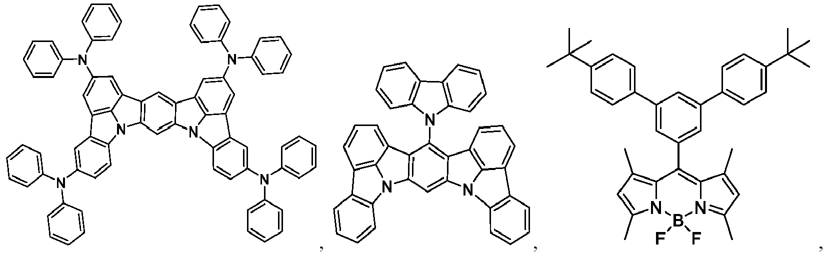 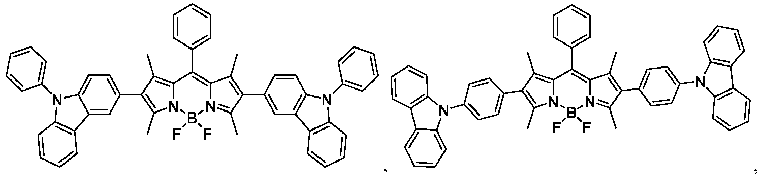 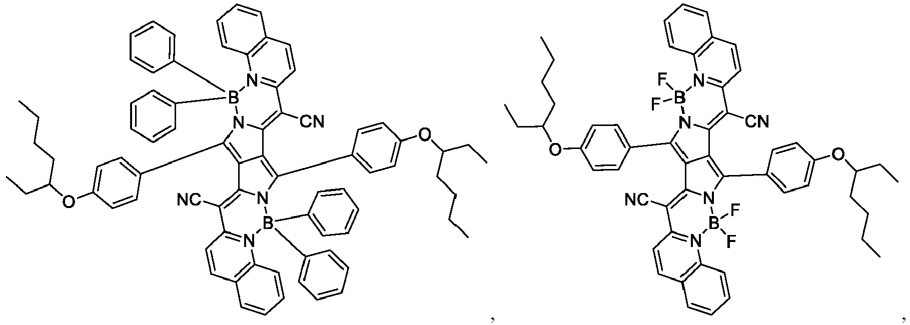 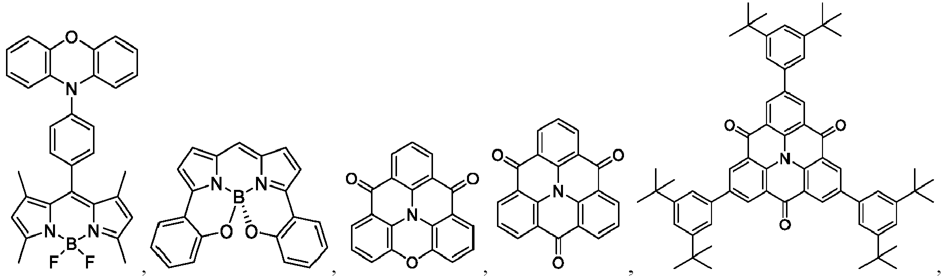 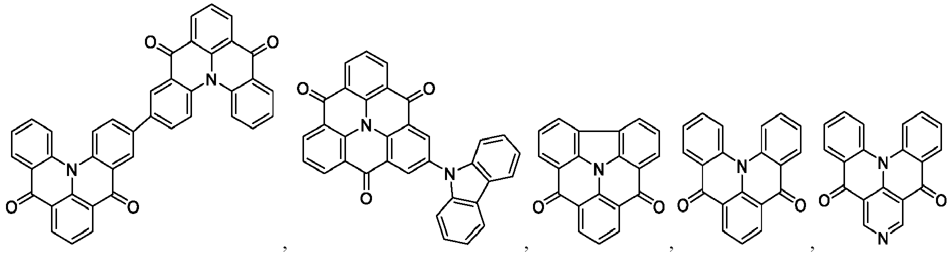 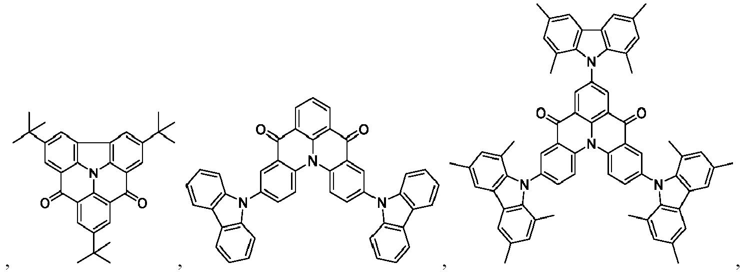 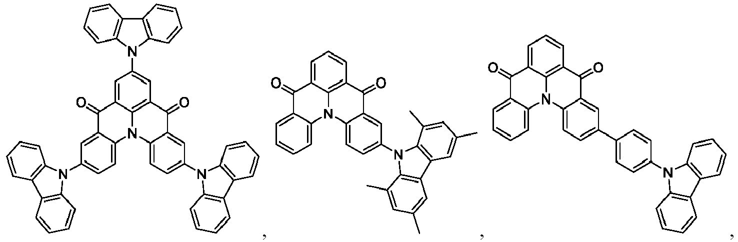 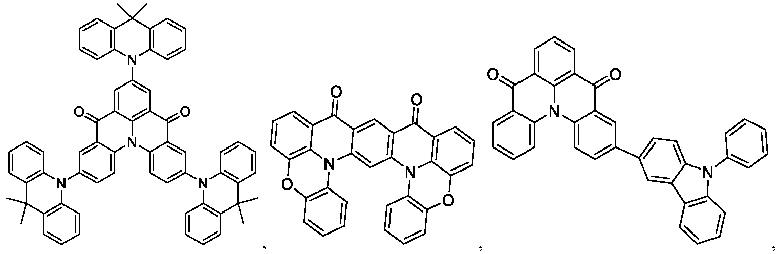 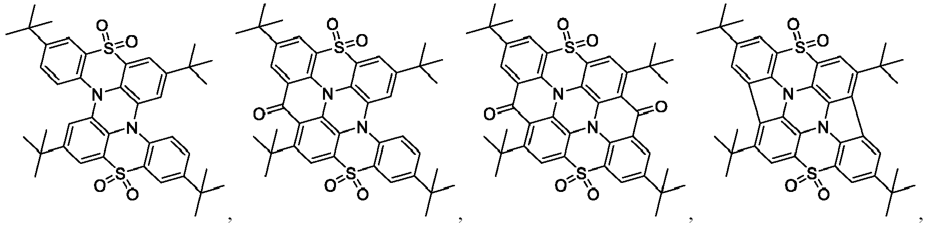 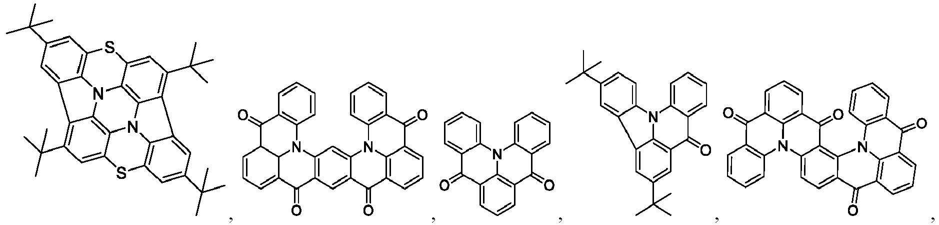 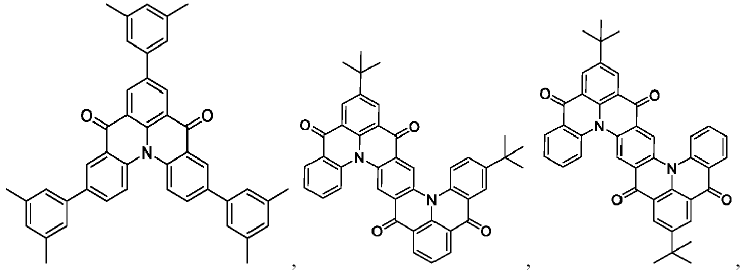 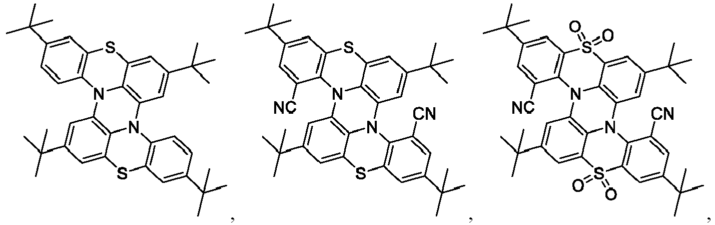 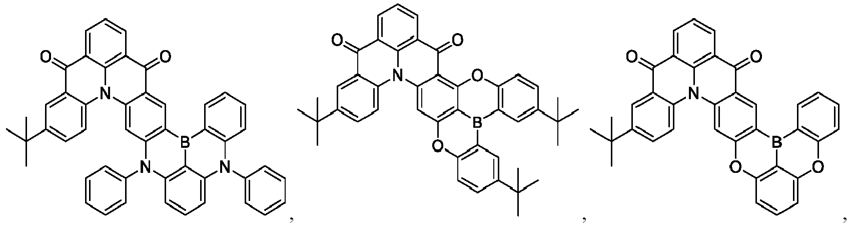 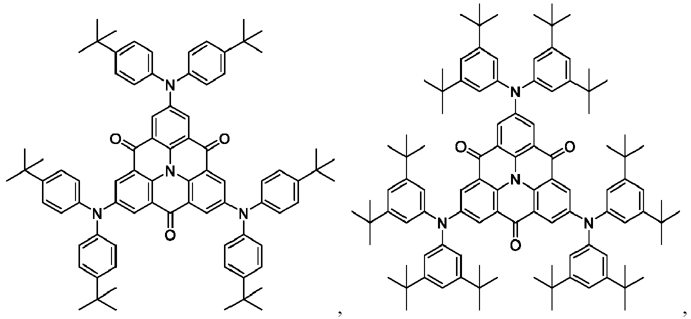 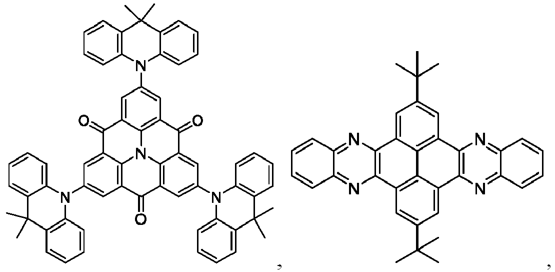 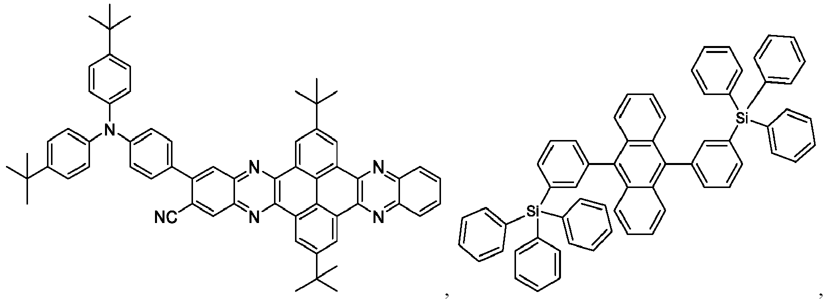 aza-substituted variants thereof, fully or partially deuterated variants thereof, and combinations thereof.

In some of the above embodiments, any carbon ring atoms up to maximum of a total number of three, together with their substituents, in each phenyl ring of any of above structures can be replaced with N.

In some embodiments, the second compound A1 comprises a fused ring system having at least five 5 - membered or 6-membered aromatic rings. In some embodiments, the second compound A1consists of a first group and a second group with the first group not overlapping with the second group; wherein at least 80% of the singlet excited state population of the lowest singlet excitation state are localized in the first group; and wherein at least 80% of the triplet excited state population of the lowest triplet excitation state are localized in the second group. In some embodiments, no fused ring system can be part of both groups.

As used herein, the first group and the second group refer to discrete groups of atoms that form the second compound A1. Because the compound consists of the first group and the second group, all atoms of the compound belong to either the first group or the second group. As used herein, "atoms of the first group do not overlap with the second group" means that no atom is in both the first group and the second group. "No fused ring system can be part of both groups" means a fused ring system cannot be divided, and it cannot straddle between the first group and the second group at the same time. In other words, a fused ring system can only be in one group.

In some embodiments, the third compound H1 comprises at least one chemical group selected from the group consisting of triphenylene, carbazole, indolocarbazole, dibenzothiophene, dibenzofuran, dibenzoselenophene, 5λ2-benzo[d]benzo[4,5]imidazo[3,2-a]imidazole, 5,9-dioxa-13b-boranaphtho[3,2,1-de]anthracene, triazine, boryl, silyl, aza-triphenylene, aza-carbazole, aza-indolocarbazole, aza-dibenzothiophene, aza-dibenzofuran, aza-dibenzoselenophene, aza-5λ²-benzo[d]benzo[4,5]imidazo[3,2-a]imidazole, and aza-(5,9-dioxa-13b-boranaphtho[3,2,1-de]anthracene).

In some embodiments, the third compound H1 is selected from the group consisting of the structures of the following, previously defined, LIST 2; wherein:
each of X³⁰, X³¹, and X³² is independently C or N;
each Y^{A} is independently selected from the group consisting of BR, BRR', NR, PR, P(O)R, O, S, Se, C=O, C=S, C=Se, C=NR', C=CRR, S=O, SO₂, CRR', SiRR', and GeRR';
each of R^{AA}, R^{BB}, R^{CC}, R^{DD}, R^{DA}, R^{EE}, R^{EA}, R^{JJ}, R^{KK}, and R^{LL} independently represents mono, up to the maximum substitutions, or no substitutions;
each of R, R', R^{AA}, R^{BB}, R^{CC}, R^{DD}, R^{DA}, R^{EE}, R^{EA}, R^{II}, R^{JJ}, R^{KK}, and R^{LL} is independently a hydrogen or a substituent selected from the group consisting of deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, germyl, selenyl, and combinations thereof; and
any two adjacent substituents can be joined or fused to form a ring.

In some embodiments where the third compound H1 is selected from LIST 2, each R^{AA}, R^{BB}, R^{CC}, R^{DD}, R^{DA}, R^{EE}, R^{EA}, R^{FF}, R^{FA}, R^{GG}, and R^{GA}, is independently a hydrogen or a substituent selected from the group consisting of deuterium, phenyl, biphenyl, pyridine, pyrimidine, triazine, pyrazine, imidazole, pyrazole, pyrrole, oxazole, furan, thiophene, thiazole, dibenzothiophene, dibenzofuran, dibenzoseleonphene, carbazole, azadibenzothiophene, azadibenzofuran, azadibenzoseleonphene, azacarbazole, 5λ2-benzo[*d*]benzo[4,5]imidazo[3,2-*a*]imidazole, aza-5λ²-benzo[*d*]benzo[4,5]imidazo[3,2-*a*]imidazole, biscarbazole, silyl, boryl, partially or fully deuterated variations thereof, and combinations thereof.

In some embodiments where the third compound H1 is selected from LIST 2, at least one of R^{AA}, R^{BB}, R^{CC}, R^{DD}, R^{DA}, R^{EE} R^{EA}, R^{FF}, R^{FA}, R^{GG} and R^{GA} is present and is not hydrogen.

In some embodiments where the third compound H1 is selected from LIST 2, at least one of X¹ to X³ is present and is N.

In some embodiments where the third compound H1 is selected from LIST 2, each of X¹ is X³ is independently C.

In some embodiments where the third compound H1 is selected from LIST 2, X¹ is present and is N.

In some embodiments, the HOMO level of the second compound A1 is deeper than at least one selected from the first compound S1 and the third compound H1.

In some embodiments, the distance between the first compound S1 and a center of mass of the second compound A1 is at least 0.75 nm.

In some embodiments, the first compound S1 has a vertical dipole ratio (VDR) value equal or less than 0.33.

In some embodiments, the first compound S1 and the second compound A1 both has a VDR value equal or less than 0.33.

In some embodiments, the second compound A1 has a VDR value equal or less than 0.33; and at least one of the first and third compounds has a VDR value larger than 0.33.

In some embodiments, the second compound A1 has a VDR value equal or greater than 0.33; and at least one of the first and third compounds has a VDR value less than 0.33.

In some embodiments, the emissive region further comprises a second host. In some such embodiments, the second host comprises a moiety selected from the group consisting of bicarbazole, indolocarbazole, triazine, pyrimidine, pyridine, and boryl.

In some embodiments, the first compound S1 can be in a layer separate from the second compound A1 in the emissive region or the first compound S1 and the second compound A1 can be in a layer as a mixture, wherein the concentration of the first compound S1 in the layer containing the first compound S1 is in the range of 1 to 50 % by weight.

In some embodiments, the second compound A1 can be in a layer separate from the first compound S 1 in the emissive region or the first compound S1 and the second compound A1 can be in a layer as a mixture,
wherein the concentration of the second compound A1 in the layer containing the second compound A1 is in the range of 0.1 to 10 % by weight.

In some embodiments, the OLED emits a luminescent radiation at room temperature when a voltage is applied across the device; wherein the luminescent radiation comprises a first radiation component contributed from the second compound A1 with an emission λₘₐₓ of 340 to 500 nm.

In some embodiments, the OLED emits a luminescent radiation at room temperature when a voltage is applied across the device; wherein the luminescent radiation comprises a first radiation component contributed from the second compound A1 with an emission λₘₐₓ of 500 to 600 nm.

In some embodiments, the OLED emits a luminescent radiation at room temperature when a voltage is applied across the device; wherein the luminescent radiation comprises a first radiation component contributed from the second compound A1 with an emission λₘₐₓ of 600 to 900 nm.

In some embodiments, the OLED emits a luminescent radiation at room temperature when a voltage is applied across the device; wherein the luminescent radiation comprises a first radiation component contributed from the second compound A1 with a full-width half maximum (FWHM) of 50 nm or less.

In some embodiments, the OLED emits a luminescent radiation at room temperature when a voltage is applied across the device; wherein the luminescent radiation comprises a first radiation component contributed from the second compound A1 with a 10% onset of the emission peak is less than 465 nm.

In some embodiments, the emissive region further comprises a first host. In some embodiments, the sensitizer compound forms an exciplex with the first host in the OLED at room temperature. In some embodiments, the first host has a LUMO energy that is lower than the LUMO energies of the sensitizer compound and the acceptor compound in the emissive region. In some embodiments, the first host has a HOMO energy that is lower than the HOMO energies of the sensitizer compound and the acceptor compound in the emissive region. In some embodiments, the first host has a HOMO energy that is higher than the HOMO energies of the sensitizer compound and the acceptor compound in the emissive region. In some embodiments, the first host has a HOMO energy that is higher than the HOMO energy of at least one of the sensitizer compound and the acceptor compound in the emissive region.

In some embodiments, the emissive region further comprises a second host. In some embodiments, the first host forms an exciplex with the second host in the OLED at room temperature. In some embodiments, the S₁-T₁ energy gap in the exciplex formed by the first host and the second host is less than 0.4, 0.3, 0.2, or 0.1 eV. In some embodiments, the T₁ energy of exciplex is greater than 2.5, 2.6, 2.7, or 2.8 eV. In some embodiments, the concentrations of the first and second hosts in the layer or layers containing the first and second host are greater than the concentrations of the sensitizer compound and the acceptor compound in the layer or layers containing the sensitizer compound and the acceptor compound. In some embodiments, the concentrations of the first and second hosts in the layer or layers containing the first and second host are greater than the concentrations of the acceptor compound in the layer or layers containing the sensitizer compound and the acceptor compound.

In some embodiments, the S₁ energy of the first host is greater than that of the acceptor compound. In some embodiments, T₁ energy of the first host is greater than that of the sensitizer compound. In some embodiments, the sensitizer compound has a HOMO energy that is greater than that of the acceptor compound. In some embodiments, the second host has a HOMO level that is shallower than that of the acceptor compound. In some embodiments, the HOMO level of the acceptor compound is deeper than at least one selected from the sensitizer compound and the first host.

In some embodiments, the first host and/or the second host comprises at least one chemical group selected from the group consisting of triphenylene, carbazole, indolocarbazole, dibenzothiophene, dibenzofuran, dibenzoselenophene, 5λ²-benzo[d]benzo[4,5]imidazo[3,2-a]imidazole, 5,9-dioxa-13b-boranaphtho[3,2,1-de]anthracene, triazine, boryl, silyl, nitrile, aza-triphenylene, aza-carbazole, aza-indolocarbazole, aza-dibenzothiophene, aza-dibenzofuran, aza-dibenzoselenophene, aza-5λ²-benzo[d]benzo[4,5]imidazo[3,2-a]imidazole, and aza-(5,9-dioxa-13b-boranaphtho[3,2,1-de]anthracene). In some embodiments the first host and the second host are both organic compounds.

In some embodiments, at least one of the first host and the second host is an metal complex. In some embodiments, each of the first host and/or the second host is independently selected from the group consisting of: 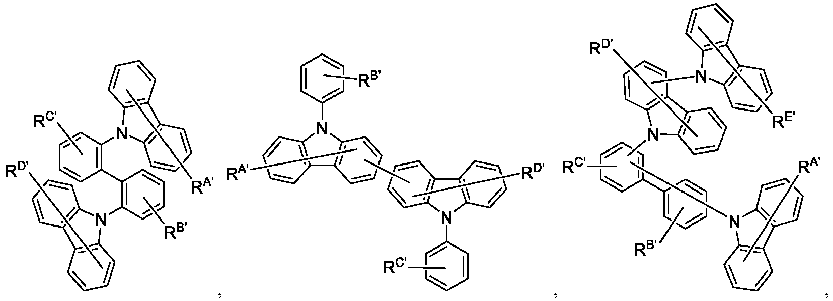 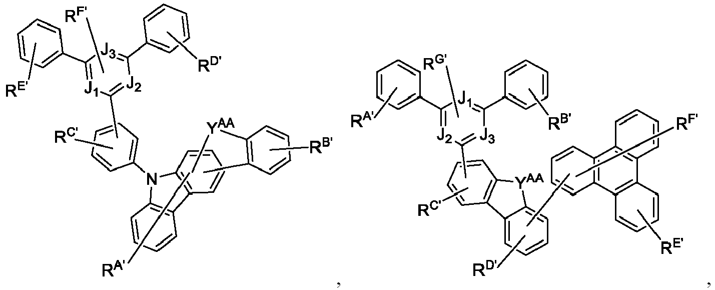 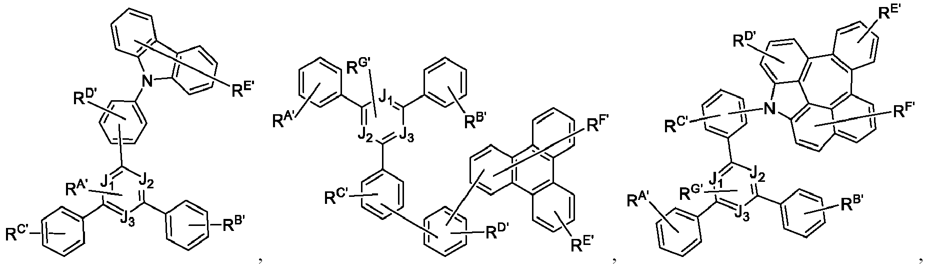 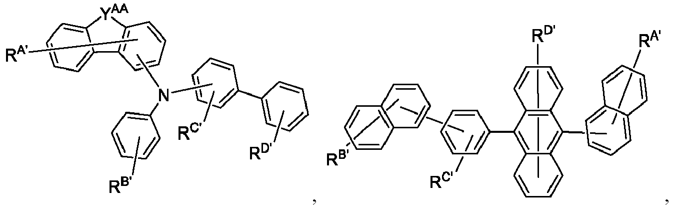 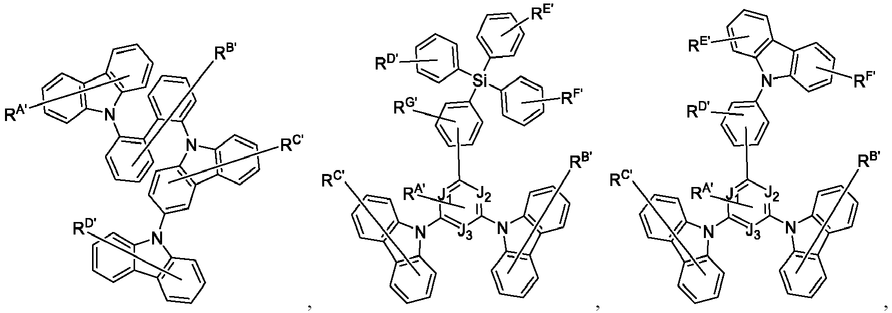 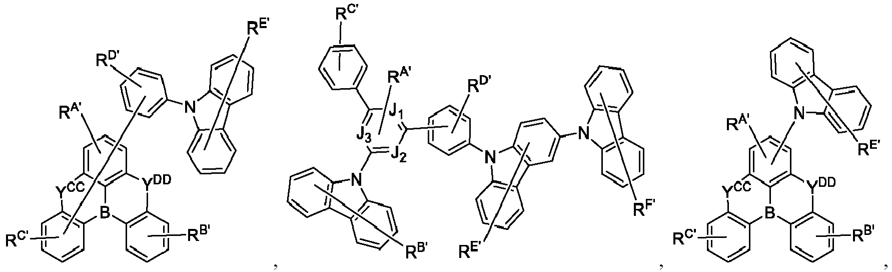 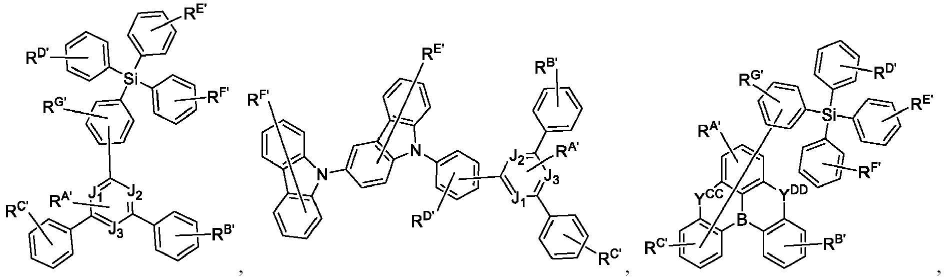 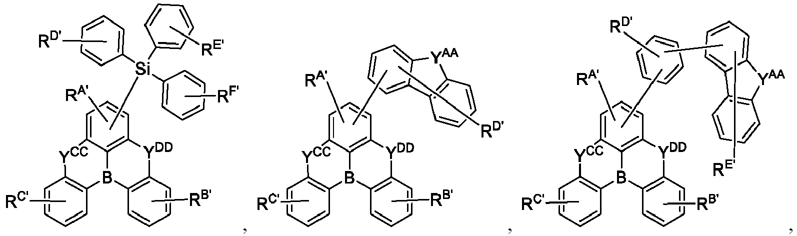 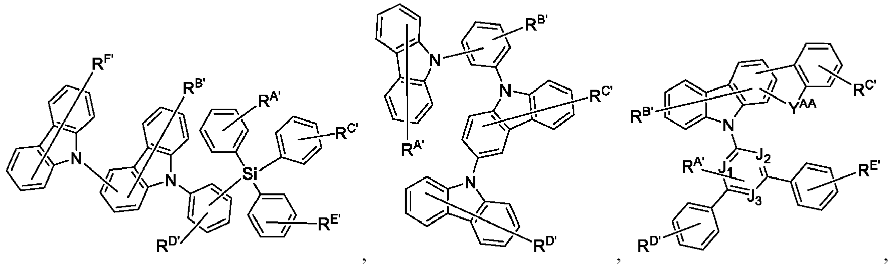 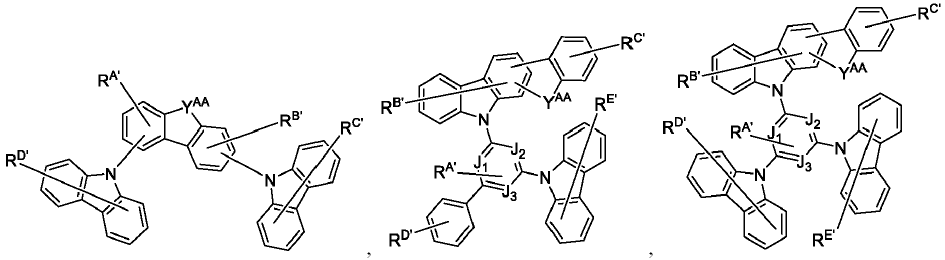 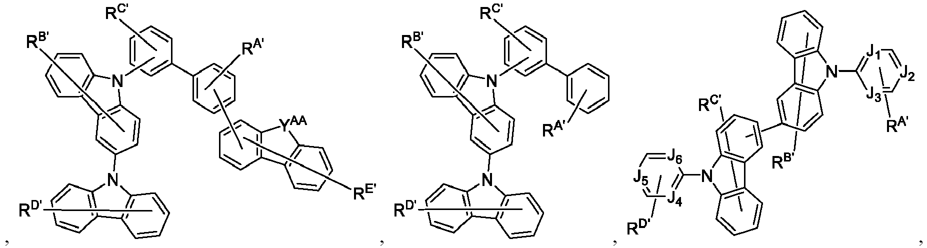 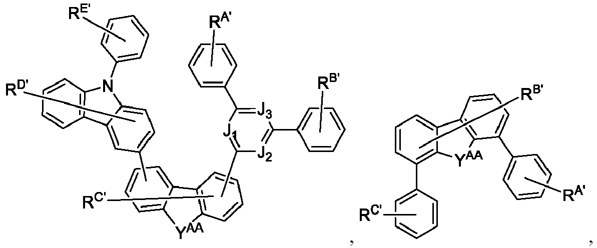 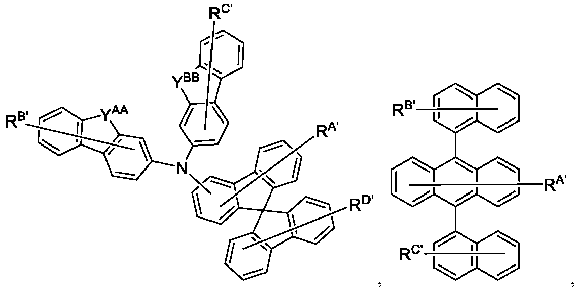 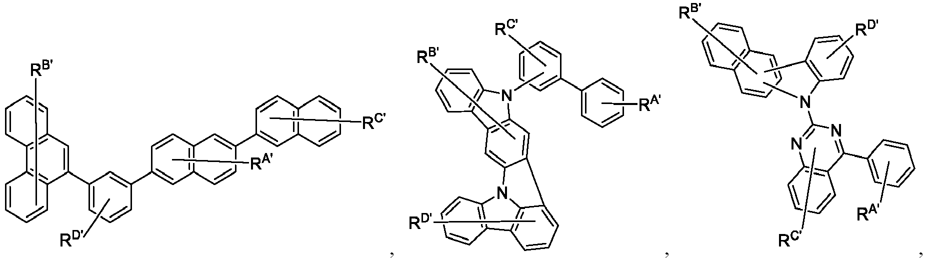 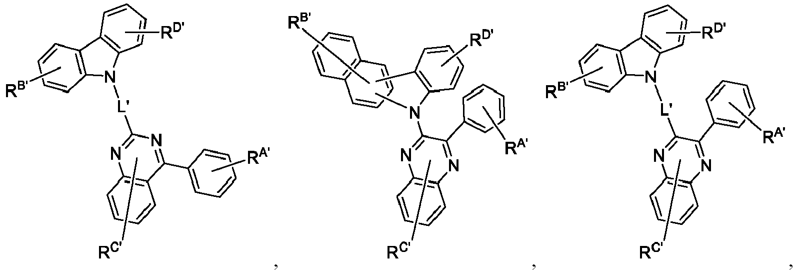 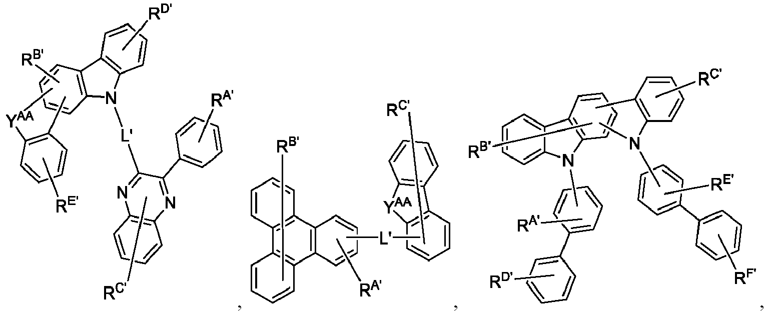 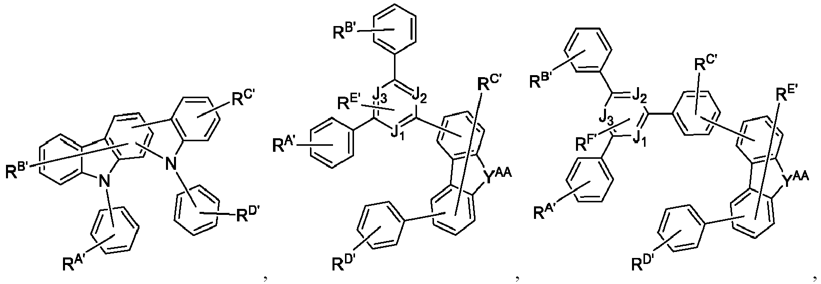 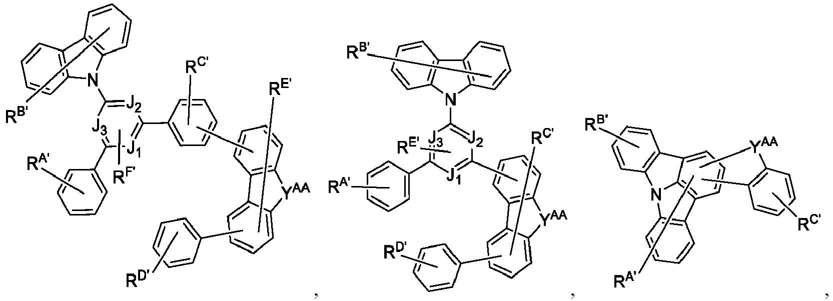 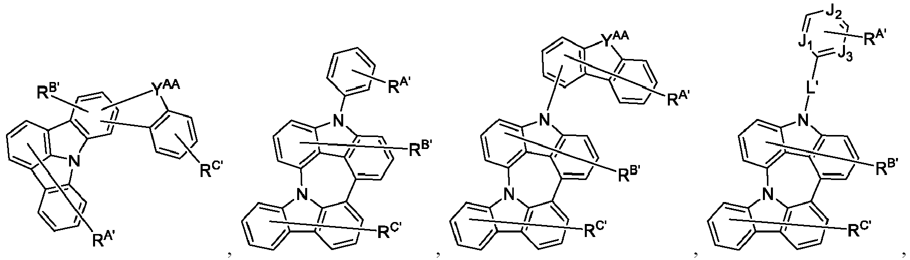 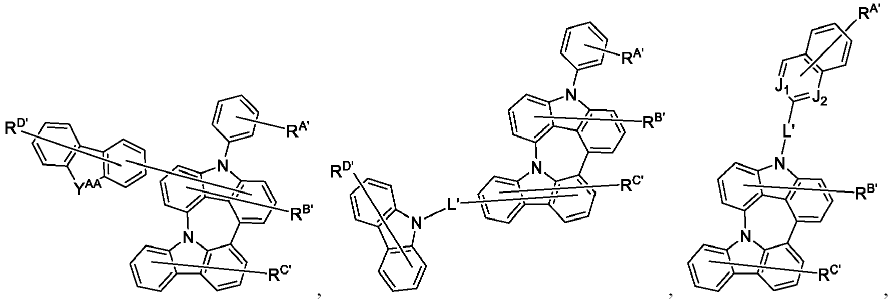 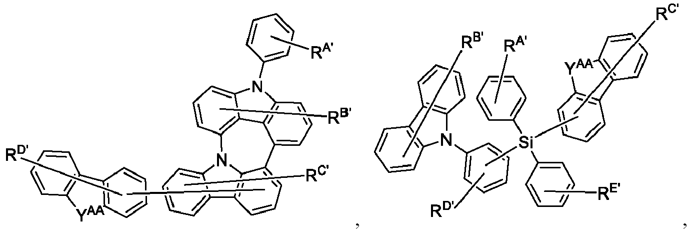 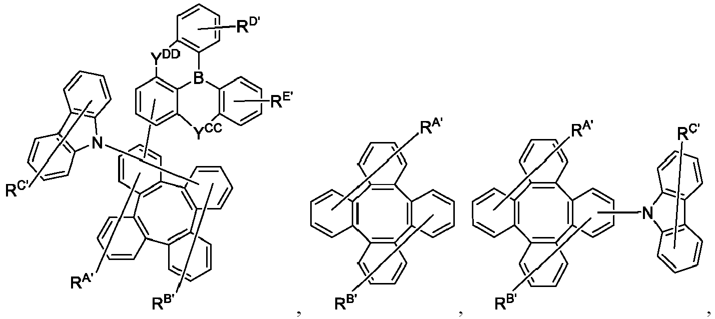 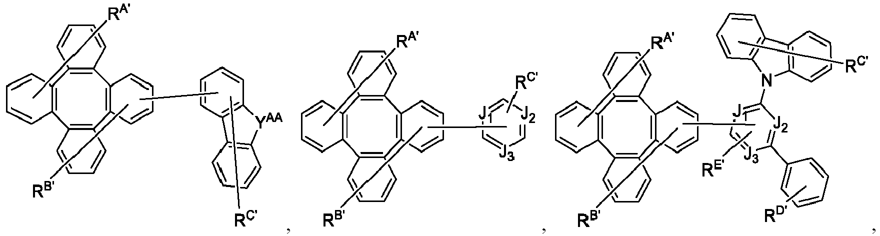 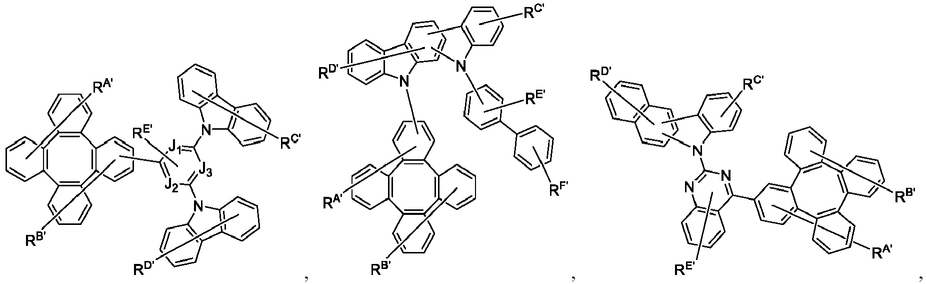 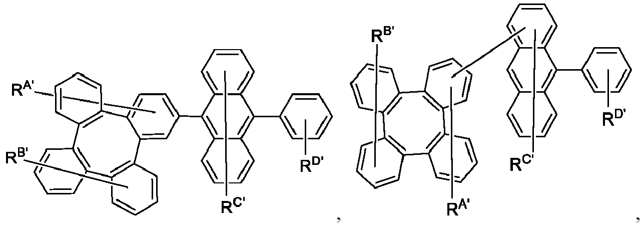 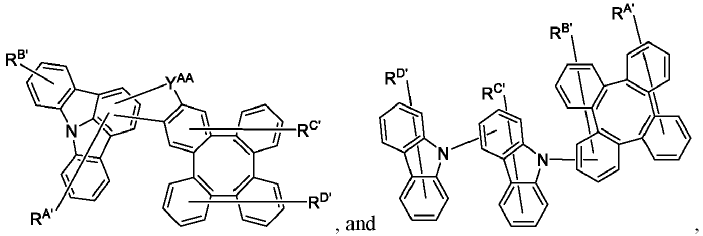 wherein:
each of J₁ to J₆ is independently C or N;
L' is a direct bond or an organic linker;
each Y^{AA}, Y^{BB}, Y^{cc}, and Y^{DD} is independently selected from the group consisting of absent a bond, direct bond, O, S, Se, CRR', SiRR', GeRR', NR, BR, BRR';
each of R^{A'} , R^{B'} , R^{C'}, R^{D'}, R^{E'}, R^{F'}, and R^{G'} independently represents mono, up to the maximum substitutions, or no substitutions;
each R, R', R^{A'}, R^{B'}, R^{C'}, R^{D'}, R^{E'}, R^{F'}, and R^{G'} is independently a hydrogen or a substituent selected from the group consisting of the general substituents as defined herein; any two substituents can be joined or fused to form a ring;
and where possible, each unsubstituted aromatic carbon atom is optionally replaced with N to form an aza-substituted ring.

In some embodiments at least one of J₁ to J₃ are N, in some embodiments at least two of J₁ to J₃ are N, in some embodiments, all three of J₃ to J₃ are N. In some embodiments, each Y^{cc} and Y^{DD} are preferably O, S, and SiRR', more preferably O, or S. In some embodiments, at least one unsubstituted aromatic carbon atom is replaced with N to form an aza-ring.

In another aspect, the present disclosure provides phosphor sensitized fluorescence OLEDs that utilize metal complexes with ligands comprising fused ring systems as sensitizers for phosphorescent sensitized fluorescent OLEDs. Judicious selection of fused moieties can introduce a ligand centered state in the phosphor which can result in a narrow emission spectrum. Narrow emission spectra are important for phosphorescent sensitizers to maximize the spectral overlap between the emission from the phosphorescent sensitizer and the extinction coefficient of the fluorescent acceptor in order to increase the rate of Főrster resonant energy transfer (FRET) without resulting in much redshift of the overall emission.

To optimize performance of phosphor sensitized fluorescence, OLEDs' FRET needs to be maximized. To increase the rate of FRET, the spectral overlap of the emission from the phosphorescent sensitizer and the extinction coefficient of the fluorescent acceptor needs to be as large as possible. Furthermore, in order to minimize the loss of energy in the FRET process, the spectral shift between the sensitizer and acceptor emission peaks should be minimized. To achieve these two objectives simultaneously, it would be beneficial to use phosphors with narrow emission spectra or sharp emission onsets. We propose the use of Ir complexes with fused ring systems as part of the cyclometallating ligand to achieve this narrow line shape for the sensitizer. Such a system can be used with narrow blue, green, and red Ir complexes to sensitize fluorophores with minimal shift in the peak emission of the device.

In some embodiments, the present disclosure provides an OLED comprising, sequentially: an anode; a hole transporting layer; an emissive region; an electron transporting layer; and a cathode; wherein the emissive region comprises: a first compound S 1; a second compound A1; and a third compound H1; wherein the first compound S1 is a sensitizer that transfers energy to the second compound A1; wherein the second compound A1 is an acceptor that is an emitter; wherein the third compound H1 is a first host, and at least one of the first compound S1 and the second compound A1 is doped in the third compound H1; wherein the first compound S1 is a metal complex comprising metal M that is selected from the group consisting of Ir, Rh, Re, Ru, Os, Pt, Pd, Zn, Ag, Au, and Cu, and a first ligand L_{A} that comprises at least one moiety F; wherein the at least one moiety F is a fused ring system comprising two or more 5-10 membered carbocyclic or heterocyclic rings and is joined to the metal M through an anionic bond; and with a proviso that if M is Pt or Pd, then the at least one moiety F is not a nonfused carbazole.

In some embodiments, the at least one moiety F is a fused ring system comprising two or more 5-membered or 6-membered carbocyclic or heterocyclic rings.

In some embodiments of the OLED, the first compound S1 is a green emitter. In some embodiments, the first compound S1 is a blue emitter.

In some embodiments, the fused ring system of the moiety F comprises at least two 6 -membered rings. Where the fused ring system of the moiety F comprises at least two 6-membered rings, the fused ring system comprises at least two rings selected from the group consisting of benzene, pyridine, pyrimidine, pyrazine, dihydropyridine, oxazine, thiazine, azaborinine. In some embodiments, the at least two 6-membered rings are fused together.

In some embodiments, the fused ring system of the moiety F comprises two or more 5-10 membered carbocyclic or heterocyclic rings. In some embodiments, the fused ring system of the moiety F comprises at least one 7-10 membered carbocyclic or heterocyclic ring.

In some embodiments, the fused ring system of the moiety F comprises at least one ring that is a fully or partially saturated.

In some embodiments, the fused ring system of the moiety F comprises at least one 5-membered ring. Where the fused ring system of the moiety F comprises at least one 5-membered ring, the fused ring system comprises at least one ring selected from the group consisting of furan, thiophene, pyrrole, oxazole, thiazole, oxadiazole, triazole, imidazole.

In some embodiments of the OLED, the first compound S1 is an iridium complex. In some embodiments, the fused ring system of the moiety F is joined to the metal through an anionic Ir-C bond. In some embodiments, the first compound S1 is an iridium complex comprising a metal carbene bond.

In some embodiments of the OLED, the first compound S1 is a Pt complex comprising a metal carbene bond.

In some embodiments of the OLED, the fused ring system of the moiety F comprises a group consisting of phenanthridine imidazole, diazaborinine, substituted or unsubstituted dibenzothiophene, substituted or unsubstituted dibenzoselenophene, substituted or unsubstituted carbazole, substituted dibenzofuran, azaphenanthridine imidazole, substituted or unsubstituted azadibenzothiophene, substituted or unsubstituted azadibenzoselenophene, substituted or unsubstituted azacarbazole, substituted or unsubstituted azadibenzofuran, substituted or unsubstituted benzothiophene, substituted or unsubstituted benzoselenophene, substituted or unsubstituted indole, substituted or unsubstituted benzofuran, substituted or unsubstituted benzimidazole, substituted or unsubstituted benzoxazole, substituted or unsubstituted benzothiazole, substituted or unsubstituted benzoxadiazole, substituted or unsubstituted benzothiadiazole, and a group comprising 4 or more fused rings.

In some embodiments, the fused ring system of the moiety F can be further substituted with nitrile, aryl, or heteroaryl.

In some embodiments, the moiety F is not dibenzofuran. In some embodiments, the at least one moiety F does not comprise a carbazole.

In some embodiments, the fused ring system of the moiety F forming an anionic bond to the metal is joined to a ring forming a dative bond to the metal through only a single bond. In some such embodiments, the at least one moiety F comprises a carbene and the metal is Ir.

In some embodiments, the first compound S 1 is a heteroleptic iridium complex.

In some embodiments, the first compound S1 is a platinum complex.

In some embodiments, the first ligand L_{A} comprises at least 4 carbocyclic or heterocyclic rings. In some embodiments, the first ligand L_{A} comprises at least 5 carbocyclic or heterocyclic rings. In some embodiments, the first ligand L_{A} comprises at least 6 carbocyclic or heterocyclic rings. In some embodiments, the first ligand L_{A} comprises at least 7 or more carbocyclic or heterocyclic rings.

In some embodiments, the at least one moiety F comprises a fused ring structure of at least 3 rings.

In some embodiments, the fused ring system of the moiety F is substituted with a substituted or unsubstituted aryl or heteroaryl group, boryl, nitrile, isonitrile, acetylide, allyl, and combinations thereof.

In some embodiments, the fused ring system of the moiety F is substituted with an electron withdrawing substituent.

In some embodiments, the fused ring system of the moiety F is substituted with a moiety comprising at least one group selected from the group consisting of F, CF₃, CN, COCH₃, CHO, COCF₃, COOMe, COOCF₃, NO₂, SF₃, SiF₃, PF₄, SF₅, OCF₃, SCF₃, SeCF₃, SOCF₃, SeOCF₃, SO₂F, SO₂CF₃, SeO₂CF₃, OSeO₂CF₃, OCN, SCN, SeCN, NC, ⁺N(R)₃, (R)₂CCN, (R)₂CCF₃, CNC(CF₃)₂, C(O)R, BR₂, BR₃, partially and fully fluorinated alkyl, partially and fully fluorinated cycloalkyl, partially and fully fluorinated aryl, heteroaryl, partially and fully fluorinated heteroaryl, cyano-containing alkyl, cyano-containing cycloalkyl, cyano-containing aryl, cyano-containing heteroaryl, carbazole, 1-substituted carbazole, and 1,8-disubstituted carbazole; where each R is independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof.

In some embodiments, the third compound H1 comprises a moiety selected from the group consisting of bicarbazole, indolocarbazole, 1-N indolocarbazole, pyridine, pyrimidine, pyrazine, triazine, dibenzofuran, dibenzothiophene, dibenzoselenophene, azadibenzothiophene, azadibenzoselenophene, azacarbazole, azadibenzofuran, silyl, phenyl nitrile, and boryl. In some embodiments, the compound H1 comprises a moiety selected from the group consisting of bicarbazole, triazine, indolocarbazole, and boryl.

In some embodiments, the first compound S1 has a full width at half maximum (FWHM) of < 50nm. In some embodiments, the first compound S1 has a FWHM of < 40nm. In some embodiments, the first compound S1 has a FWHM of < 30nm. In some embodiments, the first compound S1 has a FWHM of < 25nm.

In some embodiments, the first compound S1 has an emission onset, λₒₙₛₑₜ,_{S}, and an emission peak, λ_{maxS}, wherein λ_{maxS} - λ_{onset,S} is less than 15nm. Where emission onset, λ_{onset,S}, as used herein is defined as the shortest wavelength at which the emission of a compound is 20% of λ_{maxS} in a room temperature 2-methyltetrahydrofuran solution. In some embodiments, λ_{maxS} - λ_{onset,S} is less than 12nm. In some embodiments, λ_{maxS} - λ_{onset,S} is less than 10nm. In some embodiments, λ_{maxS} - λ_{onset,S} is less than 8nm. In some embodiments, λ_{maxS} - λ_{onset,S} is less than 6nm.

In some embodiments, the at least one moiety F is selected from the group consisting of: 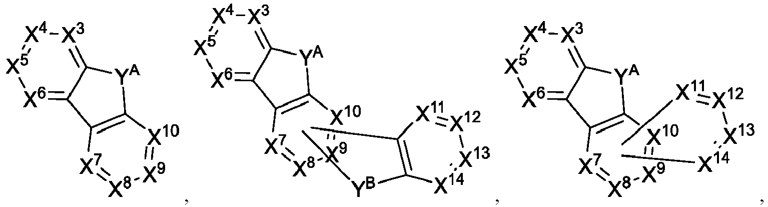 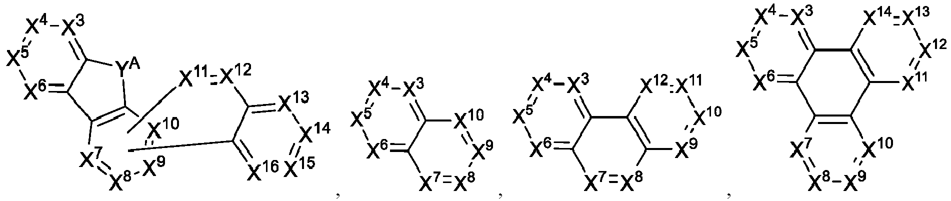 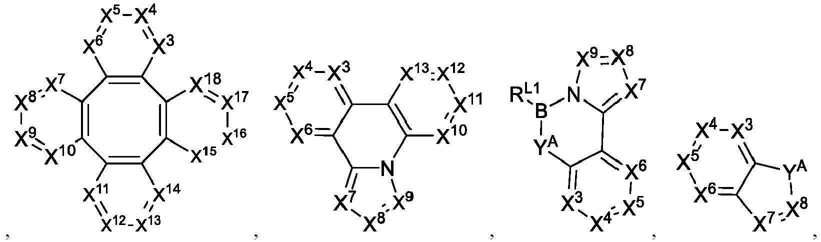 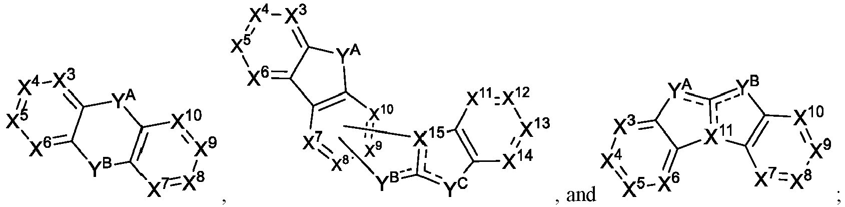 wherein:
each of X¹ -X¹⁸ can be independently C or N;
Y^{A}, Y^{B}, and Y^{C} are each independently selected from the group consisting of BR, BRR', NR, PR, P(O)R, O, S, Se, C=O, C=S, C=Se, C=NR, C=CRR', S=O, SO₂, CR, CRR', SiRR', GeRR', alkylene, cycloalkyl, aryl, cycloalkylene, arylene, heteroarylene, and combinations thereof;
each R^{L1}, R and R' is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and
any two substituents can be joined or fused to form a ring.

In some embodiments, the at least one moiety F is selected from the group consisting of: 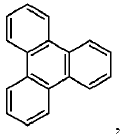 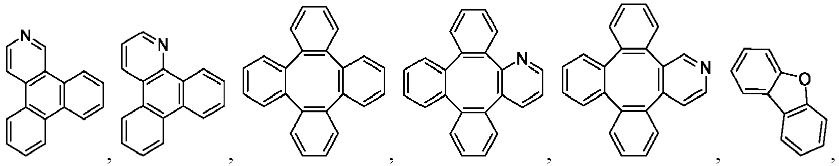 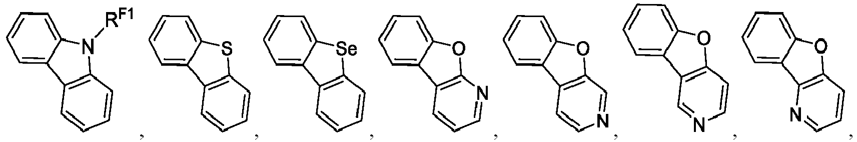 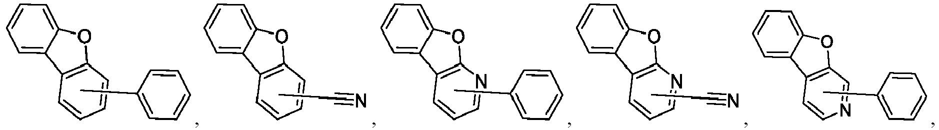 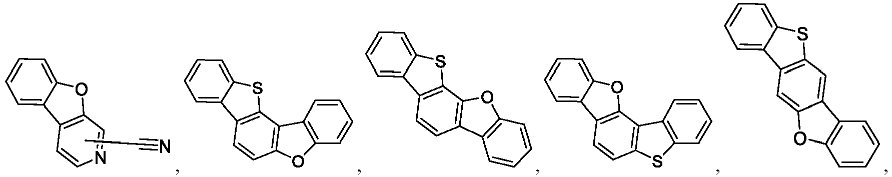 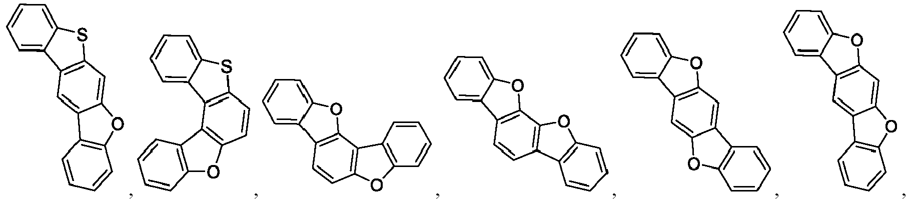 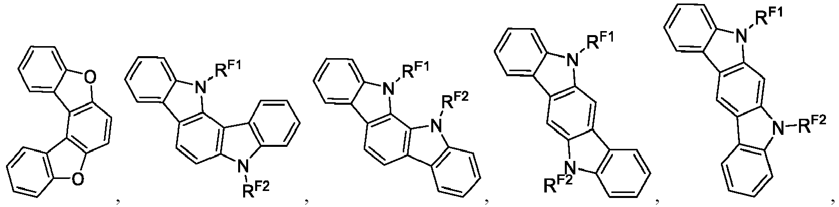 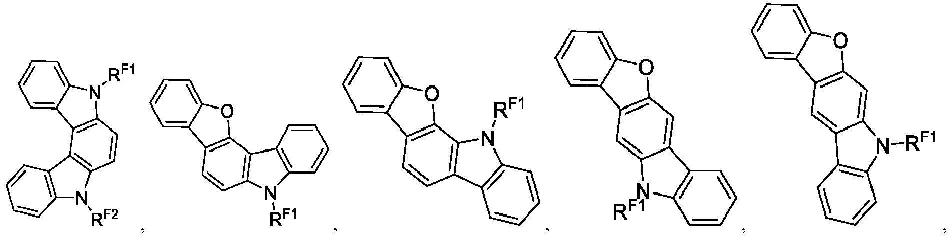 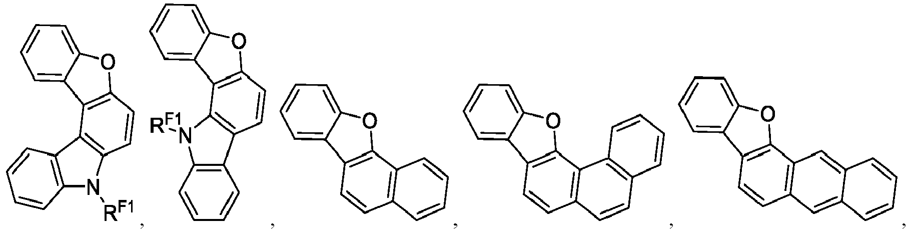 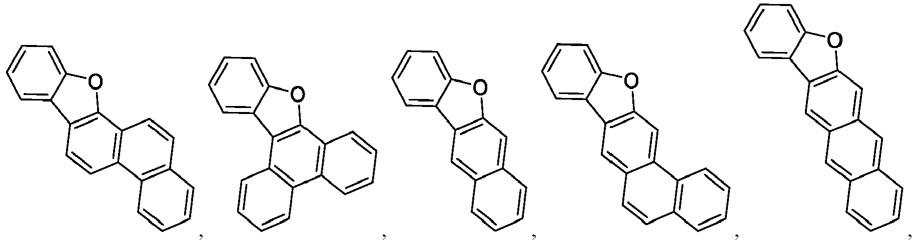 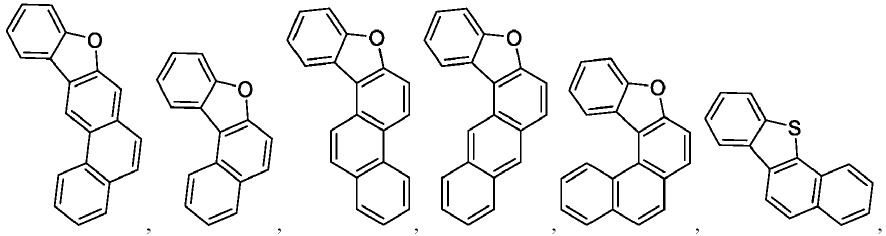 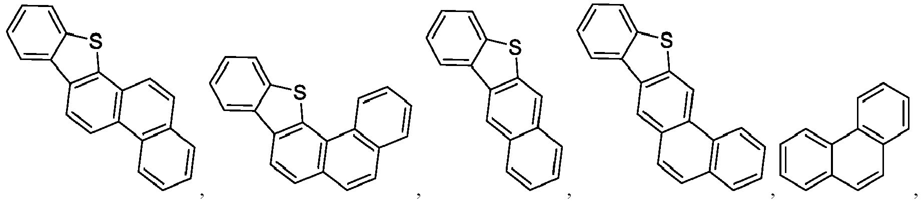 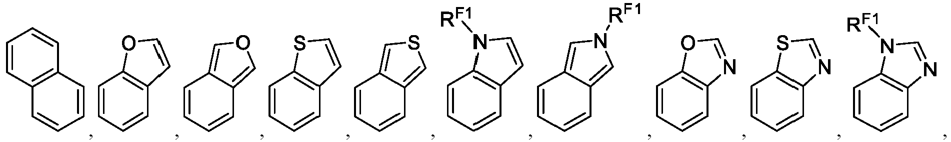 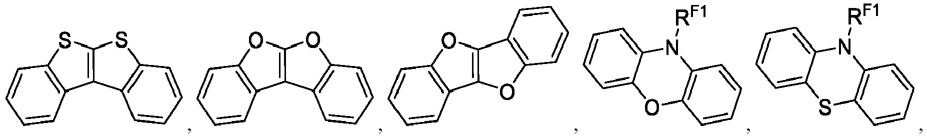 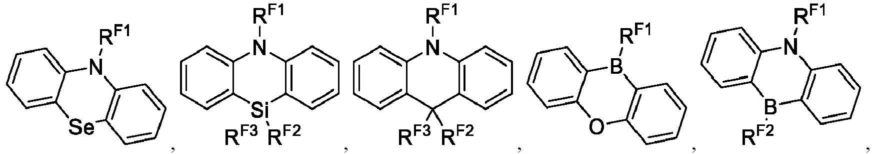 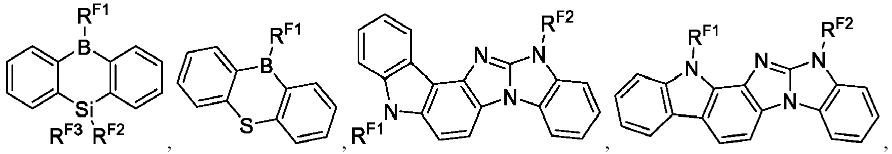 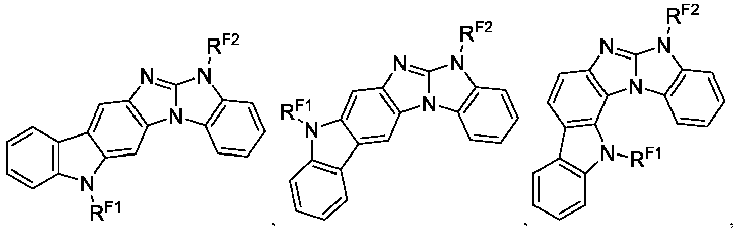 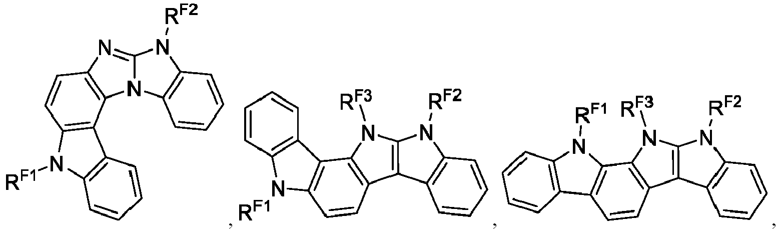 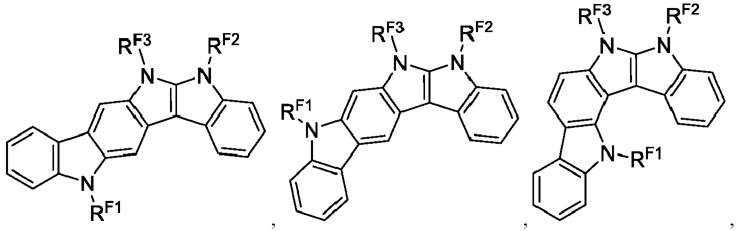 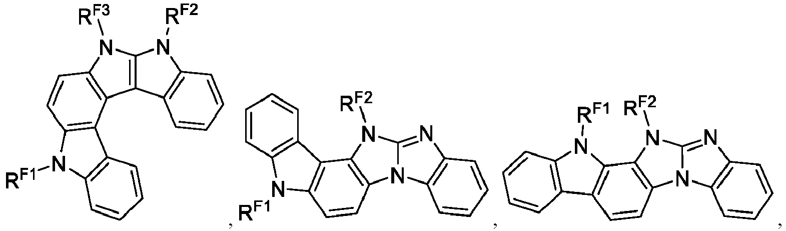 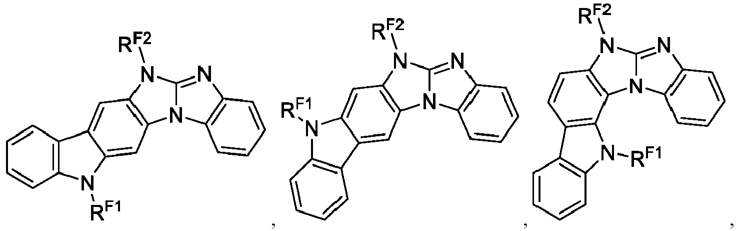 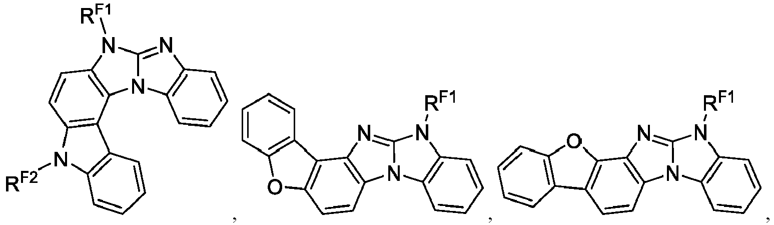 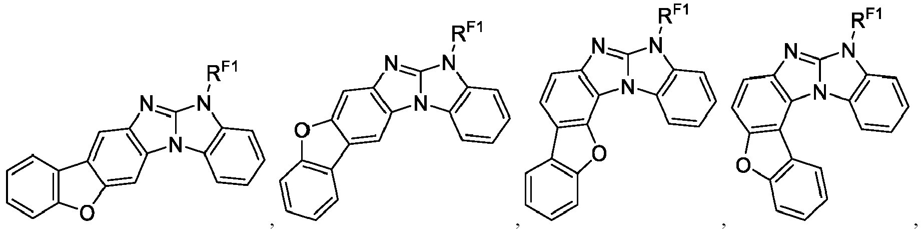 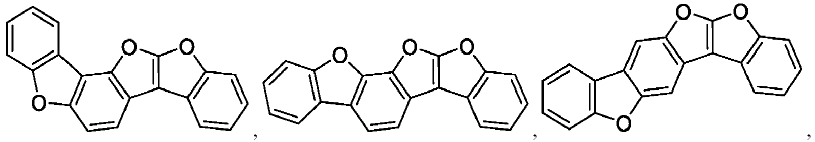 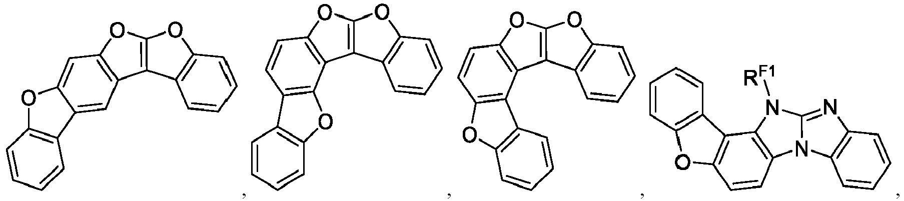 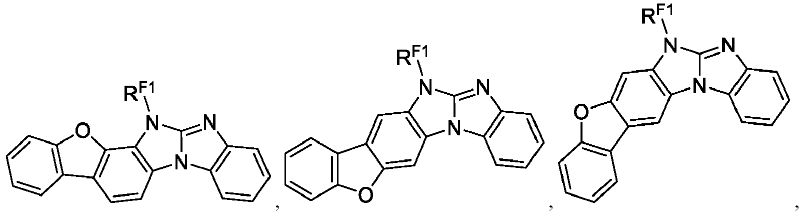 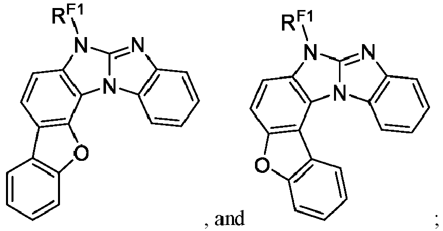 wherein R^{F1}, R^{F2}, and R^{F3} are each independently selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof.

In some embodiments, the first compound S 1 comprises a ligand L_{A} of formula I 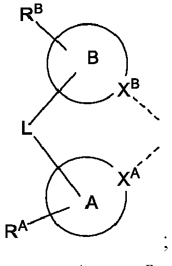 wherein moiety A and moiety B are each independently a monocyclic or polycyclic ring system; X^{A} and X^{B} are each independently C, N, or B; R^{A} and R^{B} are each independently mono to the maximum allowable substitution or no substitution; L is a direct bond or is selected from the group consisting of a direct bond, BR, BRR', NR, PR, P(O)R, O, S, Se, C=O, C=S, C=Se, C=NR, C= CRR', S=O, SO₂, CR, CRR', SiRR', GeRR', alkylene, cycloalkyl, aryl, cycloalkylene, arylene, heteroarylene, and combinations thereof; each of R, R', R^{A} and R^{B} is independently a hydrogen or is selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; any two groups may be optionally joined or fused to form a ring; and L_{A} may be optionally joined with other ligands to form a multidentate ligand.

In some embodiments, L in formula I is a direct bond. In some embodiments, each of X^{A} and X^{B} in formula I is independently C. In some embodiments, one of X^{A} and X^{B} in formula I is C, and the other is N. In some embodiments, moiety A in formula I is the at least one moiety F.

In some embodiments of the first compound S1 that comprises a ligand L_{A} of formula I, moiety B is selected from the group consisting of imidazole, benzimidazole, imidazole carbene, benzimidazole carbene, pyridylimidazole carbene, pyrimidylimidazole, pyrazineimidazole, triazine, pyrazole, oxazole, thiazole, oxadiazole, thiadiazole, pyridine, quinoline, isoquinoline, azadibenzothiophene, azadibenzofuran, azabenzothiophene, azabenzofuran,

In some embodiments of the first compound S1 that comprises a ligand L_{A} of formula I, moiety A is selected from the group consisting of naphthalene, quinoline, isoquinoline, quinazoline, benzofuran, azabenzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, carbazole, aza-carbazole, dibenzofuran, aza-dibenzofuran, dibenzothiophene, aza-dibenzothiophene, quinoxaline, phthalazine, phenanthrene, phenanthridine, fluorene, and aza-fluorene.

In some embodiments of the first compound S1 that comprises a ligand L_{A} of formula I, moiety A is monocyclic while moiety B is polycyclic. In some embodiments of the compound S1 that comprises a ligand L_{A} of formula I, moiety A is polycyclic while moiety B is monocyclic. In some such embodiments, the monocyclic can be benzene, pyridine, pyrimidine, pyridazine, pyrazine, triazine, imidazole, pyrazole, pyrrole, oxazole, furan, thiophene, or thiazole. In some such embodiments, the polycyclic can be naphthalene, quinoline, isoquinoline, quinazoline, benzofuran, benzoxazole, benzothiophene, benzothiazole, benzoselenophene, indene, indole, benzimidazole, carbazole, dibenzofuran, dibenzothiophene, quinoxaline, phthalazine, phenanthrene, phenanthridine, or fluorene.

In some embodiments of the first compound S1 that comprises a ligand L_{A} of formula I, each of moiety A and moiety B is independently a polycyclic fused ring structure. In some embodiments, each of moiety A and moiety B is independently a polycyclic fused ring structure comprising at least three fused rings. In some embodiments, the polycyclic fused ring structure has two 6-membered rings and one 5-membered ring. In some such embodiments, the 5-membered ring is fused to the ring coordinated to metal M and the second 6-membered ring is fused to the 5-membered ring. In some embodiments, each of moiety A and moiety B is independently selected from the group consisting of dibenzofuran, dibenzothiophene, dibenzoselenophene, and aza-variants thereof. In some such embodiments, each of moiety A and moiety B can independently be further substituted at the *ortho-* or *meta-* position of the O, S, or Se atom by a substituent selected from the group consisting of deuterium, fluorine, nitrile, alkyl, cycloalkyl, aryl, heteroaryl, and combinations thereof. In some such embodiments, the aza-variants contain exactly one N atom at the 6-position (*ortho* to the O, S, or Se) with a substituent at the 7-position (*meta* to the O, S, or Se).

In some embodiments of the first compound S1 that comprises a ligand L_{A} of formula I, each of moiety A and moiety B is independently a polycyclic fused ring structure comprising at least four fused rings. In some embodiments, the polycyclic fused ring structure comprises three 6-membered rings and one 5-membered ring. In some such embodiments, the 5-membered ring is fused to the ring coordinated to metal M, the second 6-membered ring is fused to the 5-membered ring, and the third 6-membered ring is fused to the second 6-membered ring. In some such embodiments, the third 6-membered ring is further substituted by a substituent selected from the group consisting of deuterium, fluorine, nitrile, alkyl, cycloalkyl, aryl, heteroaryl, and combinations thereof.

In some embodiments of the first compound S1 that comprises a ligand L_{A} of formula I, each of moiety A and moiety B is independently a polycyclic fused ring structure comprising at least five fused rings. In some embodiments, the polycyclic fused ring structure comprises four 6-membered rings and one 5-membered ring or three 6-membered rings and two 5-membered rings. In some embodiments comprising two 5-membered rings, the 5-membered rings are fused together. In some embodiments comprising two 5-membered rings, the 5-membered rings are separated by at least one 6-membered ring. In some embodiments with one 5-membered ring, the 5-membered ring is fused to the ring coordinated to metal M, the second 6-membered ring is fused to the 5-membered ring, the third 6-membered ring is fused to the second 6-membered ring, and the fourth 6-membered ring is fused to the third 6-membered ring.

In some embodiments of the first compound S1 that comprises a ligand L_{A} of formula I, each moiety A and moiety B is independently an aza version of the polycyclic fused rings described above. In some such embodiments, each moiety A and moiety B independently contains exactly one aza N atom. In some such embodiments, each moiety A and moiety B contains exactly two aza N atoms, which can be in one ring, or in two different rings. In some such embodiments, the ring having aza N atom is separated by at least two other rings from the metal M atom. In some such embodiments, the ring having aza N atom is separated by at least three other rings from the metal M atom. In some such embodiments, each of the *ortho* position of the aza N atom is substituted.

In some embodiments, the ligand L_{A} of formula I is partially or fully deuterated. In some embodiments, the second compound A1 is partially or fully deuterated. In some embodiments, the third compound H1 is partially or fully deuterated.

In some embodiments of the OLED disclosed herein, the first compound S1 is selected from the group consisting of the following structures: 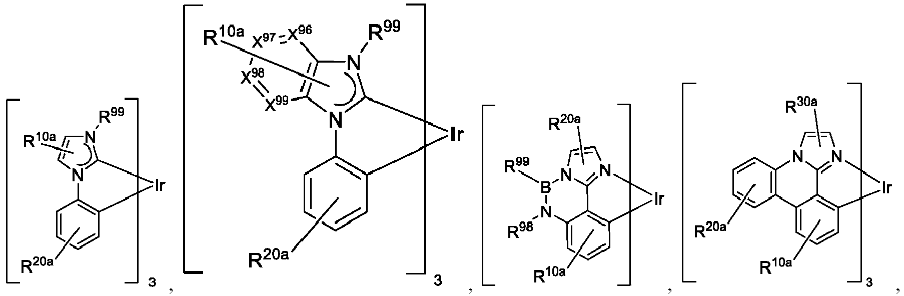 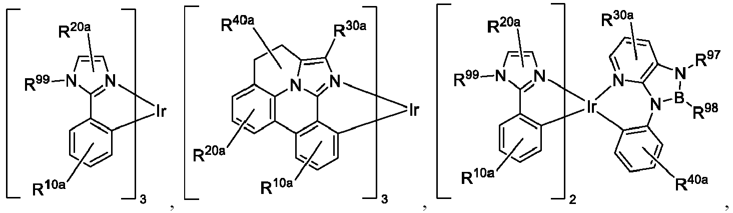 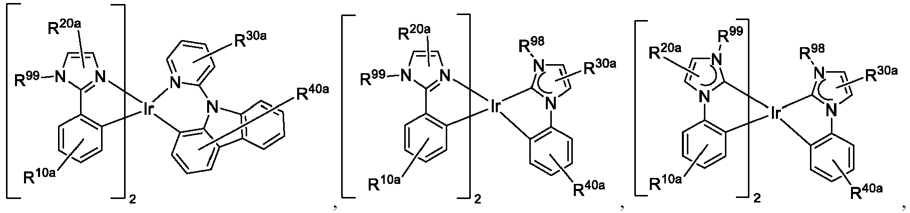 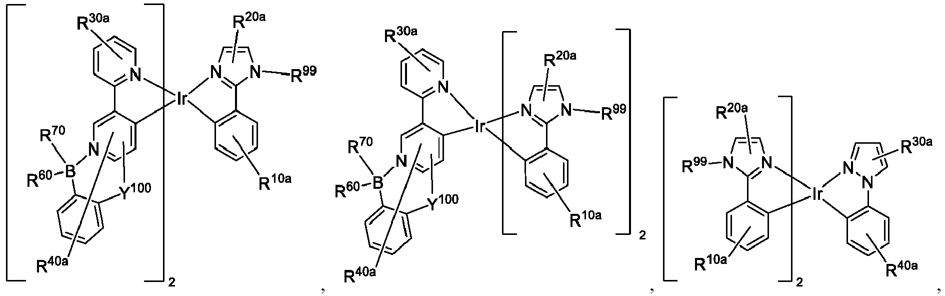 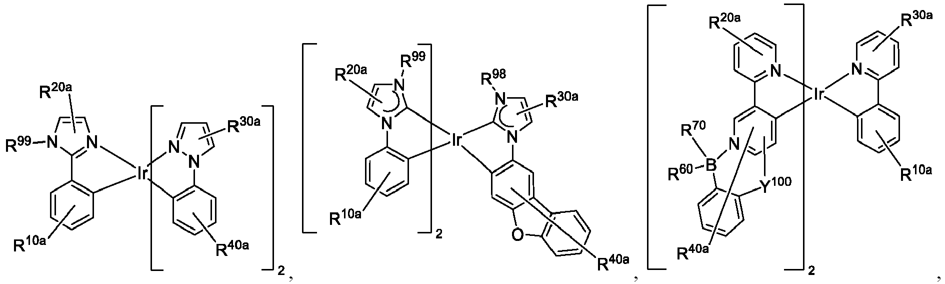 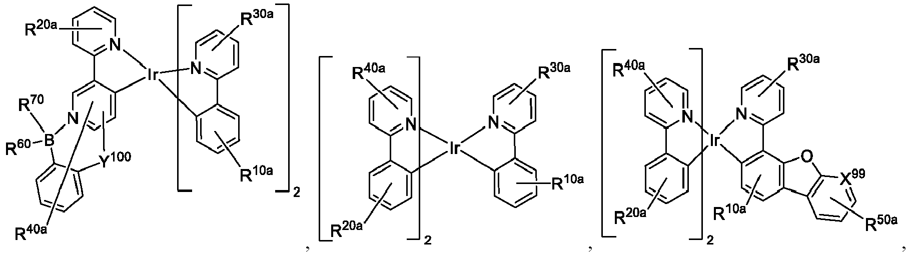 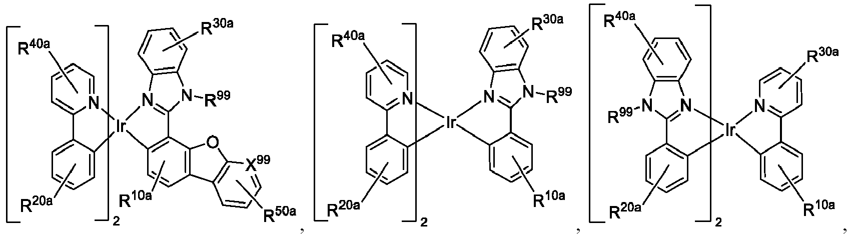 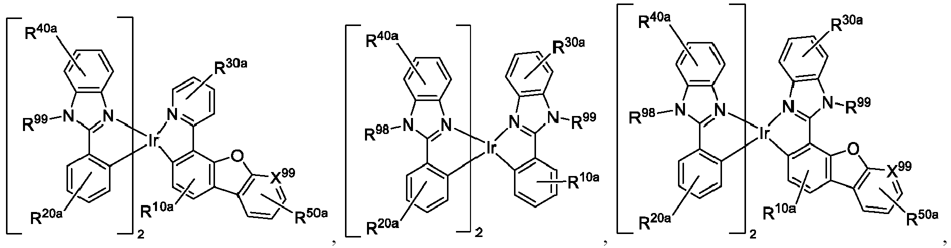 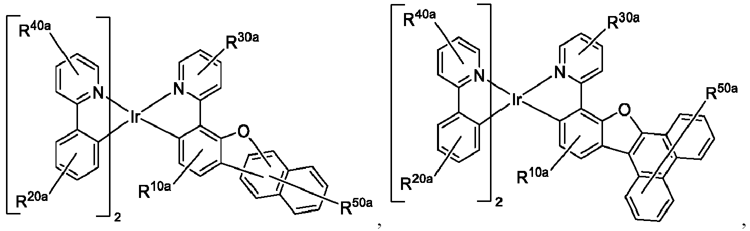 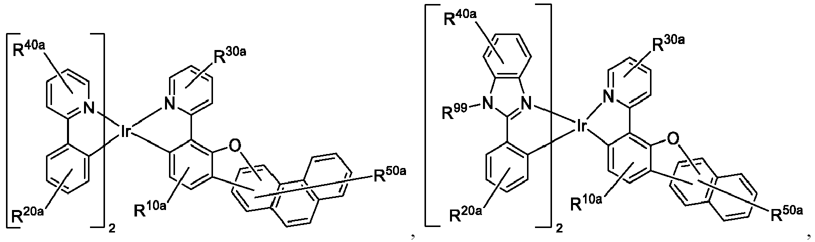 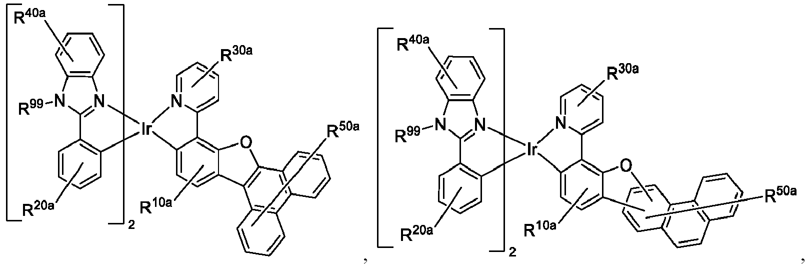 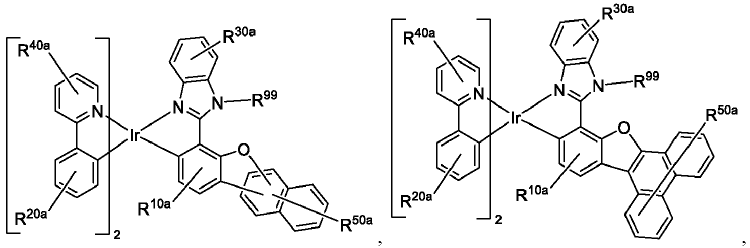 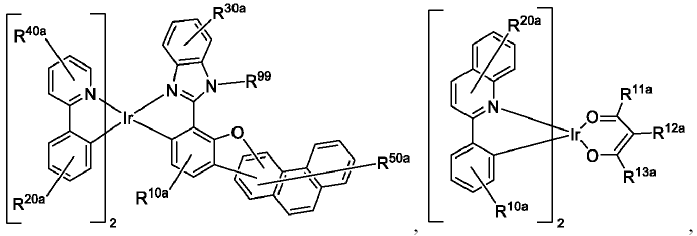 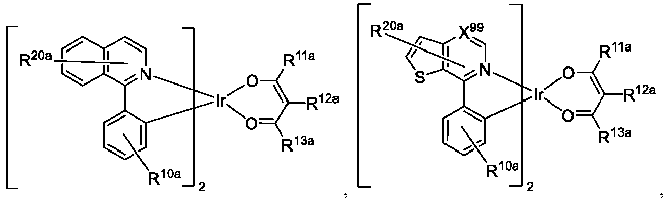 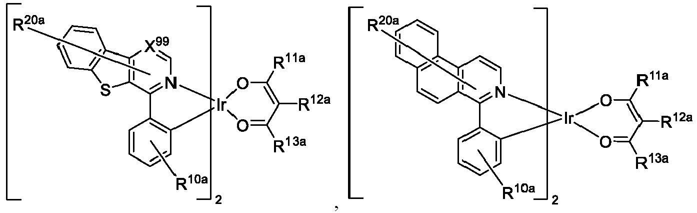 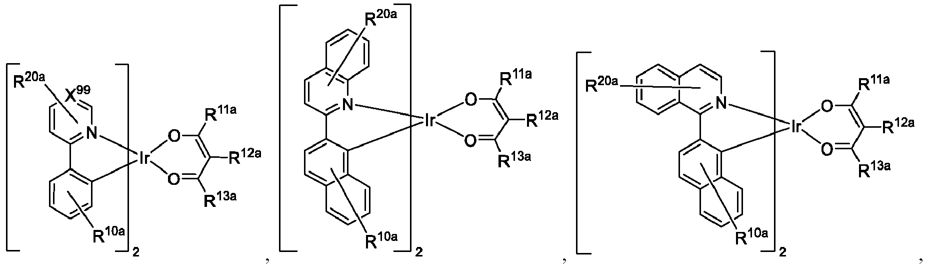 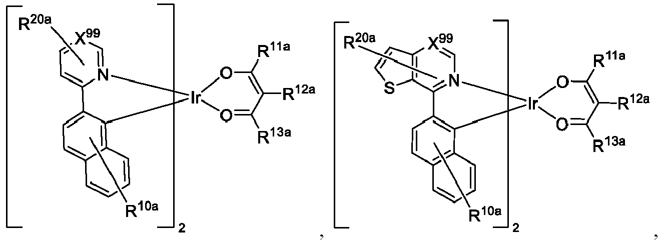 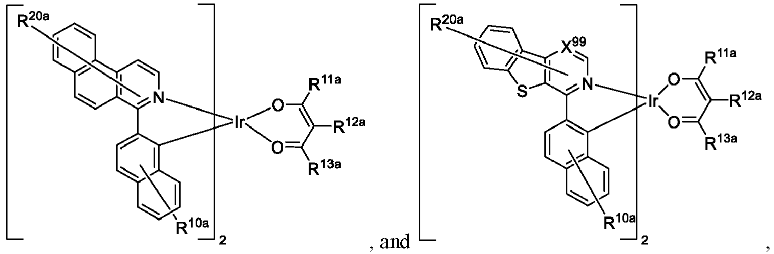 wherein
each of X⁹⁶ to X⁹⁹ is independently C or N;
each Y¹⁰⁰ is independently selected from the group consisting of a NR", O, S, and Se;
each of R^{10a}, R^{20a}, R^{30a}, R^{40a}, and R^{50a} independently represents mono substitution, up to the maximum substitutions, or no substitution;
each of R", R^{10a}, R^{11a}, R^{12a}, R^{13a}, R^{20a}, R^{30a}, R^{40a}, R^{50a}, R⁶⁰, R⁷⁰, R⁹⁷, R⁹⁸, and R⁹⁹ is independently a hydrogen or a substituent selected from the group consisting of deuterium, halide, alkyl, cycloalkyl, heteroalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, and combinations thereof; and
at least two R^{10a}, two R^{20a}, two R^{30a}, two R^{40a}, or two R^{50a} are fused to form a 5-membered or 6-membered ring for those complexes which do not comprise a fused ring system comprising two or more 5-membered and/or 6- membered carbocyclic or heterocyclic rings;
any two adjacent R^{10a}, R^{11a}, R^{12a}, R^{13a}, R^{20a}, R^{30a}, R^{40a}, R^{50a}, R⁶⁰, R⁷⁰, R⁹⁷, R⁹⁸, and R⁹⁹ are optionally joined or fused to form a ring.

In some embodiments of the OLED, the first compound S1 is selected from the group consisting of the following structures with Pt: 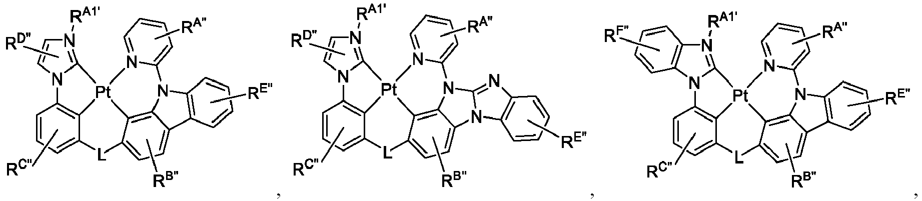 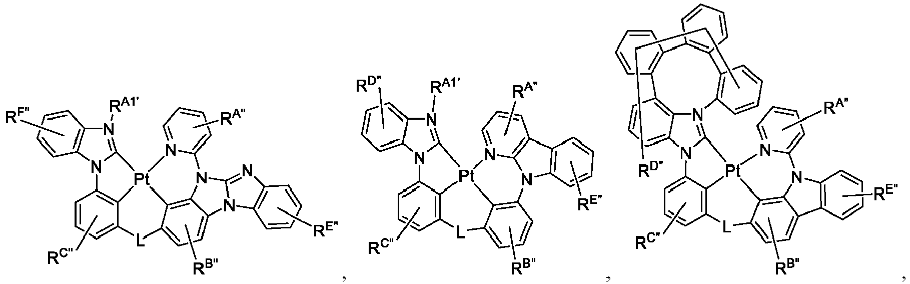 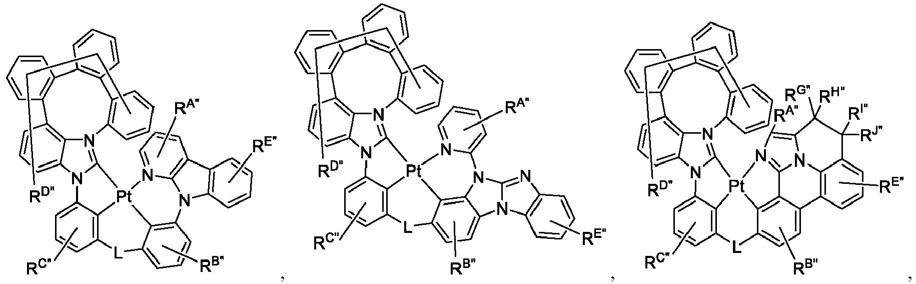 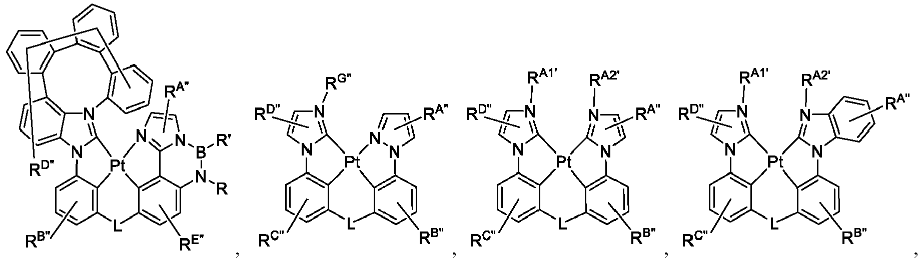 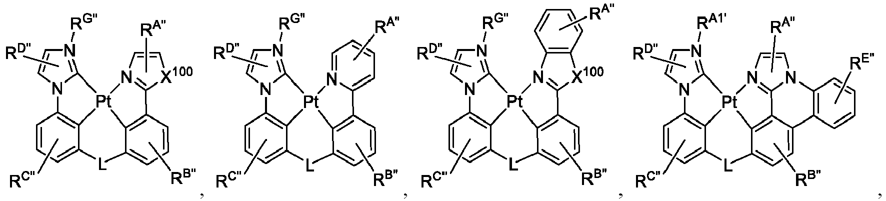 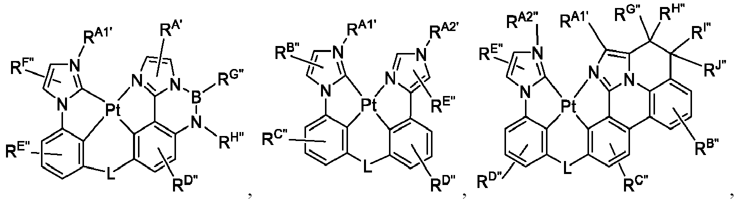 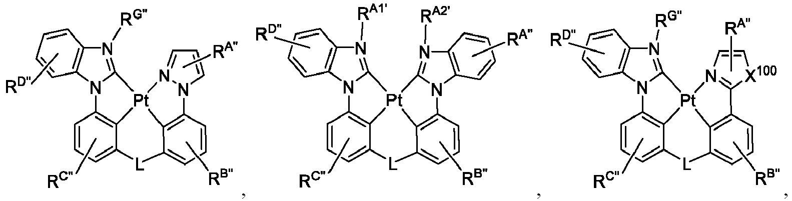 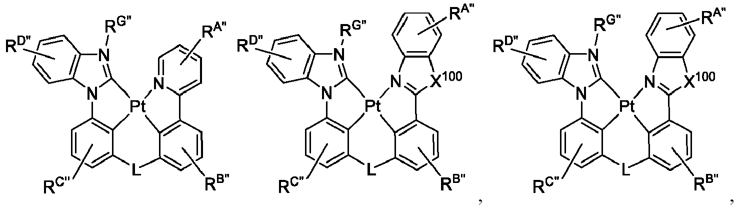 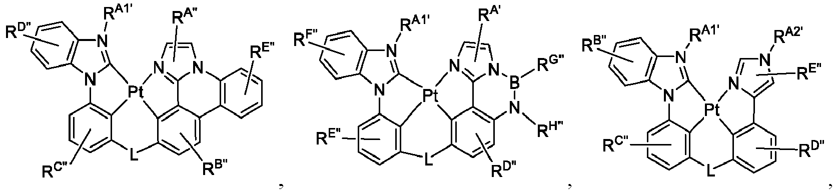 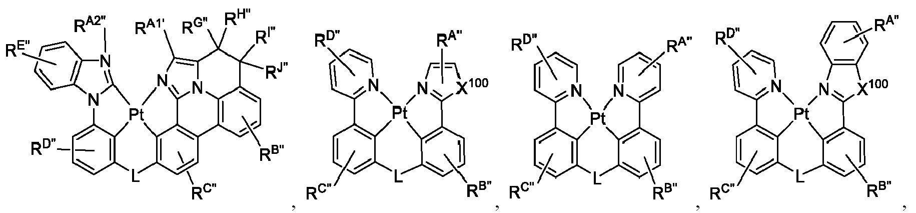 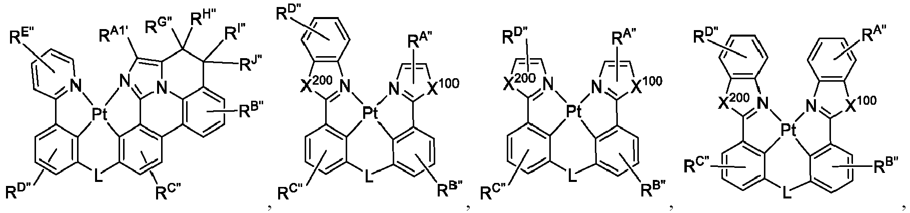 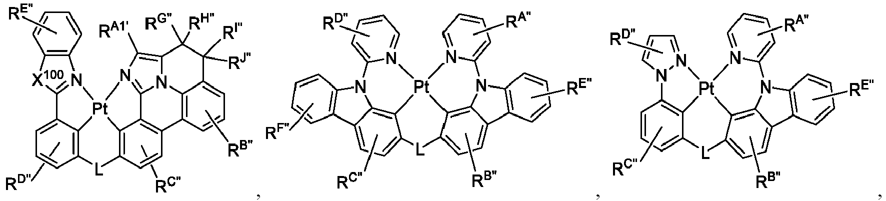 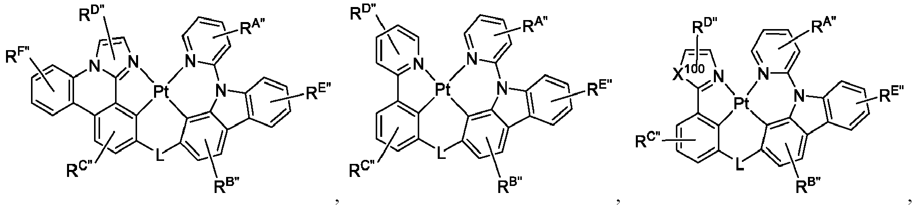 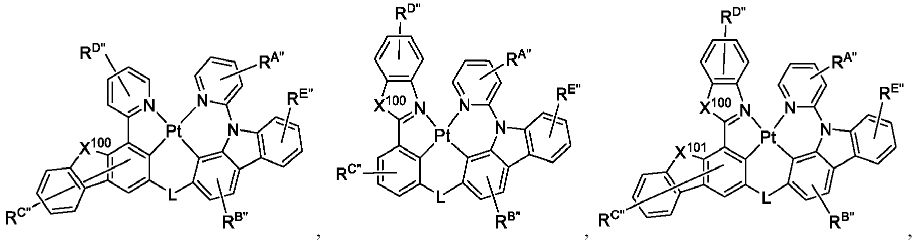 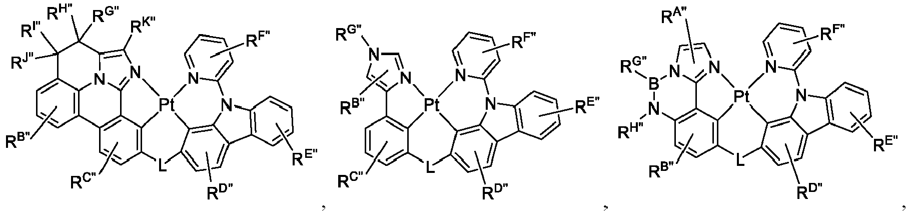 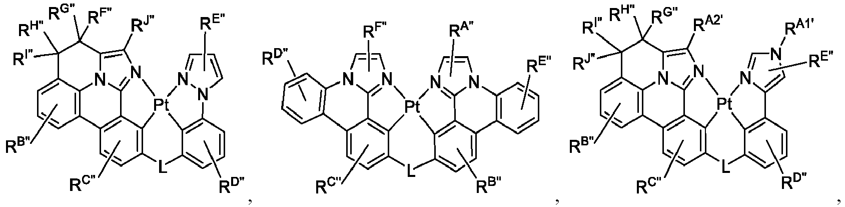 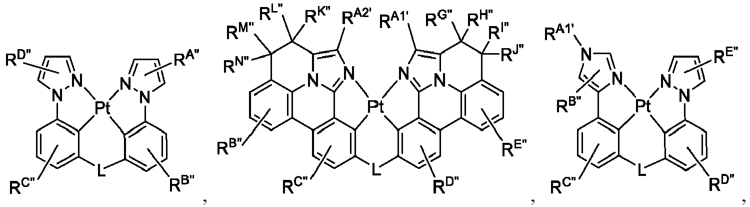 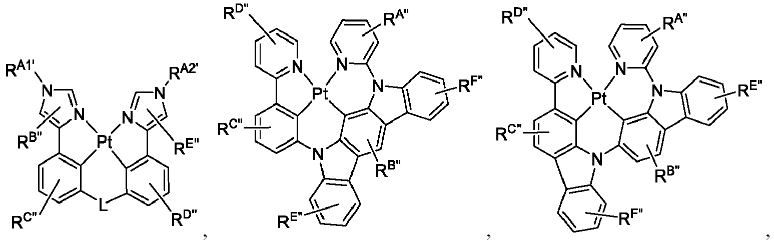 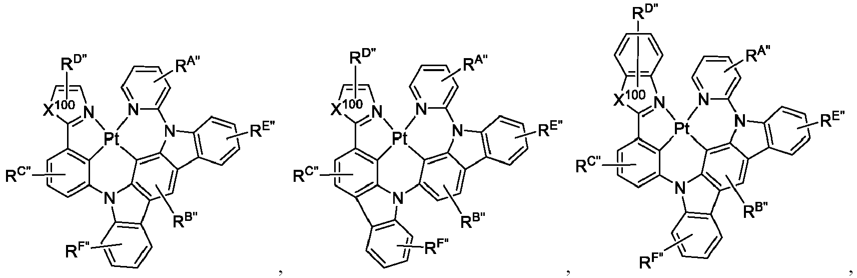 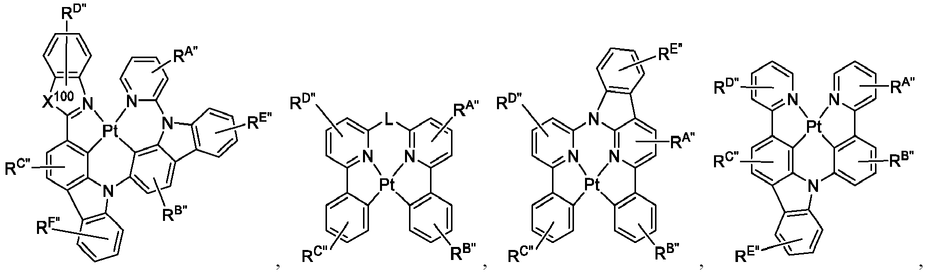 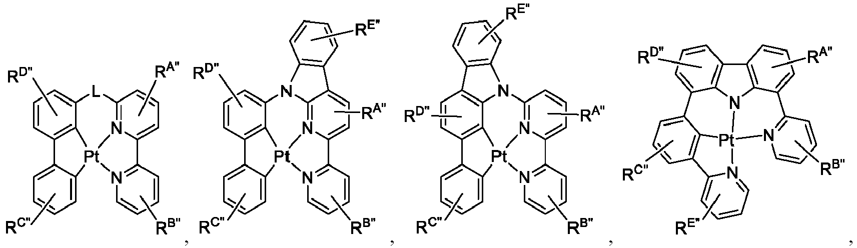 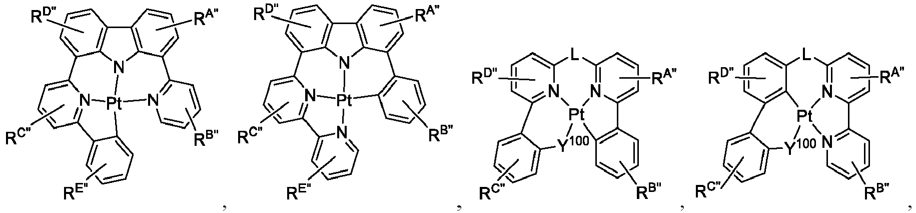 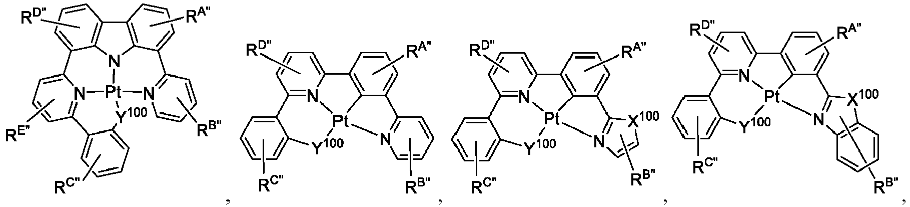 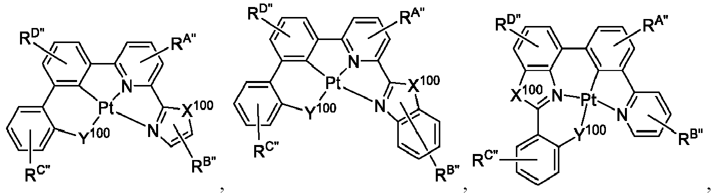 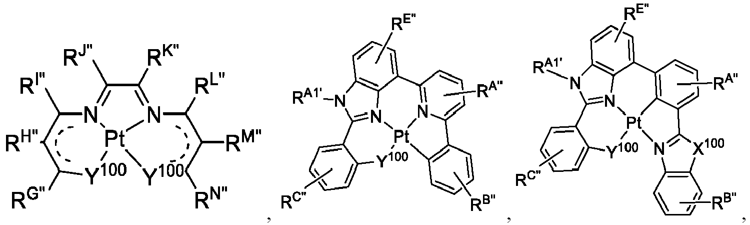 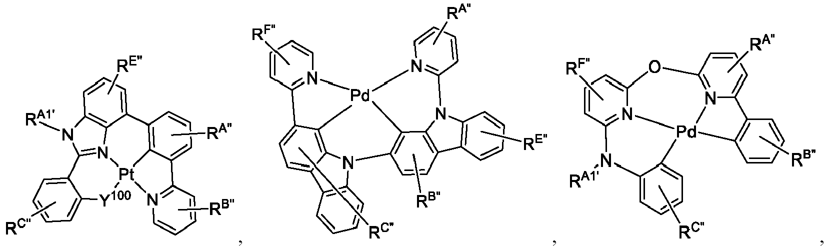 and 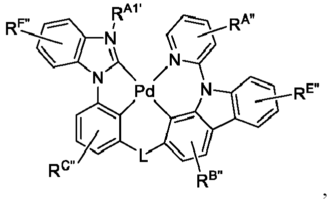 wherein:
each Y¹⁰⁰ is independently selected from the group consisting of a NR, O, S, and Se;
L is independently selected from the group consisting of a direct bond, BR, BRR', NR, PR, O, S, Se, C=O, C=S, C=Se, C=NR, C=CRR', S=O, SO₂, CR, CRR', SiRR', GeRR', alkyl, cycloalkyl, aryl, heteroaryl, and combinations thereof;
X¹⁰⁰ and X²⁰⁰ for each occurrence is selected from the group consisting of O, S, Se, NR, and CRR';
each R^{A"}, R^{B"}, R^{C"}, R^{D"}, R^{E"}, and R^{F"} independently represents mono-, up to the maximum substitutions, or no substitutions;
each of R, R', R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is independently a hydrogen or a substituent selected from the group consisting of deuterium, halide, alkyl, cycloalkyl, heteroalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, combinations thereof;
at least two R^{A"}, two R^{B"}. two R^{C"}, two R^{D"}, two R^{E"}, or two R^{F"} are fused to form a 5-membered or 6-membered ring for those complexes which do not comprise a fused ring system comprising two or more 5-membered and/or 6- membered carbocyclic or heterocyclic rings; and
two adjacent R, R', R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} may be optionally joined to form a ring.

It should be understood that the metal Pt of each of those compounds in the above structures with Pt can be replaced by Pd, and those derived Pd compounds are also intended to be specifically covered.

In some embodiments, the first compound S1 is selected from the group consisting of

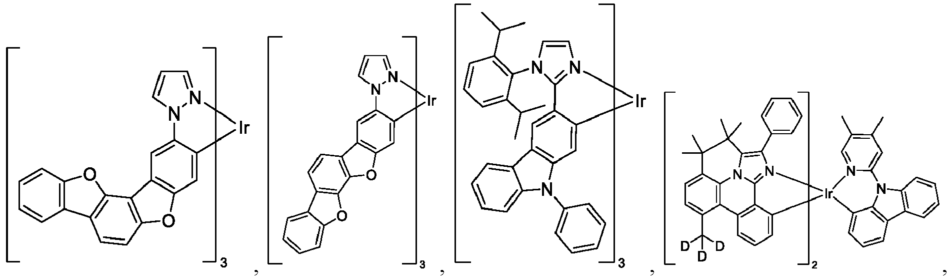

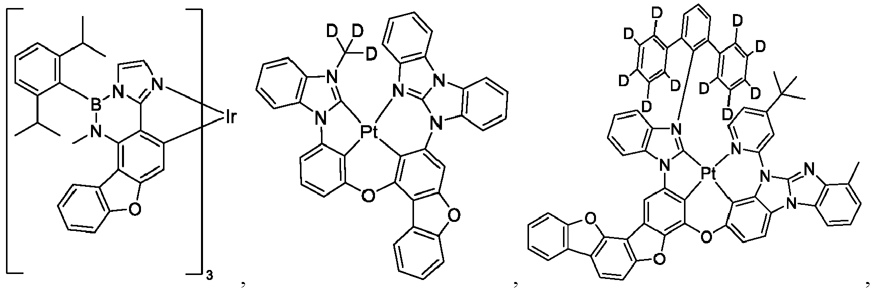

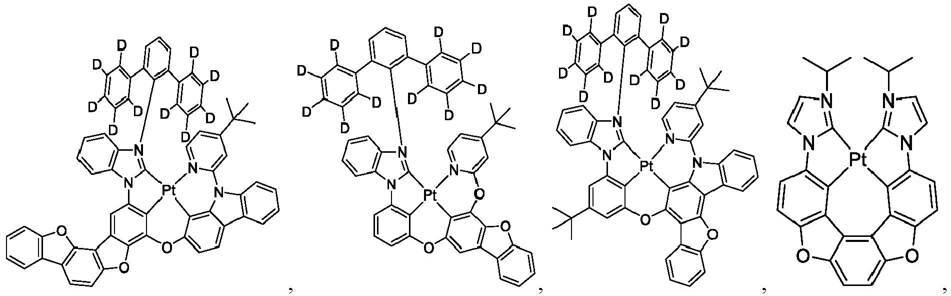

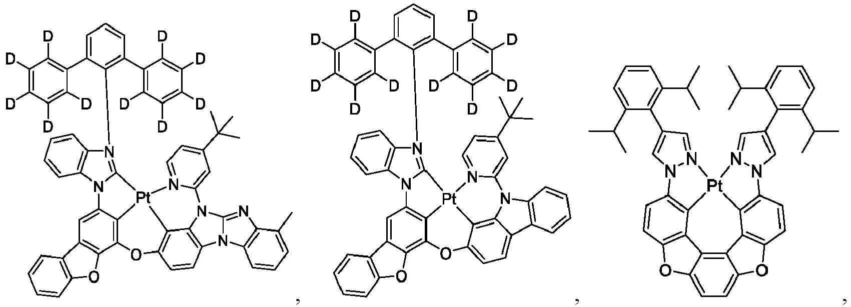

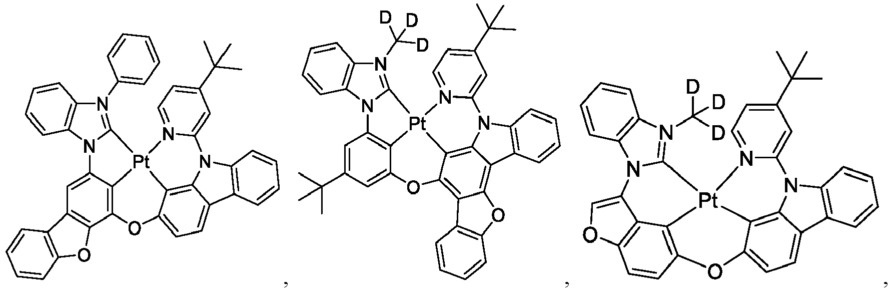

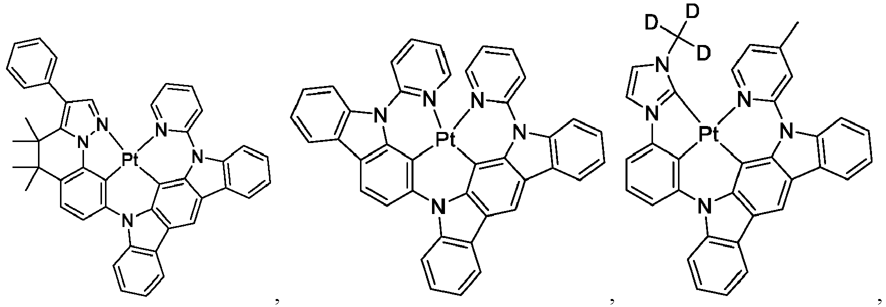

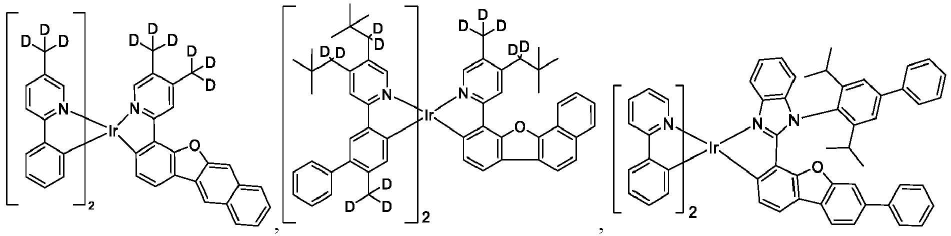

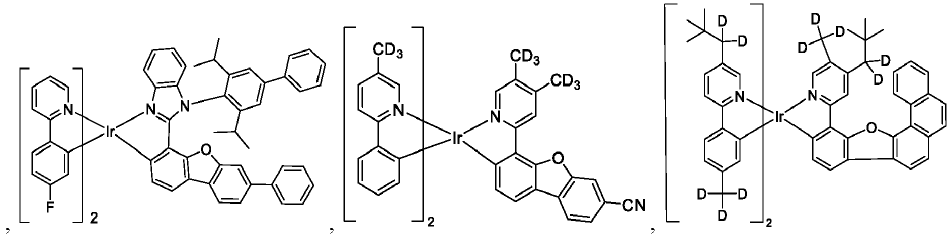

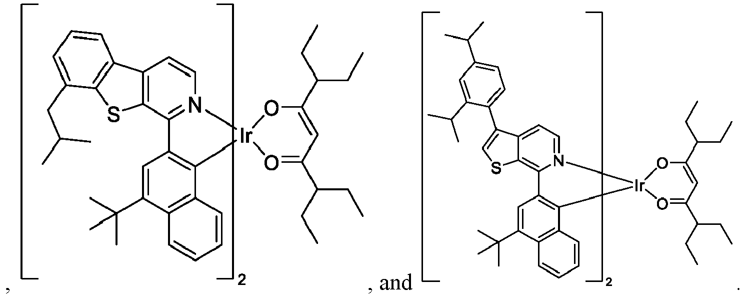

In some embodiments, the first compound S1 forms an exciplex with the first host H1 in the OLED at room temperature. In some embodiments, the first host H1 has a LUMO energy that is lower than the LUMO energies of the first compound S1 and the second compound A1 in the emissive region. In some embodiments, the first host H1 has a HOMO energy that is lower than the HOMO energies of the first compound S1 and the second compound A1 in the emissive region. In some embodiments, the first host H1 has a HOMO energy that is higher than the HOMO energies of the first compound S1 and the second compound A1 in the emissive region. In some embodiments, the first host H1 has a HOMO energy that is higher than the HOMO energy of at least one of the first compound S 1 and the second compound A1 in the emissive region.

In some of all the above embodiments, the emissive region further comprises a second host. In some embodiments, the first host H1 forms an exciplex with the second host in the OLED at room temperature. In some embodiments, the concentrations of the first and second hosts in the layer or layers containing the first and second host are greater than the concentrations of the first compound S1 and the second compound A1 in the layer or layers containing the first compound S1 and the second compound A1. In some embodiments, the concentrations of the first and second hosts in the layer or layers containing the first and second host are greater than the concentrations of the second compound A1 in the layer or layers containing the first compound S1 and the second compound A1.

In some embodiments, the S₁ energy of the first host H1 is greater than that of the second compound A1. In some embodiments, T₁ energy of the first host H1 is greater than that of the first compound S 1. In some embodiments, the first compound S1 has a HOMO energy that is greater than that of the second compound A1. In some embodiments, the second host has a HOMO level that is shallower than that of the second compound A1. In some embodiments, the HOMO level of the second compound A1 is deeper than at least one selected from the first compound S1 and the first host H1.

In some embodiments, the first host and/or the second host comprises at least one chemical group selected from the group consisting of triphenylene, carbazole, indolocarbazole, dibenzothiophene, dibenzofuran, dibenzoselenophene, 5λ²-benzo[d]benzo[4,5]imidazo[3,2-a]imidazole, 5,9-dioxa-13b-boranaphtho[3,2,1-de]anthracene, triazine, boryl, silyl, aza-triphenylene, aza-carbazole, aza-indolocarbazole, aza-dibenzothiophene, aza-dibenzofuran, aza-dibenzoselenophene, aza-5λ²-benzo[d]benzo[4,5]imidazo[3,2-a]imidazole, and aza-(5,9-dioxa-13b-boranaphtho[3,2,1-de]anthracene).

In some embodiments, each of the first host and/or the second host is independently selected from the group consisting of: 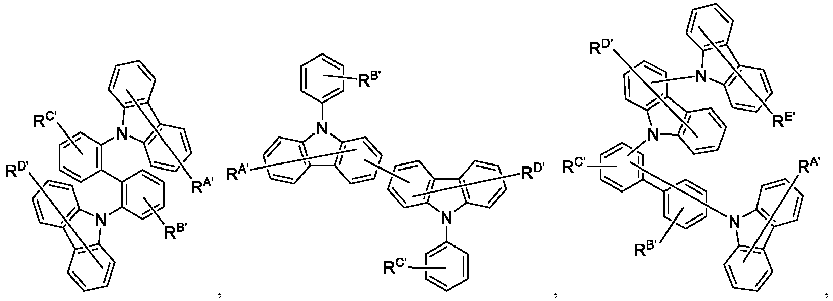 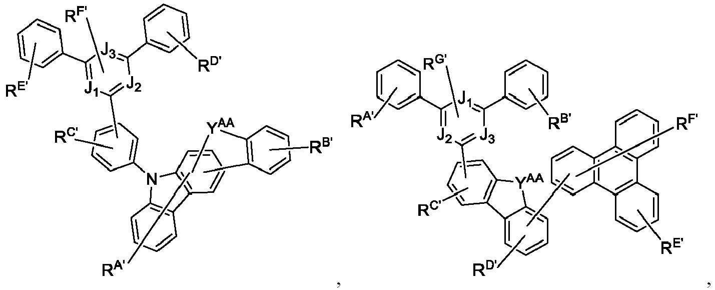 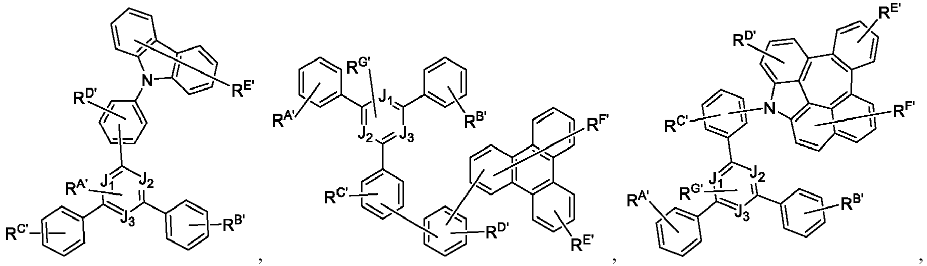 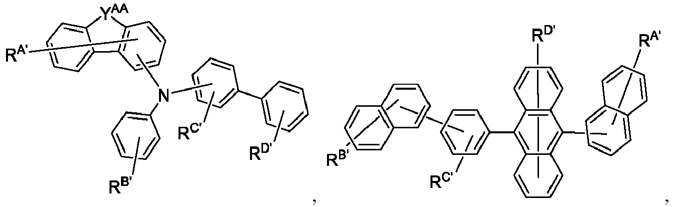 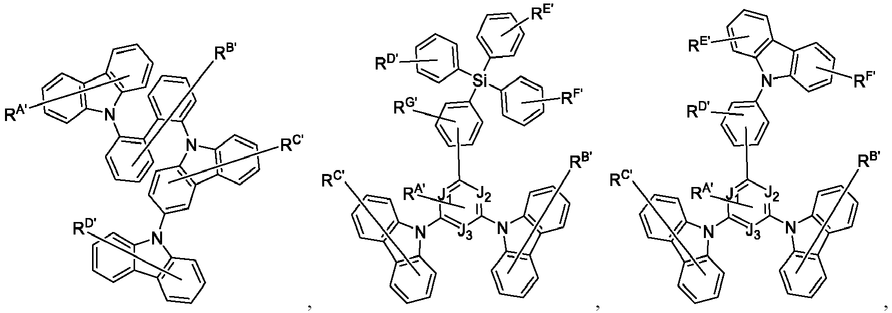 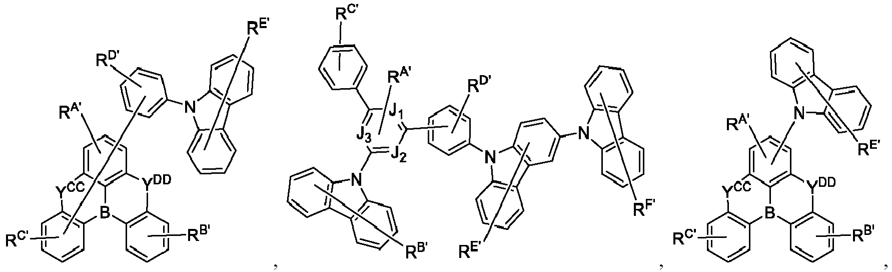 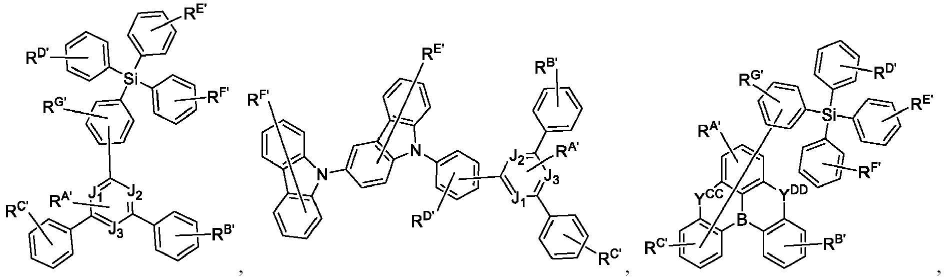 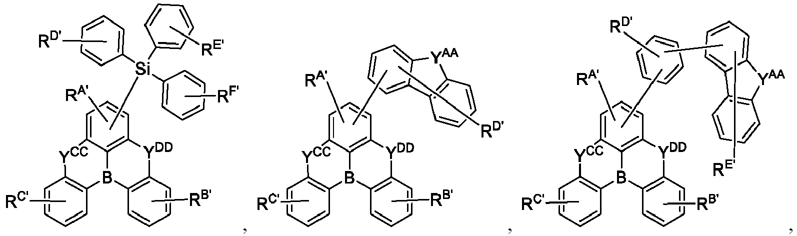 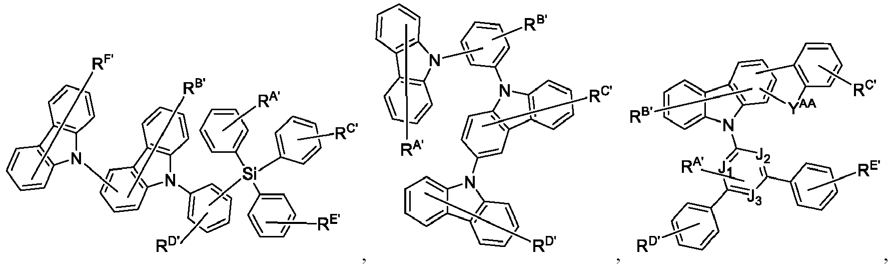 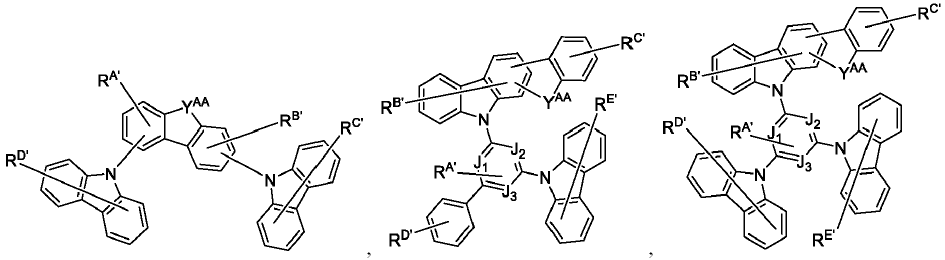 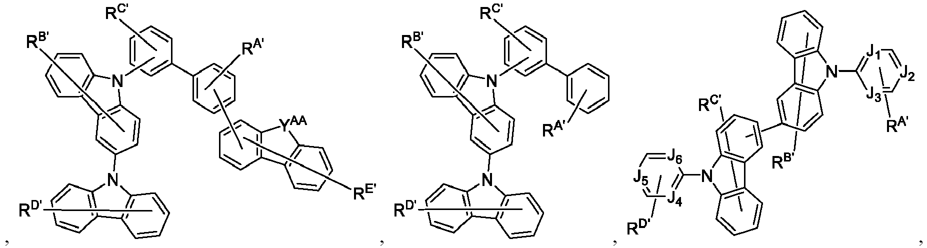 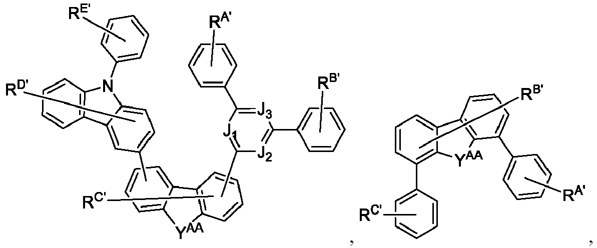 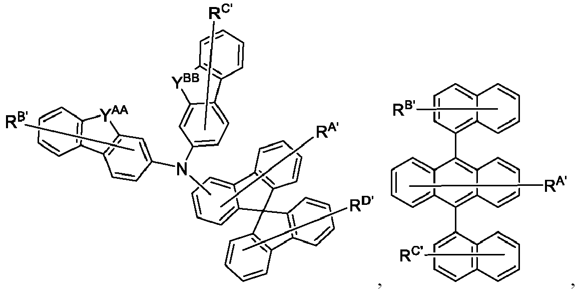 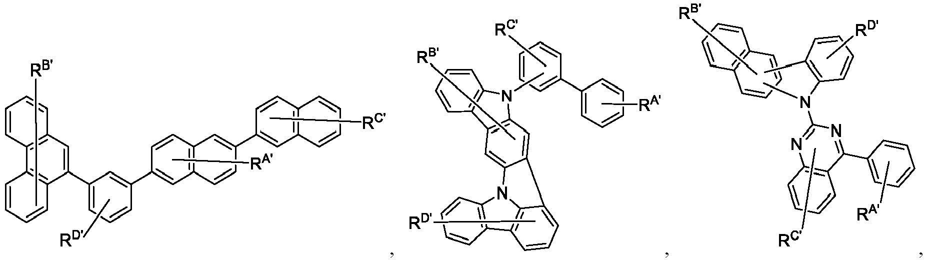 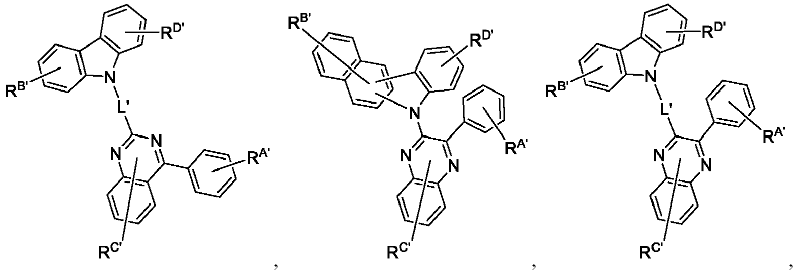 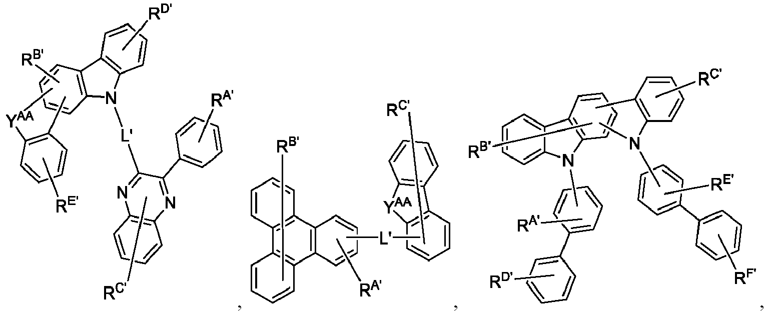 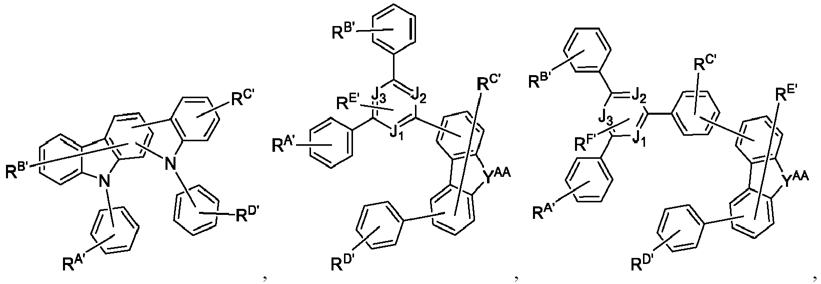 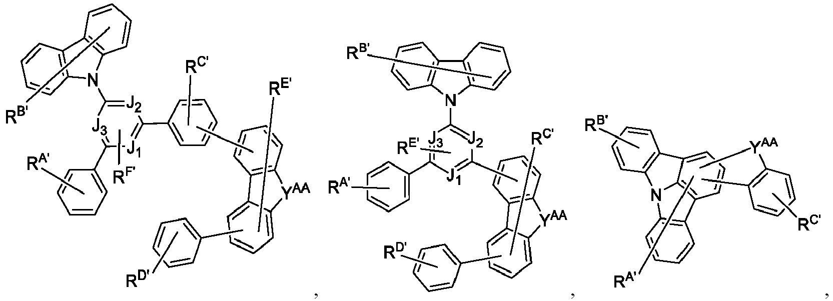 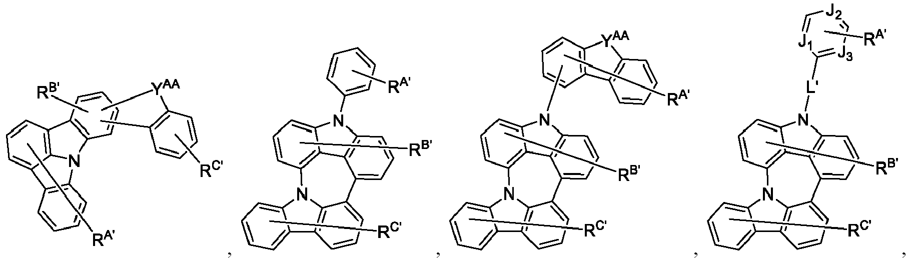 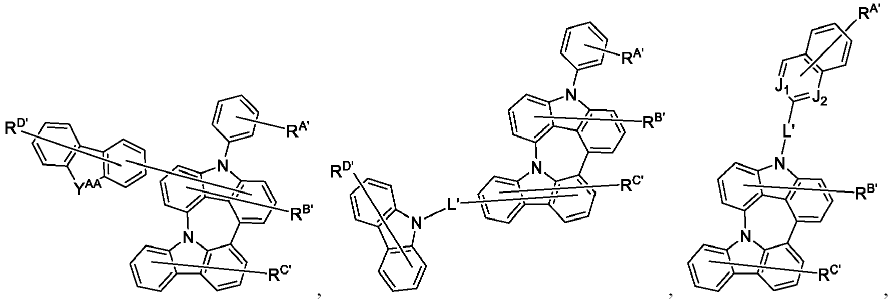 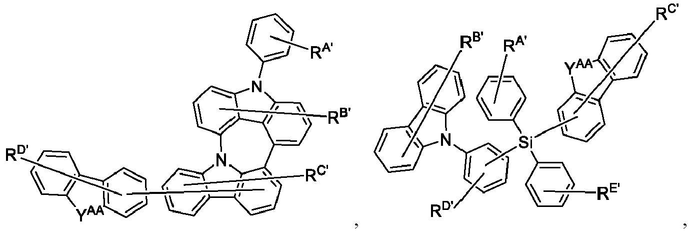 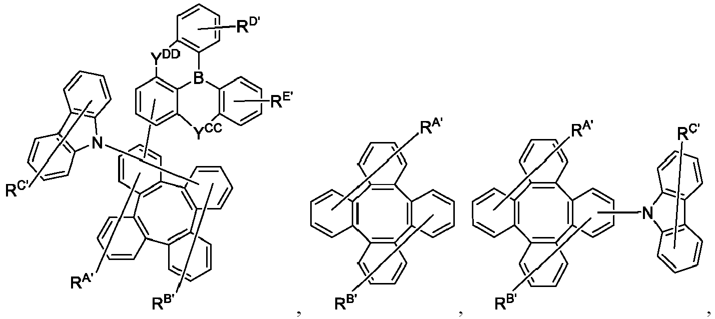 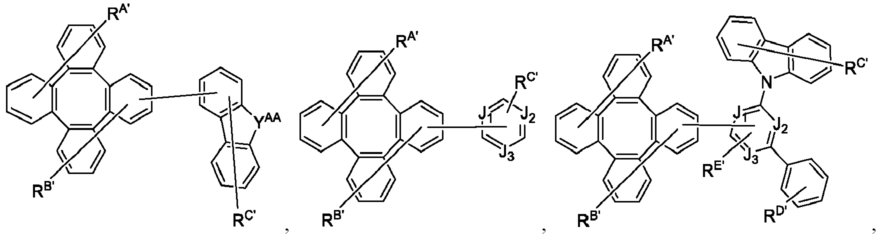 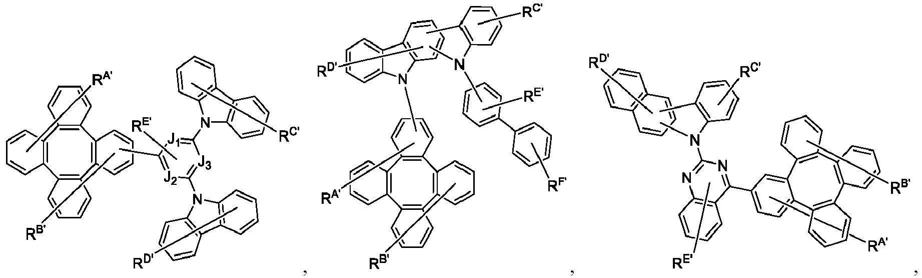 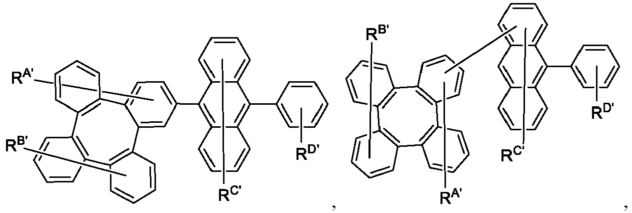 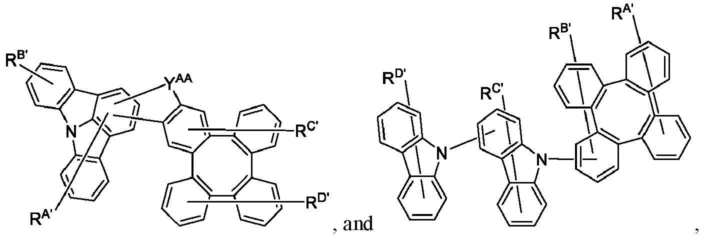 wherein:
each of J₁ to J₆ is independently C or N;
L' is a direct bond or an organic linker;
each Y^{AA}, Y^{BB}, Y^{CC}, and Y^{DD} is independently selected from the group consisting of absent a bond, direct bond, O, S, Se, CRR', SiRR', GeRR', NR, BR, BRR';
each of R^{A'} , R^{B'} , R^{C'}, R^{D'}, R^{E'}, R^{F'}, and R^{G'} independently represents mono, up to the maximum substitutions, or no substitutions;
each R, R', R^{A'}, R^{B'}, R^{C'}, R^{D'} , R^{E'}, R^{F'}, and R^{G'} is independently a hydrogen or a substituent selected from the group consisting of the general substituents as defined herein; any two substituents can be joined or fused to form a ring;
and where possible, each unsubstituted aromatic carbon atom is optionally replaced with N to form an aza-substituted ring.

In some embodiments at least one of J₁ to J₃ are N. In some embodiments at least two of J₁ to J₃ are N. In some embodiments, all three of J₁ to J₃ are N. In some embodiments, each Y^{cc} and Y^{DD} are preferably O, S, and SiRR', more preferably O, or S. In some embodiments, at least one unsubstituted aromatic carbon atom is replaced with N to form an aza-ring.

To reduce the amount of Dexter energy transfer between the sensitizer compound and the acceptor compound, it would be preferable to have a large distance between the center of mass of the sensitizer compound and the center of mass of the closest neighboring acceptor compound in the emissive region. Therefore, in some embodiments, the distance between the center of mass of the acceptor compound and the center of mass of the sensitizer compound is at least 2, 1.5, 1.0, or 0.75 nm.

Preferred acceptor/sensitizer VDR combination (A): In some embodiments, it is preferable for the VDR of the acceptor to be less than 0.33 in order to reduce the coupling of the transition dipole moment of the emitting acceptor to the plasmon modes, compared to an isotropic emitter, in order to achieve a higher outcoupling efficiency. In some cases, when the VDR of the acceptor is less than 0.33, it would be preferable for the VDR of the sensitizer to be less than 0.33 in order to improve the coupling of the transition dipole moments of the sensitizer and acceptor to optimize the Forster energy transfer rate. Accordingly, in some embodiments of the inventive OLED, the acceptor compound in the inventive OLED exhibits a VDR value equal to or less than 0.33, 0.30, 0.25, 0.2, 0.15, 0.10, 0.08, or 0.05 when the VDR is measured with an emissive thin film test sample that has the acceptor compound as the only emitter; and the sensitizer compound in the inventive OLED exhibits a VDR value equal to or less than 0.33, 0.30, 0.25, 0.2, 0.15, 0.10, 0.08, or 0.05 when the VDR is measured with an emissive thin film test sample that has the sensitizer compound as the only emitter.

Preferred acceptor/sensitizer VDR combination (B): In some embodiments, it is preferable for the VDR of the acceptor to be less than 0.33 in order to reduce the coupling of the transition dipole moment of the emitting acceptor to the plasmon modes compared to an isotropic emitter in order to achieve a higher outcoupling efficiency. In some cases, when the VDR of the acceptor is less than 0.33, it would be preferable to minimize the intermolecular interactions between the senstizer and acceptor to decrease the degree of Dexter quenching. By changing the molecular geometry of the sensitizer to reduce the intermolecular interactions, it may be preferable to have a sensitizer with a VDR greater than 0.33. Accordingly, in some embodiments of the inventive OLED, the acceptor compound in the inventive OLED exhibits a VDR value equal to or less than 0.33, 0.30, 0.25, 0.2, 0.15, 0.10, 0.08, or 0.05 when the VDR is measured with an emissive thin film test sample that has the acceptor compound as the only emitter; and the sensitizer compound in the inventive OLED exhibits a VDR value larger than 0.33, 0.4, 0.5, 0.6, or 0.7 when the VDR is measured with an emissive thin film test sample that has the sensitizer compound as the only emitter.

Preferred acceptor/sensitizer VDR combination (C): In some embodiments, it is preferable for the VDR of the acceptor to be greater than 0.33 in order to increase the coupling of the transition dipole moment of the acceptor to the plasmon modes compared to an isotropic emitter in order to decrease the transient lifetime of the excited states in the emissive layer. In some cases, the increased coupling to the plasmon modes can be paired with an enhancement layer in a plasmonic OLED device to improve efficiency and extend operational lifetime. In some cases, when the VDR of the acceptor is greater than 0.33, it would be preferable to minimize the intermolecular interactions between the senstizer and acceptor to decrease the degree of Dexter quenching. By changing the molecular geometry of the sensitizer to reduce the intermolecular interactions, it may be preferable to have a sensitizer with a VDR less than 0.33. Accordingly, in some embodiments of the inventive OLED, the acceptor compound in the inventive OLED exhibits a VDR value larger than 0.33, 0.4, 0.5, 0.6, or 0.7 when the VDR is measured with an emissive thin film test sample that has the acceptor compound as the only emitter; and the sensitizer compound in the inventive OLED exhibits a VDR value equal to or less than 0.33, 0.30, 0.25, 0.2, 0.15, 0.10, 0.08, or 0.05 when the VDR is measured with an emissive thin film test sample that has the sensitizer compound as the only emitter.

Preferred acceptor/sensitizer VDR combination (D): In some embodiments, it is preferable for the VDR of the acceptor to be greater than 0.33 in order to increase the coupling of the transition dipole moment of the acceptor to the plasmon modes compared to an isotropic emitter in order to decrease the transient lifetime of the excited states in the emissive layer. In some cases, the increased coupling to the plasmon modes can be paired with an enhancement layer in a plasmonic OLED device to improve efficiency and extend operational lifetime. In some cases, when the VDR of the acceptor is greater than 0.33, it would be preferable for the VDR of the sensitizer to be greater than 0.33 in order to improve the coupling of the transition dipole moments of the sensitizer and acceptor to optimize the Forster energy transfer rate. Accordingly, in some embodiments of the inventive OLED, the acceptor compound in the inventive OLED exhibits a VDR value larger than 0.33, 0.4, 0.5, 0.6, or 0.7 when the VDR is measured with an emissive thin film test sample that has the acceptor compound as the only emitter; and the sensitizer compound in the inventive OLED exhibits a VDR value larger than 0.33, 0.4, 0.5, 0.6, or 0.7 when the VDR is measured with an emissive thin film test sample that has the sensitizer compound as the only emitter.

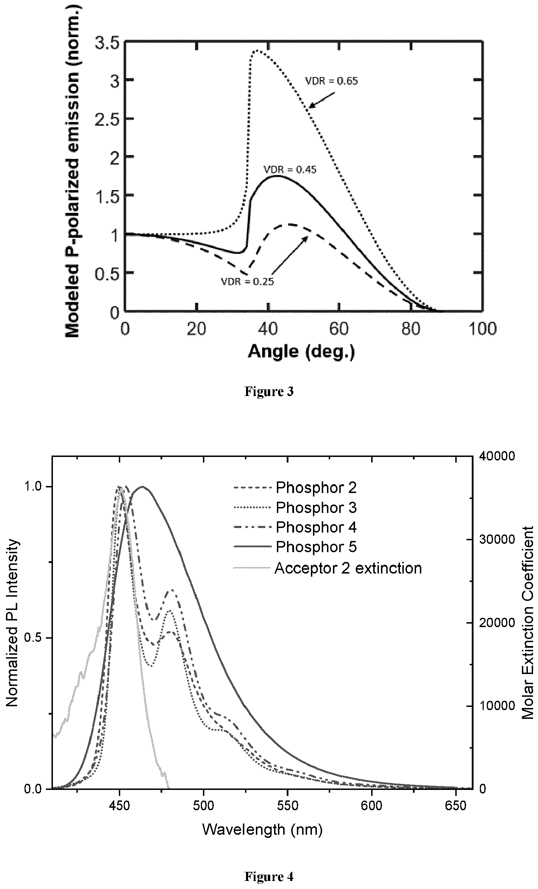

VDR is the ensemble average fraction of vertically oriented molecular dipoles of the light-emitting compound in a thin film sample of an emissive layer, where the orientation "vertical" is relative to the plane of the surface of the substrate (i.e., normal to the surface of the substrate plane) on which the thin film sample is formed. A similar concept is horizontal dipole ratio (HDR) which is the ensemble average fraction of horizontally oriented molecular dipoles of the light-emitting compound in a thin film sample of an emissive layer, where the orientation "horizontal" is relative to the plane of the surface of the substrate (i.e. parallel to the surface of the substrate plane) on which the thin film sample is formed. By definition, VDR+HDR = 1. VDR can be measured by angle dependent, polarization dependent, photoluminescence measurements. By comparing the measured emission pattern of a photo-excited thin film test sample, as a function of polarization, to the computationally modeled pattern, one can determine VDR of the thin film test sample emission layer. For example, a modelled data of p-polarized emission is shown in FIG. 3. The modelled p-polarized angle photoluminescence (PL) is plotted for emitters with different VDRs. A peak in the modelled PL is observed in the p-polarized PL around the angle of 45 degrees with the peak PL being greater when the VDR of the emitter is higher.

To measure VDR values of the thin film test samples, a thin film test sample can be formed with the acceptor compound or the sensitizer compound (depending on whether the VDR of the acceptor compound or the sensitizer compound is being measured) as the only emitter in the thin film and a Reference Host Compound A as the host. Preferably, the Reference Host Compound A is 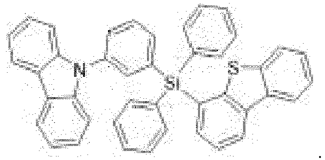 The thin film test sample is formed by thermally evaporating the emitter compound and the host compound on a substrate. For example, the emitter compound and the host compound can be co-evaporated. In some embodiments, the doping level of the emitter compounds in the host can be from 0.1 wt. % to 50 wt. %. In some embodiments, the doping level of the emitter compounds in the host can be from 3 wt. % to 20 wt. % for blue emitters. In some embodiments, the doping level of the emitter compounds in the host can be from 1 wt. % to 15 wt. % for red and green emitters. The thickness of the thermally evaporated thin film test sample can have a thickness of from 50 to 1000 Å.

In some embodiments, the OLED of the present disclosure can comprise a sensitizer, an acceptor, and one or more hosts in the emissive region, and the preferred acceptor/sensitizer VDR combinations (A) - (D) mentioned above are still applicable. In these embodiments, the VDR values for the acceptor compound can be measured with a thin film test sample formed of the one or more hosts and the acceptor, where the acceptor is the only emitter in the thin film test sample. Similarly, the VDR values for the sensitizer compound can be measured with a thin film test sample formed of the one or more hosts and the sensitizer, where the sensitizer is the only emitter in the thin film test sample.

In the example used to generate FIG. 3, a 30 nm thick film of material with a refractive index of 1.75 and the emission is monitored in a semi-infinite medium with a refractive index of 1.75. Each curve is normalized to a photoluminescence intensity of 1 at an angle of zero degrees, which is perpendicular to the surface of the film. As the VDR of the emitter is varied, the peak around 45 degrees increases greatly. When using a software to fit the VDR of experimental data, the modeled VDR would be varied until the difference between the modeled data and the experimental data is minimized.

Because the VDR represents the average dipole orientation of the light-emitting compound in the thin film sample, even if there are additional emission capable compounds in the emissive layer, if they are not contributing to the light emission, the VDR measurement does not reflect their VDR. Further, by inclusion of a host material that interacts with the light-emitting compound, the VDR of the light-emitting compound can be modified. Thus, a light-emitting compound in a thin film sample with host material A will exhibit one measured VDR value and that same light-emitting compound in a thin film sample with host material B will exhibit a different measured VDR value. Further, in some embodiments, exciplex or excimers are desirable which form emissive states between two neighboring molecules. These emissive states may have a VDR that is different than that if only one of the components of the exciplex or excimer were emitting or present in the sample.

In some embodiments, the OLED is a plasmonic OLED. In some embodiments, the OLED is a wave-guided OLED.

In some embodiments, the emissive region can further include a second host. In some embodiments, the second host comprises a moiety selected from the group consisting of bicarbazole, indolocarbazole, triazine, pyrimidine, pyridine, and boryl. In some embodiments, the second host has a HOMO level that is shallower than that of the acceptor compound.

In some embodiments, the OLED emits a white light at room temperature when a voltage is applied across the device.

In some embodiments, the OLED emits a luminescent radiation at room temperature when a voltage is applied across the device; wherein the luminescent first radiation component contributed from the acceptor compound with an emission λₘₐₓ₁ being independently selected from the group consisting of larger than 340 nm to equal or less than 500 nm, larger than 500 nm to equal or less than 600 nm, and larger than 600 nm to equal or less than 900 nm. In some embodiments, the first radiation component has FWHM of 50, 40, 35, 30, 25, 20, 15, 10, or 5 nm or less. In some embodiments, the first radiation component has a 10% onset of the emission peak is less than 465, 460, 455, or 450 nm.

In some embodiments, the sensitizer compound is partially or fully deuterated. In some embodiments, the acceptor compound is partially or fully deuterated. In some embodiments, the first host is partially or fully deuterated. In some embodiments, the second host is partially or fully deuterated.

In some embodiments, compound S1 and/or compound A1 each independently comprises at least one substituent having a spherocity greater than or equal to 0.45, 0.55, 0.65, 0.75, or 0.80. The spherocity is a measurement of the three-dimensionality of bulky groups. Spherocity is defined as the ratio between the principal moments of inertia (PMI). Specifically, spherocity is the ratio of three times PMI1 over the sum of PMI1, PMI2, and PMI3, where PMI1 is the smallest principal moment of inertia, PMI2 is the second smallest principal moment of inertia, and PMI3 is the largest principal moment of inertia. The spherocity of the lowest energy conformer of a structure after optimization of the ground state with density functional theory may be calculated. More detailed information can be found in paragraphs [0054] to [0059] of US application No. 18/062,110 filed December 6, 2022, the contents of which are incorporated herein by reference. In some embodiments, compound S1 and/or compound A1 each independently comprises at least one substituent having a Van der Waals volume greater than 153, 206, 259, 290, or 329 Å³. In some embodiments, compound S1 and/or compound A1 each independently comprises at least one substituent having a molecular weight greater than 167, 187, 259, 303, or 305 amu.

In some embodiments, one of the first and second hosts is a hole transporting host, the other one of the first and second host is an electron transporting host. In some embodiments, the first host is a hole transporting host; and wherein the first host comprises at least one chemical group selected from the group consisting of amino, carbazole, indolocarbazole, dibenzothiophene, dibenzofuran, dibenzoselenophene, and 5 λ²-benzo[d]benzo[4,5]imidazo[3,2-a]imidazole. In some embodiments, the first host is an electron transporting host; and wherein the first host comprises at least one chemical group selected from the group consisting of pyridine, pyrimidine, pyrazine, pyridazine, triazine, imidazole, aza-triphenylene, aza-carbazole, aza-dibenzothiophene, aza-dibenzofuran, aza-dibenzoselenophene, 5,9-dioxa-13b-boranaphtho[3,2,1-de]anthracene, boryl, nitrile, aza-5λ²benzo[d]benzo[4,5]imidazo[3,2-a]imidazole, and aza-(5,9-dioxa-13b-boranaphtho[3,2,1-de]anthracene). In some embodiments, one of the first and second hosts is a bipolar host comprising both hole transporting and electron transporting moieties.

In some embodiments, the OLED further comprises a color conversion layer or a color filter.

In some embodiments, a formulation can comprises at least two different compounds of the following compounds: a sensitizer compound, an acceptor compound and a host.

In some embodiments, a chemical structure selected from the group consisting of a monomer, a polymer, a macromolecule, and a supramolecule, wherein the chemical structure comprises at least two of the following components: a sensitizer compound, an acceptor compound and a host.

It should be understood that all the first compound S1 related embodiments are interchangeable throughout the disclosure unless specifically or expressly not allowed. Likewise, all the second compound A1 related embodiments are interchangeable unless specifically or expressly not allowed. Similarly, all the third compound H1 related embodiments are interchangeable unless specifically or expressly not allowed.

In some embodiments, each of the sensitizer compound, the acceptor compound, the host compound, described herein can be at least 10% deuterated, at least 20% deuterated, at least 30% deuterated, at least 40% deuterated, at least 50% deuterated, at least 60% deuterated, at least 70% deuterated, at least 80% deuterated, at least 90% deuterated, at least 95% deuterated, at least 99% deuterated, or 100% deuterated. As used herein, percent deuteration has its ordinary meaning and includes the percent of possible hydrogen atoms (e.g., positions that are hydrogen or deuterium) that are replaced by deuterium atoms.

### Other Aspects of the OLEDs of the Present Disclosure

In some embodiments, the OLED may further comprise an additional host, wherein the additional host comprises a triphenylene containing benzo-fused thiophene or benzo-fused furan, wherein any substituent in the host is an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡CCₙH₂ₙ₊₁, Ar₁, Ar₁-Ar₂, CₙH₂ₙ-Ar₁, or no substitution, wherein n is an integer from 1 to 10; and wherein Ar₁ and Ar₂ are independently selected from the group consisting of benzene, biphenyl, naphthalene, triphenylene, carbazole, and heteroaromatic analogs thereof.

In some embodiments, the additional host comprises at least one chemical group selected from the group consisting of triphenylene, carbazole, indolocarbazole, dibenzothiophene, dibenzofuran, dibenzoselenophene, 5λ2-benzo[d]benzo[4,5]imidazo[3,2-a]imidazole, 5,9-dioxa-13b-boranaphtho[3,2,1-de]anthracene, triazine, boryl, silyl, aza-triphenylene, aza-carbazole, aza-indolocarbazole, aza-dibenzothiophene, aza-dibenzofuran, aza-dibenzoselenophene, aza-5λ2-benzo[d]benzo[4,5]imidazo[3,2-a]imidazole, and aza-(5,9-dioxa-13b-boranaphtho[3,2,1-de]anthracene).

In some embodiments, the additional host may be selected from the group consisting of: 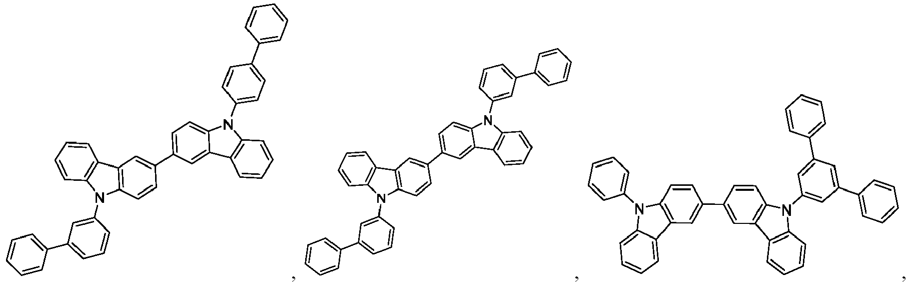 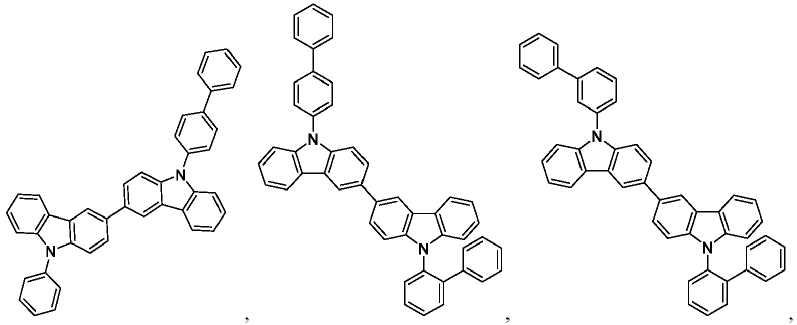 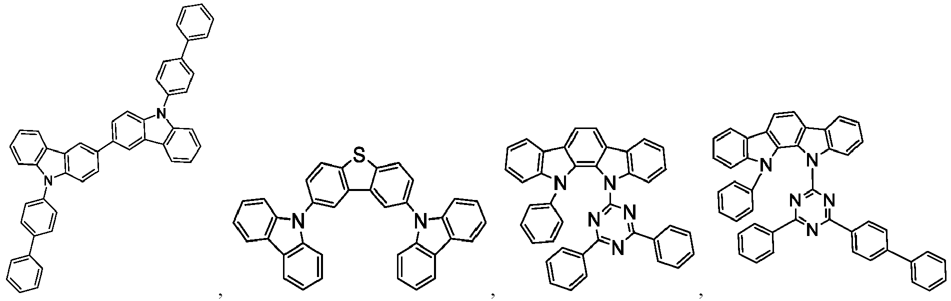 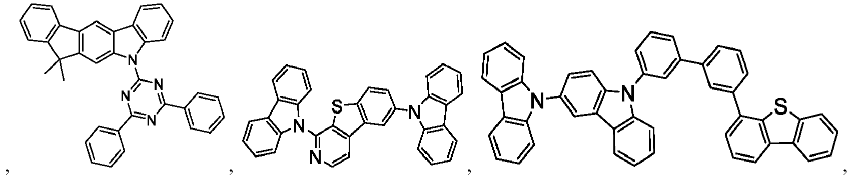 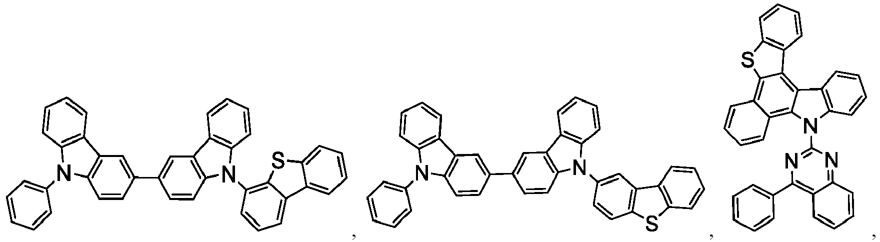 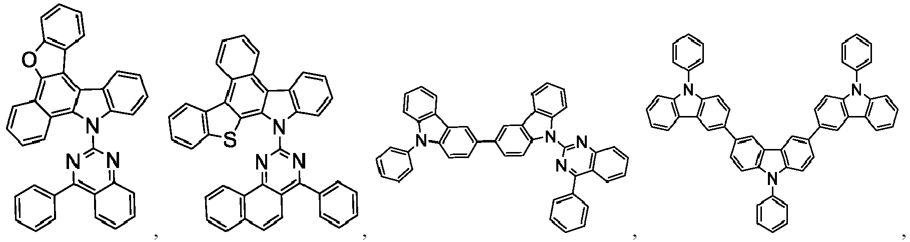 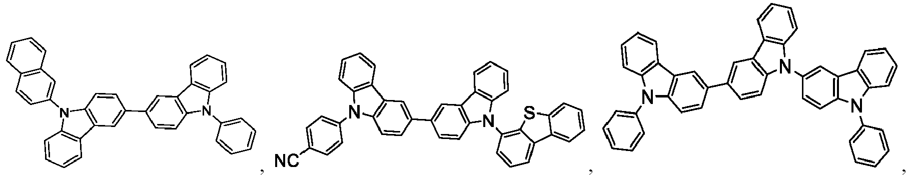 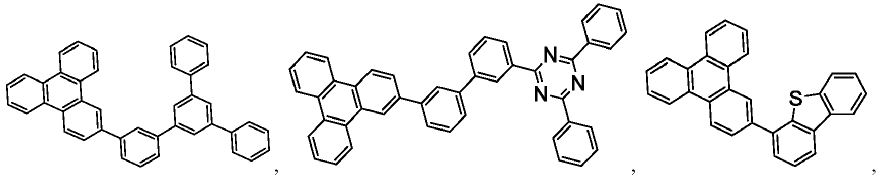 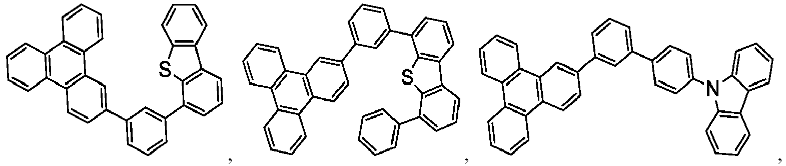 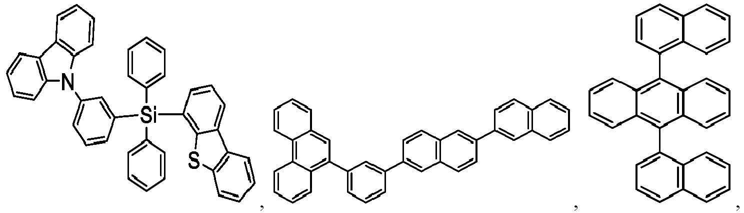 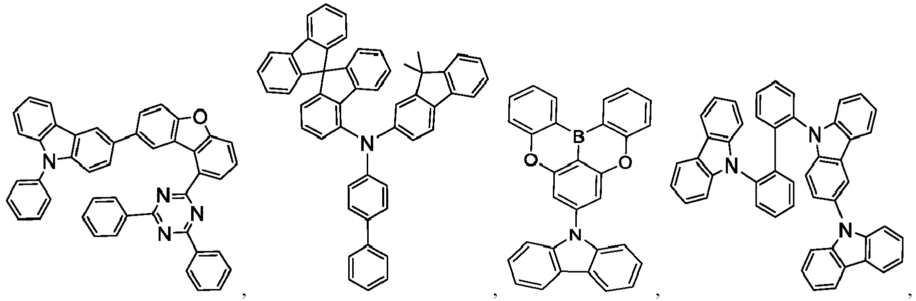 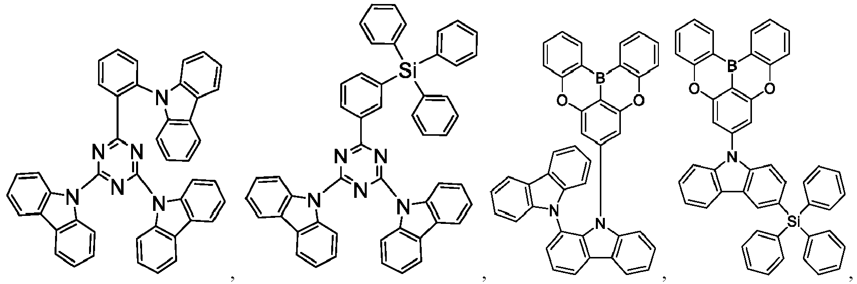 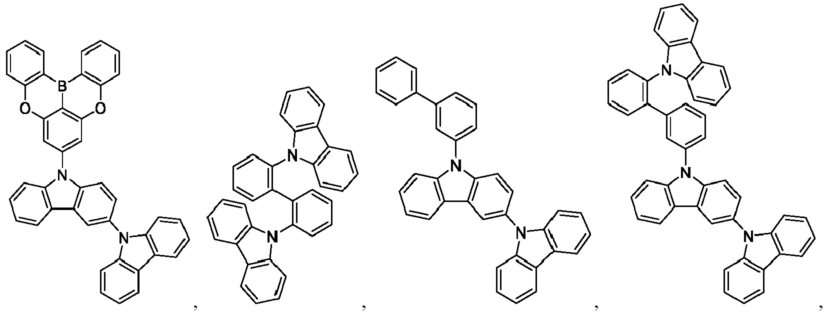 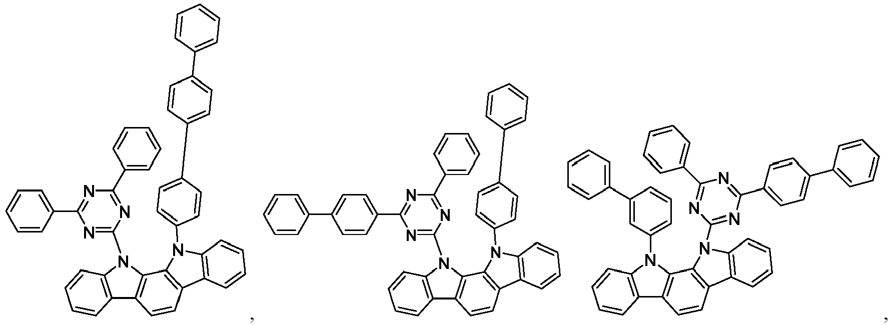 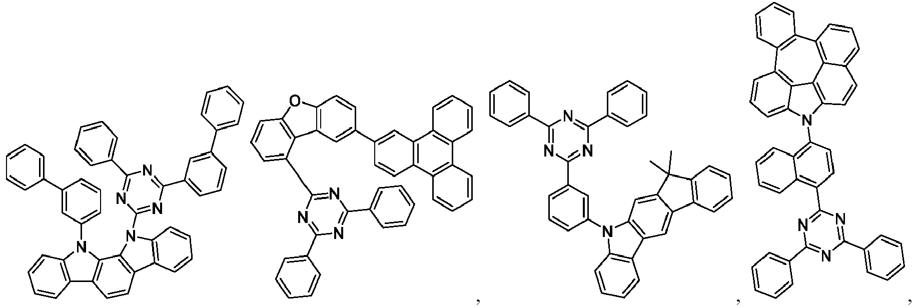 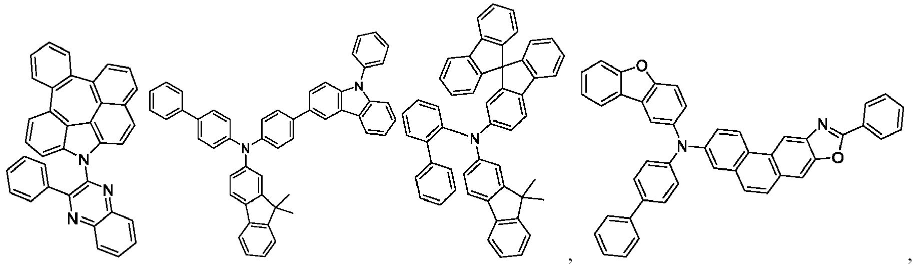 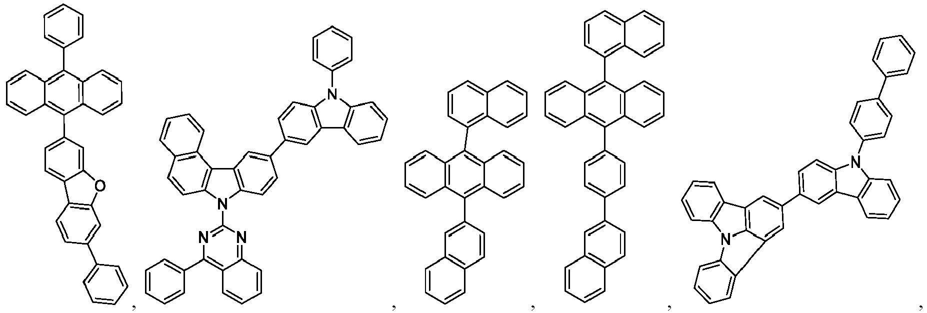 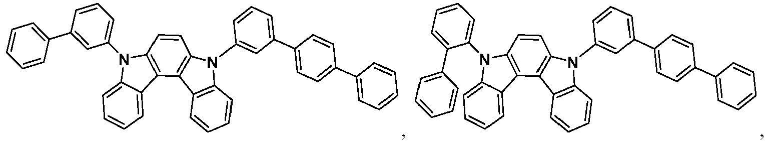 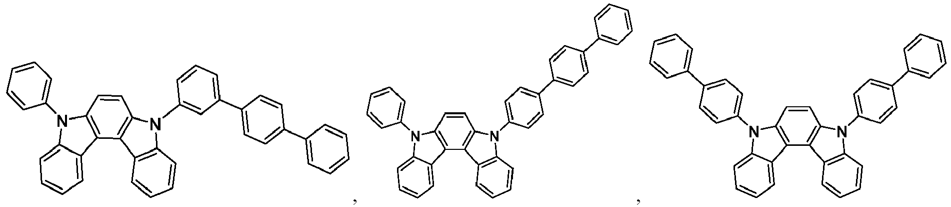 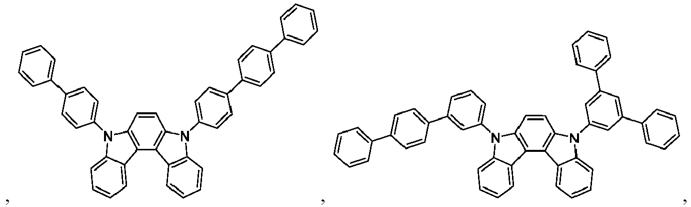 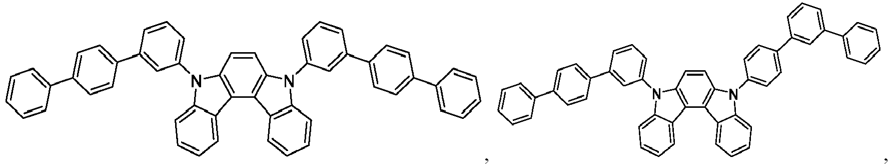 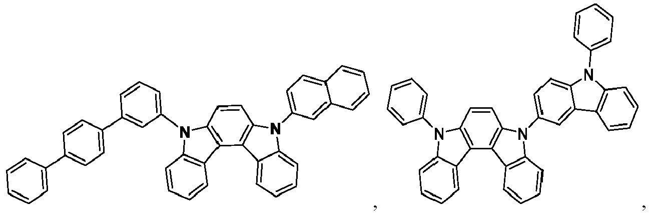 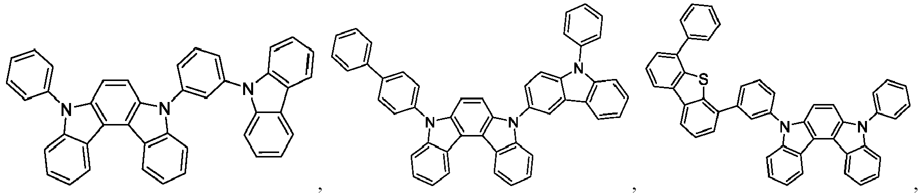 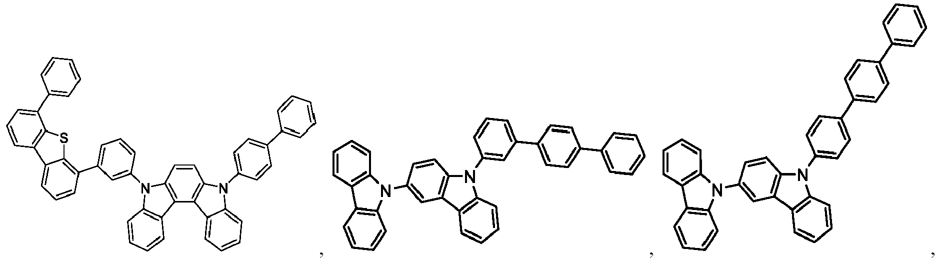 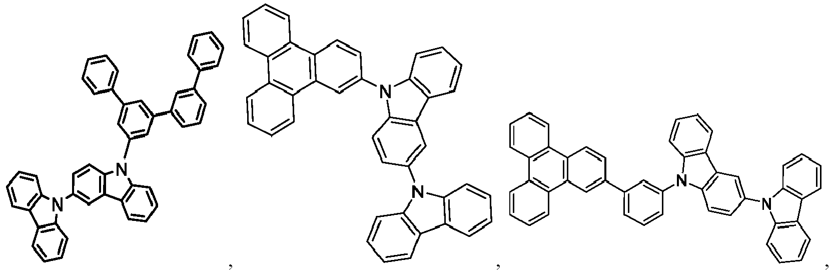 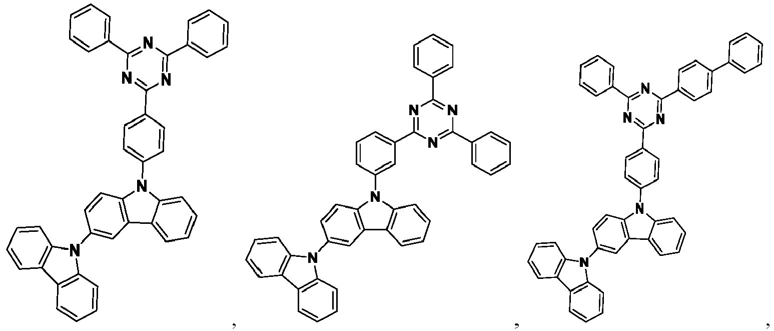 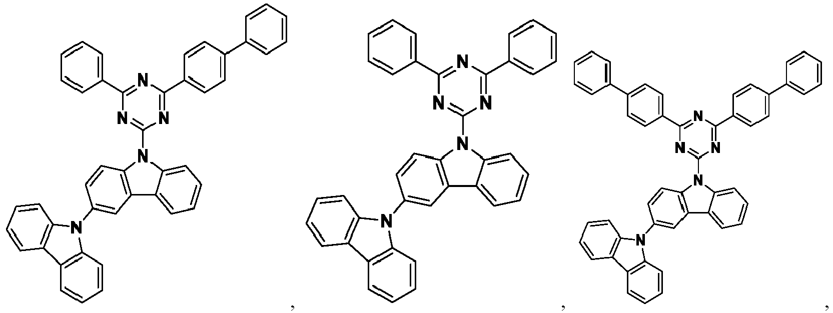 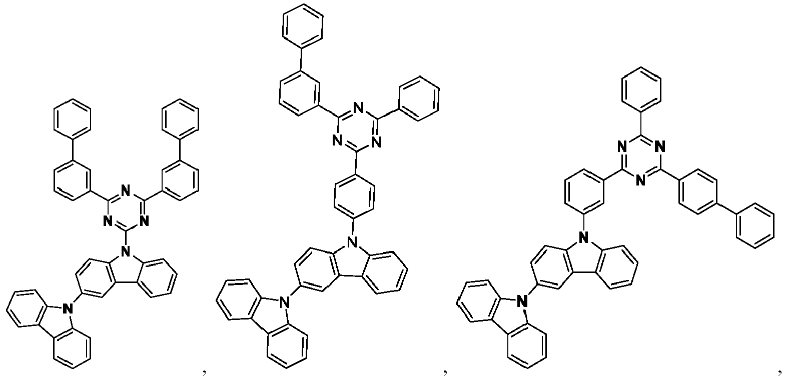 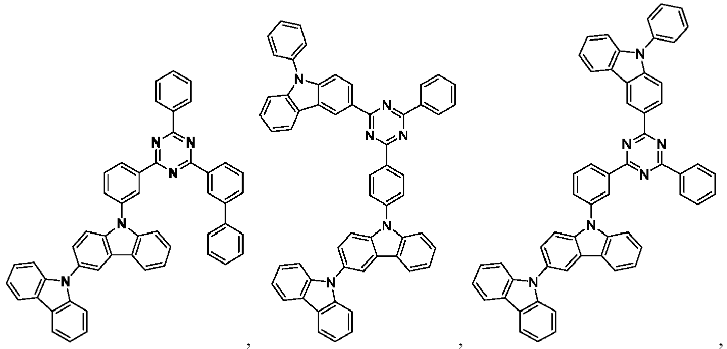 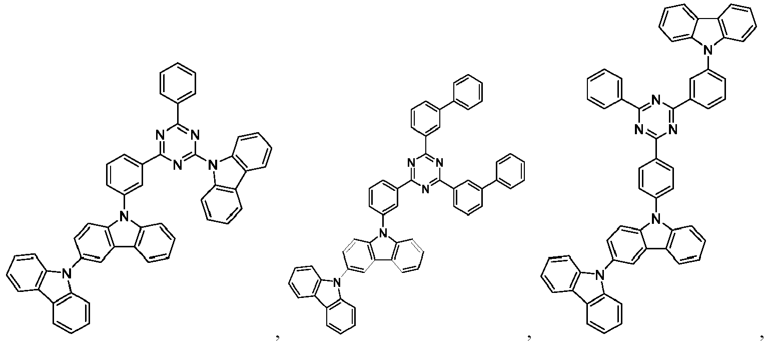 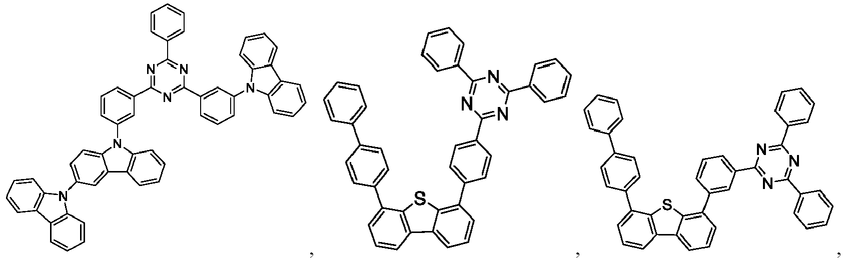 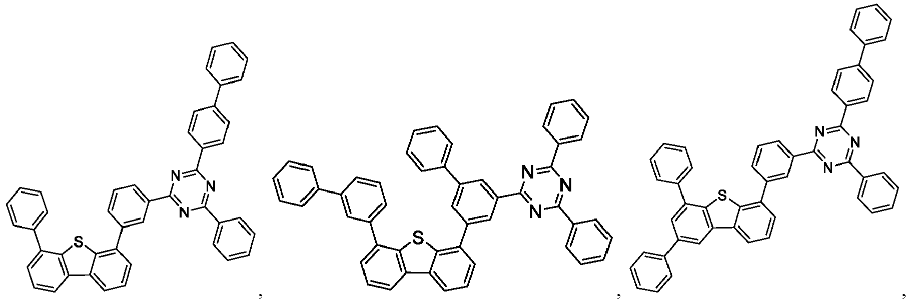 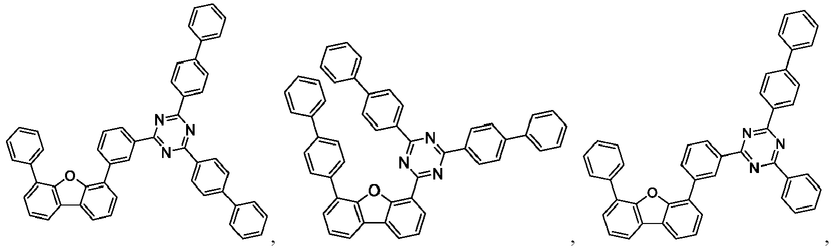 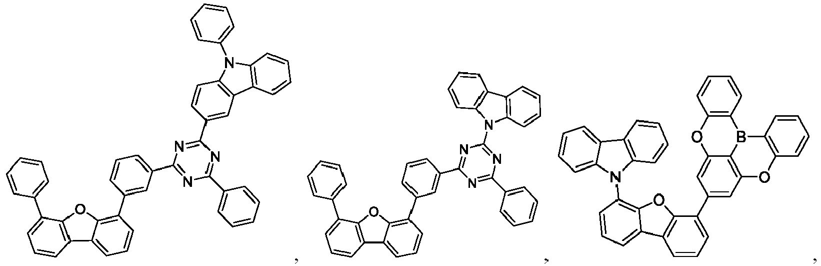 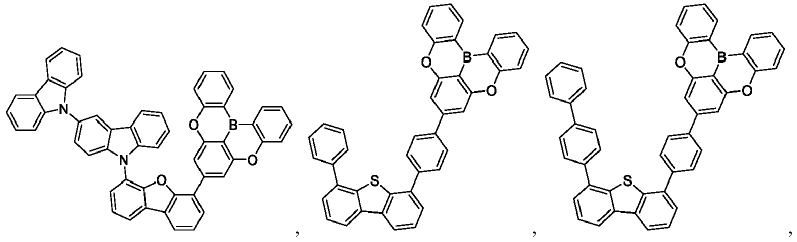 and 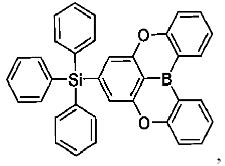 aza-substituted variants thereof, fully or partially deuterated variants thereof, and combinations thereof.

In some embodiments, the additional host comprises a metal complex.

In yet another aspect, the OLED of the present disclosure may also comprise an emissive region containing a formulation as disclosed in the above compounds section of the present disclosure.

In some embodiments, the formulation comprises: a compound S1; a compound A1; and a compound H1; wherein the compound S1 is a sensitizer that transfers energy to the compound A1; wherein the compound A1 is an acceptor that is an emitter; wherein the compound H1 is a first host, and at least one of the compound S1 and the compound A1 is doped in the compound H1; wherein the compound S1 is a metal complex comprising metal M, and a first ligand L_{A} that comprises at least one moiety F; wherein the at least one moiety F is a fused ring system comprising two or more 5-10 membered carbocyclic or heterocyclic rings and is joined to the metal M through an anionic bond; and with the proviso that if M is Pt or Pd, then the at least one moiety F is not a nonfused carbazole.

In some embodiments, the OLED has one or more characteristics selected from the group consisting of being flexible, being rollable, being foldable, being stretchable, and being curved. In some embodiments, the OLED is transparent or semi-transparent. In some embodiments, the OLED further comprises a layer comprising carbon nanotubes.

In some embodiments, the OLED further comprises a layer comprising a delayed fluorescent emitter. In some embodiments, the OLED comprises a RGB pixel arrangement or white plus color filter pixel arrangement. In some embodiments, the OLED is a mobile device, a hand held device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

In some aspects, an emissive region is disclosed. In some embodiments, the emissive region comprises the first compound S1, second compound A1, and third compound H1 as described herein.

In some embodiments of the emissive region, the emissive region further comprises a host.

In some embodiments, the compound can be an emissive dopant. In some embodiments, the compound can produce emissions via phosphorescence, fluorescence, thermally activated delayed fluorescence, i.e., TADF (also referred to as E-type delayed fluorescence), triplet-triplet annihilation, or combinations of these processes.

The OLED disclosed herein can be incorporated into one or more of a consumer product, an electronic component module, and a lighting panel. The organic layer can be an emissive layer and the compound can be an emissive dopant in some embodiments, while the compound can be a non-emissive dopant in other embodiments.

In some embodiments, the consumer product is selected from the group consisting of a flat panel display, a computer monitor, a medical monitor, a television, a billboard, a light for interior or exterior illumination and/or signaling, a heads-up display, a fully or partially transparent display, a flexible display, a laser printer, a telephone, a cell phone, tablet, a phablet, a personal digital assistant (PDA), a wearable device, a laptop computer, a digital camera, a camcorder, a viewfinder, a micro -display that is less than 2 inches diagonal, a 3-D display, a virtual reality or augmented reality display, a vehicle, a video wall comprising multiple displays tiled together, a theater or stadium screen, a light therapy device, and a sign.

The organic layer can also include a host. In some embodiments, two or more hosts are preferred. In some embodiments, the hosts used maybe a) bipolar, b) electron transporting, c) hole transporting or d) wide band gap materials that play little role in charge transport. In some embodiments, the host can include a metal complex. The host can be an inorganic compound.

In some aspects, a formulation comprising a first compound S 1, a second compound A1, and a third compound H1 is provided. The first compound S1 is capable of phosphorescent emission at room temperature and is a sensitizer that transfers energy to the second compound A1; the second compound A1 is an acceptor that is an emitter; and the third compound H1 is a first host comprising a boron atom, and at least one of the first compound S1 and the second compound A1 is doped in the third compound H1. The first compound S1, second compound A1, and third compound H1 have the same definitions as described herein.

In some aspects, a premixed co-evaporation source that is a mixture of a first compound S1 and a second compound A1 is provided. The co-evaporation source is a co-evaporation source for vacuum deposition process or organic vapor jet printing (OVJP) process. In the premixed co-evaporation source, the first compound S1 and the second compound A1 are differently selected from the group consisting of:
(1) a compound capable of phosphorescent emission that is a sensitizer that transfers energy to an acceptor that is an emitter in an OLED at room temperature;
(2) a compound being an acceptor that is the emitter in said OLED at room temperature; and
(3) a compound being a host in said OLED at room temperature;
   wherein the first compound S1 has an evaporation temperature T1 of 150 to 350 °C;
   wherein the second compound A1 has an evaporation temperature T2 of 150 to 350 °C;
   wherein absolute value of T1-T2 is less than 20 °C;
   wherein the first compound S 1 has a concentration C1 in said mixture and a concentration C2 in a film formed by evaporating the mixture in a vacuum deposition tool at a constant pressure between 1×10⁻⁶ Torr to 1x10⁻⁹ Torr, at a 2Å/sec deposition rate on a surface positioned at a predefined distance away from the mixture being evaporated; and wherein absolute value of (C1-C2)/C1 is less than 5%.

In some embodiments of the premixed co-evaporation source, the first compound S1 is a compound being capable of functioning as a phosphorescent emitter in an OLED at room temperature; wherein the second compound A1 is a delayed-fluorescent compound functioning as a thermally activated delayed fluorescence (TADF) emitter in the OLED at room temperature.

In some embodiments of the premixed co-evaporation source, the first compound S1 is a compound being capable of functioning as a phosphorescent emitter in an OLED at room temperature; wherein the second compound A1 is a fluorescent compound functioning as a fluorescent emitter in the OLED at room temperature.

In some embodiments of the premixed co-evaporation source, the first compound S1 is capable of functioning as a TADF emitter in an organic light emitting device at room temperature; wherein the second compound A1 is a fluorescent compound functioning as a fluorescent emitter in the OLED at room temperature.

In some embodiments of the premixed co-evaporation source, the mixture further comprises a third compound; wherein the third compound is different from the first and the second compounds, and is selected from the same group; and wherein the third compound has an evaporation temperature T3 of 150 to 350 °C, and wherein absolute value of T1-T3 is less than 20 °C.

In some embodiments of the premixed co-evaporation source, the first compound S1 has evaporation temperature T1 of 200 to 350 °C and the second compound A1 has evaporation temperature T2 of 200 to 350 °C.

In some embodiments of the premixed co-evaporation source, the absolute value of (C₁-C₂)/C₁ is less than 3%.

In some embodiments of the premixed co-evaporation source, the first compound S1 has a vapor pressure of P1 at T1 at 1 atm, and the second compound A1 has a vapor pressure of P2 at T2 at 1 atm; and wherein the ratio of P1/P2 is within the range of 0.90:1 to 1.10:1.

In some embodiments of the premixed co-evaporation source, the first compound S1 has a first mass loss rate and the second compound A1 has a second mass loss rate, wherein the ratio between the first mass loss rate and the second mass loss rate is within the range of 0.90:1 to 1.10:1. In some embodiments of the premixed co-evaporation source, the ratio between the first mass loss rate and the second mass loss rate is within the range of 0.95:1 to 1.05:1. In some embodiments of the premixed co-evaporation source, the ratio between the first mass loss rate and the second mass loss rate is within the range of 0.97:1 to 1.03:1.

In some embodiments of the premixed co-evaporation source, the first compound S1 and the second compound A1 each has a purity in excess of 99 % as determined by high pressure liquid chromatography.

In some embodiments of the premixed co-evaporation source, the composition is in liquid form at a temperature less than the lesser of T1 and T2.

In some aspects, a method for fabricating an organic light emitting device is provided. The method includes providing a substrate having a first electrode disposed thereon; depositing a first organic layer over the first electrode by evaporating a pre-mixed co-evaporation source that is a mixture of a first compound S1 and a second compound A1 in a high vacuum deposition tool with a chamber base pressure between 1×10⁻⁶ Torr to 1x10⁻⁹ Torr; and depositing a second electrode over the first organic layer, wherein the first compound S1 and the second compound A1 are differently selected from the group consisting of:
(1) a compound capable of phosphorescent emission that is a sensitizer that transfers energy to an acceptor that is an emitter in an OLED at room temperature;
(2) a compound being an acceptor that is the emitter in said OLED at room temperature;
(3) a compound being a host in said OLED at room temperature;
   wherein the first compound S1 has an evaporation temperature T1 of 150 to 350 °C;
   wherein the second compound A1 has an evaporation temperature T2 of 150 to 350 °C;
   wherein absolute value of T1-T2 is less than 20 °C;
   wherein the first compound S1 has a concentration C1 in said mixture and a concentration C2 in a film formed by evaporating the mixture in a vacuum deposition tool at a constant pressure between 1×10⁻⁶ Torr to 1x10⁻⁹ Torr, at a 2Å/sec deposition rate on a surface positioned at a predefined distance away from the mixture being evaporated; and wherein absolute value of (C1-C2)/C1 is less than 5%.

It should also be understood that embodiments of all the compounds and devices described herein may be interchangeable if those embodiments are also applicable under different aspects of the entire disclosure.

In some embodiments, each of the first compound S 1, the second compound A1, the third host compound H1, described herein can be at least 10% deuterated, at least 20% deuterated, at least 30% deuterated, at least 40% deuterated, at least 50% deuterated, at least 60% deuterated, at least 70% deuterated, at least 80% deuterated, at least 90% deuterated, at least 95% deuterated, at least 99% deuterated, or 100% deuterated. As used herein, percent deuteration has its ordinary meaning and includes the percent of possible hydrogen atoms (e.g., positions that are hydrogen or deuterium) that are replaced by deuterium atoms.

### COMBINATION OF THE COMPOUNDS OF THE PRESENT DISCLOSURE WITH OTHER MATERIALS

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

Various materials may be used for the various emissive and non-emissive layers and arrangements disclosed herein. Examples of suitable materials are disclosed in U.S. Patent Application Publication No. 2017/0229663, which is incorporated by reference in its entirety.

### Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

### HIL/HTL:

A hole injecting/transporting material to be used in the present invention is not particularly limited, and any compound may be used as long as the compound is typically used as a hole injecting/transporting material. EBL:

An electron blocking layer (EBL) may be used to reduce the number of electrons and/or excitons that leave the emissive layer. The presence of such a blocking layer in a device may result in substantially higher efficiencies, and or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and or higher triplet energy than one or more of the hosts closest to the EBL interface. In one aspect, the compound used in EBL contains the same molecule or the same functional groups used as one of the hosts described below.

### Host:

The light emitting layer of the organic EL device of the present invention preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. Any host material may be used with any dopant so long as the triplet criteria is satisfied.

### HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further from the vacuum level) and or higher triplet energy than the emitter closest to the HBL interface. In some embodiments, the HBL material has a lower HOMO (further from the vacuum level) and or higher triplet energy than one or more of the hosts closest to the HBL interface.

### ETL:

An electron transport layer (ETL) may include a material capable of transporting electrons. The electron transport layer may be intrinsic (undoped), or doped. Doping may be used to enhance conductivity. Examples of the ETL material are not particularly limited, and any metal complexes or organic compounds may be used as long as they are typically used to transport electrons.

### Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

### EXPERIMENTAL SECTION

The triplet state energy (T1) for Host H1, Host H2, and Host H3 are shown in Table 1. The T1 was obtained from peak maximum of the gated emission of a frozen sample in 2-MeTHF at 77 K. The gated emission spectra were collected on a Horiba Fluorolog-3 spectrofluorometer equipped with a Xenon Flash lamp with a flash delay of 10 milliseconds and a collection window of 50 milliseconds. The sample was excited at 300nm.

The LUMO values for Host H1, Host H2, and Host H3, shown in Table 1, were determined using solution electrochemistry. Solution cyclic voltammetry and differential pulsed voltammetry were performed using a CH Instruments model 6201B potentiostat using anhydrous dimethylformamide solvent and tetrabutylammonium hexafluorophosphate as the supporting electrolyte. Glassy carbon, and platinum and silver wires were used as the working, counter and reference electrodes, respectively. Electrochemical potentials were referenced to an internal ferrocene-ferroconium redox couple (Fc/Fc+) by measuring the peak potential differences from differential pulsed voltammetry. The corresponding highest occupied molecular orbital (HOMO) and lowest unoccupied molecular orbital (LUMO) energies were determined by referencing the cationic and anionic redox potentials to ferrocene (4.8 eV vs. vacuum) according to literature ((a) Fink, R.; Heischkel, Y.; Thelakkat, M.; Schmidt, H.-W. Chem. Mater. 1998, 10, 3620-3625. (b) Pommerehne, J.; Vestweber, H.; Guss, W.; Mahrt, R. F.; Bassler, H.; Porsch, M.; Daub, J. Adv. Mater. 1995, 7, 551).

**Table 1: optoelectronic properties**

| Host | Structure | T1 | HOMO | LUMO |
|---|---|---|---|---|
| Host H1 | 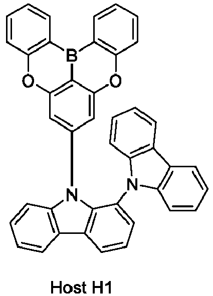 | 427nm | -5.7 | -2.5eV |
| Host H2 | 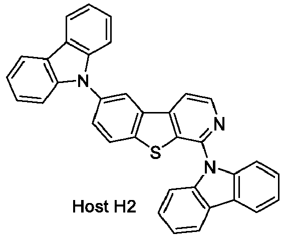 | 420nm | -5.7 | -2.5eV |
| Host H3 | 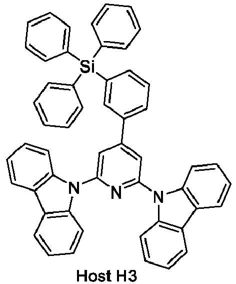 | 408nm | -5.8 | -2.5eV |

OLED devices were fabricated using Host H1, Host H2 and Host H3 as an electron transporting host and Acceptor 1 as the fluorescent acceptor. The device results are shown in Table 2, where the EQE and voltage are taken at 10mA/cm² and the lifetime (LT₉₀) is the time to reduction of brightness to 90% of the initial luminance at a constant current density of 20mA/cm².

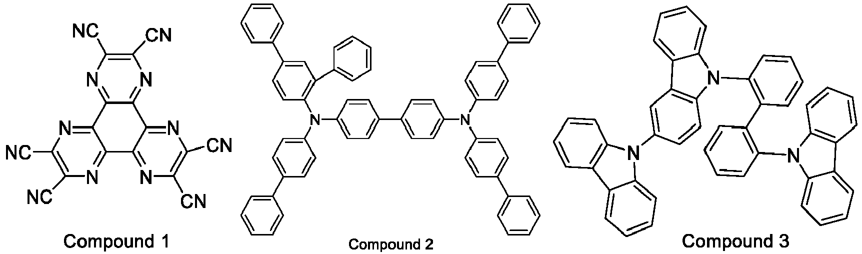

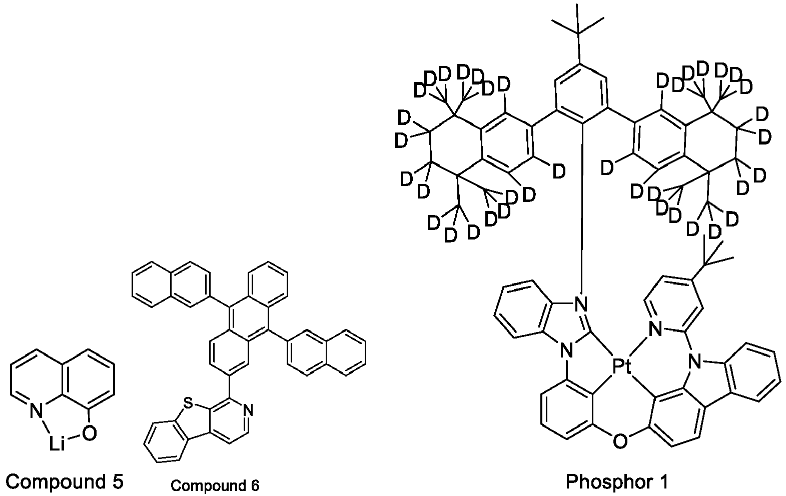

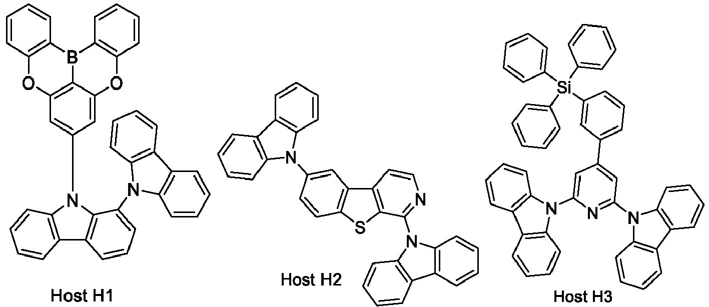

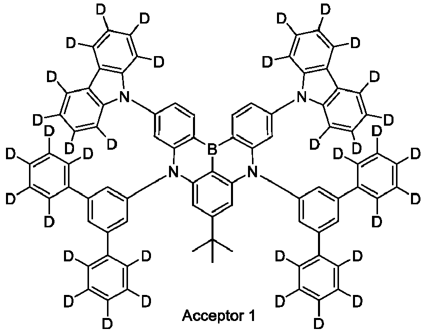

OLEDs were grown on a glass substrate pre-coated with an indium-tin-oxide (ITO) layer having a sheet resistance of 15-Q/sq. Prior to any organic layer deposition or coating, the substrate was degreased with solvents and then treated with an oxygen plasma for 1.5 minutes with 50W at 100 mTorr and with UV ozone for 5 minutes. The devices were fabricated in high vacuum (< 10⁻⁶ Torr) by thermal evaporation. The anode electrode was 750 Å of indium tin oxide (ITO). All devices were encapsulated with a glass lid sealed with an epoxy resin in a nitrogen glove box (<1ppm of H₂O and O₂,) immediately after fabrication with a moisture getter incorporated inside the package. Doping percentages are in volume percent.

The devices shown in Table 2 had organic layers consisting of, sequentially, from the ITO surface, 100 Å of Compound 1 (HIL), 250 Å of Compound 2 (HTL), 50 Å of Compound 3 (EBL), 300 Å of Compound 3 doped with X% of Host, 12% of Phosphor 1 and 0 or 1.5% of Acceptor 1(EML), 50Å of Host (BL), 300 Å of Compound 5 doped with 35% of Compound 6 (ETL), 10 Å of Compound 5 (EIL) followed by 1,000 Å of A1 (Cathode). The device performance for the devices with Host H1, Host H2, and Host H3, with and without Acceptor 1 are shown in Table 1. The V, EQE, and LT₉₀ for the device Example 1 and Comparisons 1-4 are reported relative to the values for Comparison 5.

**TABLE 2: Device Data**

| Device | Host | Acceptor | | at 10mA/cm² | | | at 20mA/cm² |
|---|---|---|---|---|---|---|---|
| | | | λmax (nm) | CIE | | EQE | LT₉₀ |
| Example 1 | 35% Host H1 | Acceptor 1 | 466 | (0.125, 0.137) | 0.83 | 1.42 | 1.29 |
| Comparison 1 | 35% Host H1 | None | 460 | (0.132, 0.131) | 0.83 | 1.06 | 1.00 |
| Comparison 2 | 30% Host H2 | Acceptor 1 | 465 | (0.125, 0.120) | 0.91 | 1.31 | 0.57 |
| Comparison 3 | 30% Host H2 | None | 460 | (0.133, 0.126) | 0.93 | 0.90 | 0.86 |
| Comparison 4 | 60% Host H3 | Acceptor 1 | 465 | (0.126, 0.116) | 0.98 | 1.31 | 0.71 |
| Comparison 5 | 60% Host H3 | None | 459 | (0.133, 0.125) | 1.00 | 1.00 | 1.00 |

The above data shows that the device Example 1, exhibited the longest lifetime, lowest voltage, and highest EQE relative to the five comparison devices. The at least 29% increase in device lifetime compared to Comparison 1, Comparison 3, and Comparison 5, which did not contain the fluorophore, and at least 81% longer lifetime compared to the devices with Host H2 and Host H3 which did contain the fluorophore are beyond any value that could be attributed to experimental error and the observed improvements are significant. Based on the fact, that the host materials have a similar LUMO level and all contain the same fluorescent acceptor and/or phosphor, the significant performance improvements observed in the above data are unexpected. The 29% lifetime increase with Host H1 is counter to the drop in lifetime of 35% and 29% for Host H2 and Host H3 respectively, upon adding the acceptor. Without being bound by any theory, the unexpected improvement from the combination of the boron containing host and the use of fluorescent acceptor may be attributed to favorable intermolecular interactions between the triangulene boron core of Host H1 and the triangulene boron core of Acceptor 1.

The phosphorescent emission spectra for Phosphor 2, Phosphor 3, Phosphor 4, and Phosphor 5 were both measured from degassed solution samples in 2-MeTHF at room temperature. The emission was measured on a Horiba Fluorolog-3 spectrofluorometer equipped with a Synapse Plus CCD detector. The T1 onset is the wavelength corresponding the high energy emission edge at 20% of the peak intensity and the λₘₐₓ is taken at the emission peak of each of these spectra. The samples were excited at 340nm.

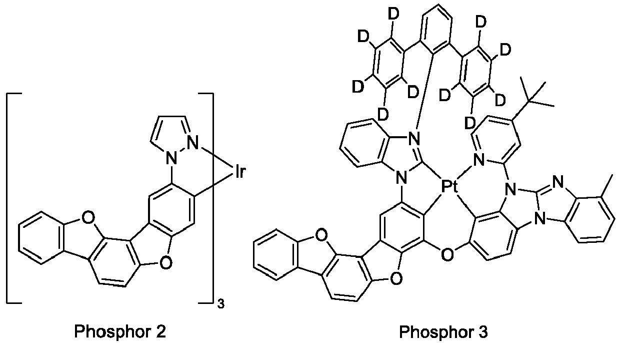

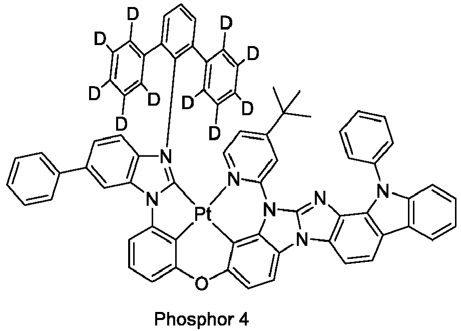

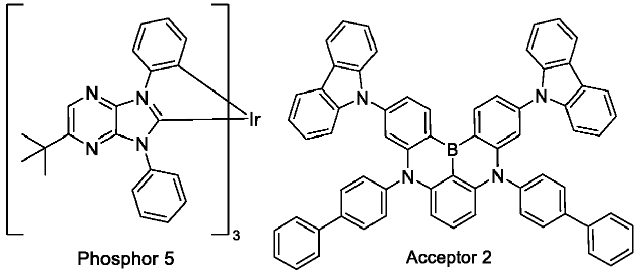

**Table 3: spectral overlap integrals for several phosphors**

| Emitter | T1 onset | λₘₐₓ | Spectral overlap (cm⁻¹nm⁴M⁻¹) |
|---|---|---|---|
| Phosphor 2 | 438nm | 449nm | 5.54 x 10¹⁴ |
| Phosphor 3 | 441nm | 451nm | 5.31 x 10¹⁴ |
| Phosphor 4 | 440nm | 454nm | 4.86 x 10¹⁴ |
| Phosphor 5 | 434nm | 464nm | 3.91 x 10¹⁴ |

The above data shows that the complexes with fused ring systems, Phosphor 2, Phosphor 3, and Phosphor 4, have narrower emission spectra and consequently have higher spectral overlap integrals. The 24-42% higher spectral overlap integrals for Phosphor 2, Phosphor 3, and Phosphor 4 compared to the comparison compound Phosphor 5 are beyond any values that could be attributed to experimental error and the observed improvements are significant. Based on the fact that Phosphor 2, Phosphor 3, and Phosphor 4 have similar or slightly redshifted triplet energy onsets, the significant performance improvement in the above data is unexpected. Without being bound by any theories, the polycyclic fused ring structures on each of Phosphor 2, Phosphor 3, and Phosphor 4 result in more ligand centered emission character resulting in narrower emission bands. The small difference between the triplet onset and the emission peak ensures a large amount of spectral overlap without needing such a high triplet energy. Similarly, the narrow emission width, ensures that the maximum amount of the emission area overlaps with the acceptor absorption. The application of fused ring structures to optimize spectral overlap is expected to translate to other emission colors when appropriately paired with a different acceptor that emits in another spectral region.
Additional OLED devices were fabricated with the following material set.

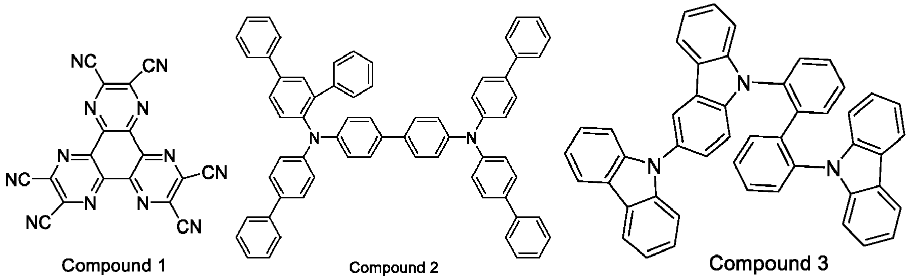

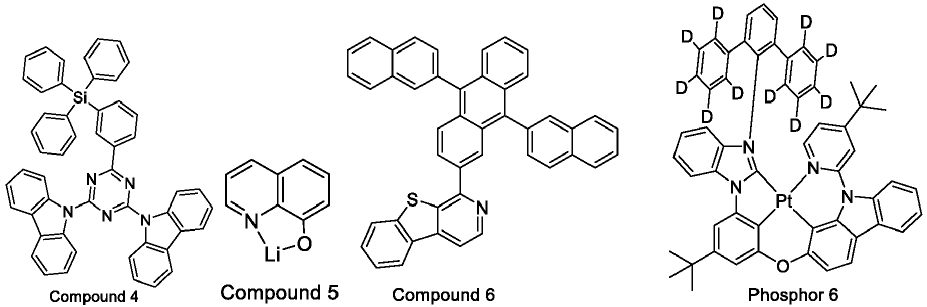

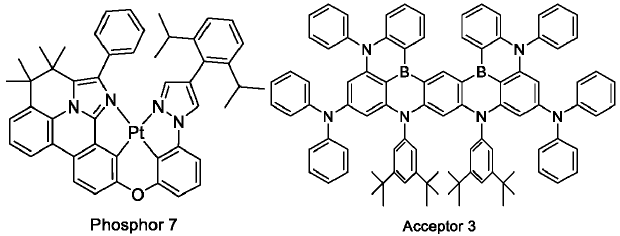

Two devices were grown having organic layers consisting of, sequentially, from the ITO surface, 100 Å of Compound 1 (HIL), 250 Å of Compound 2 (HTL), 50 Å of Compound 3 (EBL), 300 Å Compound 3 doped with 50% of Compound 4, 12% of either Phosphor 6 or Phosphor 7 and 0.8% of Acceptor 3 (EML), 50Å of EHost (BL), 300 Å of Compound 5 doped with 35% of Compound 6 (ETL), 10 Å of Compound 5 (EIL) followed by 1,000 Å of A1 (Cathode). The emission characteristics, voltage, and EQE are taken at 10mA/cm² and reported in Table 4. Both the voltage and EQE for Example 2 are reported relative to the values for Comparison 6.

**TABLE 4: Device Data**

| Device | Phosphor | CIE | λmax (nm) | Relative V | Relative EQE |
|---|---|---|---|---|---|
| Example 2 | Phosphor 6 | (0.125, 0.138) | 470 | 1.00 | 1.00 |
| Comparison 6 | Phosphor 7 | (0.125, 0.139) | 469 | 0.95 | 1.07 |

The above data shows that the sensitizer with the fused ring structure has a higher EQE and lower V compared to the emitter without a fused ring structure. The 7% increase in EQE and 5% reduction in V are both beyond any value that could be attributed to experimental error and the observed improvement is significant. The similar emission properties from each device indicates that the emission primarily originates the fluorescent acceptor. Based on the fact that the device structures are similar and both ultimately emit from the same fluorescent emitter, the significant performance improvement observed in the above data is unexpected. Without being bound by any theory, this improvement may be attributed to a better charge recombination efficiency resulting from the planar fused ring structure.

It is understood that the various embodiments described herein are by way of example only, and are not intended to limit the scope of the invention. For example, many of the materials and structures described herein may be substituted with other materials and structures without deviating from the spirit of the invention. The present invention as claimed may therefore include variations from the particular examples and preferred embodiments described herein, as will be apparent to one of skill in the art. It is understood that various theories as to why the invention works are not intended to be limiting.

It should also be understood that embodiments of all the compounds and devices described herein may be interchangeable if those embodiments are also applicable under different aspects of the entire disclosure.

## Claims

1. An organic light emitting device (OLED) comprising:
an anode;
a cathode; and
an emissive region disposed between the anode and the cathode;
wherein the emissive region comprises:
a first compound S1;
a second compound A1; and
a third compound H1;
wherein the first compound S1 is capable of phosphorescent emission at room temperature and is a sensitizer that transfers energy to the second compound A1;
wherein the second compound A1 is an acceptor that is an emitter; and
wherein the third compound H1 is a first host, and at least one of the first compound S1 and the second compound A1 is doped in the third compound H1;
with at least one of the following conditions being true:
(1) the third compound H1 comprises a boron atom; or
(2) the first compound S1 is a metal complex comprising metal M, and a first ligand L_{A} that comprises at least one moiety F; wherein the at least one moiety F is a fused ring system comprising two or more 5-10 membered carbocyclic or heterocyclic rings and is joined to the metal M through an anionic bond; wherein M is selected from the group consisting of Ir, Rh, Re, Ru, Os, Pt, Pd, Zn, Ag, Au, and Cu; and with the proviso that if M is Pt or Pd, then the at least one moiety F is not a nonfused carbazole.

2. The OLED of claim 1, wherein the third compound H1 comprises a boron atom; and/or wherein the first compound S1 is capable of functioning as a thermally activated delayed fluorescent (TADF) emitter in an OLED at room temperature; and/or wherein the first compound S1 is capable of emitting light from a triplet excited state to a ground singlet state in an OLED at room temperature; and/or wherein the first compound S1 forms an exciplex with the third compound H1 in said OLED at room temperature; and/or wherein the second compound A1 is a delayed-fluorescent compound functioning as a thermally activated delayed fluorescent (TADF) emitter or a fluorescent compound functioning as an emitter in said OLED at room temperature; and/or wherein the first compound S1 is partially or fully deuterated; and/or wherein the second compound A1 is partially or fully deuterated; and/or wherein the third compound H1 is partially or fully deuterated.

3. The OLED of claim 1, wherein the third compound H1 has a structure selected from the group consisting of: 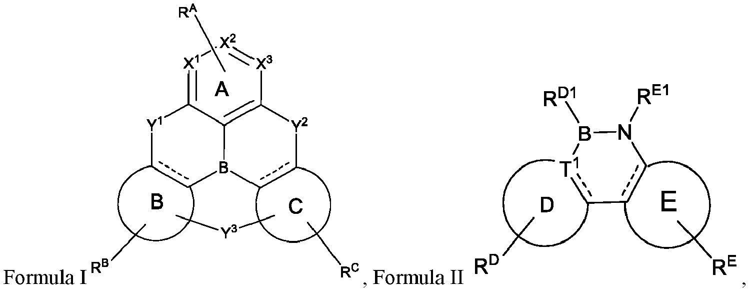 and 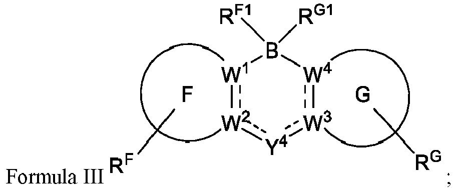 wherein:
rings B, C, D, E, F, and G are each independently a 5-membered or 6-membered carbocyclic or heterocyclic ring;
Y¹, Y², Y³, and Y⁴ are each independently absent or are selected from the group consisting of BR, BRR', NR, PR, P(O)R, O, S, Se, C=O, C=S, C=Se, C=NR, C=CRR', S=O, SO₂, CR, CRR', SiRR', GeRR', alkylene, cycloalkyl, aryl, cycloalkylene, arylene, heteroarylene, and combinations thereof;
each of X¹, X², and X³ is independently C or N;
T¹ is CorN;
each of W¹, W², W³, and W⁴ is independently C or N;
each ------- is independently a single bond or a double bond;
each of R^{A}, R^{B}, R^{C}, R^{D}, R^{E}, R^{F}, and R^{G} independently represents mono, or up to a maximum allowed substitutions, or no substitutions;
each R, R', R^{D1}, R^{E1}, R^{F1}, R^{G1}, R^{A}, R^{B}, R^{C}, R^{D}, R^{E}, R^{F}, and R^{G} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and
any two substituents can be joined or fused to form a ring.

4. The OLED of claim 3, wherein each of rings B, C, D, E, F, and G is independently selected from the group consisting of benzene, pyridine, pyrimidine, pyridazine, pyrazine, triazine, imidazole, pyrazole, pyrrole, oxazole, furan, thiophene, thiazole, and triazole; and/or wherein at least one of R, R', R^{D1}, R^{E1}, R^{F1}, R^{G1}, R^{A}, R^{B}, R^{C}, R^{D}, R^{E}, R^{F}, and R^{G} is present and comprises a moiety selected from the group consisting of silyl, germyl, tetraphenylene, benzene, pyridine, pyrimidine, pyridazine, pyrazine, triazine, imidazole, pyrazole, pyrrole, oxazole, furan, thiophene, thiazole, triazole, dibenzothiophene, dibenzofuran, dibenzoseleonphene, carbazole, azadibenzothiophene, azadibenzofuran, 5λ2-benzo[*d*]benzo[4,5]imidazo[3,2-*a*]imidazole, azadibenzoseleonphene, and partially or fully deuterated variations thereof.

5. The OLED of claim 1, wherein the third compound H1 has a structure selected from the group consisting of 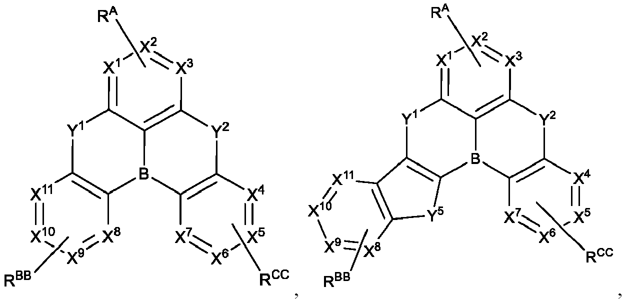 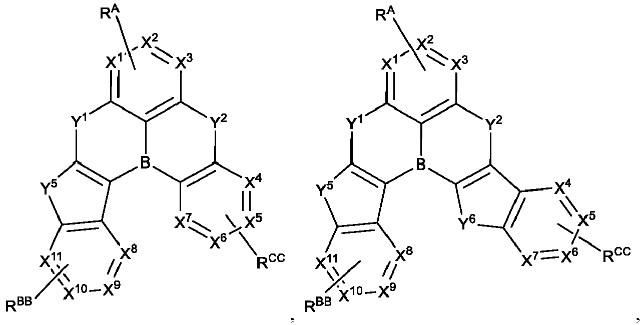 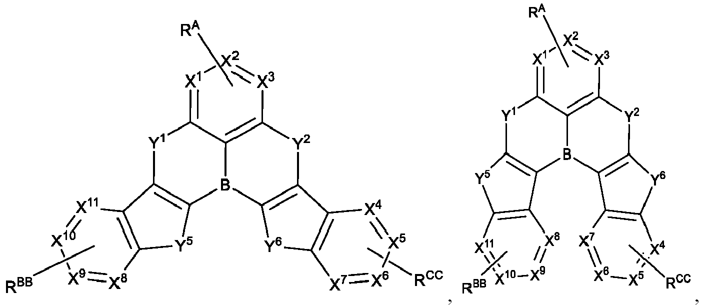 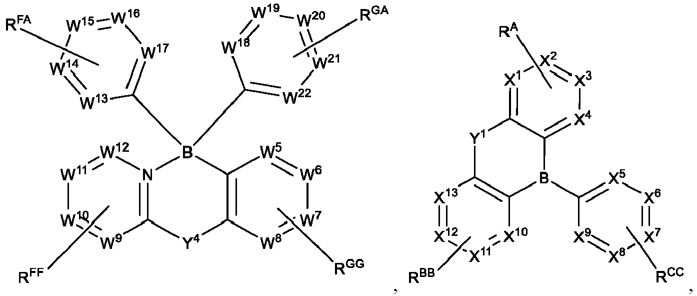 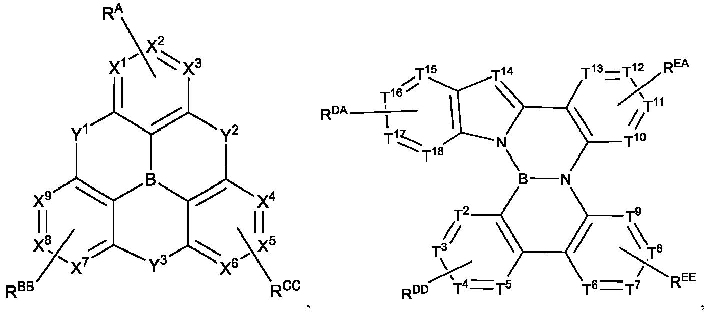 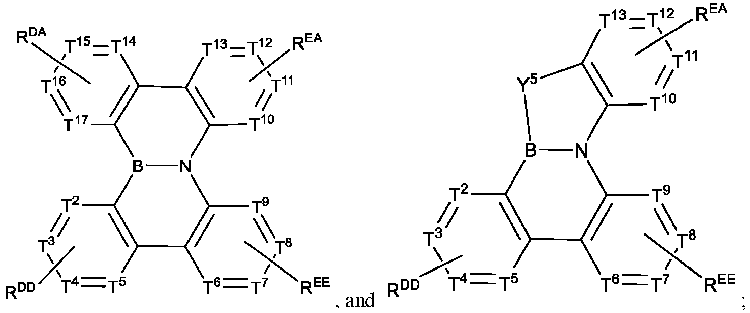 wherein:
each of X⁴ to X¹³ is independently C or N;
each of T² to T¹⁸ is independently C or N;
each of W⁵ to W²² is independently C or N;
Y⁵ and Y⁶ are each independently selected from the group consisting of BR, BRR', NR, PR, P(O)R, O, S, Se, C=O, C=S, C=Se, C=NR', C=CRR, S=O, SO₂, CRR', SiRR', and GeRR';
each of R^{BB}, R^{CC}, R^{DD}, R^{DA}, R^{EE}, R^{EA}, R^{FF}, R^{FA}, R^{GG}, and R^{GA} independently represents mono, or up to a maximum allowed substitutions, or no substitutions;
each R, R', R^{BB}, R^{CC}, R^{DD}, R^{DA}, R^{EE}, R^{EA}, R^{FF}, R^{FA}, R^{GG}, and R^{GA} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and
any two substitutions can be joined or fused to form a ring.

6. The OLED of claim 1, wherein the third compound H1 has a structure selected from the group consisting of: 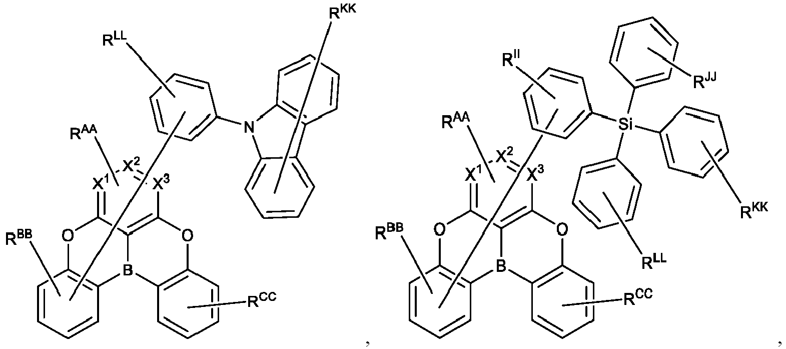 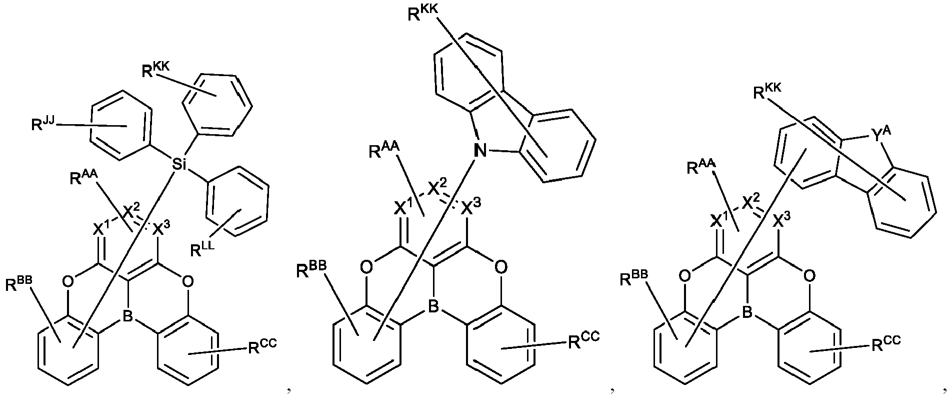 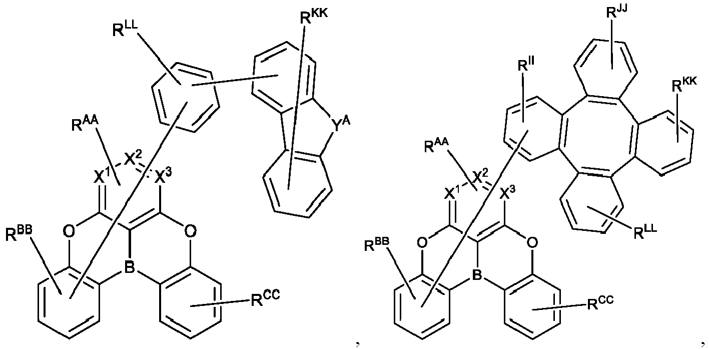 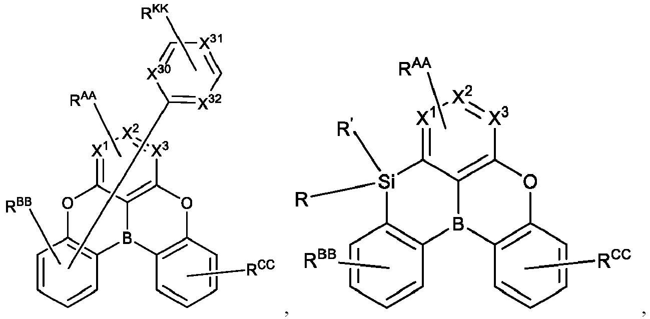 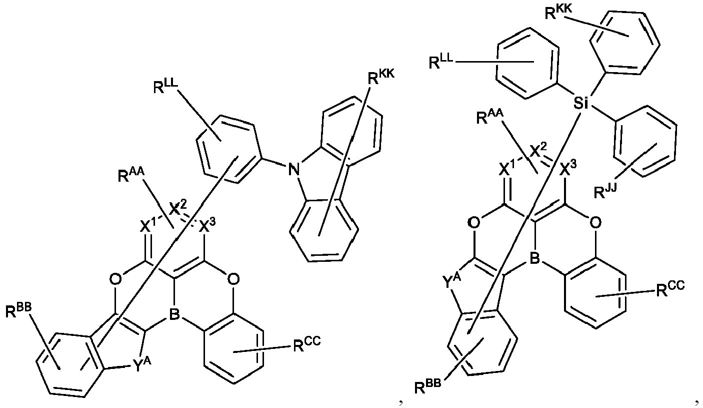 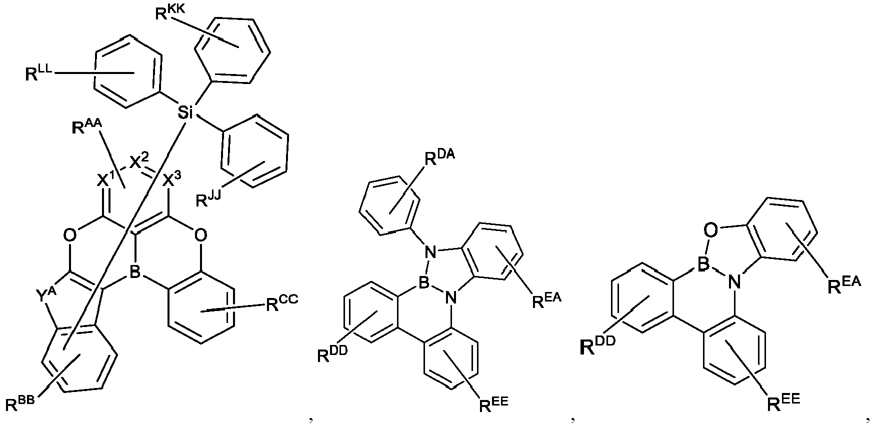 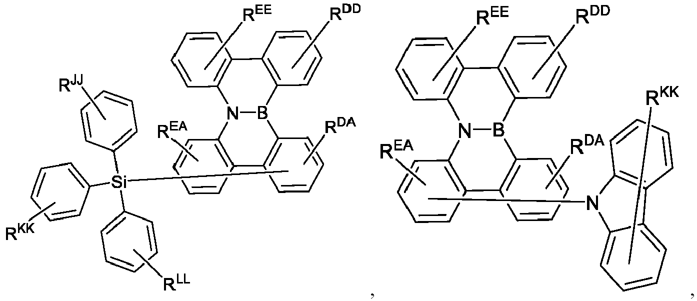 and 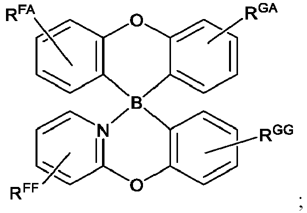 wherein:
each of X³⁰, X³¹, and X³² is independently C or N;
each Y^{A} is independently selected from the group consisting of BR, BRR', NR, PR, P(O)R, O, S, Se, C=O, C=S, C=Se, C=NR', C=CRR, S=O, SO₂, CRR', SiRR', and GeRR';
each of R^{AA}, R^{BB}, R^{CC}, R^{DD}, R^{DA}, R^{EE}, R^{EA}, R^{JJ}, R^{KK}, and R^{LL} independently represents mono, up to the maximum substitutions, or no substitutions;
each of R, R', R^{AA}, R^{BB}, R^{CC}, R^{DD}, R^{DA}, R^{EE}, R^{EA}, R^{II}, R^{JJ}, R^{KK}, and R^{LL} is independently a hydrogen or a substituent selected from the group consisting of deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, germyl, selenyl, and combinations thereof; and
any two adjacent substituents can be joined or fused to form a ring.

7. The OLED of claim 1, wherein the third compound H1 has a structure selected from the group consisting of 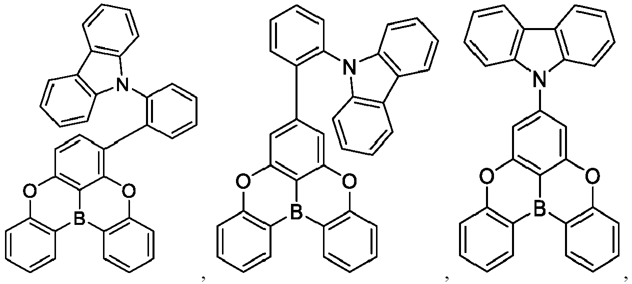 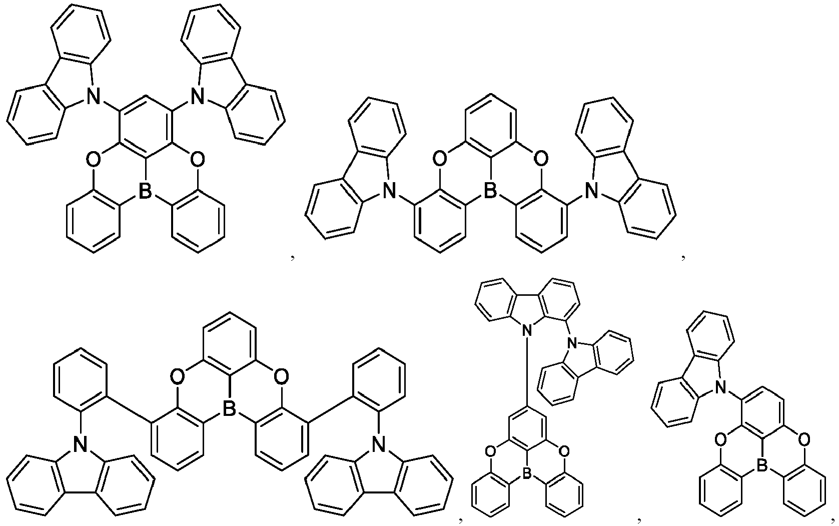 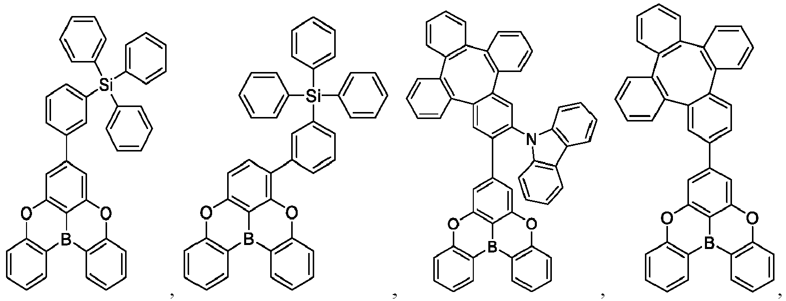 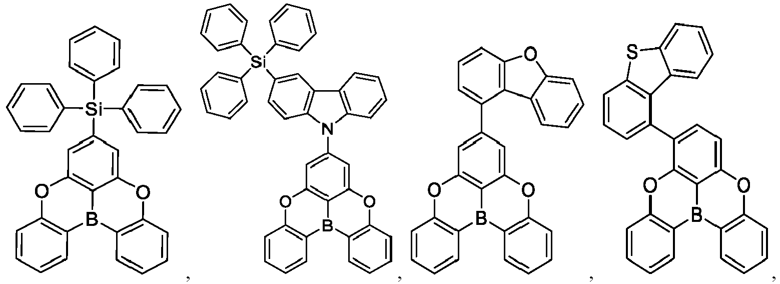 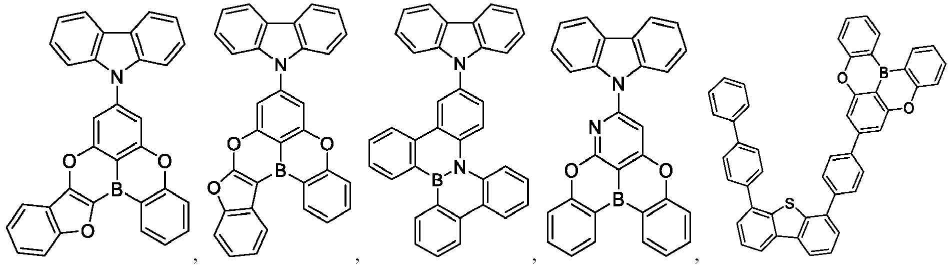 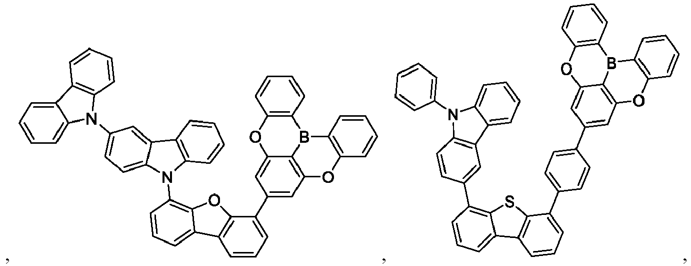 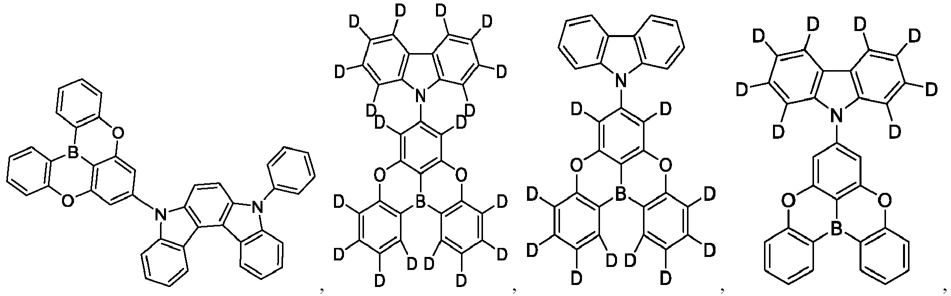 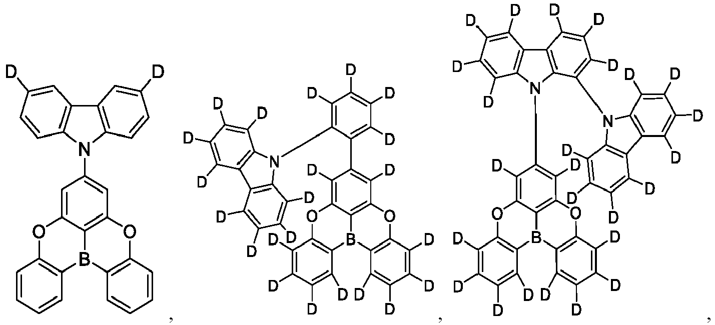 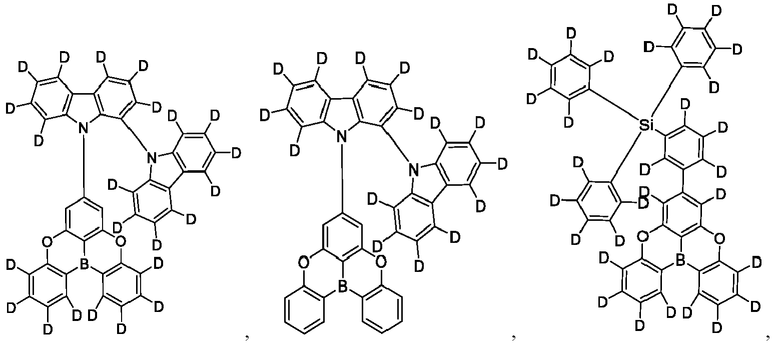 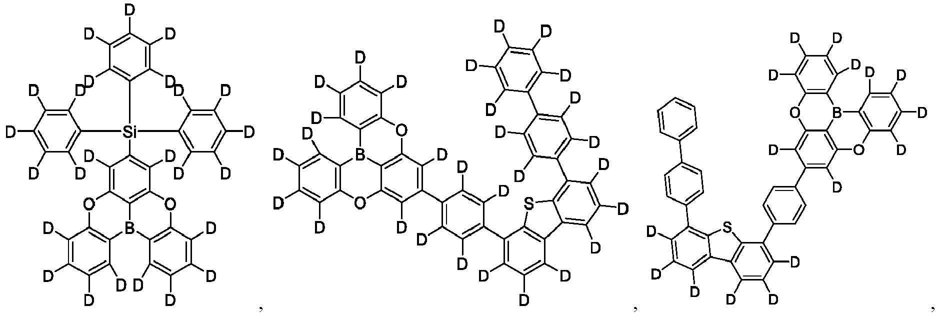 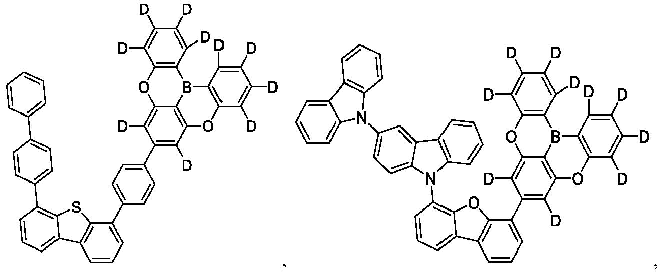 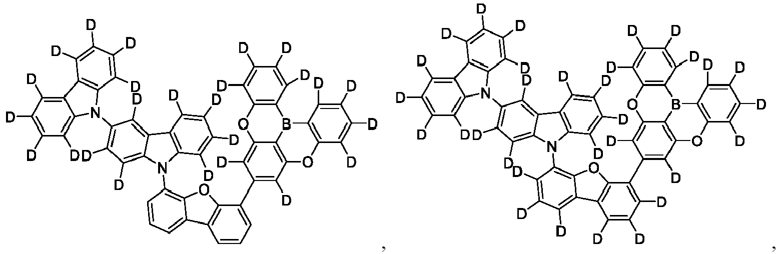 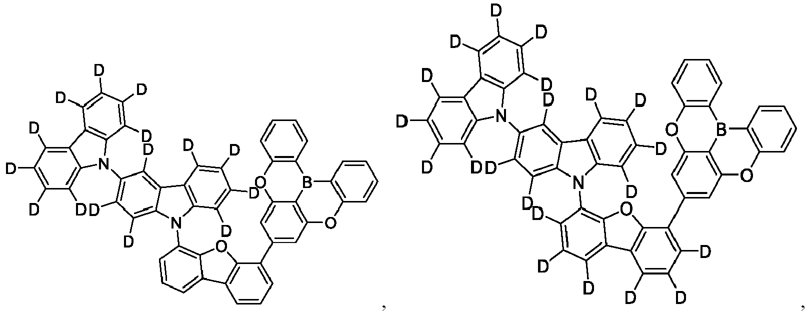 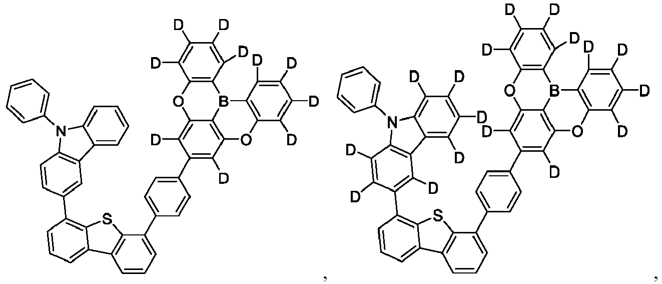 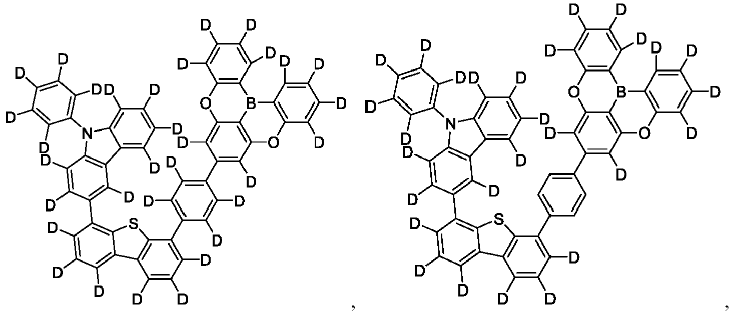 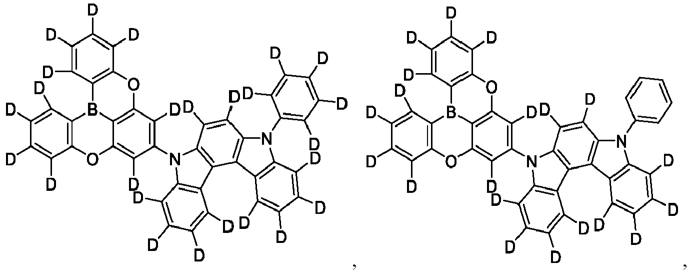 and

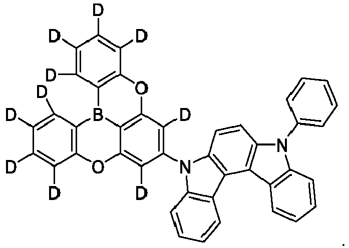

8. The OLED of claim 1, wherein an S₁-T₁ energy gap of the first compound S1 is less than 300 meV; and/or wherein an S₁-T₁ energy gap of the second compound A1 is less than 300 meV; and/or wherein the second compound A1 has a Stokes shift of 30 nm or less; and/or wherein the first compound S1 has a maximum emission wavelength of λₘₐₓ₁ at room temperature in a monochromic OLED having the third compound H1 as the host; wherein the second compound A1 has a maximum emission wavelength of λₘₐₓ₂ in the monochromic OLED by replacing the first compound S1 with the second compound A1; wherein Δλ =λₘₐₓ₁ - λₘₐₓ₂; and wherein Δλ is equal to or less than the number selected from the group consisting of 15, 12, 10, 8, 6, 4, 2, 0, -2, - 4, -6, -8, and -10 nm; and/or wherein the OLED emits a luminescent radiation at room temperature when a voltage is applied across the device; wherein the luminescent radiation comprises a first radiation component contributed from the second compound A1 with a full width half maximum (FWHM) of 50 nm or less.

9. The OLED of claim 1, wherein the first compound S1 has the formula of M(L¹)ₓ(L²)_{y}(L³)_{z};
wherein L¹, L², and L³ can be the same or different;
wherein x is 1, 2, or 3;
wherein y is 0, 1, or 2;
wherein z is 0, 1, or 2;
wherein x+y+z is the oxidation state of the metal M;
wherein L¹ is selected from the group consisting of the structures of the following LIST 4: 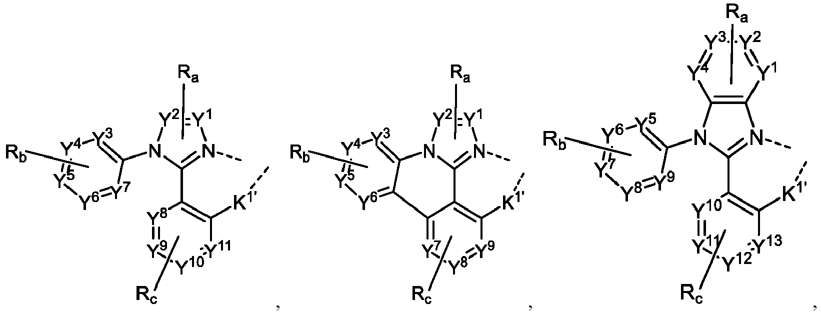 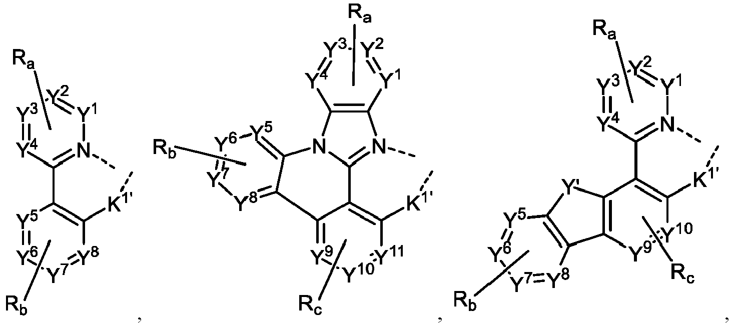 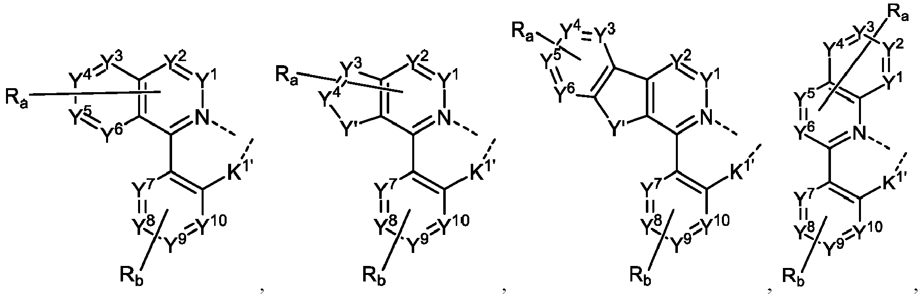 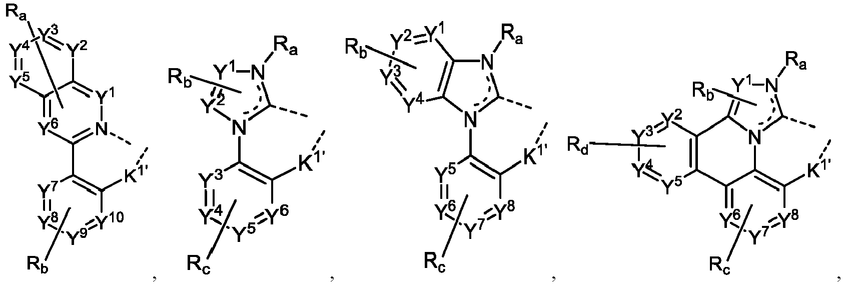 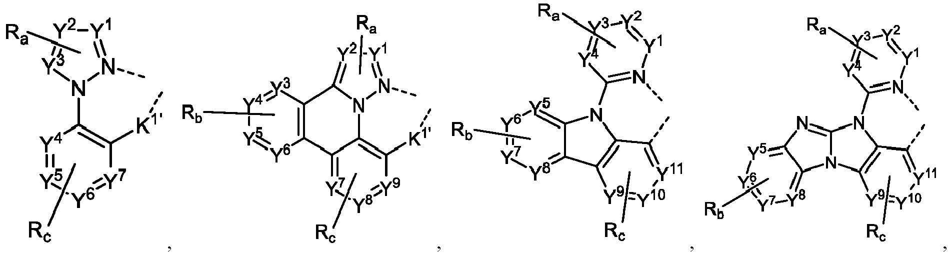 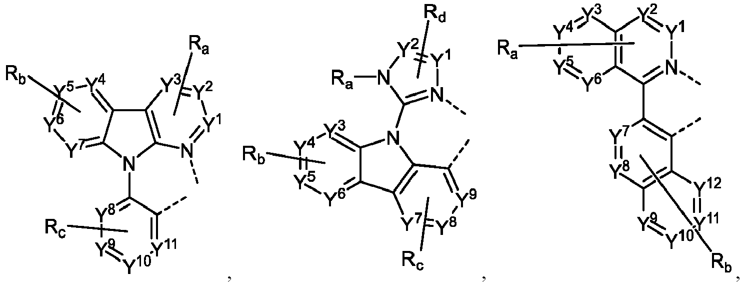 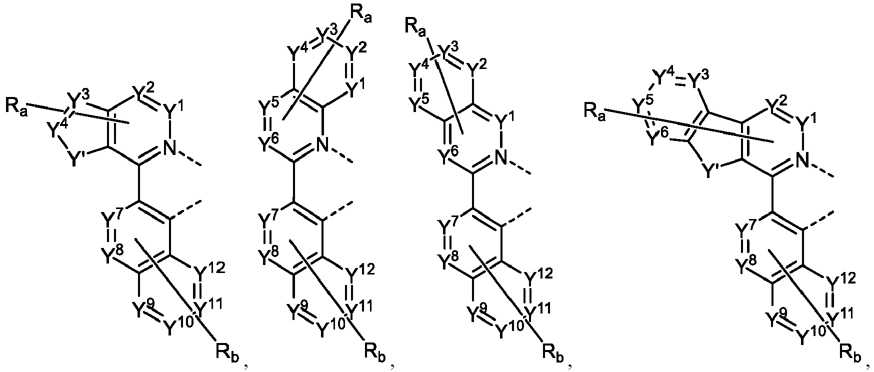 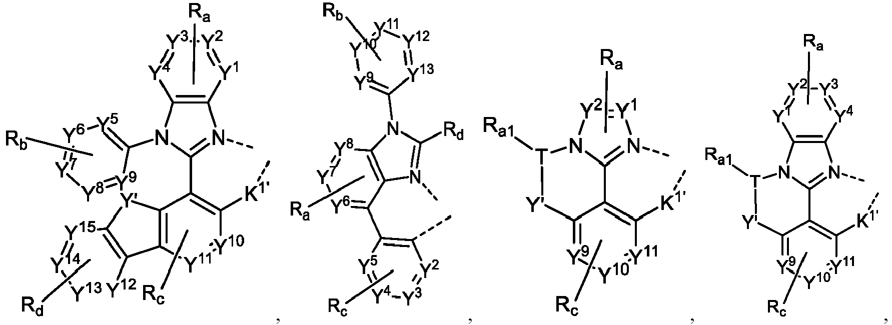 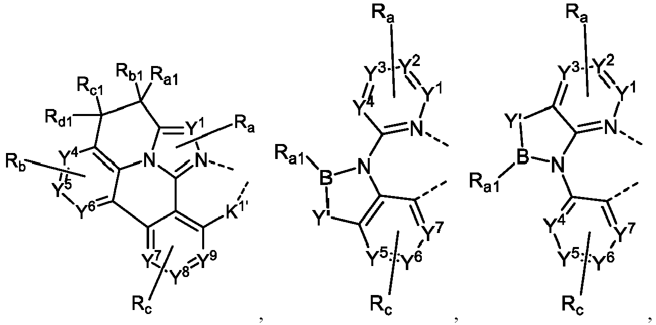 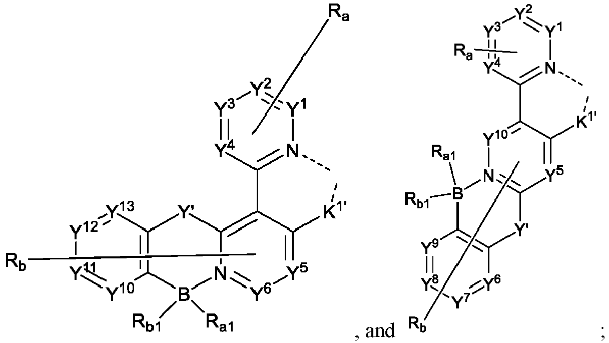
wherein L² and L³ are independently selected from the group consisting of 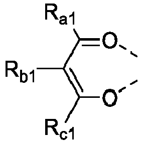 and the structures of LIST 4;
wherein:
T is selected from the group consisting of B, A1, Ga, and In;
K^{1'} is a direct bond or is selected from the group consisting of NRₑ, PRₑ, O, S, and Se;
each Y¹ to Y¹³ are independently selected from the group consisting of carbon and nitrogen;
Y' is selected from the group consisting of B Rₑ, N Rₑ, P Rₑ, O, S, Se, C=O, S=O, SO₂, CRₑR_{f}, SiRₑR_{f}, and GeRₑR_{f};
Rₑ and R_{f} can be fused or joined to form a ring;
each Rₐ, R_{b}, R_{c}, and R_{d} can independently represent from mono to the maximum possible number of substitutions, or no substitution;
each Rₐ₁, R_{b1}, R_{c1}, R_{d1}, Rₐ, R_{b}, Rₑ, R_{d}, Rₑ, and R_{f} is independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and
any two adjacent substituents of Rₐ₁, R_{b1}, R_{c1}, R_{d1}, Rₐ, R_{b}, R_{c}, and R_{d} can be fused or joined to form a ring or form a multidentate ligand.

10. The OLED of claim 1, wherein the first compound S1 is selected from the group consisting of: 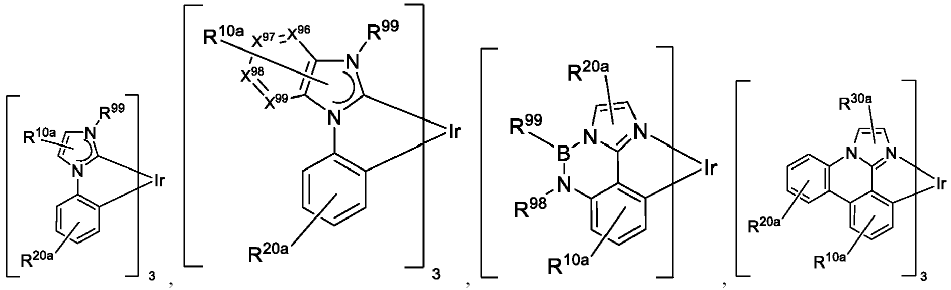 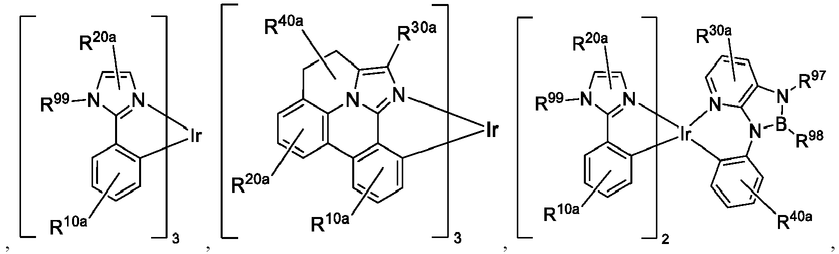 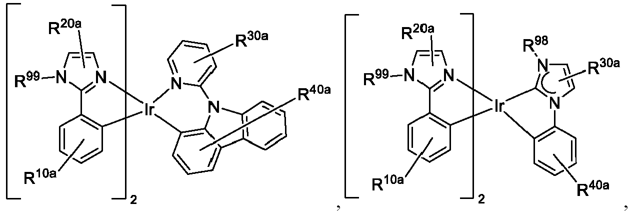 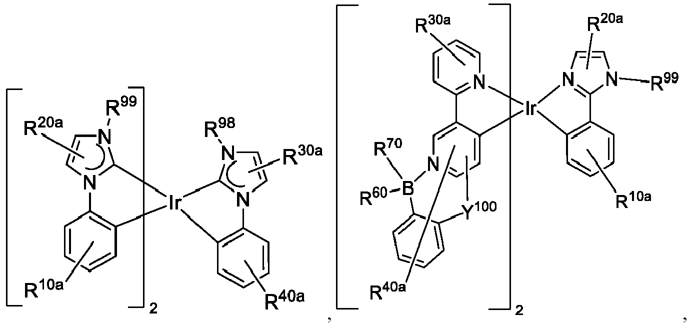 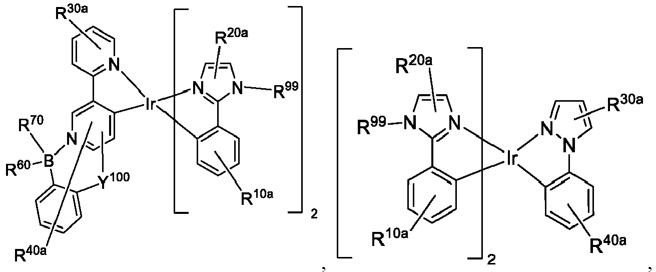 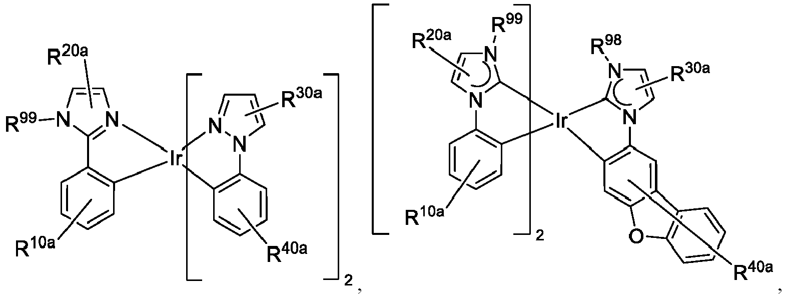 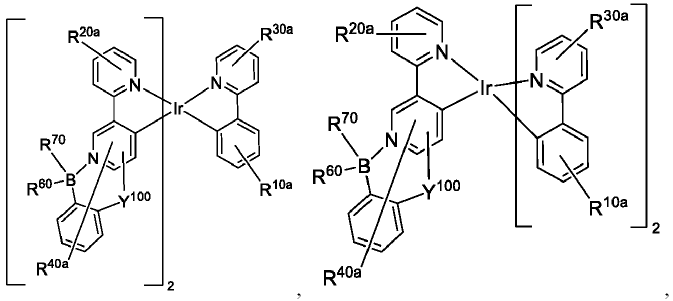 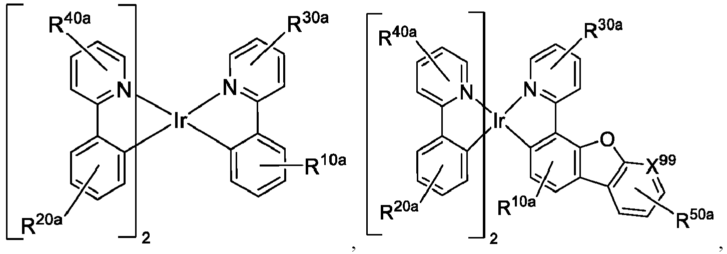 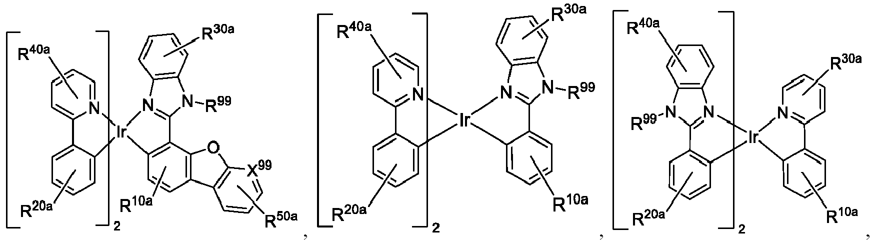 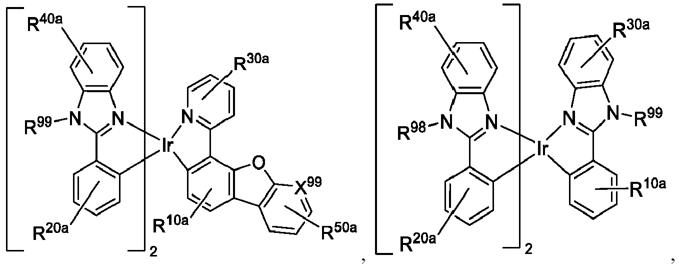 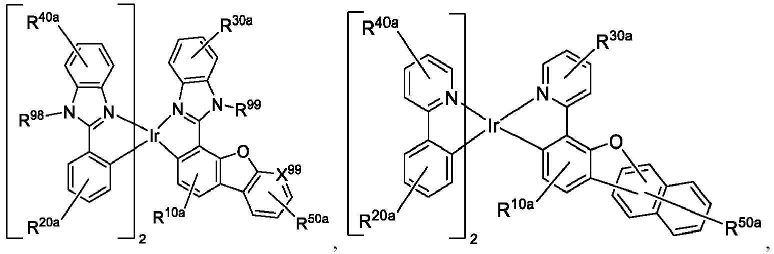 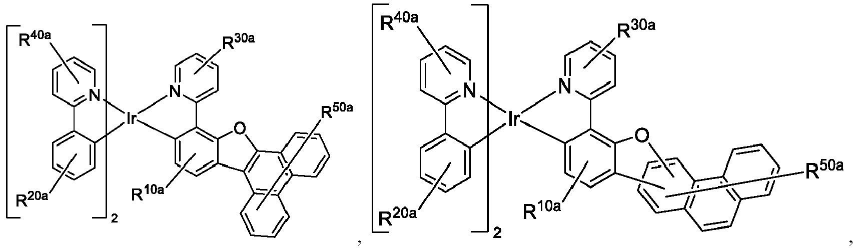 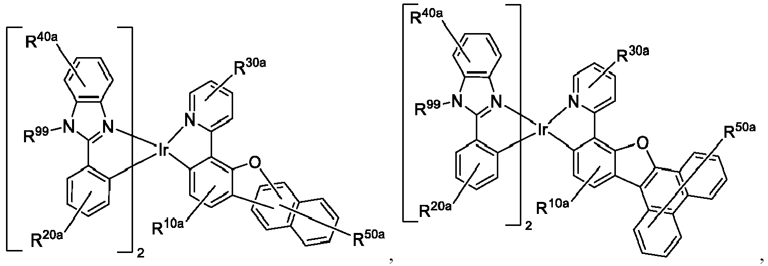 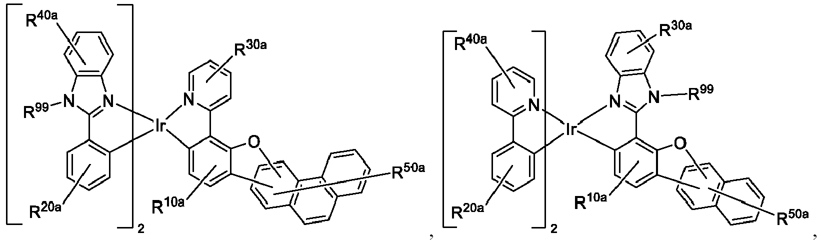 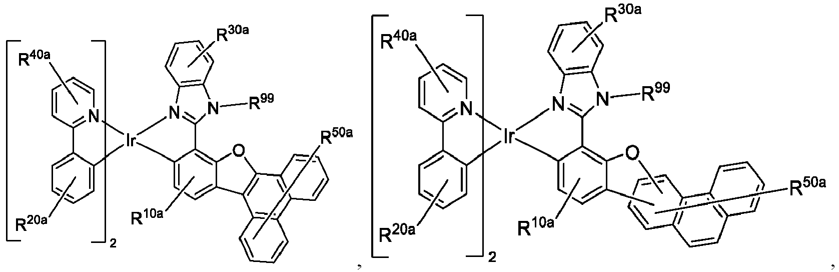 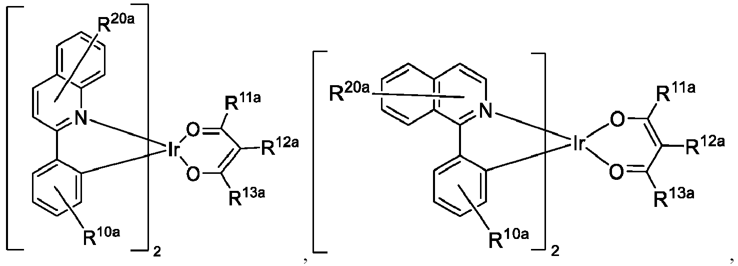 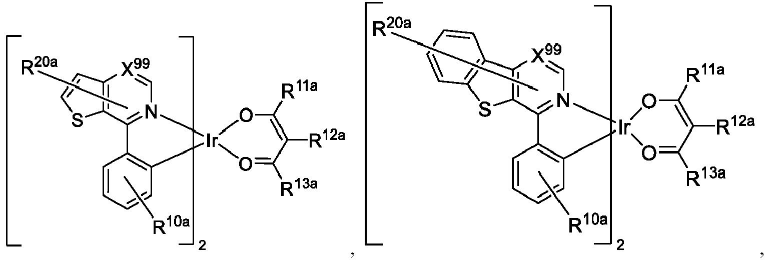 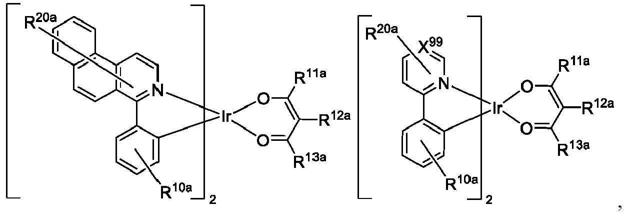 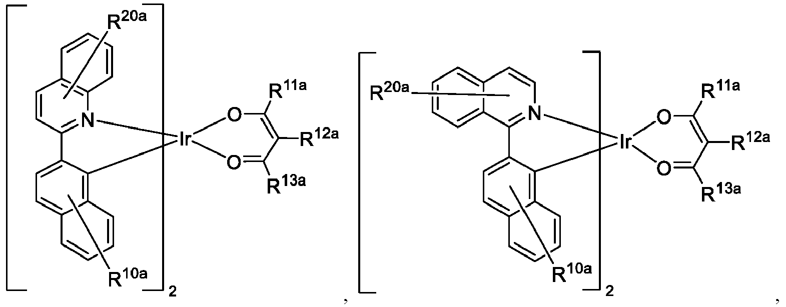 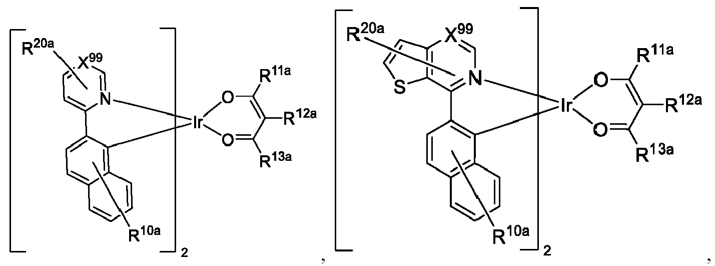 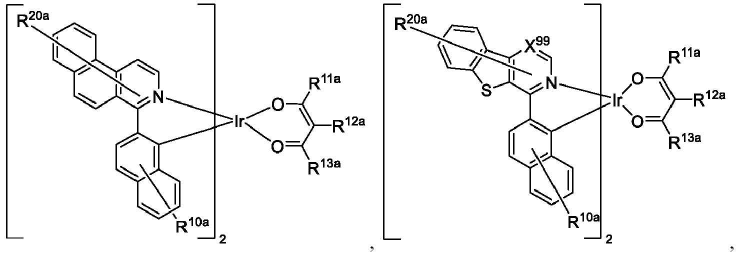 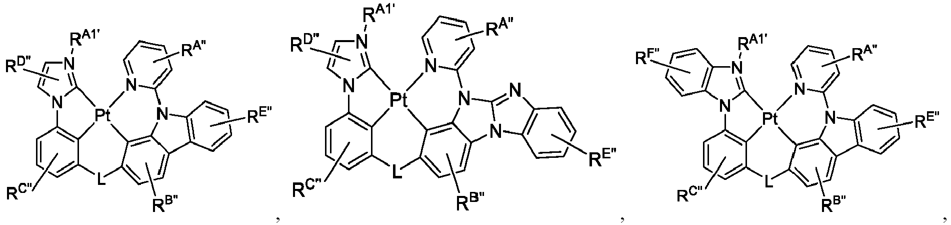 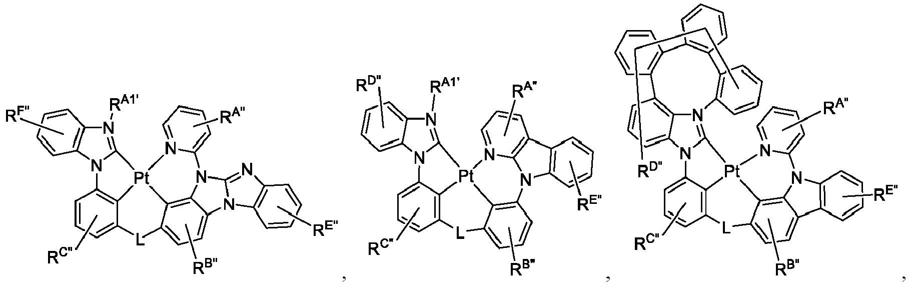 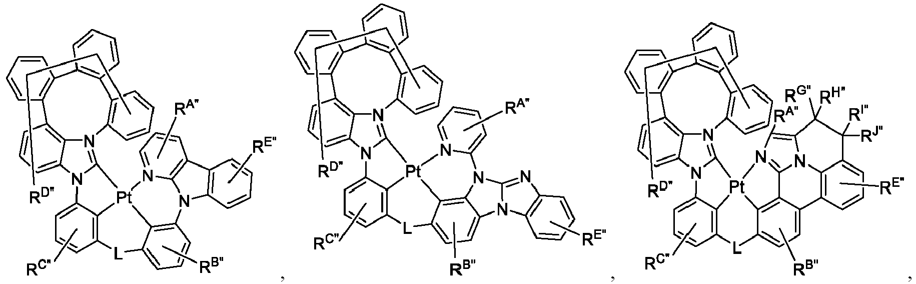 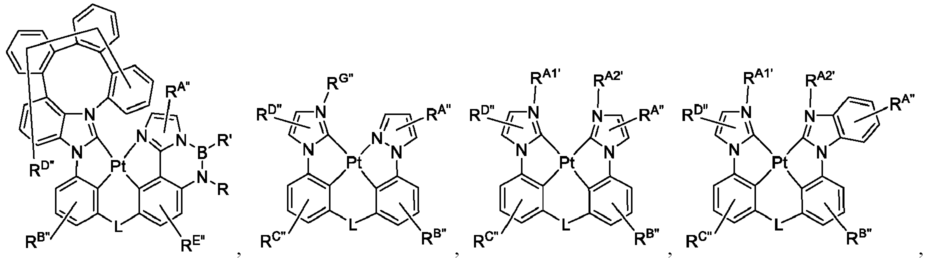 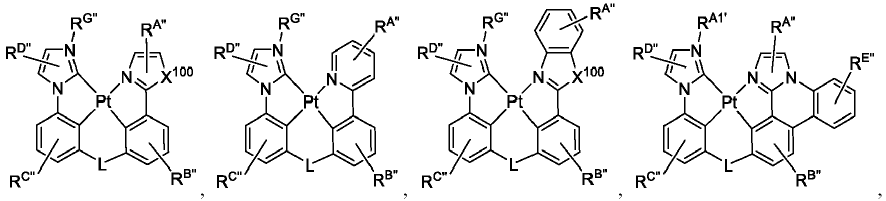 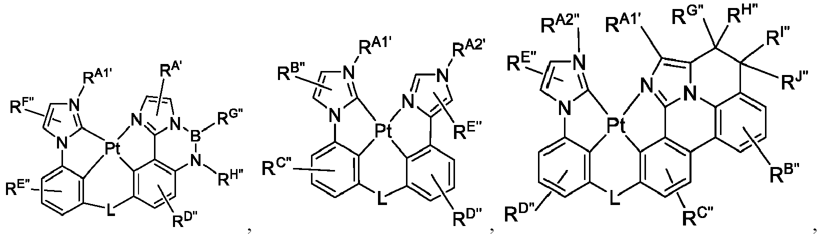 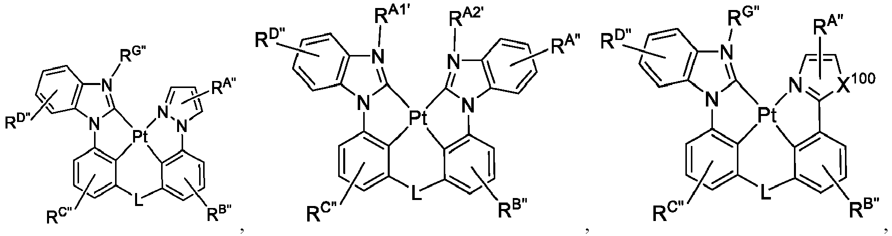 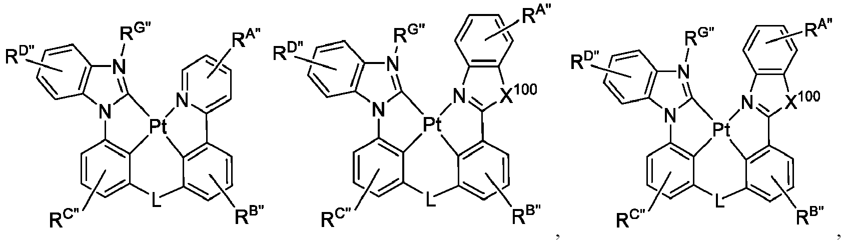 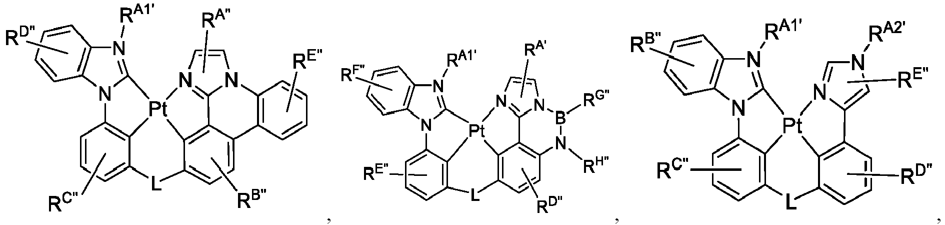 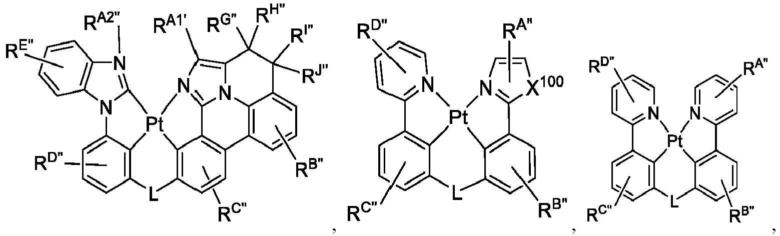 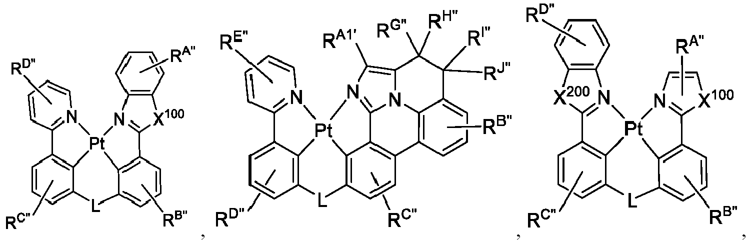 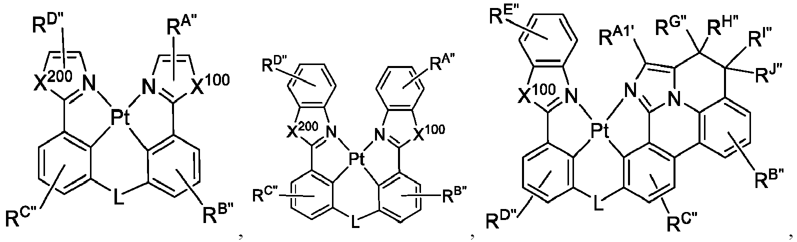 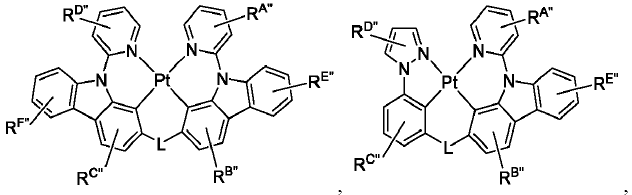 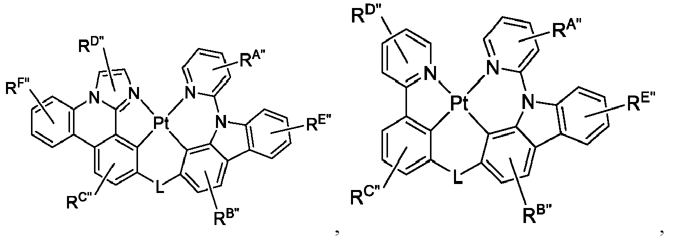 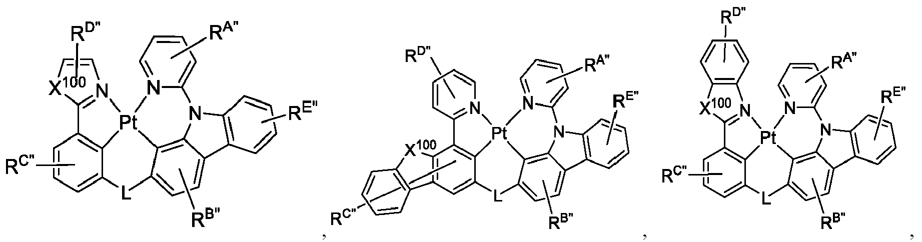 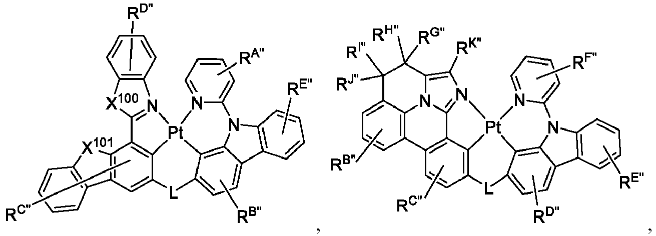 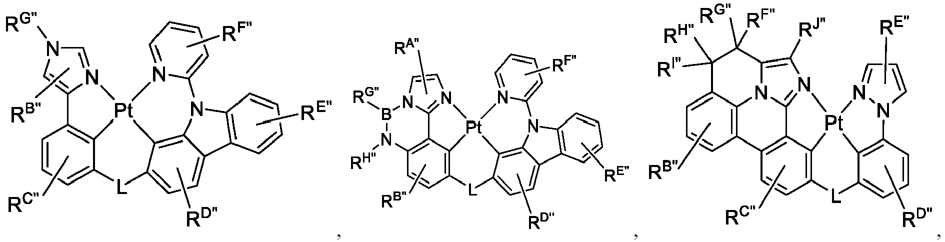 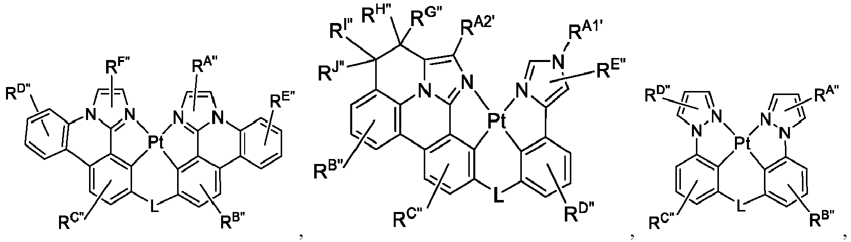 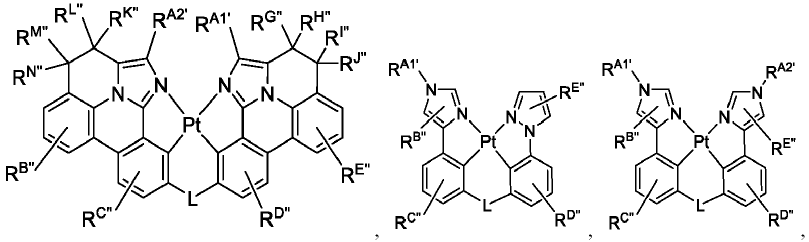 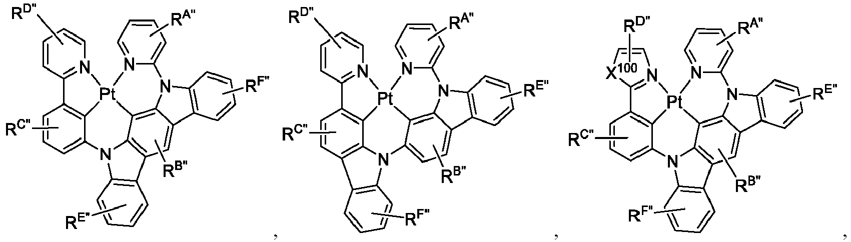 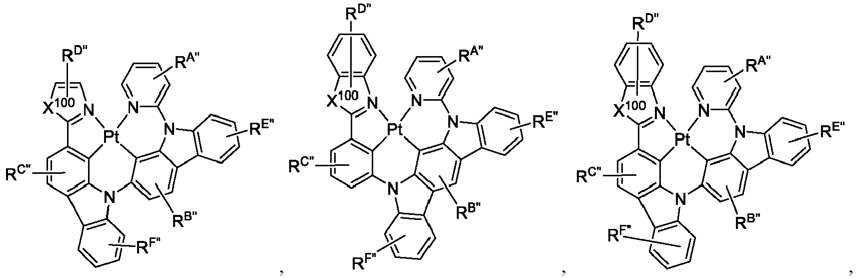 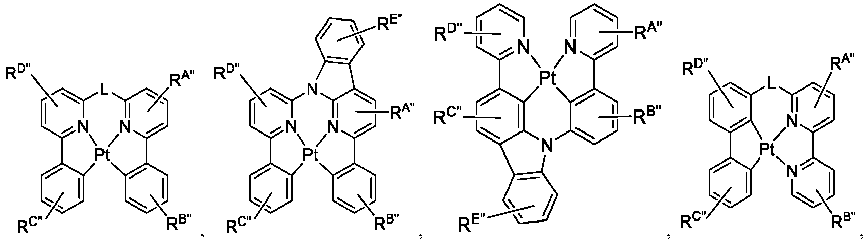 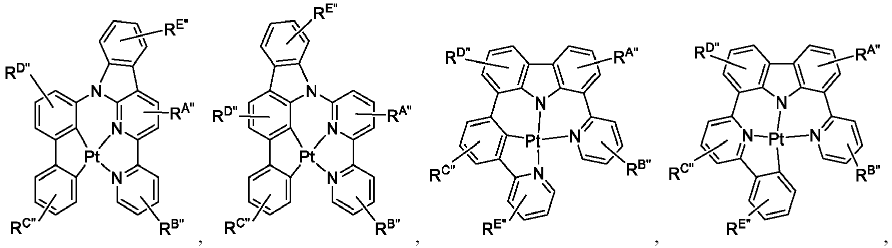 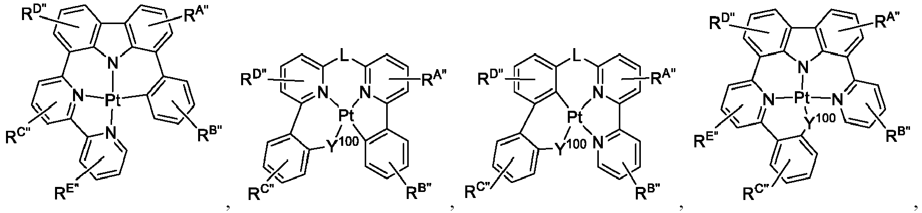 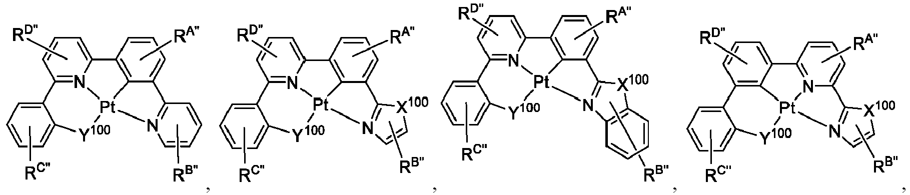 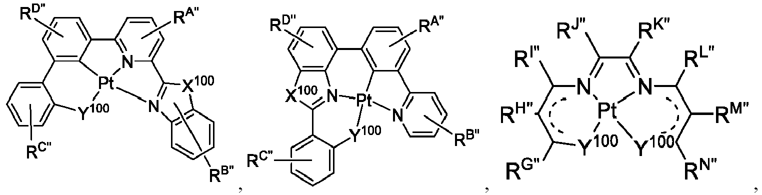 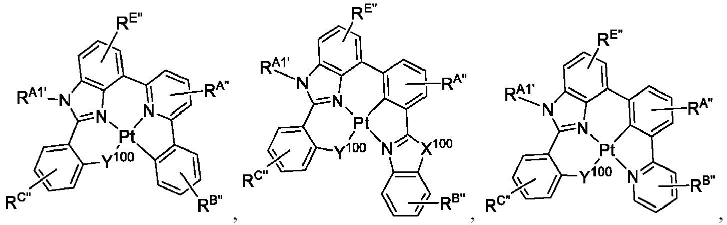 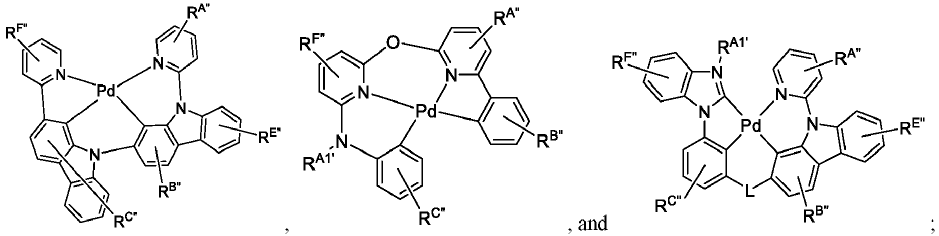 wherein:
each of X⁹⁶ to X⁹⁹ is independently C or N;
each of Y¹⁰⁰ and Y²⁰⁰ is independently selected from the group consisting of a NR", O, S, and Se;
L is independently selected from the group consisting of a direct bond, BR", BR"R"', NR", PR", O, S, Se, C=O, C=S, C=Se, C=NR", C=CR"R"', S=O, SO₂, CR", CR"R"', SiR"R"', GeR"R"', alkyl, cycloalkyl, aryl, heteroaryl, and combinations thereof;
X¹⁰⁰ for each occurrence is selected from the group consisting of O, S, Se, NR", and CR"R‴;
each R^{10a}, R^{20a}, R^{30a}, R^{40a}, and R^{50a}, R^{A"}, R^{B"}, R^{C"}, R^{D"}, R^{E"}, and R^{F"} independently represents mono-, up to the maximum substitutions, or no substitutions;
each R, R', R", R"', R^{10a}, R^{11a}, R^{12a}, R^{13a}, R^{20a}, R^{30a}, R^{40a}, R^{50a}, R⁶⁰, R⁷⁰, R⁹⁷, R⁹⁸, R⁹⁹, R^{A1'}, R^{A2'}, R^{A"}, R^{B"}, R^{C"} , R^{D"}, R^{E"}, R^{F"}, R^{G"}, R^{H"}, R^{I"}, R^{J"}, R^{K"}, R^{L"}, R^{M"}, and R^{N"} is independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof.

11. The OLED of claim 1, wherein the first compound S1 is selected from the group consisting of: 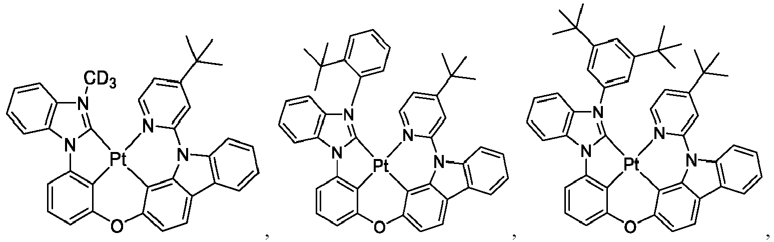 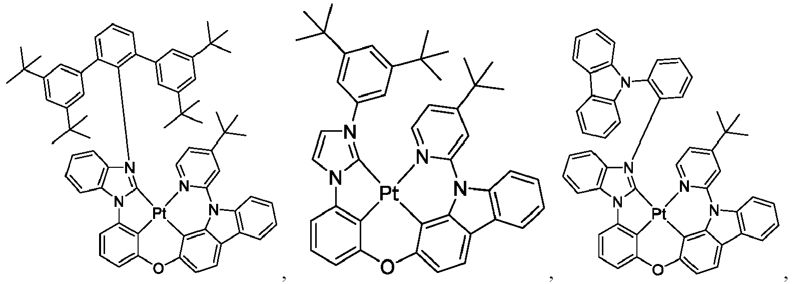 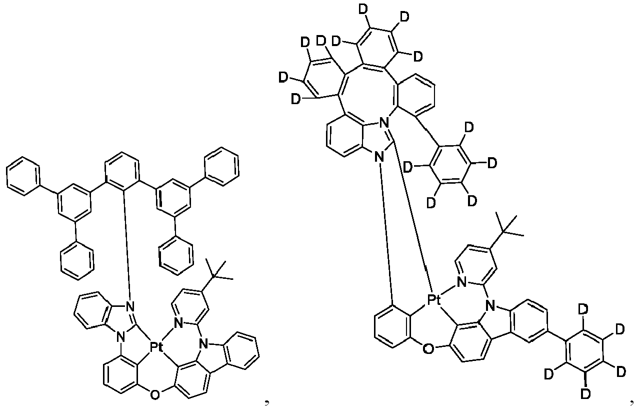 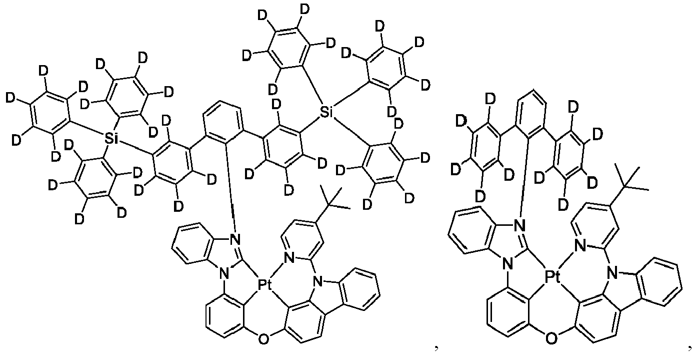 and

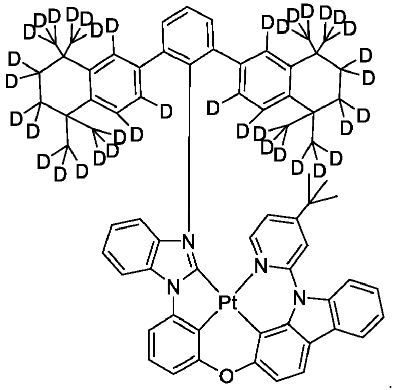

12. The OLED of claim 1, wherein the third compound H1 is selected from the group consisting of: 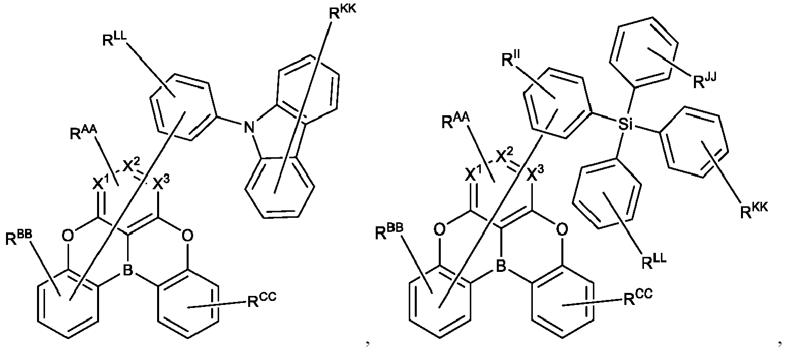 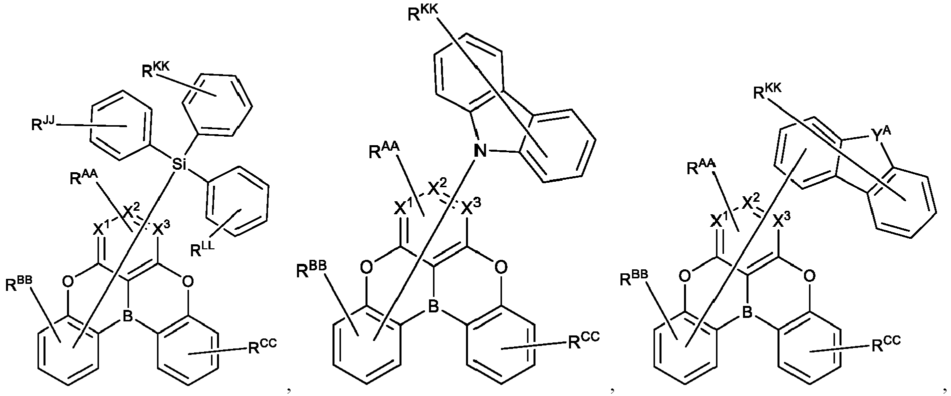 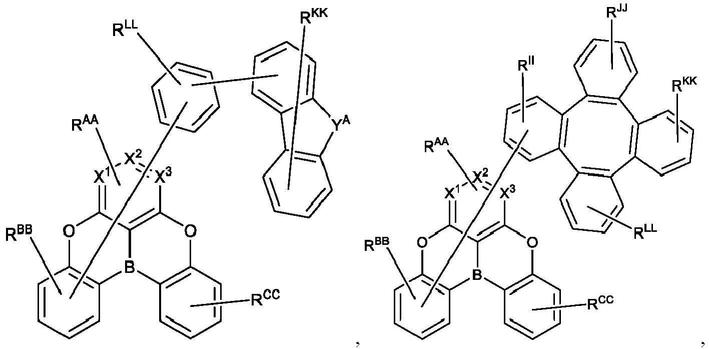 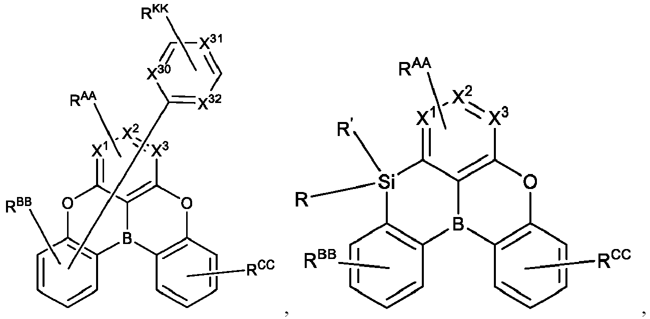 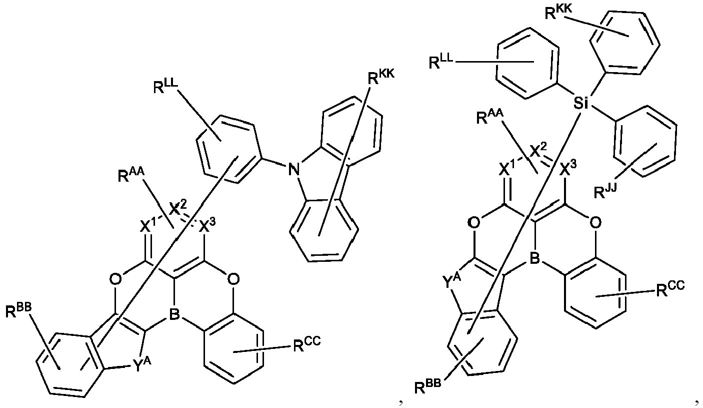 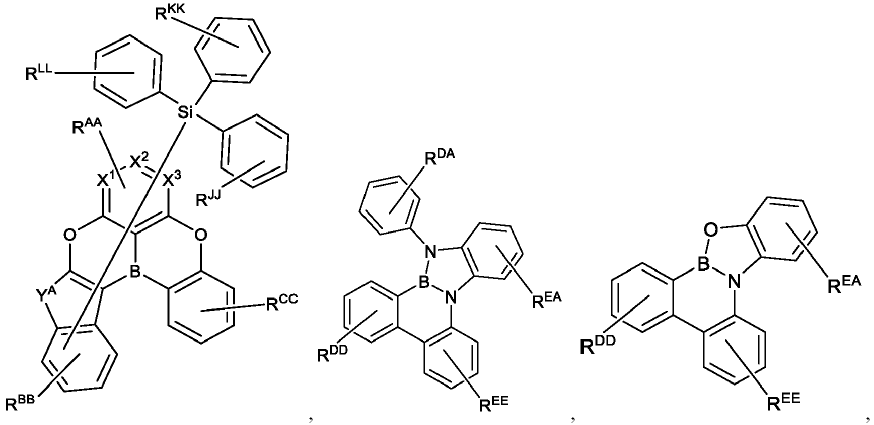 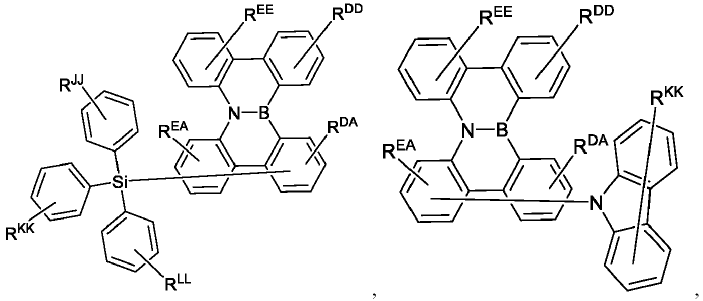 and 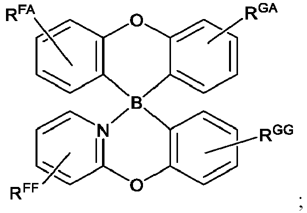 wherein:
each of X³⁰, X³¹, and X³² is independently C or N;
each Y^{A} is independently selected from the group consisting of BR, BRR', NR, PR, P(O)R, O, S, Se, C=O, C=S, C=Se, C=NR', C=CRR, S=O, SO₂, CRR', SiRR', and GeRR';
each of R^{AA}, R^{BB}, R^{CC}, R^{DD}, R^{DA}, R^{EE}, R^{EA}, R^{JJ}, R^{KK}, and R^{LL} independently represents mono, up to the maximum substitutions, or no substitutions;
each of R, R', R^{AA}, R^{BB}, R^{CC}, R^{DD}, R^{DA}, R^{EE}, R^{EA}, R^{II}, R^{JJ}, R^{KK}, and R^{LL} is independently a hydrogen or a substituent selected from the group consisting of deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, germyl, selenyl, and combinations thereof; and
any two adjacent substituents can be joined or fused to form a ring.

13. The OLED of claim 1, wherein the first compound S1 is a metal complex comprising metal M, and a first ligand L_{A} that comprises at least one moiety F; wherein the at least one moiety F is a fused ring system comprising two or more 5-10 membered carbocyclic or heterocyclic rings and is joined to the metal M through an anionic bond; wherein M is selected from the group consisting of Ir, Rh, Re, Ru, Os, Pt, Pd, Zn, Ag, Au, and Cu; and with the proviso that if M is Pt or Pd, then the at least one moiety F is not a nonfused carbazole; and/or wherein the fused ring system comprises a group consisting of phenanthridine imidazole, diazaborinine, substituted or unsubstituted dibenzothiophene, substituted or unsubstituted dibenzoselenophene, substituted or unsubstituted carbazole, substituted dibenzofuran, azaphenanthridine imidazole, substituted or unsubstituted azadibenzothiophene, substituted or unsubstituted azadibenzoselenophene, substituted or unsubstituted azacarbazole, substituted or unsubstituted azadibenzofuran, substituted or unsubstituted benzothiophene, substituted or unsubstituted benzoselenophene, substituted or unsubstituted indole, substituted or unsubstituted benzofuran, substituted or unsubstituted benzimidazole, substituted or unsubstituted benzoxazole, substituted or unsubstituted benzothiazole, substituted or unsubstituted benzoxadiazole, substituted or unsubstituted benzothiadiazole, and a group comprising 4 or more fused rings; and/or wherein the third compound H1 comprises a moiety selected from the group consisting of bicarbazole, indolocarbazole, 1-N indolocarbazole, pyridine, pyrimidine, pyrazine, triazine, dibenzofuran, dibenzothiophene, dibenzoselenophene, azadibenzothiophene, azadibenzoselenophene, azacarbazole, azadibenzofuran, silyl, phenyl nitrile, and boryl; and/or wherein the first compound S1 has a full width at half maximum (FWHM) of < 50nm.

14. The OLED of claim 13, wherein the at least one moiety F is selected from the group consisting of: 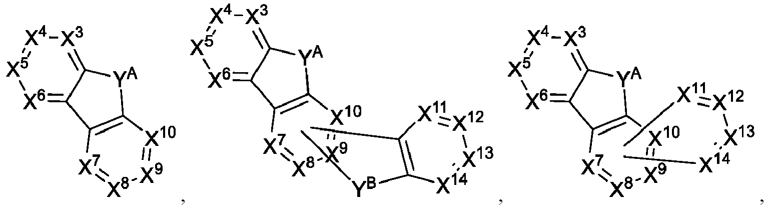 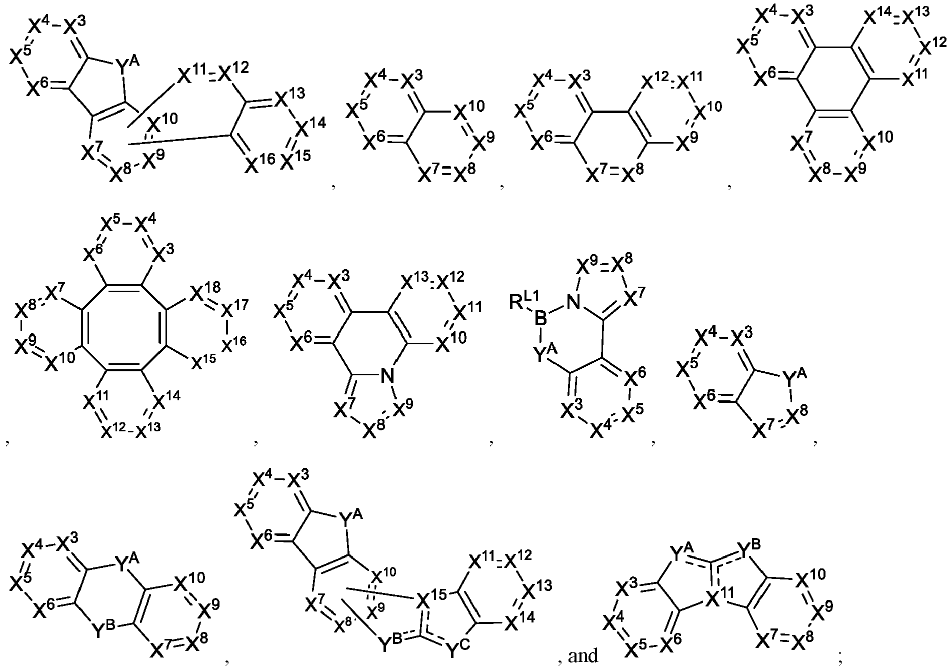 wherein:
each of X¹-X¹⁸ can be independently C or N;
Y^{A}, Y^{B}, and Y^{C} are each independently selected from the group consisting of BR, BRR', NR, PR, P(O)R, O, S, Se, C=O, C=S, C=Se, C=NR, C=CRR', S=O, SO₂, CR, CRR', SiRR', GeRR', alkylene, cycloalkyl, aryl, cycloalkylene, arylene, heteroarylene, and combinations thereof;
each R^{L1}, R and R' is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and
any two substituents can be joined or fused to form a ring.

15. The OLED of claim 13, wherein the compound S1 is selected from the group consisting of the following structures: 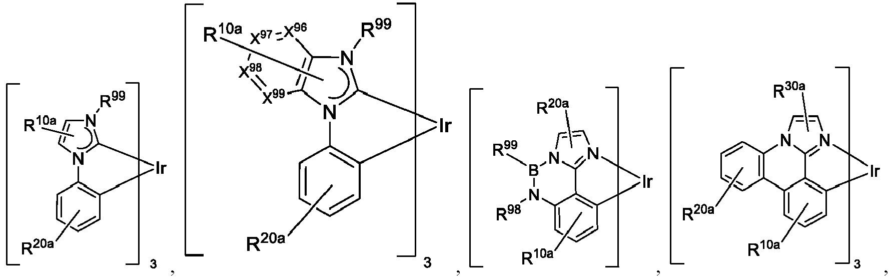 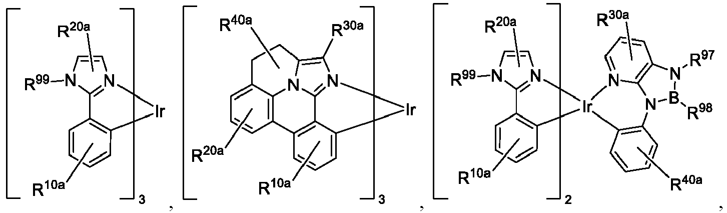 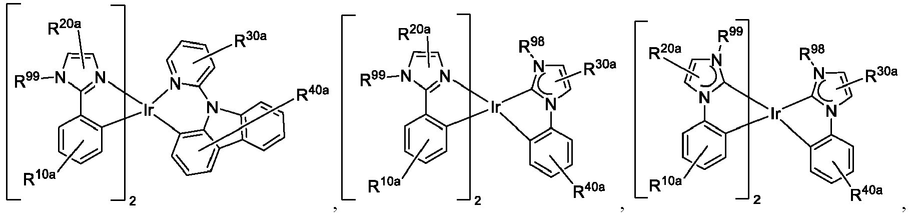 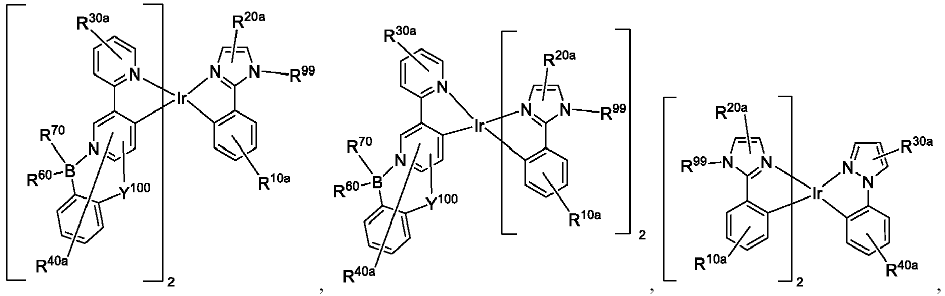 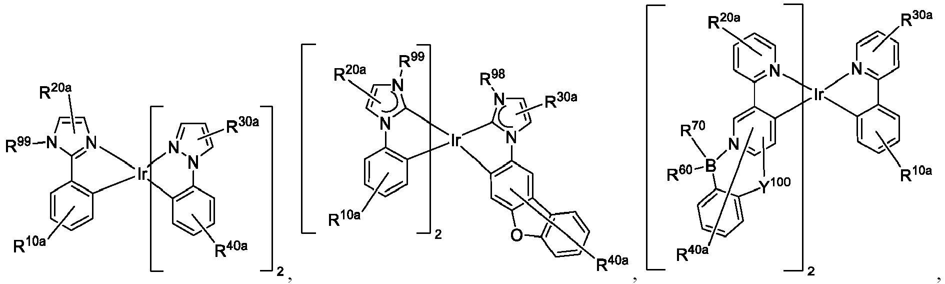 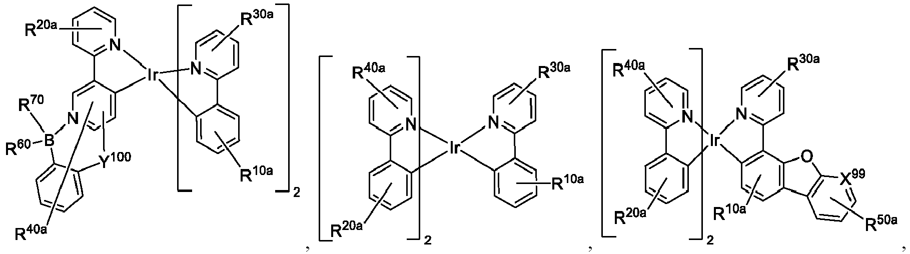 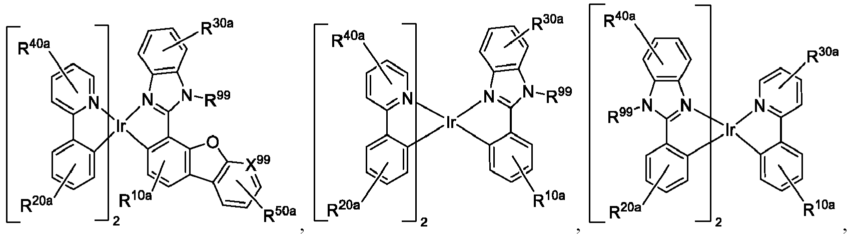 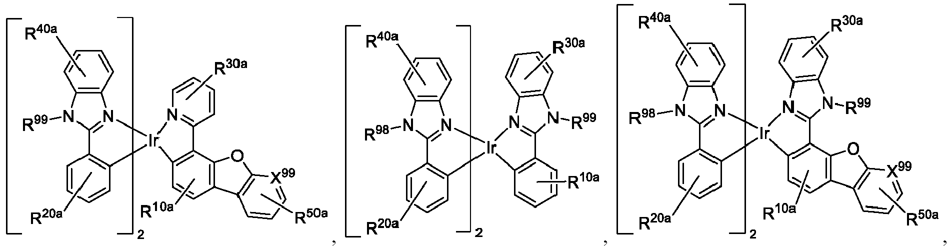 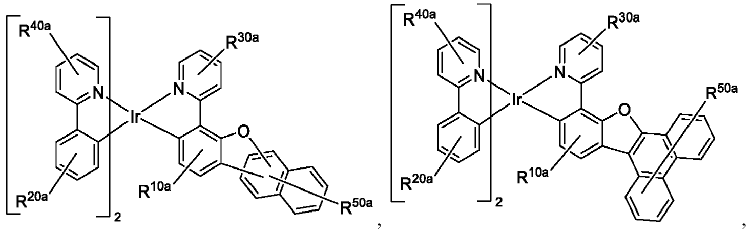 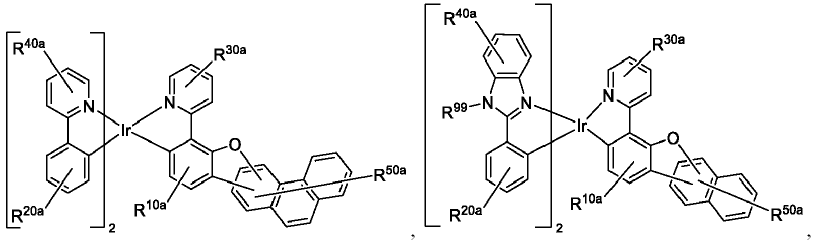 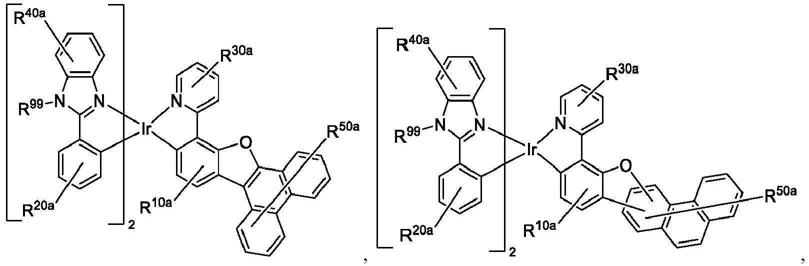 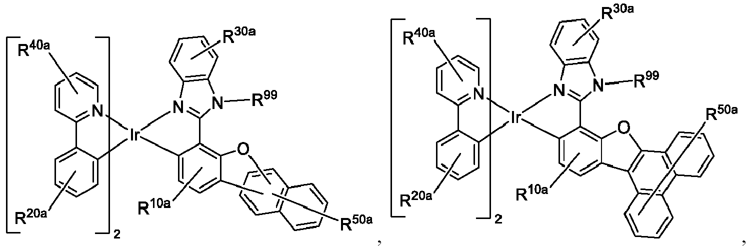 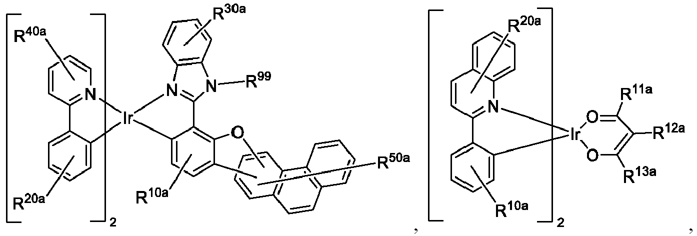 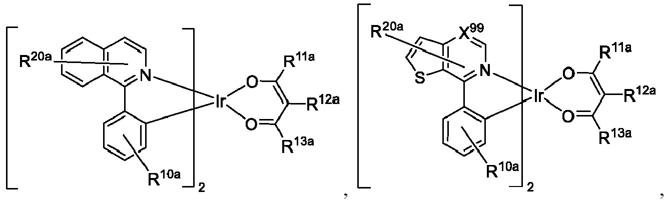 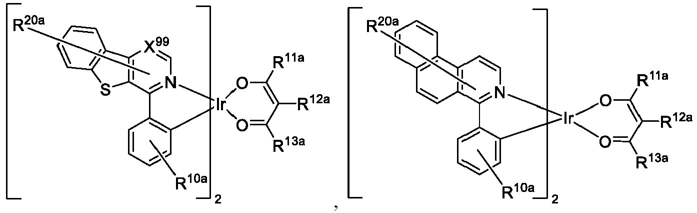 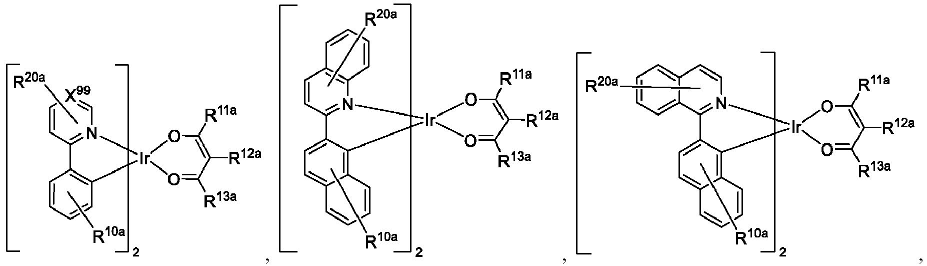 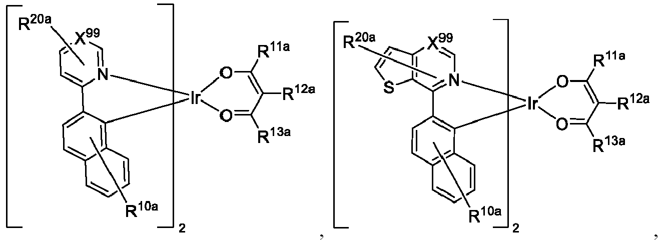 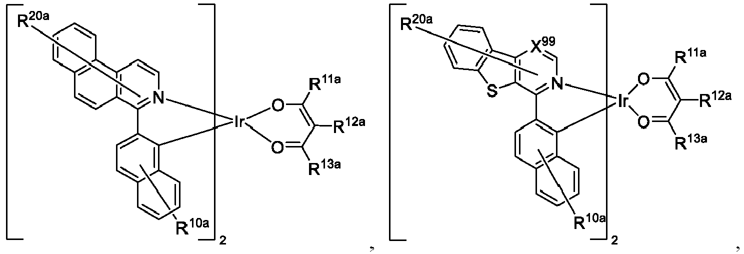 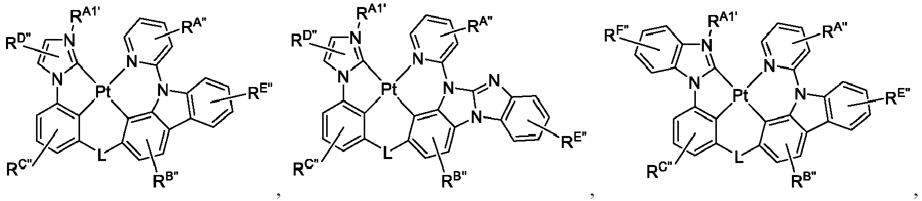 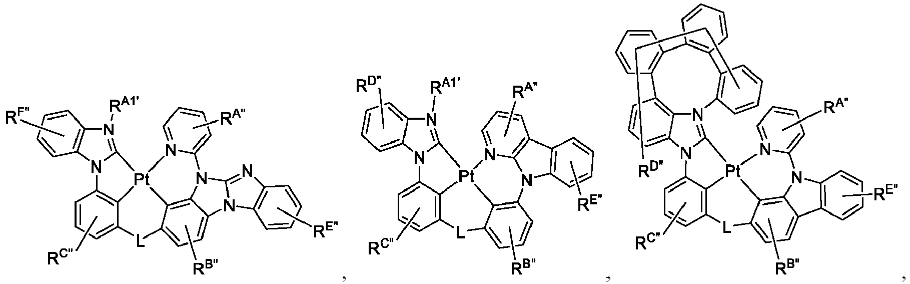 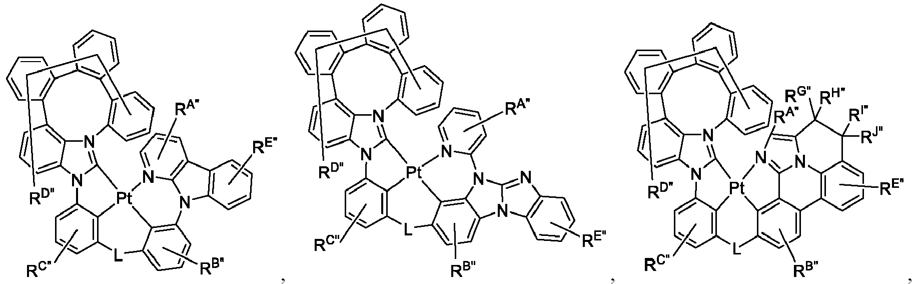 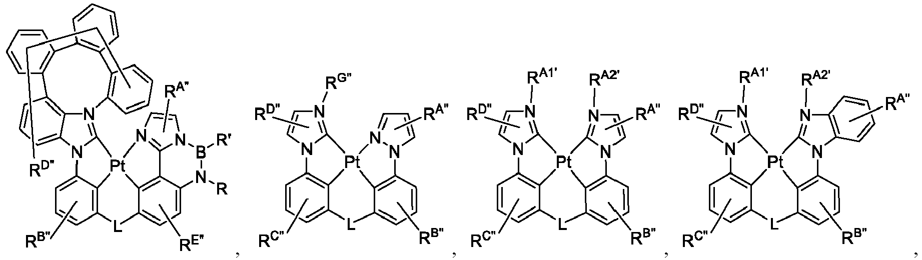 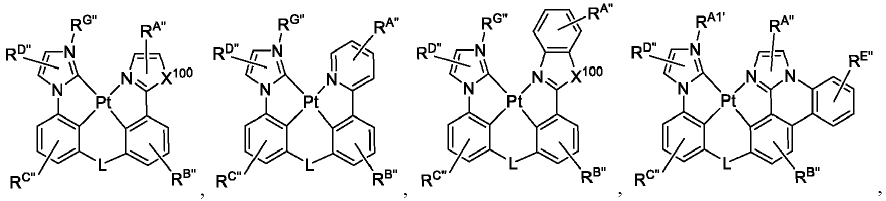 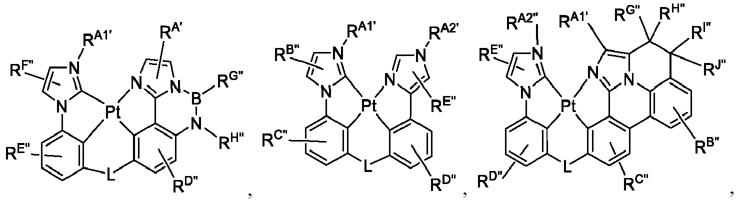 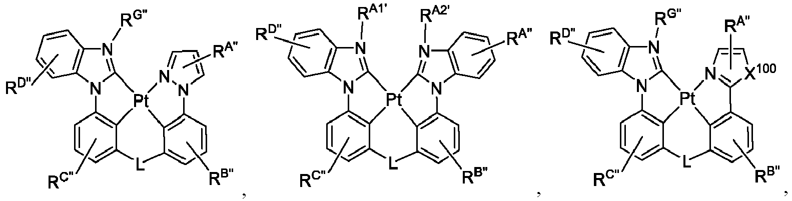 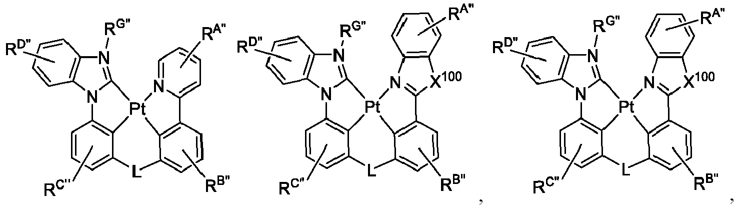 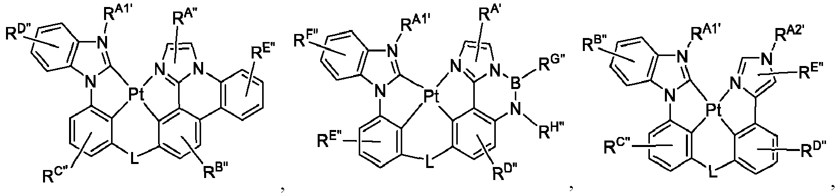 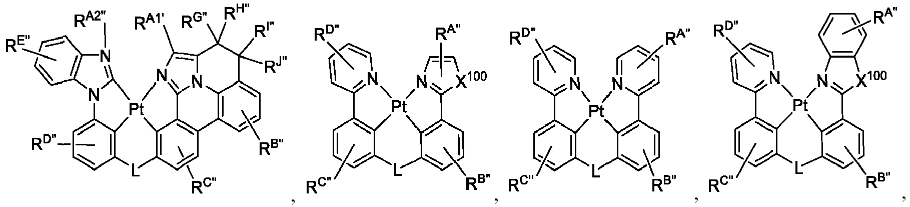 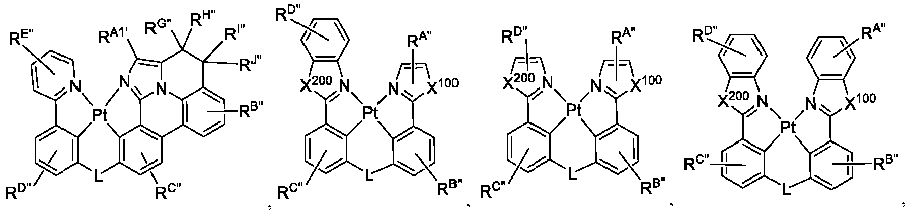 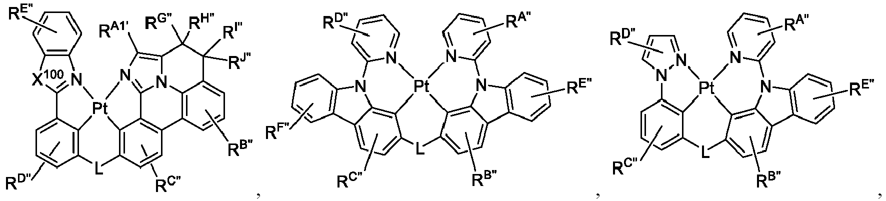 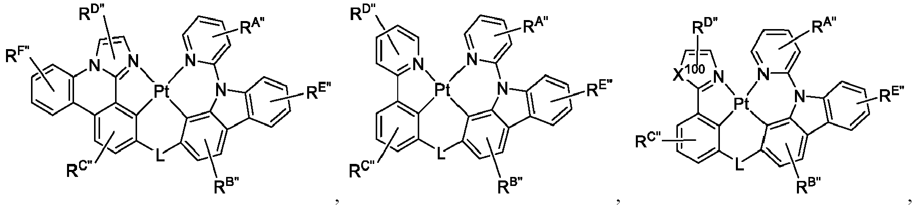 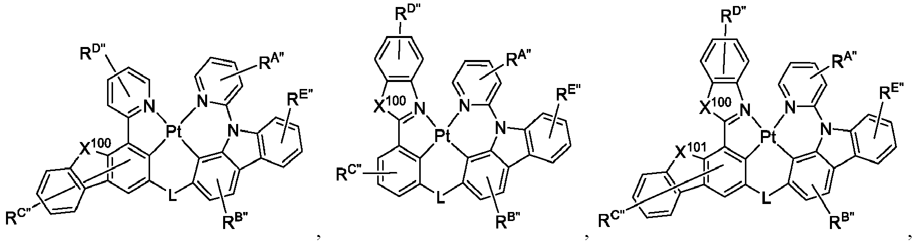 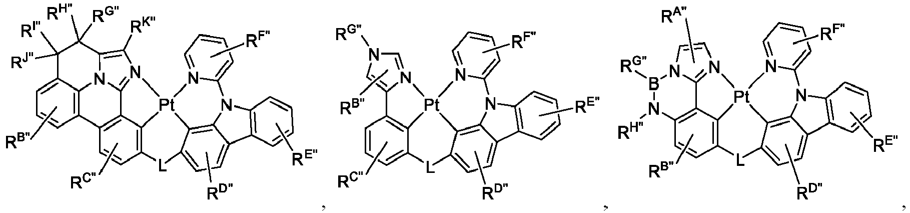 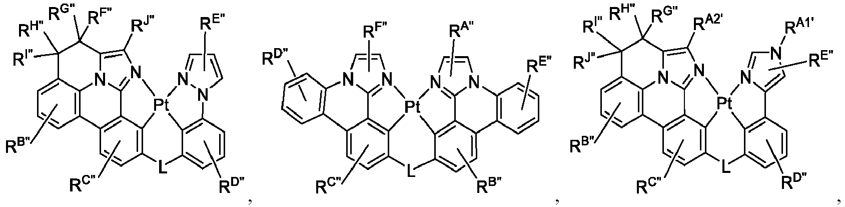 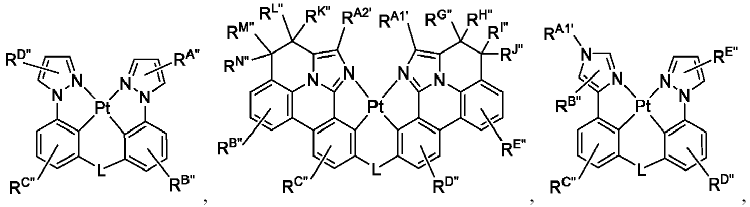 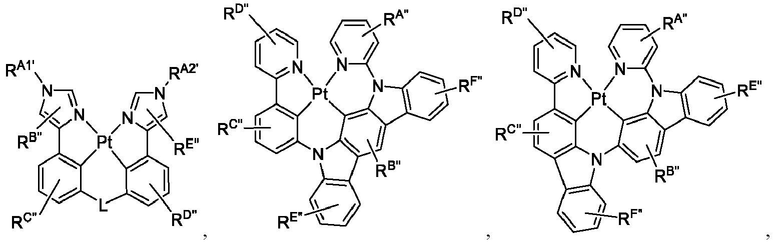 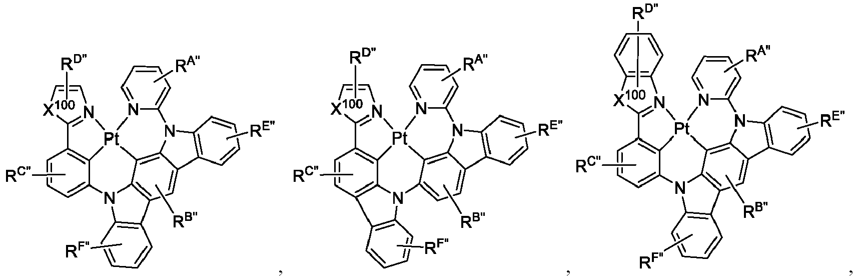 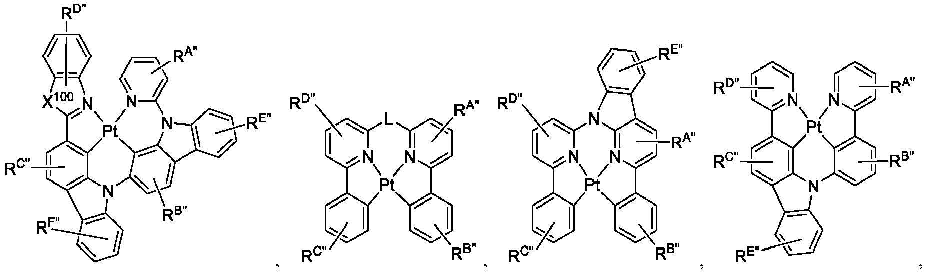 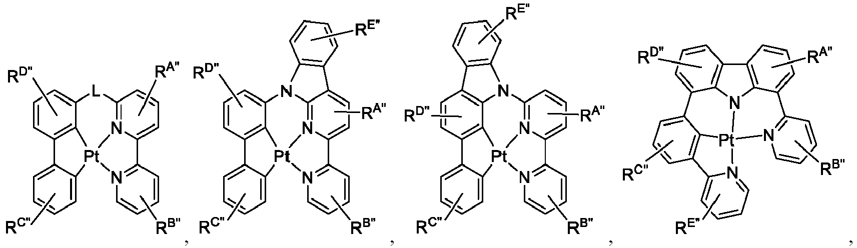 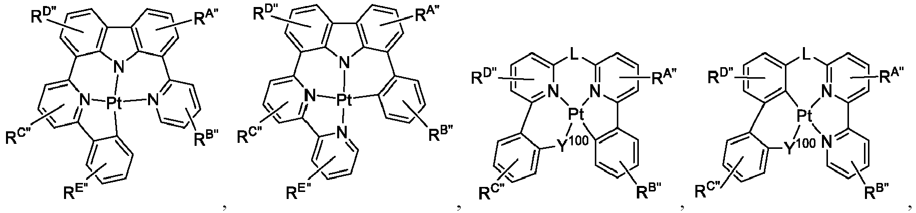 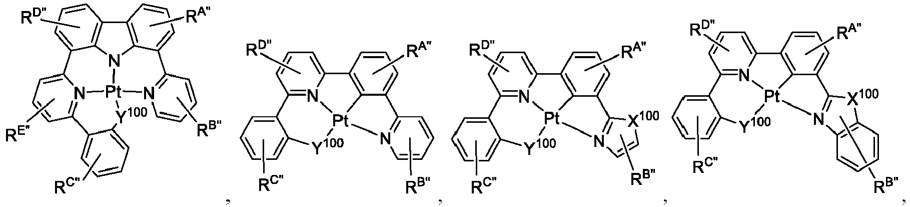 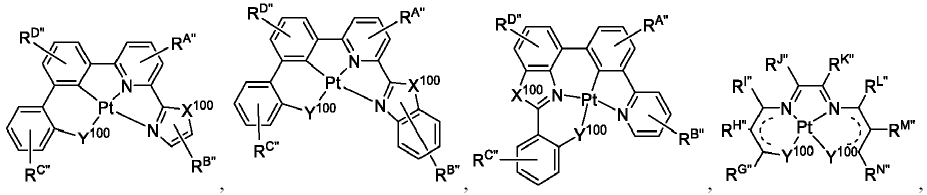 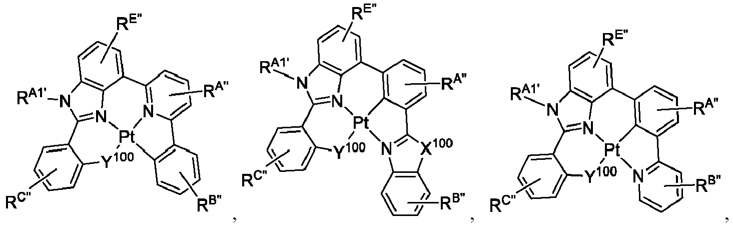 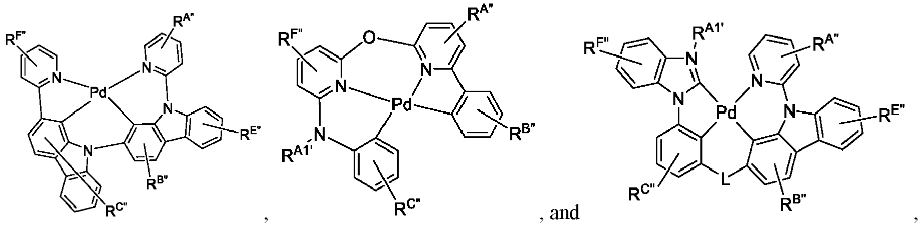 wherein:
each of X⁹⁶ to X⁹⁹ is independently C or N;
each Y¹⁰⁰ is independently selected from the group consisting of a NR, O, S, and Se;
L is independently selected from the group consisting of a direct bond, BR, BRR', NR, PR, O, S, Se, C=O, C=S, C=Se, C=NR, C=CRR', S=O, SO₂, CR, CRR', SiRR', GeRR', alkyl, cycloalkyl, aryl, heteroaryl, and combinations thereof;
X¹⁰⁰, and X²⁰⁰ for each occurrence is selected from the group consisting of O, S, Se, NR and CRR';
each R^{10a}, R^{20a} , R^{30a}, R^{40a}, R^{50a}, R^{A"}, R^{B"}, R^{C"}, R^{D"}, R^{E"}, and R^{F"} independently represents mono-, up to the maximum substitutions, or no substitutions;
each of R, R', R", R^{10a}, R^{11a}, R^{12a}, R^{13a}, R^{20a}, R^{30a}, R^{40a}, R^{50a}, R⁶⁰, R⁷⁰, R⁹⁷, R⁹⁸, R⁹⁹, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is independently a hydrogen or a substituent selected from the group consisting of deuterium, halide, alkyl, cycloalkyl, heteroalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, combinations thereof;
at least two R^{10a}, two R^{20a}, two R^{30a}, two R^{40a}, two R^{50a}, R^{A"}, two R^{B"}, two R^{C"}, two R^{D"}, two R^{E"}, or two R^{F"} are fused to form a 5-membered or 6-membered ring for those complexes which do not comprise a fused ring system comprising two or more 5-membered and/or 6- membered carbocyclic or heterocyclic rings; and
two adjacent R^{10a}, R^{11a}, R^{12a}, R^{13a}, R^{20a}, R^{30a}, R^{40a}, R^{50a}, R⁶⁰, R⁷⁰, R⁹⁷, R⁹⁸, R⁹⁹, R, R', R^{A1'}, R^{A2'}, R^{A"}, R^{B"} , R^{C"}, R^{D"} , R^{E"}, R^{F"} , R^{G"}, R^{H"}, R^{I"}, R^{J"}, R^{K"}, R^{L"}, R^{M"}, and R^{N"} may be optionally joined to form a ring.
